(19) Europäisches Patentamt
European Patent Office
Office européen des brevets

(11) EP 4 027 400 B1

(12) # EUROPEAN PATENT SPECIFICATION

(45) Date of publication and mention of the grant of the patent:
**13.05.2026 Bulletin 2026/20**

(21) Application number: **22150279.2**

(22) Date of filing: **05.01.2022**

(51) International Patent Classification (IPC):
***H10K 50/11*** *(2023.01)* ***H10K 85/60*** *(2023.01)*
***H10K 85/40*** *(2023.01)*

(52) Cooperative Patent Classification (CPC):
**H10K 85/615; H10K 85/40;** H10K 50/11; H10K 85/657; H10K 85/6572; H10K 85/6574; H10K 2101/10; H10K 2101/30

(54) **ORGANIC LIGHT-EMITTING DEVICE**

ORGANISCHE LICHTEMITTIERENDE VORRICHTUNG

DISPOSITIF ÉLECTROLUMINESCENT ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **07.01.2021 KR 20210002217**

(43) Date of publication of application:
**13.07.2022 Bulletin 2022/28**

(73) Proprietor: **Samsung Electronics Co., Ltd.**
**Suwon-si, Gyeonggi-do 16677 (KR)**

(72) Inventors:
- **CHUNG, Yeonsook**
**16678 Suwon-si (KR)**
- **KANG, Hosuk**
**16678 Suwon-si (KR)**
- **KIM, Sangmo**
**16678 Suwon-si (KR)**
- **KIM, Inkoo**
**16678 Suwon-si (KR)**
- **KIM, Joonghyuk**
**16678 Suwon-si (KR)**
- **LEE, Hasup**
**16678 Suwon-si (KR)**
- **JEONG, Daun**
**16678 Suwon-si (KR)**
- **JUNG, Yongsik**
**16678 Suwon-si (KR)**
- **CHOI, Hyeonho**
**16678 Suwon-si (KR)**

(74) Representative: **Elkington and Fife LLP**
**Prospect House**
**8 Pembroke Road**
**Sevenoaks, Kent TN13 1XR (GB)**

(56) References cited:
**US-A1- 2015 171 356**

- **KARATSU ET AL: "Blue electroluminescence of silyl substituted anthracene derivatives", ORGANIC ELECTRONICS, ELSEVIER, AMSTERDAM, NL, vol. 8, no. 4, 16 May 2007 (2007-05-16), pages 357 - 366, XP022080901, ISSN: 1566-1199, DOI: 10.1016/J.ORGEL.2006.12.009**
- **WOLAK MASON A ET AL: "High-performance organic light-emitting diodes based on dioxolane-substituted pentacene derivatives", ADVANCED FUNCTIONAL MATERIALS, WILEY - V C H VERLAG GMBH & CO. KGAA, DE, vol. 16, no. 15, 1 January 2006 (2006-01-01), pages 1943 - 1949, XP009154901, ISSN: 1616-301X**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

FIELD OF THE INVENTION

The present disclosure relates to an organic light-emitting device.

BACKGROUND OF THE INVENTION

Organic light-emitting devices (OLEDs) are self-emissive devices which produce full-color images. In addition, OLEDs have wide viewing angles and exhibit excellent driving voltage and response speed characteristics.

OLEDs include an anode, a cathode, and an organic layer between the anode and the cathode and including an emission layer. A hole transport region may be between the anode and the emission layer, and an electron transport region may be between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. The excitons may transition from an excited state to a ground state, thus generating visible light.

Various types of organic light emitting devices are known. However, there still remains a need in OLEDs having one or more, preferably all, of high efficiency, long lifespan, and high triplet-triplet fusion (TTF) ratio characteristics. The document US 2015/171356 A1 is concerning an organic light emitting diode comprising an anthracene as a host material in the light emission layer.

SUMMARY OF THE INVENTION

Provided herein is an organic light-emitting device including a silane compound as a host, thus having high efficiency, long lifespan, and high triplet-triplet fusion (TTF) ratio characteristics.

Additional aspects will be set forth in part in the description which follows and, in part, will be apparent from the description, or may be learned by practice of the presented embodiments of the disclosure.

According to the present invention, an organic light-emitting device includes:

a first electrode,
a second electrode, and
an organic layer between the first electrode and the second electrode and including an emission layer,
wherein the emission layer may include a host and a dopant, and the host includes at least one silane compound represented by Formula 1.

Formula 1

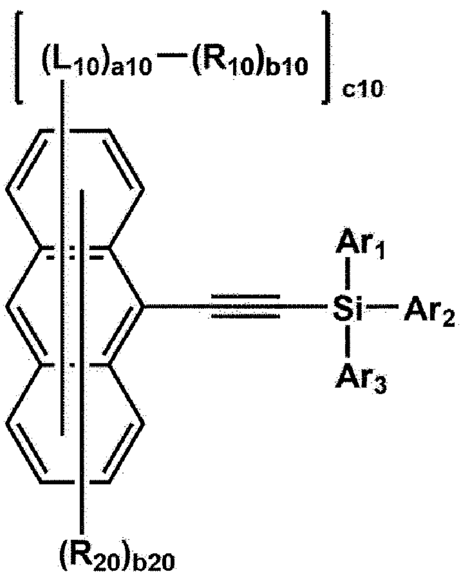

wherein the substituents in Formula 1 are as defined in present claim 1.

BRIEF DESCRIPTION OF THE DRAWING

The above and other aspects, features, and advantages of certain embodiments of the disclosure will be more apparent from the following description taken in conjunction with the FIGURE, which shows a schematic cross-sectional view of an organic light-emitting device according to an embodiment.

DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

It will be understood that when an element is referred to as being "on" another element, it can be directly in contact with the other element or intervening elements may be present therebetween. In contrast, when an element is referred to as being "directly on" another element, there are no intervening elements present.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

The terminology used herein is for the purpose of describing particular embodiments only and is not intended to be limiting. As used herein, the singular forms "a," "an," and "the" are intended to include the plural forms as well, unless the context clearly indicates otherwise.

The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within $\pm$ 20%, 10%, 5% of the stated value.

In any formula, * and *' each indicate a binding site to a neighboring atom or a neighboring functional group.

The term "room temperature" used herein refers to a temperature of about 25 °C.

According to an embodiment, not in accordance with present invention as claimed but useful for understanding its context, a silane compound represented by Formula 1 may be provided:

Formula 1

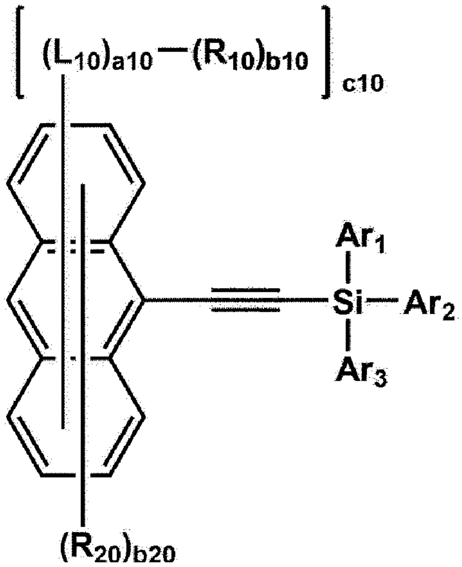

wherein, in Formula 1, $Ar_1$ to $Ar_3$ may each independently be a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-B(Q_6)(Q_7)$, or - $P(=O)(Q_8)(Q_9)$, or
at least one of $Ar_1$ to $Ar_3$ may be a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group.

In an embodiment, $Ar_1$ to $Ar_3$ may each independently be:

a $C_1$-$C_{20}$ alkyl group, $C_1$-$C_{20}$ alkylthio group, or a $C_1$-$C_{20}$ alkoxy group;
a $C_1$-$C_{20}$ alkyl group, $C_1$-$C_{20}$ alkylthio group, or a $C_1$-$C_{20}$ alkoxy group, each independently substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a phenyl group, a naphthyl group, a pyridinyl group, a pyrimidinyl group, a pyrazinyl group, a pyridazinyl group, or a triazinyl group;
a cyclopentyl group, a cyclohexyl group, a cyclopentenyl group, a cyclohexenyl group, a cycloheptenyl group, a phenyl group, a pentalenyl group, an indenyl group, a naphthyl group, an azulenyl group, a heptalenyl group, an indacenyl group, an acenaphthyl group, a fluorenyl group, a spiro-bifluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pyrrolyl group, an imidazolyl group, a pyrazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoxazolyl group, a benzimidazolyl group, a furanyl group, a benzofuranyl group, a thiophenyl group, a benzothiophenyl group, a thiazolyl group, an isothiazolyl group, a benzothiazolyl group, an isoxazolyl group, an oxazolyl group, a triazolyl group, a tetrazolyl group, an oxadiazolyl group, a triazinyl group, a carbazolyl group, a dibenzofuranyl group, a dibenzothiophenyl group, a benzocarbazolyl group, an azacarbazolyl group, an azadibenzofuranyl group, an azadibenzothiophenyl group, a phenoxazinyl group, a phenothiazinyl group, an imidazopyrimidinyl group, or an imidazopyridinyl group; or
a cyclopentyl group, a cyclohexyl group, a cyclopentenyl group, a cyclohexenyl group, a cycloheptenyl group, a

phenyl group, a pentalenyl group, an indenyl group, a naphthyl group, an azulenyl group, a heptalenyl group, an indacenyl group, an acenaphthyl group, a fluorenyl group, a spiro-bifluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pyrrolyl group, an imidazolyl group, a pyrazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoxazolyl group, a benzimidazolyl group, a furanyl group, a benzofuranyl group, a thiophenyl group, a benzothiophenyl group, a thiazolyl group, an isothiazolyl group, a benzothiazolyl group, an isoxazolyl group, an oxazolyl group, a triazolyl group, a tetrazolyl group, an oxadiazolyl group, a triazinyl group, a carbazolyl group, a dibenzofuranyl group, a dibenzothiophenyl group, a benzocarbazolyl group, an azacarbazolyl group, an azadibenzofuranyl group, an azadibenzothiophenyl group, a phenoxazinyl group, a phenothiazinyl group, an imidazopyrimidinyl group, or an imidazopyridinyl group, each independently substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_2$-$C_{20}$ alkenyl group, a $C_2$-$C_{20}$ alkynyl group, a $C_1$-$C_{20}$ alkoxy group, a $C_1$-$C_{20}$ alkylthio group, a phenyl group, a naphthyl group, an anthracenyl group, a pyrenyl group, a phenanthrenyl group, a fluorenyl group, a pyridinyl group, a pyrimidinyl group, a pyrazinyl group, a pyridazinyl group, a triazinyl group, a quinolinyl group, an isoquinolinyl group, a phthalazinyl group, a quinoxalinyl group, a cinnolinyl group, or a quinazolinyl group.

In an embodiment, at least one of $Ar_1$ to $Ar_3$ may be:

a cyclopentyl group, a cyclohexyl group, a cyclopentenyl group, a cyclohexenyl group, a cycloheptenyl group, a phenyl group, a pentalenyl group, an indenyl group, a naphthyl group, an azulenyl group, a heptalenyl group, an indacenyl group, an acenaphthyl group, a fluorenyl group, a spiro-bifluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pyrrolyl group, an imidazolyl group, a pyrazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoxazolyl group, a benzimidazolyl group, a furanyl group, a benzofuranyl group, a thiophenyl group, a benzothiophenyl group, a thiazolyl group, an isothiazolyl group, a benzothiazolyl group, an isoxazolyl group, an oxazolyl group, a triazolyl group, a tetrazolyl group, an oxadiazolyl group, a triazinyl group, a carbazolyl group, a dibenzofuranyl group, a dibenzothiophenyl group, a benzocarbazolyl group, an azacarbazolyl group, an azadibenzofuranyl group, an azadibenzothiophenyl group, a phenoxazinyl group, a phenothiazinyl group, an imidazopyrimidinyl group, or an imidazopyridinyl group; or

a cyclopentyl group, a cyclohexyl group, a cyclopentenyl group, a cyclohexenyl group, a cycloheptenyl group, a phenyl group, a pentalenyl group, an indenyl group, a naphthyl group, an azulenyl group, a heptalenyl group, an indacenyl group, an acenaphthyl group, a fluorenyl group, a spiro-bifluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pyrrolyl group, an imidazolyl group, a pyrazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoxazolyl group, a benzimidazolyl group, a furanyl group, a benzofuranyl group, a thiophenyl group, a benzothiophenyl group, a thiazolyl group, an isothiazolyl group, a benzothiazolyl group, an isoxazolyl group, an oxazolyl group, a triazolyl group, a tetrazolyl group, an oxadiazolyl group, a triazinyl group, a carbazolyl group, a dibenzofuranyl group, a dibenzothiophenyl group, a benzocarbazolyl group, an azacarbazolyl group, an azadibenzofuranyl group, an azadibenzothiophenyl group, a phenoxazinyl group, a phenothiazinyl group, an imidazopyrimidinyl group, or an imidazopyridinyl group, each independently substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_2$-$C_{20}$ alkenyl group, a $C_2$-$C_{20}$ alkynyl group, a $C_1$-$C_{20}$ alkoxy group, a $C_1$-$C_{20}$ alkylthio group, a phenyl group, a naphthyl group, an anthracenyl group, a pyrenyl group, a phenanthrenyl group, a fluorenyl group, a pyridinyl group, a pyrimidinyl group, a pyrazinyl group, a pyridazinyl group, a triazinyl group, a quinolinyl group, an isoquinolinyl

group, a phthalazinyl group, a quinoxalinyl group, a cinnolinyl group, or a quinazolinyl group.

In an embodiment, $Ar_1$ to $Ar_3$ may each independently be a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group.

**In** an embodiment, $Ar_1$ to $Ar_3$ may each independently be: a cyclopentyl group, a cyclohexyl group, a cyclopentenyl group, a cyclohexenyl group, a cycloheptenyl group, a phenyl group, a pentalenyl group, an indenyl group, a naphthyl group, an azulenyl group, a heptalenyl group, an indacenyl group, an acenaphthyl group, a fluorenyl group, a spiro-bifluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pyrrolyl group, an imidazolyl group, a pyrazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoxazolyl group, a benzimidazolyl group, a furanyl group, a benzofuranyl group, a thiophenyl group, a benzothiophenyl group, a thiazolyl group, an isothiazolyl group, a benzothiazolyl group, an isoxazolyl group, an oxazolyl group, a triazolyl group, a tetrazolyl group, an oxadiazolyl group, a triazinyl group, a carbazolyl group, a dibenzofuranyl group, a dibenzothiophenyl group, a benzocarbazolyl group, an azacarbazolyl group, an azadibenzofuranyl group, an azadibenzothiophenyl group, a phenoxazinyl group, a phenothiazinyl group, an imidazopyrimidinyl group, or an imidazopyridinyl group; or
a cyclopentyl group, a cyclohexyl group, a cyclopentenyl group, a cyclohexenyl group, a cycloheptenyl group, a phenyl group, a pentalenyl group, an indenyl group, a naphthyl group, an azulenyl group, a heptalenyl group, an indacenyl group, an acenaphthyl group, a fluorenyl group, a spiro-bifluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pyrrolyl group, an imidazolyl group, a pyrazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoxazolyl group, a benzimidazolyl group, a furanyl group, a benzofuranyl group, a thiophenyl group, a benzothiophenyl group, a thiazolyl group, an isothiazolyl group, a benzothiazolyl group, an isoxazolyl group, an oxazolyl group, a triazolyl group, a tetrazolyl group, an oxadiazolyl group, a triazinyl group, a carbazolyl group, a dibenzofuranyl group, a dibenzothiophenyl group, a benzocarbazolyl group, an azacarbazolyl group, an azadibenzofuranyl group, an azadibenzothiophenyl group, a phenoxazinyl group, a phenothiazinyl group, an imidazopyrimidinyl group, or an imidazopyridinyl group, each independently substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_2$-$C_{20}$ alkenyl group, a $C_2$-$C_{20}$ alkynyl group, a $C_1$-$C_{20}$ alkoxy group, a $C_1$-$C_{20}$ alkylthio group, a phenyl group, a naphthyl group, an anthracenyl group, a pyrenyl group, a phenanthrenyl group, a fluorenyl group, a pyridinyl group, a pyrimidinyl group, a pyrazinyl group, a pyridazinyl group, a triazinyl group, a quinolinyl group, an isoquinolinyl group, a phthalazinyl group, a quinoxalinyl group, a cinnolinyl group, or a quinazolinyl group.

In an embodiment, $Ar_1$ to $Ar_3$ may each independently be:

a phenyl group, a biphenyl group, a terphenyl group, a naphthyl group, a fluorenyl group, a carbazolyl group, a dibenzofuranyl group, a dibenzothiophenyl group, an azacarbazolyl group, an azadibenzofuranyl group, an azadibenzothiophenyl group, a phenoxazinyl group, or a phenothiazinyl group; or
a phenyl group, a biphenyl group, a terphenyl group, a naphthyl group, a fluorenyl group, a carbazolyl group, a dibenzofuranyl group, a dibenzothiophenyl group, an azacarbazolyl group, an azadibenzofuranyl group, an azadibenzothiophenyl group, a phenoxazinyl group, or a phenothiazinyl group, each independently substituted with at least one of deuterium, a cyano group, a $C_1$-$C_{20}$ alkyl group, a $C_1$-$C_{20}$ alkoxy group, a $C_1$-$C_{20}$ alkylthio group, a phenyl group, a biphenyl group, a terphenyl group, or a naphthyl group.

In Formula 1, $L_{10}$ may be a substituted or unsubstituted $C_5$-$C_{30}$ carbocyclic group or a substituted or unsubstituted $C_1$-$C_{30}$ heterocyclic group.

In an embodiment, $L_{10}$ may be: a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, a pentacenylene group, a carbazolylene group, a dibenzofuranylene group, a dibenzothiophenylene group, a dibenzosilolylene group, a benzocarbazolylene group, a pyridinylene group, a pyrimidinylene group, a triazinylene group, a quinolinylene group, an isoquinolinylene group, a benzoquinolinylene group, a phthalazinylene group, a naphthyridinylene group, a quinoxalinylene group, a quinazolinylene group, a phenanthridinylene group, an acridinylene group, a phenanthrolinylene group, a phenazinylene group, a phenoxazinylene group, a phenothiazinylene group, an azacarbazolylene group, an azadibenzofuranylene group, or an azadibenzothiophenylene group;

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, a pentacenylene group, a carbazolylene group, a dibenzofuranylene group, a dibenzothiophenylene group, a dibenzosilolylene group, a benzocarbazolylene group, a pyridinylene group, a pyrimidinylene group, a triazinylene group, a quinolinylene group, an isoquinolinylene group, a benzoquinolinylene group, a phthalazinylene group, a naphthyridinylene group, a quinoxalinylene group, a quinazolinylene group, a phenanthridinylene group, an acridinylene group, a phenanthrolinylene group, a phenazinylene group, a phenoxazinylene group, a phenothiazinylene group, an azacarbazolylene group, an azadibenzofuranylene group, or an azadibenzothiophenylene group, each independently substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group; or
a group represented by Formula 2A or Formula 2B:

Formula 2A

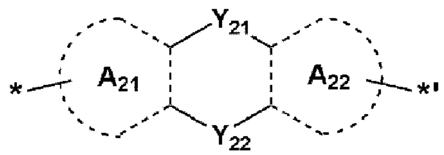

Formula 2B

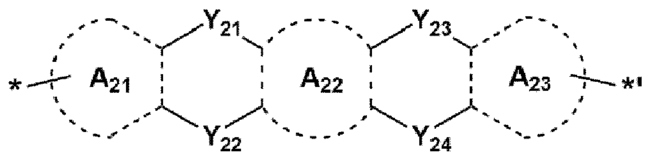

wherein, in Formulae 2A and 2B,
$Y_{21}$ to $Y_{24}$ may each independently be a single bond, O, S, $N(R_{21})$, $C(R_{21})(R_{22})$, $Si(R_{21})(R_{22})$, C(=O), S(=O), $S(=O)_2$, $B(R_{21})$, $P(R_{21})$, or $P(=O)(R_{21})$,
$A_{21}$ to $A_{23}$ may each independently be a phenyl group, a naphthalene group, a 1,2,3,4-tetrahydronaphthalene group, a phenanthrene group, a pyridine group, a pyrimidine group, a pyrazine group, a triazine group, a quinoline group, an isoquinoline group, a quinoxaline group, a quinazoline group, a phenanthroline group, a benzofuran group, a benzothiophene group, a fluorene group, a carbazole group, a dibenzofuran group, a dibenzothiophene group, a dibenzosilole group, an azafluorene group, an azacarbazole group, an azadibenzofuran group, an azadibenzothiophene group, or an azadibenzosilole group,
$R_{21}$ and $R_{22}$ may each independently be understood by referring to the description of $R_{10}$ or $R_{20}$ provided herein, and
* and *' each indicate a binding site to an adjacent atom.

In an embodiment, in Formulae 2A and 2B, $Y_{21}$ to $Y_{24}$ may each independently be a single bond, O, S, $N(R_{21})$, $C(R_{21})(R_{22})$, or $Si(R_{21})(R_{22})$.
In an embodiment, $Y_{21}$ and $Y_{22}$ may not each be a single bond simultaneously, and $Y_{23}$ and $Y_{24}$ may not each be a single bond simultaneously.
In an embodiment, $A_{21}$ to $A_{23}$ may each independently be a phenyl group, a naphthalene group, a pyridine group,

or a pyrimidine group.

In an embodiment, $A_{21}$ to $A_{23}$ may each independently be a phenyl group or a naphthalene group.

In Formula 1, a10 may be an integer from 0 to 3, and when a10 is 2 or greater, at least two $L_{10}$(s) may be identical to or different from each other.

In an embodiment, a10 may be 0 or 1. For example, a10 may be 0. In an embodiment, a10 may be 1.

In an embodiment, when a10 is 0, $-(L_{10})_{a10}-$ represents a single bond.

In an embodiment not forming part of the present invention, in Formula 1, $R_{10}$ and $R_{20}$ may each independently be hydrogen, deuterium, - F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-B(Q_6)(Q_7)$, or $-P(=O)(Q_8)(Q_9)$.

In an embodiment not forming part of the present invention, $R_{10}$ and $R_{20}$ may each independently be:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, a $C_1$-$C_{20}$ alkyl group, a $C_1$-$C_{20}$ alkylthio group, or a $C_1$-$C_{20}$ alkoxy group;

a $C_1$-$C_{20}$ alkyl group, a $C_1$-$C_{20}$ alkylthio group, or a $C_1$-$C_{20}$ alkoxy group, each independently substituted with at least one of deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, or a pyrimidinyl group;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group, each independently substituted with at least one of deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_1$-$C_{20}$ alkylthio group, a

cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group; or

$-N(Q_1)(Q_2)$, $-Si(Q_3)(Q_4)(Q_5)$, $-B(Q_6)(Q_7)$, or $-P(=O)(Q_8)(Q_9)$,

wherein $Q_1$ to $Q_9$ may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, or $-CD_2CDH_2$;

an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a phenyl group, or a naphthyl group; or

an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group, each independently substituted with at least one of deuterium, a $C_1$-$C_{10}$ alkyl group, or a phenyl group.

In an embodiment not forming part of the present invention,

$R_{10}$ and $R_{20}$ may each independently be: hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkylthio group, or a $C_1$-$C_{20}$ alkoxy group;

a $C_1$-$C_{20}$ alkyl group, a $C_1$-$C_{20}$ alkylthio group, or a $C_1$-$C_{20}$ alkoxy group, each independently substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a phenyl group, a naphthyl group, a pyridinyl group, a pyrimidinyl group, a pyrazinyl group, a pyridazinyl group, or a triazinyl group;

a cyclopentyl group, a cyclohexyl group, a cyclopentenyl group, a cyclohexenyl group, a cycloheptenyl group, a phenyl group, a pentalenyl group, an indenyl group, a naphthyl group, an azulenyl group, a heptalenyl group, an indacenyl group, an acenaphthyl group, a fluorenyl group, a spiro-bifluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pyrrolyl group, an imidazolyl group, a pyrazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoxazolyl group, a benzimidazolyl group, a furanyl group, a benzofuranyl group, a thiophenyl group, a benzothiophenyl group, a thiazolyl group, an isothiazolyl group, a benzothiazolyl group, an isoxazolyl group, an oxazolyl group, a triazolyl group, a tetrazolyl group, an oxadiazolyl group, a triazinyl group, a carbazolyl group, a dibenzofuranyl group, a dibenzothiophenyl group, a benzocarbazolyl group, an azacarbazolyl group, an azadibenzofuranyl group, an azadibenzothiophenyl group, a phenoxazinyl group, a phenothiazinyl group, an imidazopyrimidinyl group, or an imidazopyridinyl group; or

a cyclopentyl group, a cyclohexyl group, a cyclopentenyl group, a cyclohexenyl group, a cycloheptenyl group, a phenyl group, a pentalenyl group, an indenyl group, a naphthyl group, an azulenyl group, a heptalenyl group, an indacenyl group, an acenaphthyl group, a fluorenyl group, a spiro-bifluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pyrrolyl group, an imidazolyl group, a pyrazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoxazolyl group, a benzimidazolyl group, a furanyl group, a benzofuranyl group, a thiophenyl group, a benzothiophenyl group, a thiazolyl group, an isothiazolyl group, a benzothiazolyl group, an isoxazolyl group, an oxazolyl group,

a triazolyl group, a tetrazolyl group, an oxadiazolyl group, a triazinyl group, a carbazolyl group, a dibenzofuranyl group, a dibenzothiophenyl group, a benzocarbazolyl group, an azacarbazolyl group, an azadibenzofuranyl group, an azadibenzothiophenyl group, a phenoxazinyl group, a phenothiazinyl group, an imidazopyrimidinyl group, or an imidazopyridinyl group, each independently substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_2$-$C_{20}$ alkenyl group, a $C_2$-$C_{20}$ alkynyl group, a $C_1$-$C_{20}$ alkoxy group, a $C_1$-$C_{20}$ alkylthio group, a phenyl group, a naphthyl group, an anthracenyl group, a pyrenyl group, a phenanthrenyl group, a fluorenyl group, a pyridinyl group, a pyrimidinyl group, a pyrazinyl group, a pyridazinyl group, a triazinyl group, a quinolinyl group, an isoquinolinyl group, a phthalazinyl group, a quinoxalinyl group, a cinnolinyl group, a quinazolinyl group, a carbazolyl group, a dibenzofuranyl group, a dibenzothiophenyl group, a benzocarbazolyl group, an azacarbazolyl group, an azadibenzofuranyl group, an azadibenzothiophenyl group, a phenoxazinyl group, or a phenothiazinyl group.

In the embodiments of the present invention, $R_{10}$ and $R_{20}$ are each independently be deuterium, -F, a cyano group, $-CD_3$, $-CD_2H$, $-CDH_2$, $-CF_3$, $-CF_2H$, $-CFH_2$, groups represented by Formulae 9-1 to 9-19, or groups represented by Formulae10-1 to 10-211:

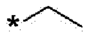
9-1
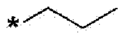
9-2
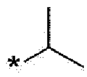
9-3
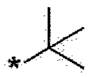
9-4
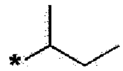
9-5
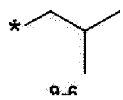
9-6
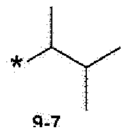
9-7

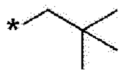
9-8
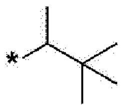
9-9
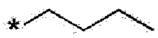
9-10
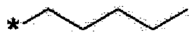
9-11
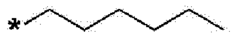
9-12

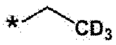
9-13
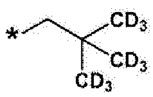
9-14
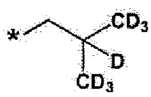
9-15
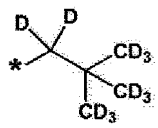
9-16
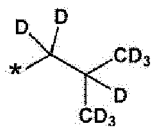
9-17
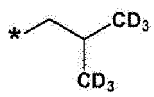
9-18

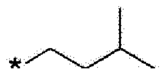
9-19

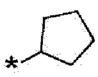
10-1
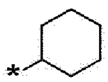
10-2
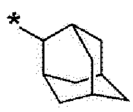
10-3
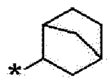
10-4
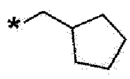
10-5
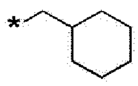
10-6
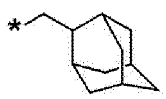
10-7

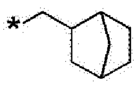
10-8
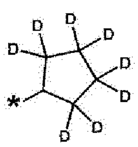
10-9
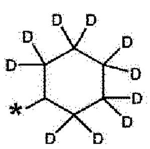
10-10
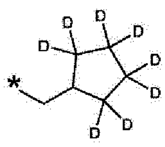
10-11
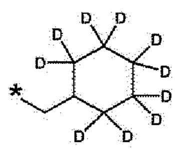
10-12
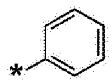
10-13

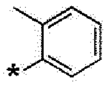
10-14
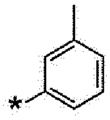
10-15
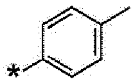
10-16
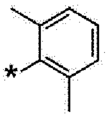
10-17
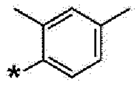
10-18
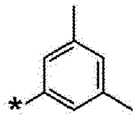
10-19
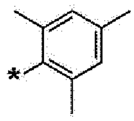
10-20

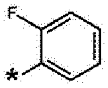
10-21
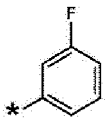
10-22
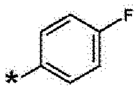
10-23
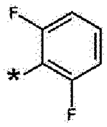
10-24
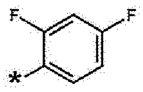
10-25
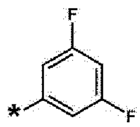
10-26
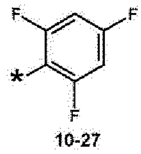
10-27

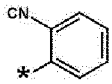
10-28
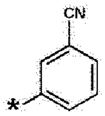
10-29
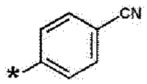
10-30
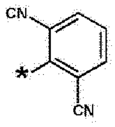
10-31
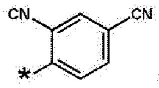
10-32
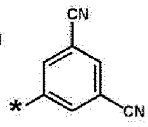
10-33
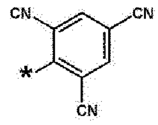
10-34

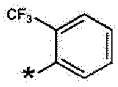
10-35
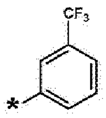
10-36
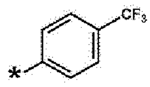
10-37
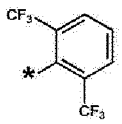
10-38
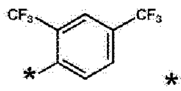
10-39
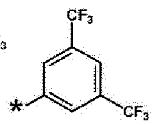
10-40
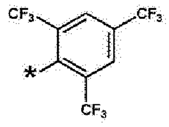
10-41

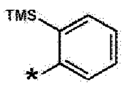
10-42
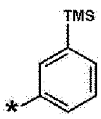
10-43
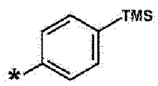
10-44
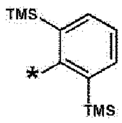
10-45
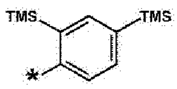
10-46
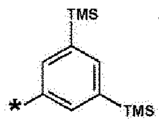
10-47
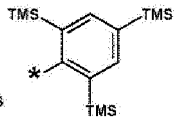
10-48

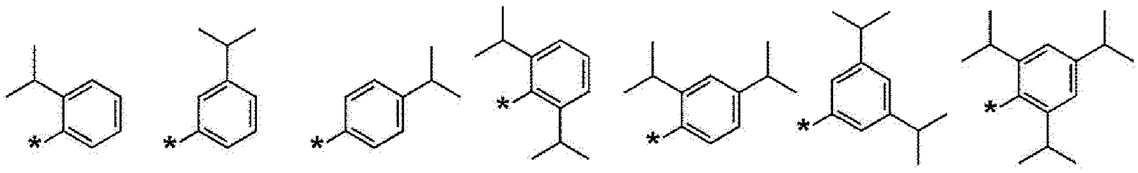
10-49 10-50 10-51 10-52 10-53 10-54 10-55

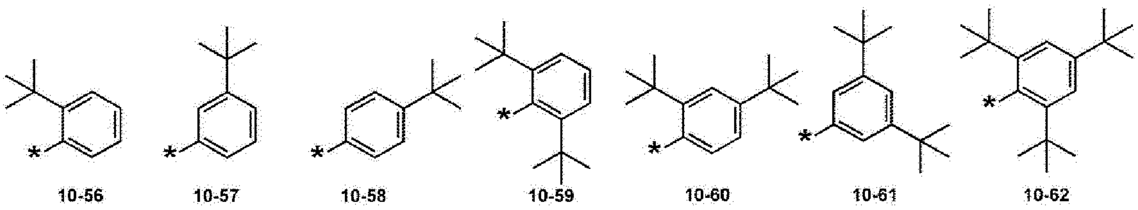
10-56 10-57 10-58 10-59 10-60 10-61 10-62

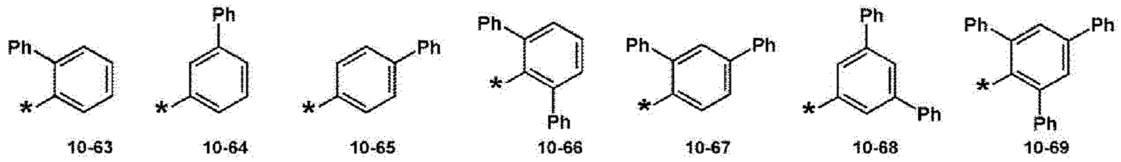
10-63 10-64 10-65 10-66 10-67 10-68 10-69

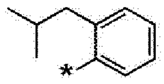
10-70

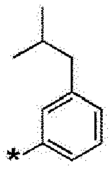
10-71

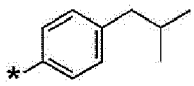
10-72

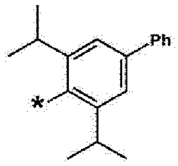
10-73

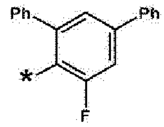
10-74

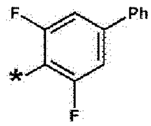
10-75

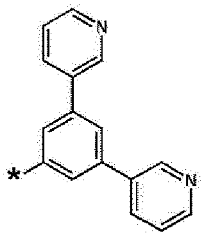
10-76

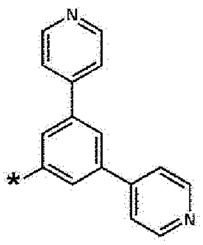
10-77

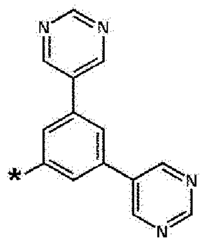
10-78

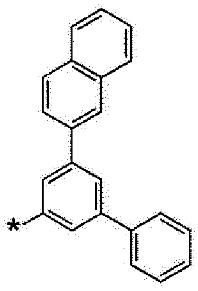
10-79

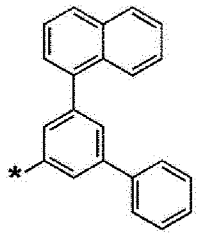
10-80

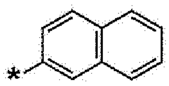
10-81

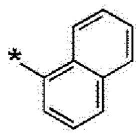
10-82

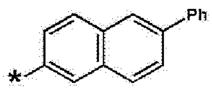
10-83

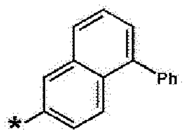
10-84

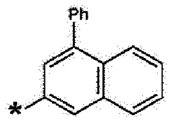
10-85

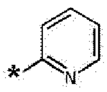
10-86

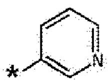
10-87

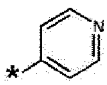
10-88

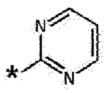
10-89

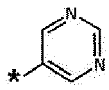
10-90

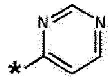
10-91

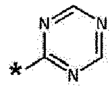
10-92

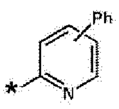
10-93

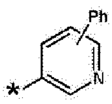
10-94

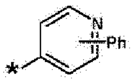
10-95

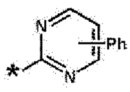
10-96

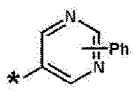
10-97

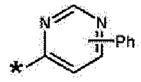
10-98

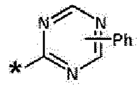
10-99

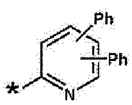
10-100

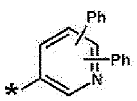
10-101

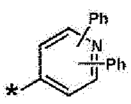
10-102

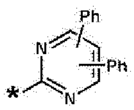
10-103

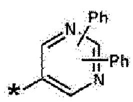
10-104

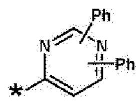
10-105

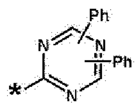
10-106

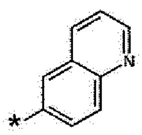
10-107

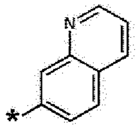
10-108

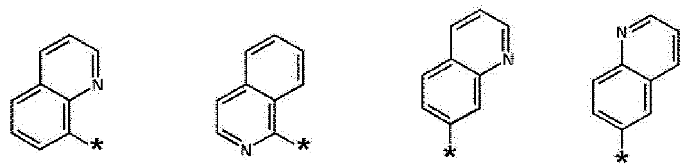
10-109

10-110

10-111

10-112

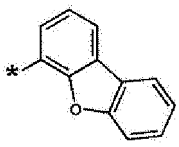 10-113
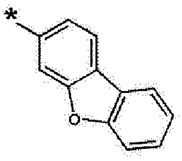 10-114
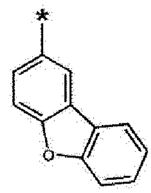 10-115
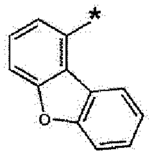 10-116
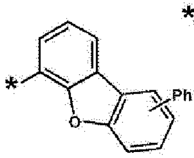 10-117
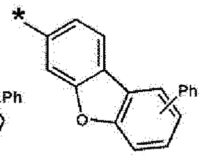 10-118

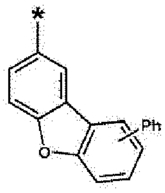 10-119
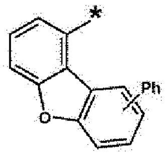 10-120
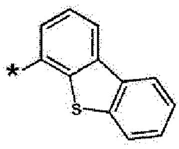 10-121
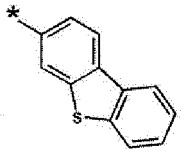 10-122
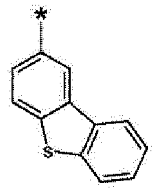 10-123
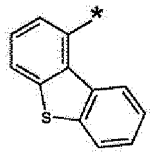 10-124

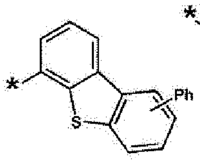 10-125
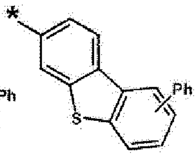 10-126
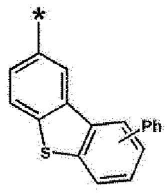 10-127
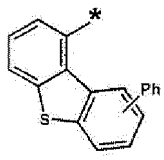 10-128
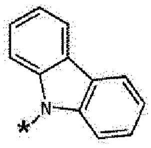 10-129
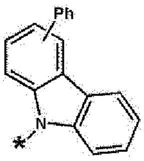 10-130

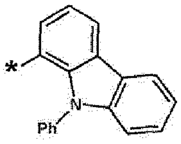 10-131
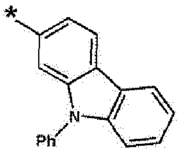 10-132
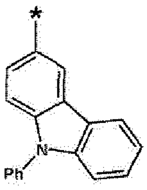 10-133
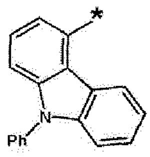 10-134
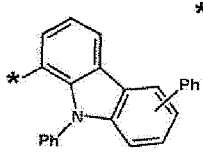 10-135
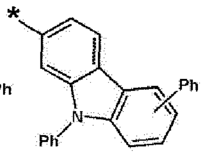 10-136

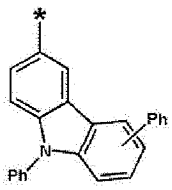 10-137
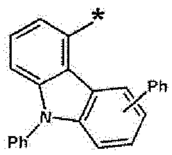 10-138
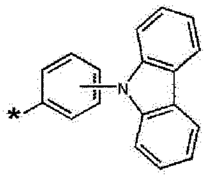 10-139
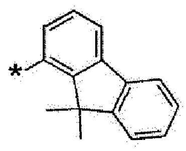 10-140
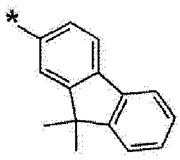 10-141
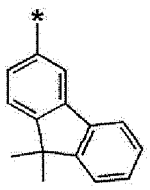 10-142

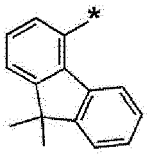 10-143
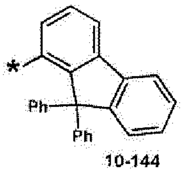 10-144
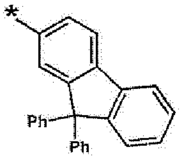 10-145
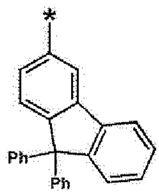 10-146
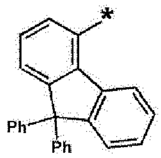 10-147

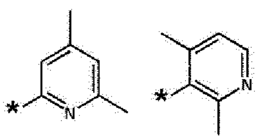 10-148 10-149
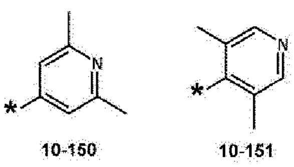 10-150 10-151
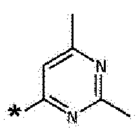 10-152
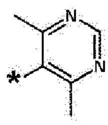 10-153
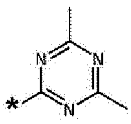 10-154

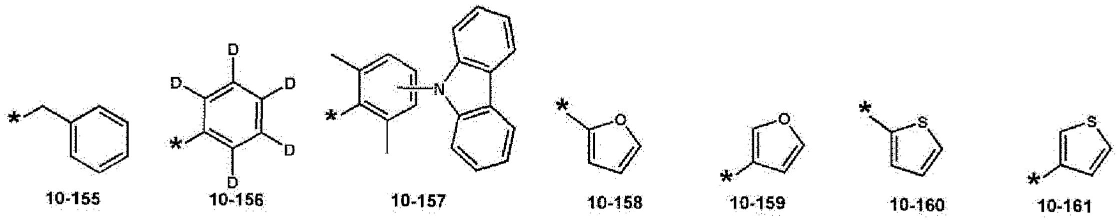

10-155 10-156 10-157 10-158 10-159 10-160 10-161

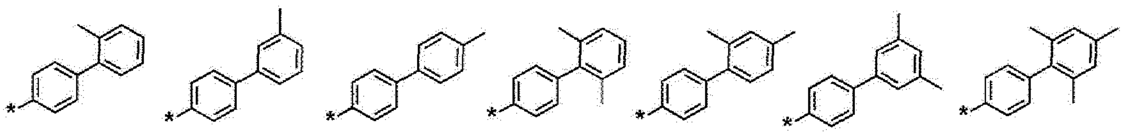

10-162 10-163 10-164 10-165 10-166 10-167 10-168

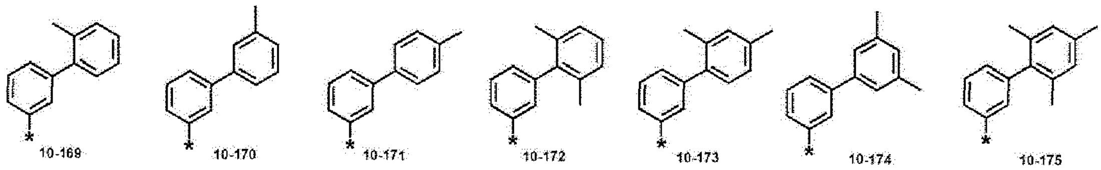

10-169 10-170 10-171 10-172 10-173 10-174 10-175

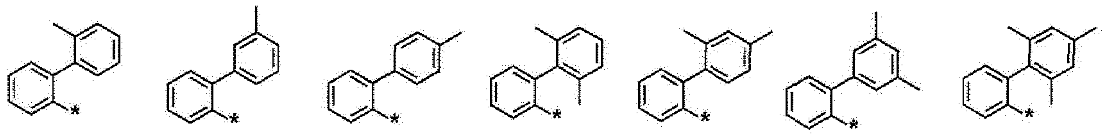

10-176 10-177 10-178 10-179 10-180 10-181 10-182

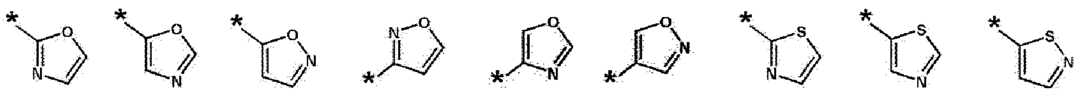

10-183 10-184 10-185 10-186 10-187 10-188 10-189 10-190 10-191

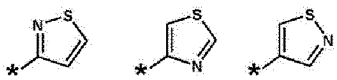

10-192 10-193 10-194

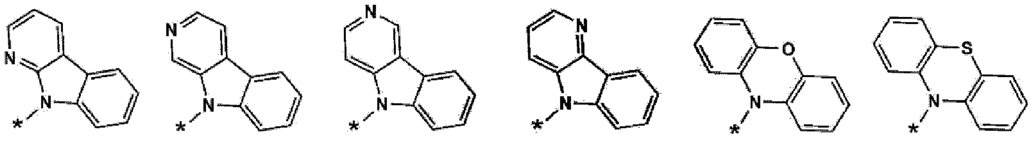

10-195 10-196 10-197 10-198 10-200 10-201

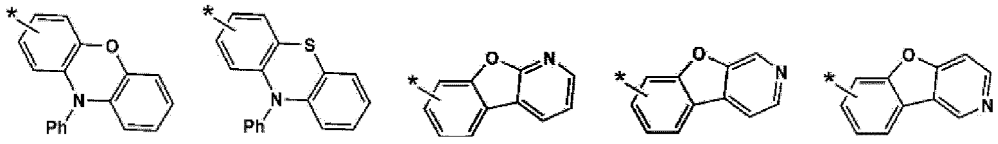

10-202 10-203 10-204 10-205 10-206

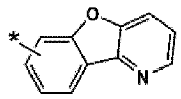 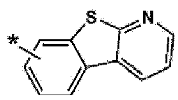 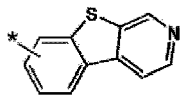 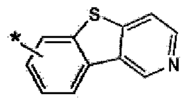 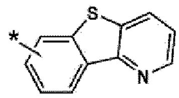

10-207 10-208 10-209 10-210 10-211

wherein, in Formulae 9-1 to 9-19 and 10-1 to 10-211, * indicates a binding site to an adjacent atom, "Ph" represents a phenyl group, and "TMS" represents a trimethylsilyl group.

In an embodiment not forming part of the present invention, $R_{10}$ and $R_{20}$ may each independently be: hydrogen, deuterium, -F, a cyano group, $-CD_3$, $-CD_2H$, $-CDH_2$, $-CF_3$, $-CF_2H$, $-CFH_2$, a $C_1$-$C_{20}$ alkyl group, a $C_1$-$C_{20}$ alkylthio group, or a $C_1$-$C_{20}$ alkoxy group;

a $C_1$-$C_{20}$ alkyl group, a $C_1$-$C_{20}$ alkylthio group, or a $C_1$-$C_{20}$ alkoxy group, each independently substituted with at least one of deuterium, a cyano group, a phenyl group, a biphenyl group, a terphenyl group, or a naphthyl group;
a cyclopentyl group, a cyclohexyl group, a cyclopentenyl group, a cyclohexenyl group, a cycloheptenyl group, a phenyl group, a biphenyl group, a terphenyl group, a naphthyl group, a fluorenyl group, a carbazolyl group, a dibenzofuranyl group, a dibenzothiophenyl group, a benzocarbazolyl group, an azacarbazolyl group, an azadibenzofuranyl group, an azadibenzothiophenyl group, a phenoxazinyl group, or a phenothiazinyl group; or
a cyclopentyl group, a cyclohexyl group, a cyclopentenyl group, a cyclohexenyl group, a cycloheptenyl group, a phenyl group, a biphenyl group, a terphenyl group, a naphthyl group, a fluorenyl group, a carbazolyl group, a dibenzofuranyl group, a dibenzothiophenyl group, a benzocarbazolyl group, an azacarbazolyl group, an azadibenzofuranyl group, an azadibenzothiophenyl group, a phenoxazinyl group, or a phenothiazinyl group, each independently substituted with at least one of deuterium, a cyano group, a $C_1$-$C_{20}$ alkyl group, a $C_1$-$C_{20}$ alkoxy group, a $C_1$-$C_{20}$ alkylthio group, a phenyl group, a biphenyl group, a terphenyl group, or a naphthyl group.

In an embodiment, $R_{10}$ may be: deuterium, -F, a cyano group, $-CD_3$, $-CD_2H$, - $CDH_2$, $-CF_3$, $-CF_2H$, $-CFH_2$, a $C_1$-$C_{20}$ alkyl group, a $C_1$-$C_{20}$ alkylthio group, or a $C_1$-$C_{20}$ alkoxy group;

a $C_1$-$C_{20}$ alkyl group, a $C_1$-$C_{20}$ alkylthio group, or a $C_1$-$C_{20}$ alkoxy group, each independently substituted with at least one of deuterium, a cyano group, a phenyl group, a biphenyl group, a terphenyl group, or a naphthyl group;
a cyclopentyl group, a cyclohexyl group, a cyclopentenyl group, a cyclohexenyl group, a cycloheptenyl group, a phenyl group, a biphenyl group, a terphenyl group, a naphthyl group, a fluorenyl group, a carbazolyl group, a dibenzofuranyl group, a dibenzothiophenyl group, a benzocarbazolyl group, an azacarbazolyl group, an azadibenzofuranyl group, an azadibenzothiophenyl group, a phenoxazinyl group, or a phenothiazinyl group; or
a cyclopentyl group, a cyclohexyl group, a cyclopentenyl group, a cyclohexenyl group, a cycloheptenyl group, a phenyl group, a biphenyl group, a terphenyl group, a naphthyl group, a fluorenyl group, a carbazolyl group, a dibenzofuranyl group, a dibenzothiophenyl group, a benzocarbazolyl group, an azacarbazolyl group, an azadibenzofuranyl group, an azadibenzothiophenyl group, a phenoxazinyl group, or a phenothiazinyl group, each independently substituted with at least one of deuterium, a cyano group, a $C_1$-$C_{20}$ alkyl group, a $C_1$-$C_{20}$ alkoxy group, a $C_1$-$C_{20}$ alkylthio group, a phenyl group, a biphenyl group, a terphenyl group, a naphthyl group, a carbazole group, a dibenzofuranyl group, or a dibenzothiophenyl group.

In an embodiment not forming part of the present invention, $R_{20}$ may be hydrogen, deuterium, -F, a cyano group, $-CD_3$, $-CD_2H$, $-CDH_2$, $-CF_3$, $-CF_2H$, $-CFH_2$, a $C_1$-$C_{20}$ alkyl group, or a phenyl group.
In Formula 1, substituents $L_{10}$, $R_{10}$, and $R_{20}$ are present on each ring through which the bond with the corresponding substituent passes
In Formula 1, b10 and b20 may each independently be an integer from 1 to 8. When b10 is 2 or greater, at least two $R_{10}$(s) may be identical to or different from each other. When b20 is 2 or greater, at least two $R_{20}$(s) may be identical to or different from each other.
In an embodiment, b10 and b20 may each independently be 1, 2, 3, or 4.
In an embodiment, b10 may be 1.
In an embodiment, b20 may be 1.
In Formula 1, c10 may be an integer from 1 to 9. When c10 is 2 or greater, at least two $-[(L_{10})_{a10}-(R_{10})_{b10}]$ group(s) may be identical to or different from each other.
In an embodiment, c10 may be 1, 2, 3, or 4.
In an embodiment, c10 may be 1 or 2.
In an embodiment, c10 may be 1.
In Formula 1, a sum of b20 and c10 may be 9.

In an embodiment, the silane compound represented by Formula 1 may be represented by one of Formulae 10-1 to 10-5:

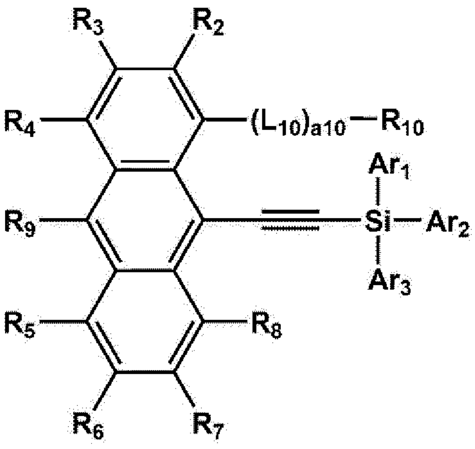

10-1

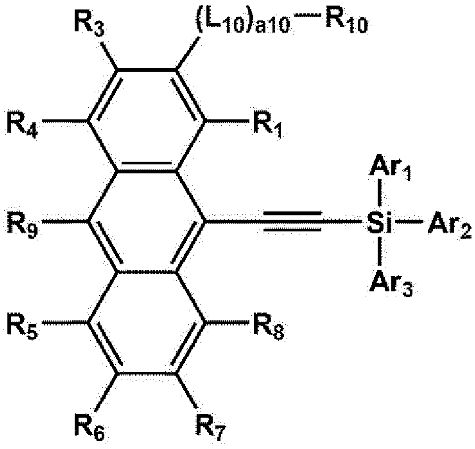

10-2

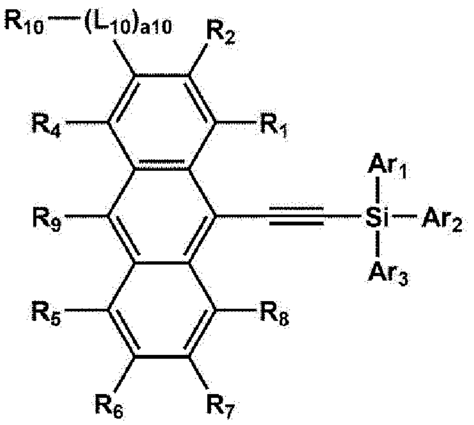

10-3

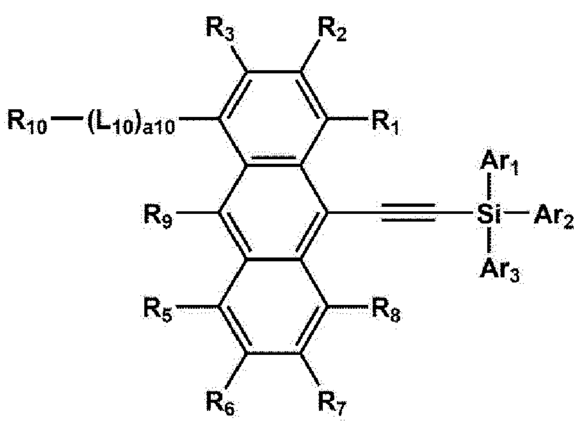

10-4

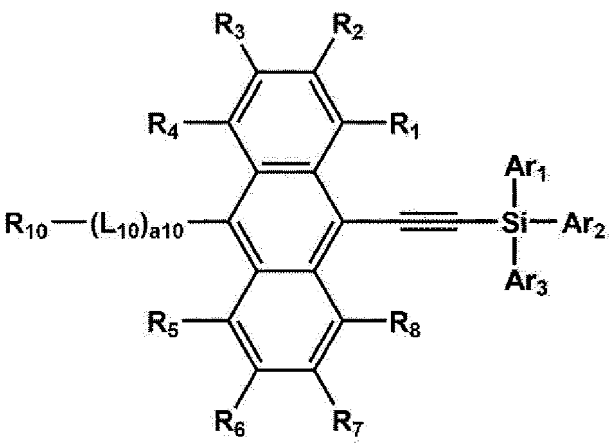

10-5

wherein, in Formulae 10-1 to 10-5,

descriptions of $Ar_1$ to $Ar_3$, $L_{10}$, a10, and $R_{10}$ may respectively be understood by referring to the descriptions of $Ar_1$ to

$Ar_3$, $L_{10}$, a10, and $R_{10}$ provided herein, and
$R_1$ to $R_9$ may each independently be understood by referring to the description of $R_{20}$ provided herein.

In an embodiment, the silane compound represented by Formula 1 may be a compound represented by Formula 10-5.

In an embodiment, not defining *per se* the present invention as claimed but useful for understanding its context,

in Formulae 10-1 to 10-5, $R_{10}$ may be: a $C_1$-$C_{20}$ alkyl group, a $C_1$-$C_{20}$ alkylthio group, or a $C_1$-$C_{20}$ alkoxy group;

a $C_1$-$C_{20}$ alkyl group, a $C_1$-$C_{20}$ alkylthio group, or a $C_1$-$C_{20}$ alkoxy group, each independently substituted with at least one of deuterium, a cyano group, a phenyl group, a biphenyl group, a terphenyl group, or a naphthyl group;
a cyclopentyl group, a cyclohexyl group, a cyclopentenyl group, a cyclohexenyl group, a cycloheptenyl group, a phenyl group, a biphenyl group, a terphenyl group, a naphthyl group, a fluorenyl group, a carbazolyl group, a dibenzofuranyl group, or a dibenzothiophenyl group; or
a cyclopentyl group, a cyclohexyl group, a cyclopentenyl group, a cyclohexenyl group, a cycloheptenyl group, a phenyl group, a biphenyl group, a terphenyl group, a naphthyl group, a fluorenyl group, a carbazolyl group, a dibenzofuranyl group, or a dibenzothiophenyl group, each independently substituted with at least one of deuterium, a cyano group, a $C_1$-$C_{20}$ alkyl group, a $C_1$-$C_{20}$ alkoxy group, a $C_1$-$C_{20}$ alkylthio group, a phenyl group, a biphenyl group, a terphenyl group, or a naphthyl group.

In an embodiment, the silane compound may be one of Compounds 1 to 160:

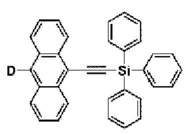
1
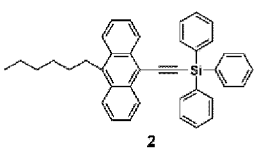
2
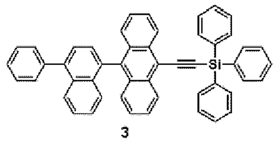
3
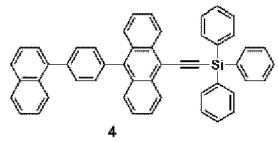
4

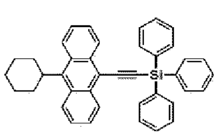
5
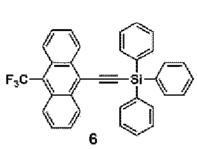
6
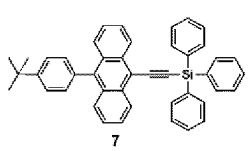
7
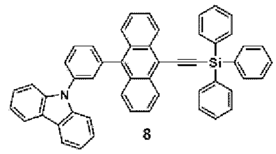
8

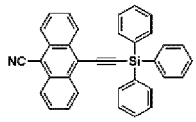
9
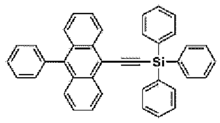
10
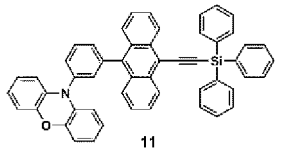
11
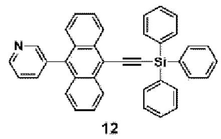
12

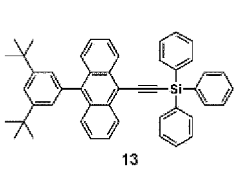
13
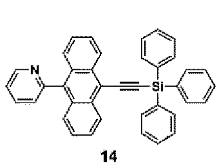
14
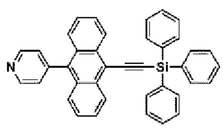
15
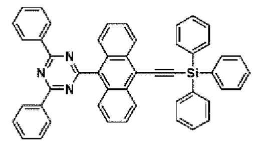
16

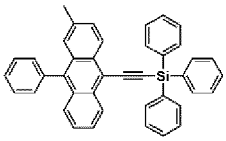
17
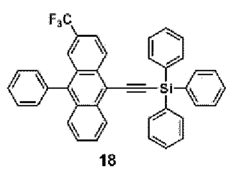
18
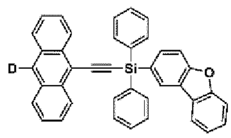
19
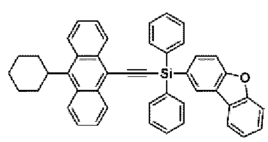
20

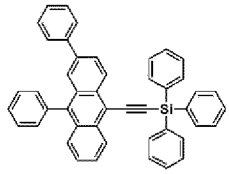
21
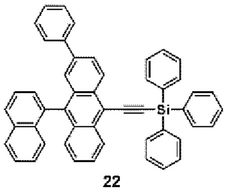
22
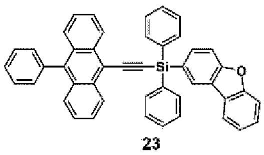
23
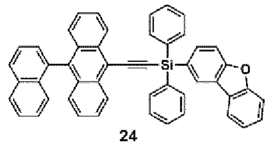
24
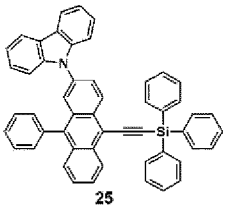
25
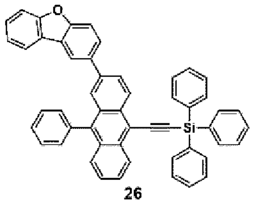
26
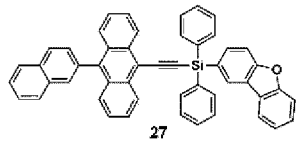
27
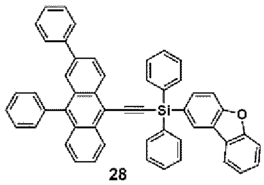
28
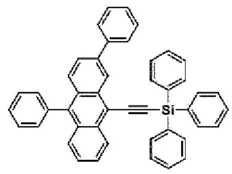
29
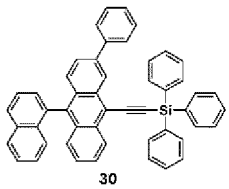
30
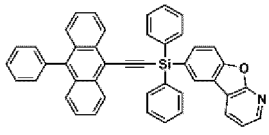
31
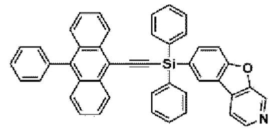
32
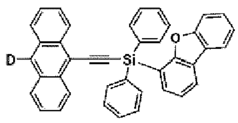
33
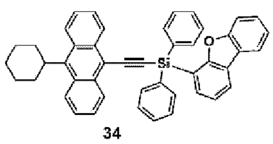
34
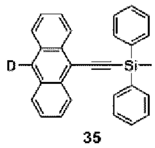
35
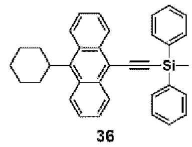
36
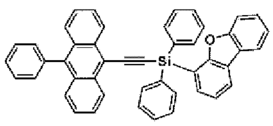
37
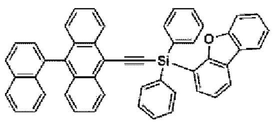
38
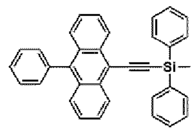
39
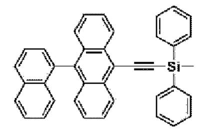
40
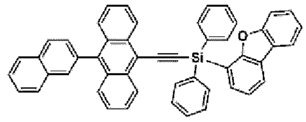
41
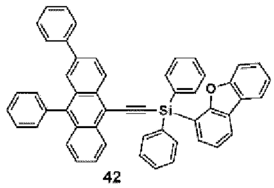
42
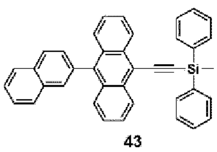
43
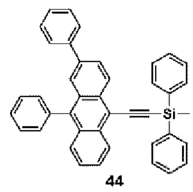
44
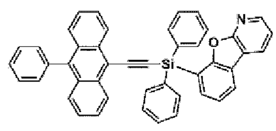
45
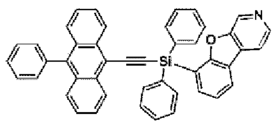
46
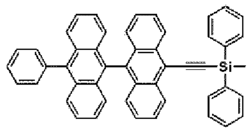
47
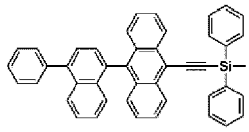
48
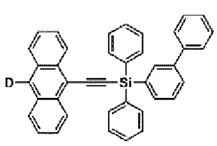
49
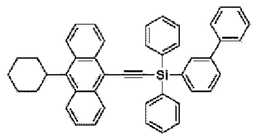
50
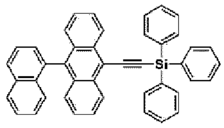
51
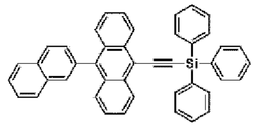
52

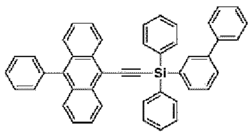
53

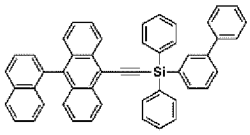
54

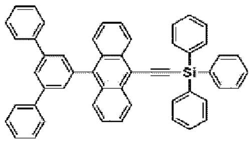
55

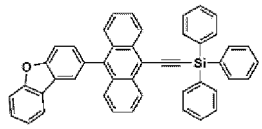
56

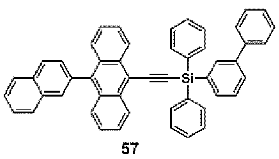
57

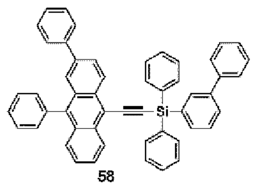
58

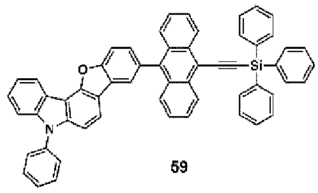
59

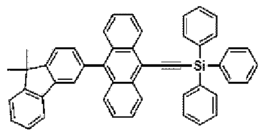
60

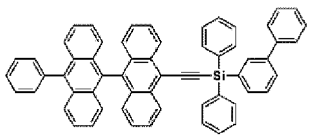
61

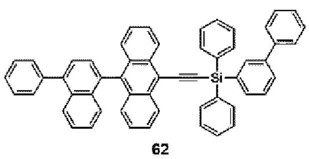
62

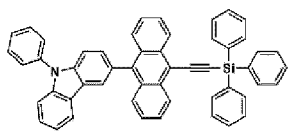
63

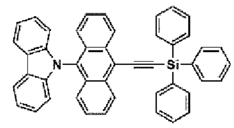
64

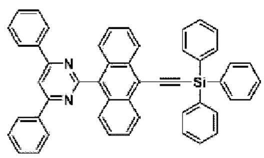
65

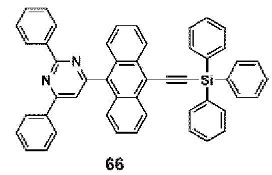
66

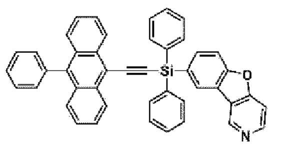
67

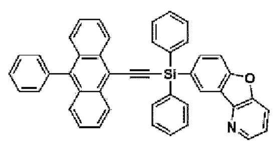
68

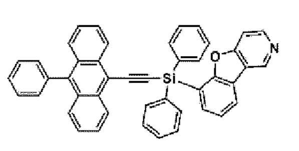
69

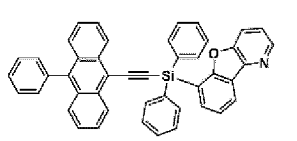
70

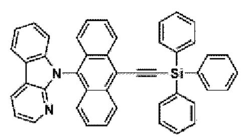
71

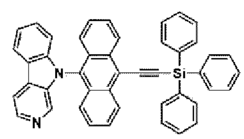
72

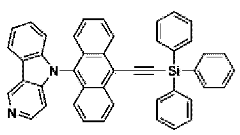
73

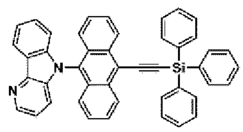
74

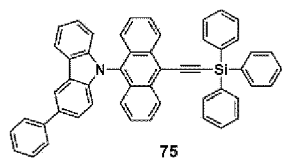
75

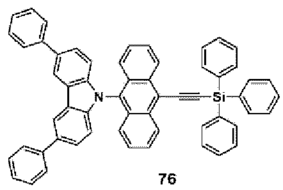
76

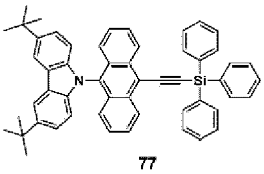
77

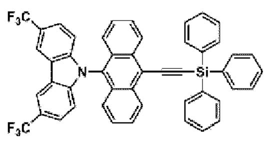
78

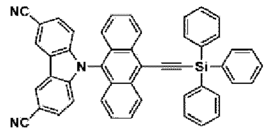
79

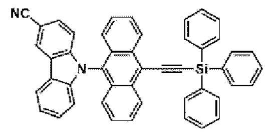
80

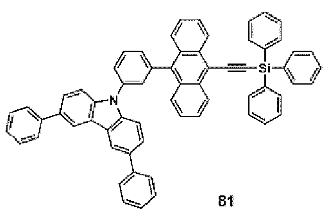
81

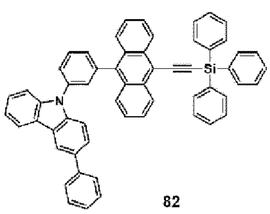
82

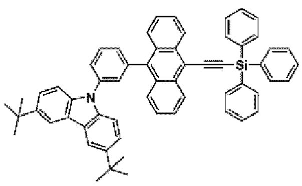
83

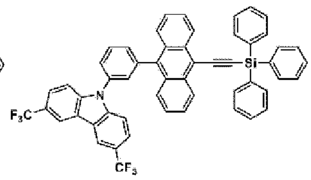
84

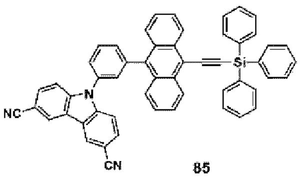
85

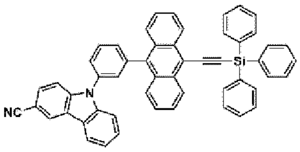
86

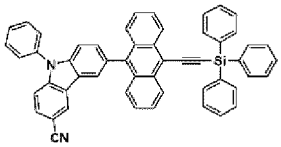
87

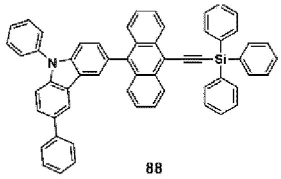
88

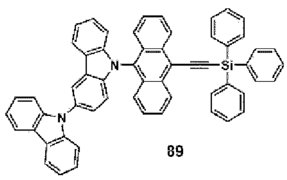
89

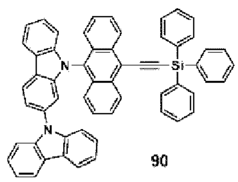
90

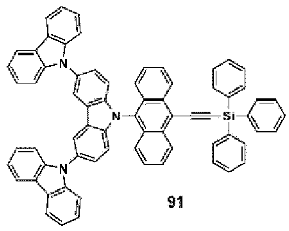
91

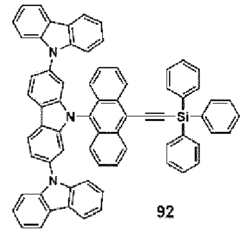
92

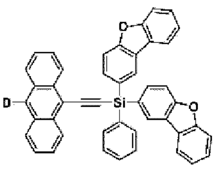
93

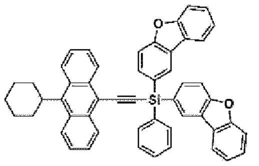
94

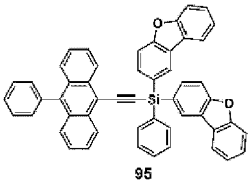
95

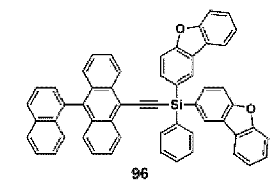
96

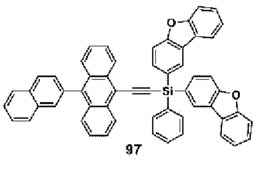
97

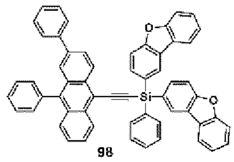
98

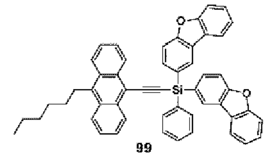
99

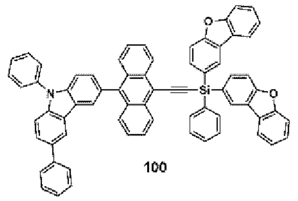
100

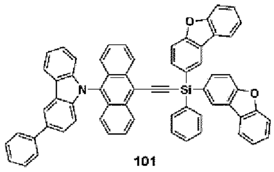
101

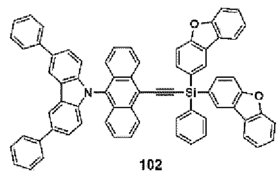
102

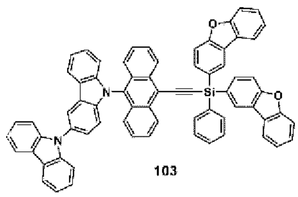
103

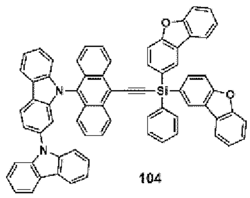
104

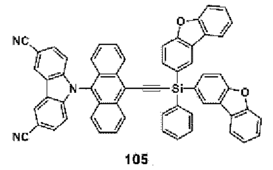
105

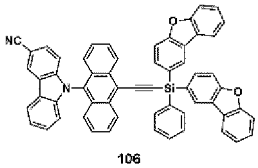
106

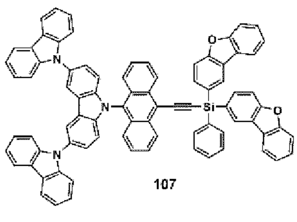
107

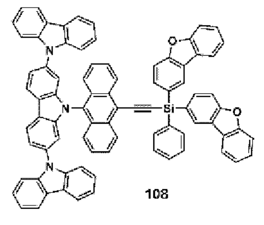
108

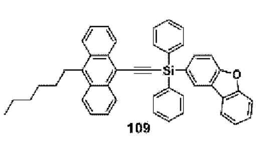
109

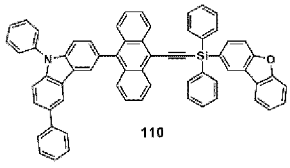
110

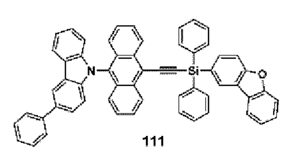
111

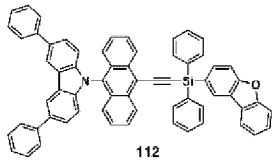
112

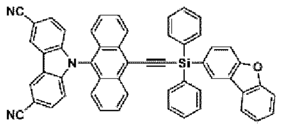
113

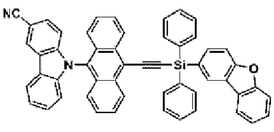
114

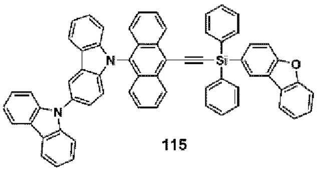
115

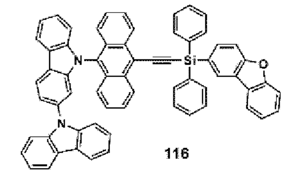
116

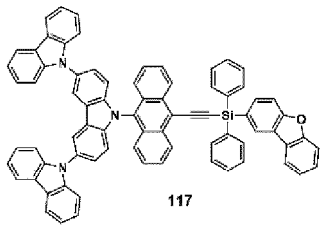
117

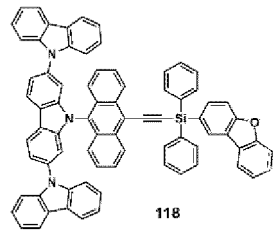
118

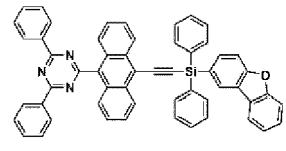
119

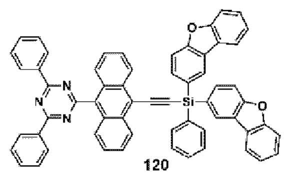
120

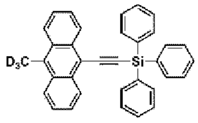
121

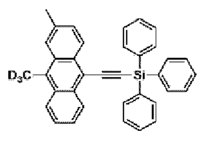
122

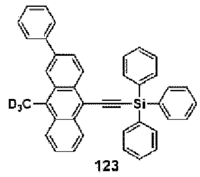
123

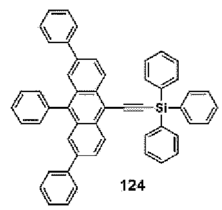
124

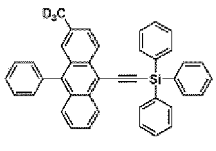
125

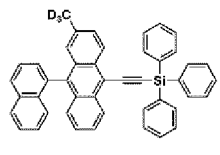
126

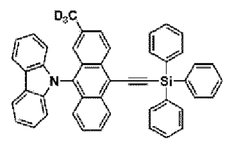
127

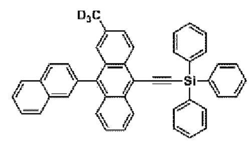
128

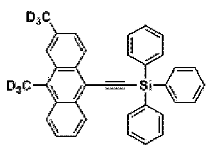
129

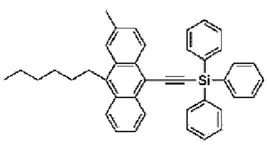
130

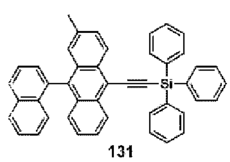
131

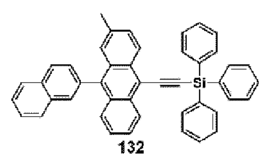
132

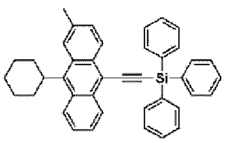
133

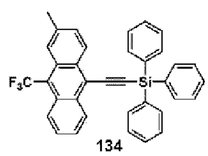
134

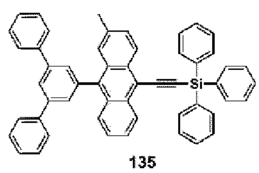
135

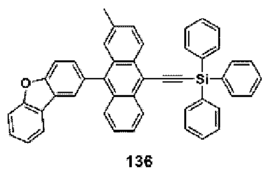
136

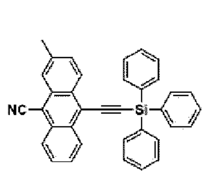
137

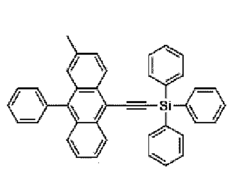
138

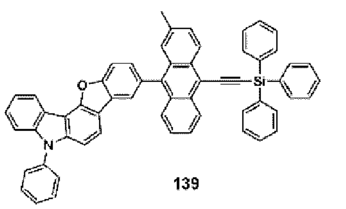
139

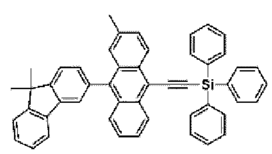
140

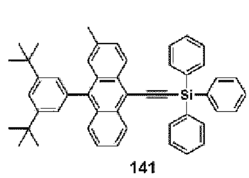
141

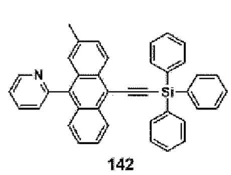
142

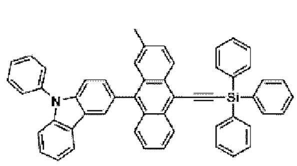
143

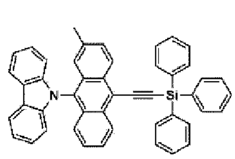
144

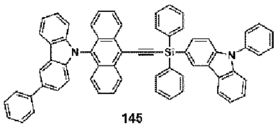
145
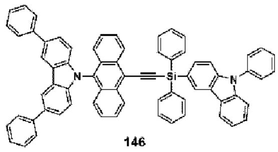
146
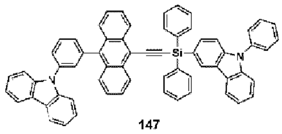
147
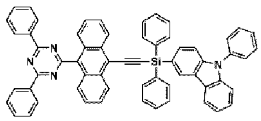
148

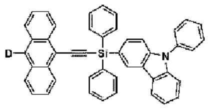
149
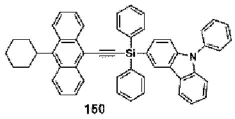
150
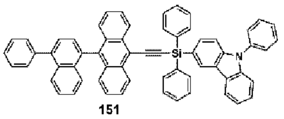
151
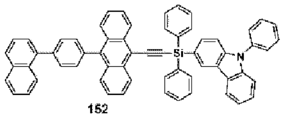
152

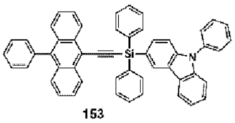
153
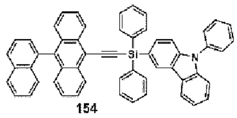
154
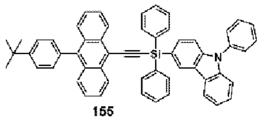
155
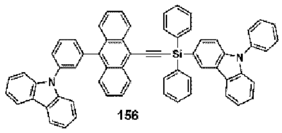
156

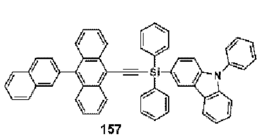
157
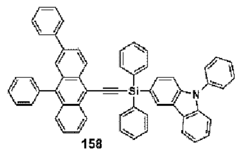
158
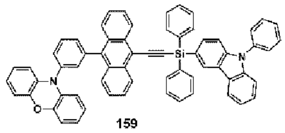
159
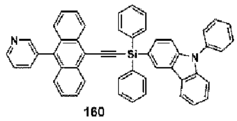
160
.

When the silane compound represented by Formula 1 may have an asymmetric structure, it may have a low crystallinity of a material. In an embodiment, as intermolecular close packing of the silane compound represented by Formula 1 may be prevented, the silane compound may have relatively excellent or improved amorphous thin film characteristics.

As described above, the silane compound represented by Formula 1 may have suitable electrical characteristics for a material for organic light-emitting devices, e.g., a host material, a hole transport material, and an electron transport material in an emission layer. In an embodiment, an organic light-emitting device including the silane compound may have high or improved efficiency and/or a long or improved lifespan.

In an embodiment, the silane compound represented by Formula 1 may satisfy Equation 1:

Equation 1

$$E(T1) < E(S1) < 2 \times E(T1)$$

wherein, in Equation 1,

E(T1) indicates a lowest excited triplet energy level of the silane compound, and E(S1) indicates a lowest excited singlet energy level of the silane compound.

In an embodiment, the silane compound represented by Formula 1 may satisfy Equation 2:

Equation 2

$$[\, 2 \times E(T1) \,] - E(S1) < 1 \text{ eV}$$

wherein, in Equation 2,

E(T1) indicates a lowest excited triplet energy level of the silane compound, and E(S1) indicates a lowest excited singlet energy level of the silane compound.

While not wishing to be bound by theory, it is understood that when the silane compound represented by Formula 1 satisfies Equation 1 and/or Equation 2, a triplet-triplet fusion (TTF) phenomenon, in which triplet excitons may be fused to thereby form singlet excitons, may occur. Thus, when the silane compound is applied to an organic light-emitting device, fluorescent emission may occur from the produced singlet excitons due to such a TTF phenomenon, and thus, the organic light-emitting device may have improved luminescence efficiency and lifespan.

In an embodiment, the silane compound represented by Formula 1 may satisfy Equation 2-1:

Equation 2-1

$$[\ 2 \times E(T1)\ ] - E(S1) < 0.5\ eV$$

wherein, in Equation 2-1,
E(T1) indicates a lowest excited triplet energy level of the silane compound, and E(S1) indicates a lowest excited singlet energy level of the silane compound.

A method of synthesizing the silane compound represented by Formula 1 may be apparent to one of ordinary skill in the art by referring to Synthesis Examples provided herein.

The silane compound represented by Formula 1 may be suitable for use as an organic layer material of an organic light-emitting device, for example, an emission layer material, a hole transport region material, and/or an electron transport region material of the organic layer. According to an aspect of an embodiment, an organic light-emitting device may include: a first electrode; a second electrode; and an organic layer between the first electrode and the second electrode, the organic layer including an emission layer and at least one of the silane compound represented by Formula 1.

As the organic light-emitting device has an organic layer including the silane compound represented by Formula 1, the organic light-emitting device may have a low driving voltage, high or improved efficiency, high or improved luminance, high or improved quantum efficiency, and long or improved lifespan.

In an embodiment, in the organic light-emitting device,

the first electrode may be an anode, the second electrode may be a cathode,
the organic layer may include a hole transport region between the first electrode and the emission layer and an electron transport region between the emission layer and the second electrode,
wherein the hole transport region may include a hole injection layer, a hole transport layer, an electron blocking layer, or any combination thereof, and
the electron transport region may include a hole blocking layer, an electron transport layer, an electron injection layer, or a combination thereof, but embodiments are not limited thereto.

In an embodiment, the emission layer in the organic light-emitting device may include at least one of the silane compounds represented by Formula 1.

In an embodiment, the emission layer in the organic light-emitting device may include a host and a dopant, wherein the host may include at least one of the silane compound represented by Formula 1, and the dopant may include a phosphorescent dopant or a fluorescent dopant. In an embodiment, the dopant may include a phosphorescent dopant (e.g., an organometallic compound represented by Formula 81 provided herein). The host may further include any suitable host, in addition to the silane compound represented by Formula 1.

The emission layer may emit red light, green light, or blue light.

In an embodiment, the emission layer may include a fluorescent dopant, but embodiments are not limited thereto.

In an embodiment, the emission layer may include a phosphorescent dopant, but embodiments are not limited thereto.

In an embodiment, the silane compound represented by Formula 1 may be included in a hole transport region of the organic light-emitting device.

In an embodiment, a hole transport region of the organic light-emitting device may include at least one of a hole injection layer, a hole transport layer, or an electron blocking layer, wherein at least one of the hole injection layer, the hole transport layer, or the electron blocking layer may include the silane compound represented by Formula 1.

In an embodiment, the silane compound represented by Formula 1 may be included in an electron transport region of the organic light-emitting device.

In an embodiment, an electron transport region of the organic light-emitting device may include at least one of a hole blocking layer, an electron transport layer, or an electron injection layer, wherein at least one of the hole blocking layer, the electron transport layer, or the electron injection layer, may include the silane compound represented by Formula 1.

In an embodiment, a hole transport region of the organic light-emitting device may include an electron blocking layer, wherein the electron blocking layer may include the silane compound represented by Formula 1. The electron blocking layer may be in a direct contact with the emission layer.

In an embodiment, an electron transport region of the organic light-emitting device may include a hole blocking layer, wherein the hole blocking layer may include the silane compound represented by Formula 1. The hole blocking layer may be in a direct contact with the emission layer.

In an embodiment, an organic light-emitting device may include: a first electrode; a second electrode; and an organic layer between the first electrode and the second electrode and including an emission layer, wherein the emission layer may include a host and a dopant, and the host may include at least one silane compound represented by Formula 1.

**In** an embodiment, a content of the host may be greater than a content of the dopant in the emission layer in the

organic light-emitting device.

**In** an embodiment, the host in the emission layer in the organic light-emitting device may consist of the silane compound.

**In** an embodiment, a ratio of emission components emitted from the dopant may be 80% or greater of the whole emission components emitted from the emission layer of the organic light-emitting device.

In an embodiment, the dopant in the emission layer in the organic light-emitting device may be a fluorescent dopant.

For example, the fluorescent dopant may be a condensed polycyclic compound or a styryl-based compound.

For example, the fluorescent dopant may include a naphthalene-containing core, a fluorene-containing core, a spiro-bifluorene-containing core, a benzofluorene-containing core, a dibenzofluorene-containing core, a phenanthrene-containing core, an anthracene-containing core, a fluoranthene-containing core, a triphenylene-containing core, a pyrene-containing core, a chrysene-containing core, a naphthacene-containing core, a picene-containing core, a perylene-containing core, a pentaphene-containing core, an indenoanthracene-containing core, a tetracene-containing core, a bisanthracene-containing core, or a core represented by one of Formulae 501-1 to 501-18, but embodiments are not limited thereto:

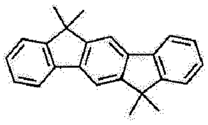
501-1

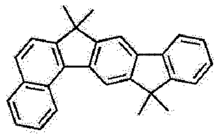
501-2

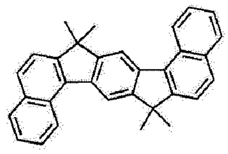
501-3

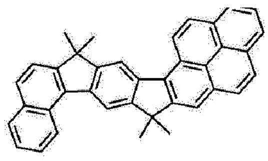
501-4

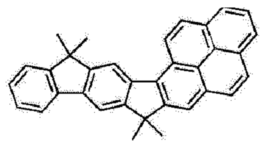
501-5

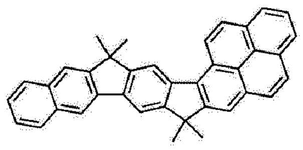
501-6

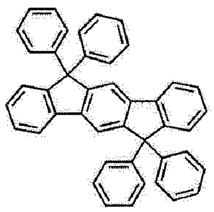
501-7

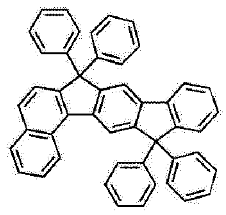
501-8

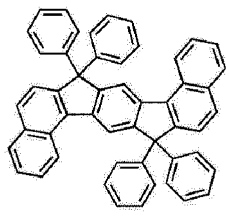
501-9

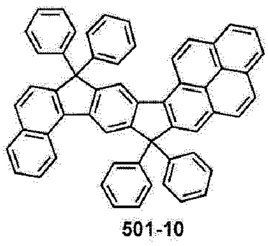
501-10

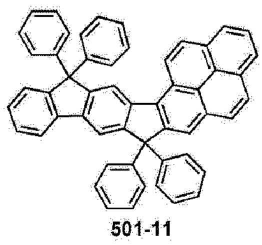
501-11

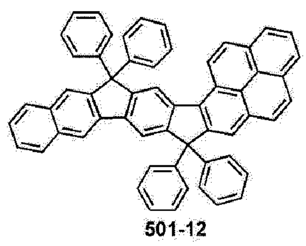
501-12

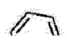

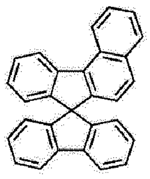

501-13

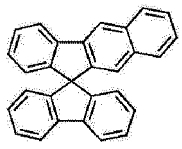

501-14

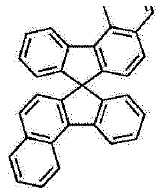

501-15

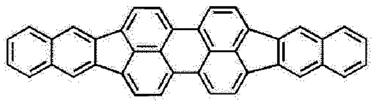

501-16

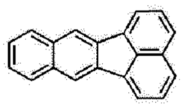

501-17

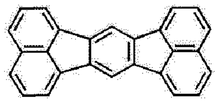

501-18

.

In an embodiment, the fluorescent dopant may be a styryl-amine-based compound or a styryl-carbazole-based compound, but embodiments are not limited thereto.

In an embodiment, the fluorescent dopant may be compounds represented by Formula 501:

Formula 501

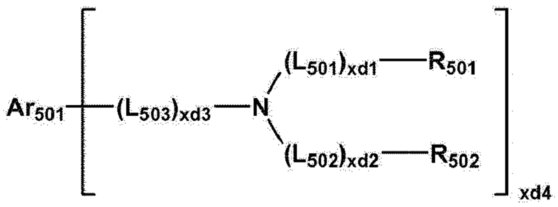

wherein, in Formula 501,

$Ar_{501}$ may be:

a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a tetracene group, a bisanthracene group, or a group represented by one of Formulae 501-1 to 501-18; or

a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a tetracene group, a bisanthracene group, or a group represented by one of Formulae 501-1 to 501-18, each independently substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, or - $Si(Q_{501})(Q_{502})(Q_{503})$ (wherein $Q_{501}$ to $Q_{503}$ may each independently be hydrogen, a $C_1$-$C_{60}$ alkyl group, a $C_1$-$C_{60}$ alkoxy group, a $C_1$-$C_{60}$ alkylthio group, a $C_6$-$C_{60}$ aryl group, a $C_1$-$C_{60}$ heteroaryl group, a monovalent non-aromatic condensed polycyclic group, or a monovalent non-aromatic condensed heteropolycyclic group),

$L_{501}$ to $L_{503}$ may each independently be a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene group, a substituted or unsubstituted $C_1$-$C_{60}$ heteroarylene group, a substituted or unsubstituted divalent non-aromatic condensed polycyclic group, or a substituted or unsubstituted divalent non-aromatic condensed heteropolycyclic group,

$R_{501}$ and $R_{502}$ may each independently be:

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, a triazinyl group, a dibenzofuranyl group, or a dibenzothiophenyl group; or

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, or a dibenzothiophenyl group, each independently substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_1$-$C_{20}$ alkylthio group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, or a dibenzothiophenyl group,

xd1 to xd3 may be each independently 0, 1, 2, or 3, and

xd4 may be 0, 1, 2, 3, 4, 5, or 6.

In an embodiment, in Formula 501,

$Ar_{501}$ may be:

a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a tetracene group, a bisanthracene group, or a group represented by one of Formulae 501-1 to 501-18; or

a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a tetracene group, a bisanthracene group, or a group represented by one of Formulae 501-1 to 501-18, each independently substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_1$-$C_{20}$ alkylthio group, a phenyl group, a biphenyl group, a terphenyl group, a naphthyl group, a fluorenyl group, a dibenzofuranyl group, a dibenzothiophenyl group, a carbazolyl group, a pyridinyl group, a pyrimidinyl group, a triazinyl group, a quinolinyl group, an isoquinolinyl group, or -Si($Q_{501}$)($Q_{502}$)($Q_{503}$) (wherein $Q_{501}$ to $Q_{503}$ may each independently be hydrogen, a $C_1$-$C_{20}$ alkyl group, a $C_1$-$C_{20}$ alkoxy group, a $C_1$-$C_{20}$ alkylthio group, a phenyl group, a biphenyl group, a terphenyl group, or a naphthyl group),

$L_{501}$ to $L_{503}$ may each be understood by referring to the description of $L_{10}$ provided herein,

xd1 to xd3 may each independently be 0, 1, or 2,

xd4 may be 0, 1, 2, or 3, but embodiments are not limited thereto.

In an embodiment, the fluorescent dopant may include a compound represented by one of Formulae 502-1 to 502-5:

Formula 502-1

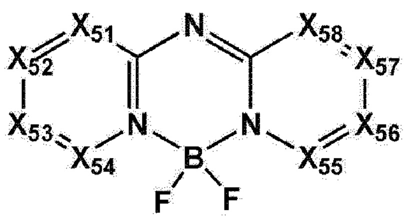

Formula 502-2

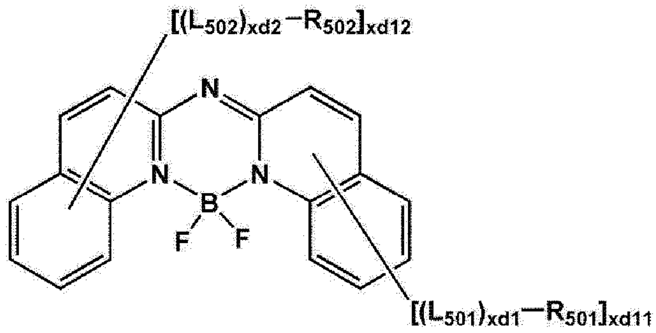

Formula 502-3

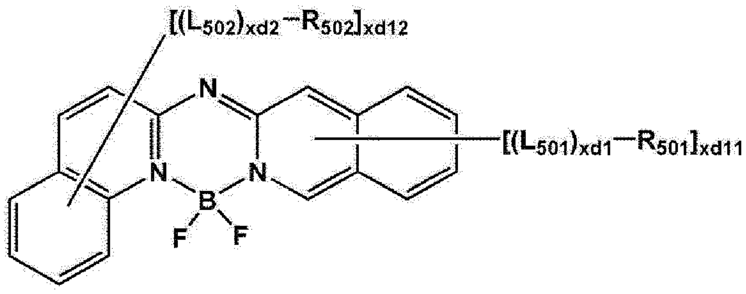

Formula 502-4

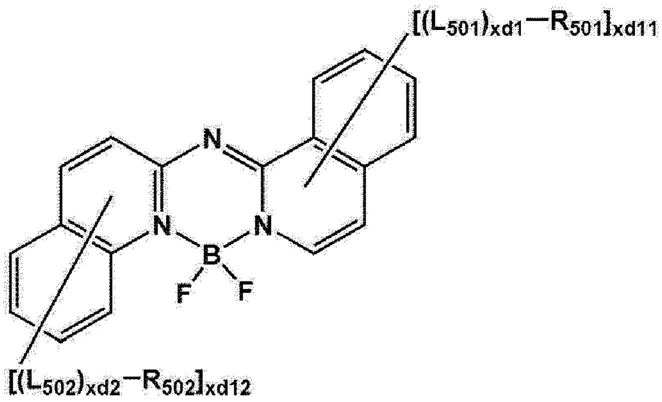

Formula 502-5

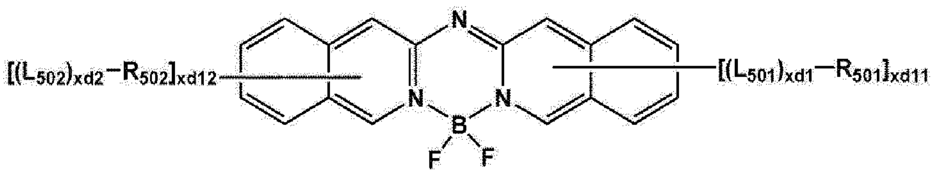

wherein, in Formulae 502-1 to 502-5,

$X_{51}$ may be N or C-[$(L_{501})_{xd1}$-$R_{501}$], $X_{52}$ may be N or C-[$(L_{502})_{xd2}$-$R_{502}$], $X_{53}$ may be N or C-[$(L_{503})_{xd3}$-$R_{503}$], $X_{54}$ may be N or C-[$(L_{504})_{xd4}$-$R_{504}$], $X_{55}$ may be N or C-[$(L_{505})_{xd5}$-$R_{505}$], $X_{56}$ may be N or C-[$(L_{506})_{xd6}$-$R_{506}$], $X_{57}$ may be N or C-[$(L_{507})_{xd7}$-$R_{507}$], $X_{58}$ may be N or C-[$(L_{508})_{xd8}$-$R_{508}$],
$L_{501}$ to $L_{508}$ may each be understood by referring to the description of $L_{501}$ in Formula 501,
xd1 to xd8 may each be understood by referring to the description of xd1 in Formula 501,
$R_{501}$ to $R_{508}$ may each independently be:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkylthio group, or a $C_1$-$C_{20}$ alkoxy group;

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, a triazinyl group, a dibenzofuranyl group, or a dibenzothiophenyl group; or

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, or a dibenzothiophenyl group, each independently substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_1$-$C_{20}$ alkylthio group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, or a dibenzothiophenyl group,

xd11 and xd12 may each independently be an integer from 0 to 5,

two of $R_{501}$ to $R_{504}$ may optionally be bound to form a saturated or unsaturated ring,

two of $R_{505}$ to $R_{508}$ may optionally be bound to form a saturated or unsaturated ring, and

wherein in Formulae 502-2 to 502-5, substituents $L_{501}$, $L_{502}$, $R_{501}$, and $R_{502}$ are present on each ring through which the bond with the corresponding substituent passes.

The fluorescent dopant may include, for example, Compounds FD(1) to FD(16) or FD1 to FD13:

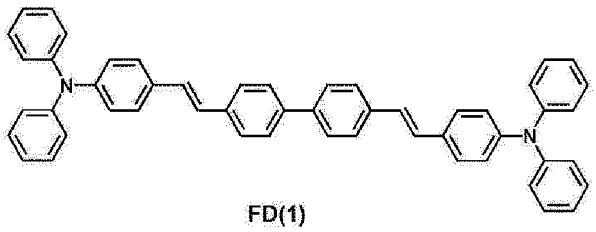

FD(1)

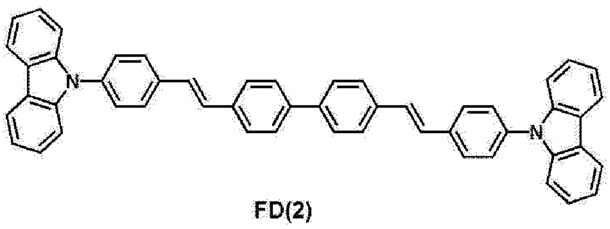

FD(2)

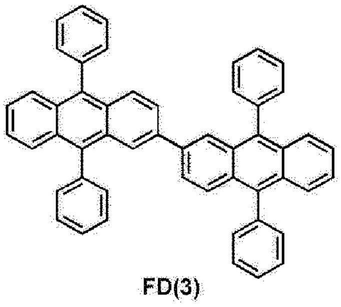

FD(3)

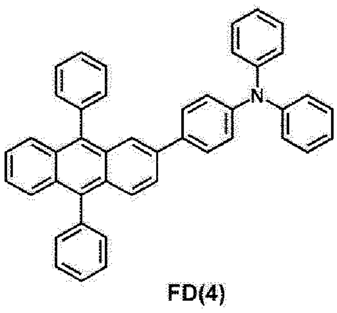

FD(4)

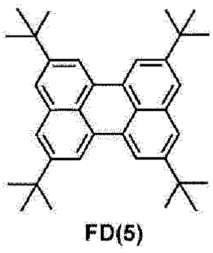

FD(5)

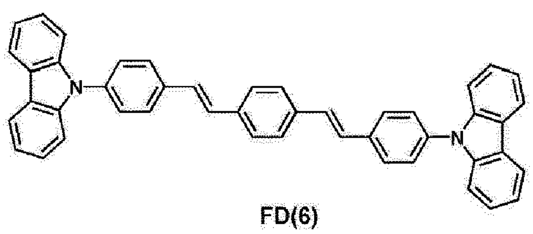

FD(6)

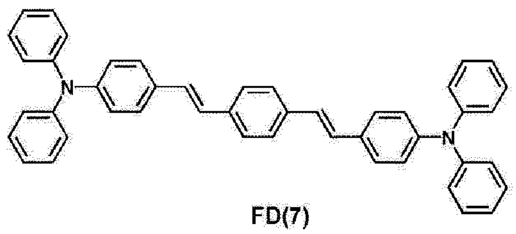

FD(7)

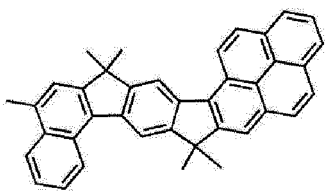

FD(8)

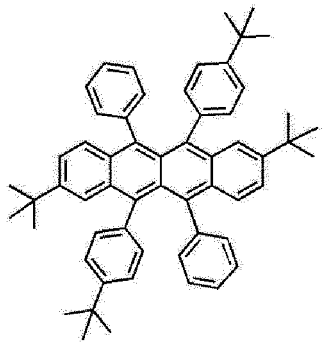

FD(9)

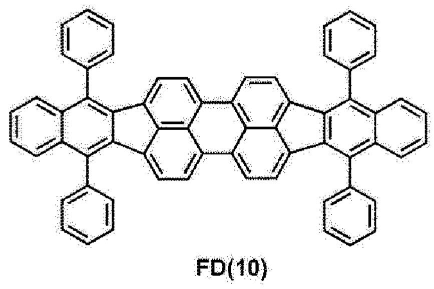

FD(10)

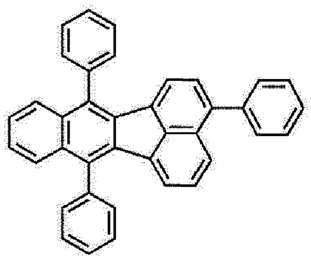

FD(11)

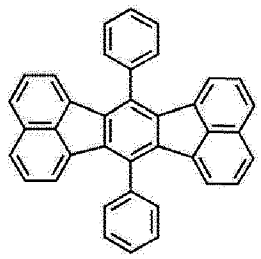

FD(12)

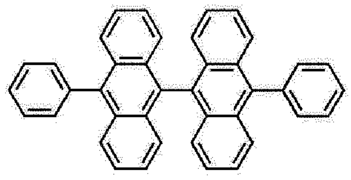

FD(13)

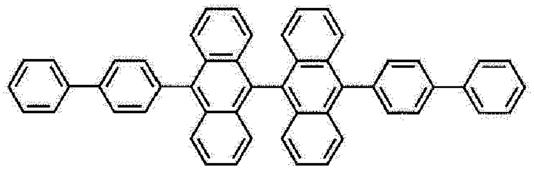

FD(14)

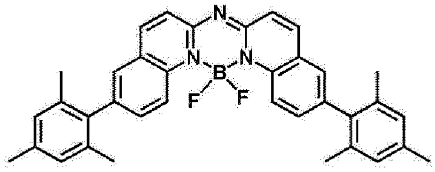

FD(15)

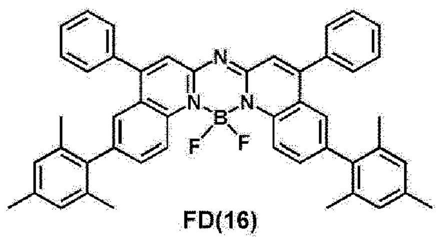

FD(16)

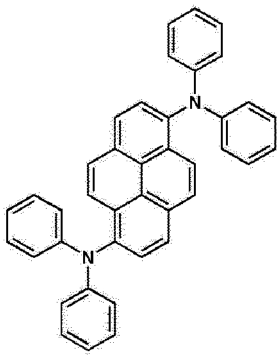

FD1

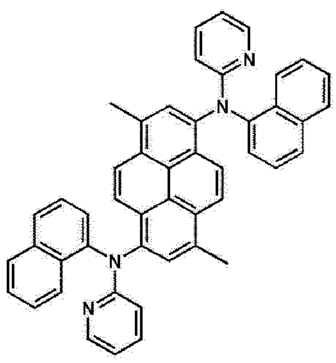

FD2

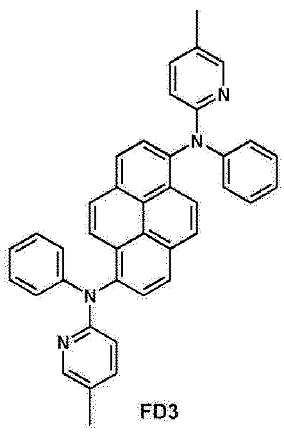

FD3

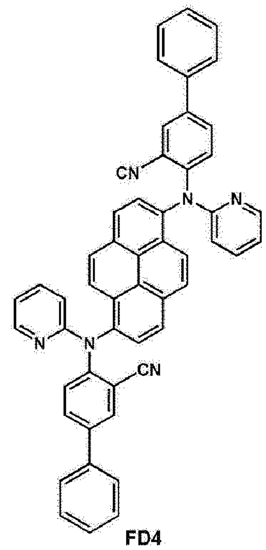

FD4

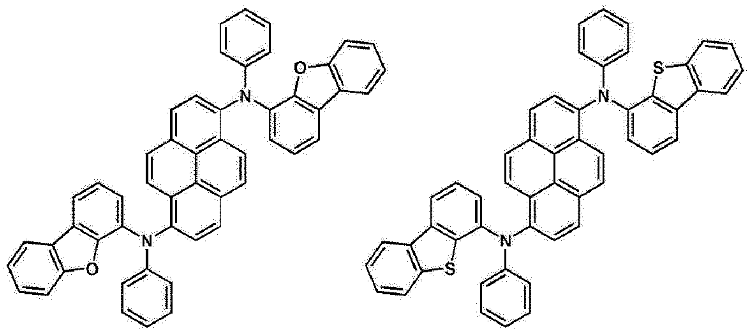

FD5 FD6

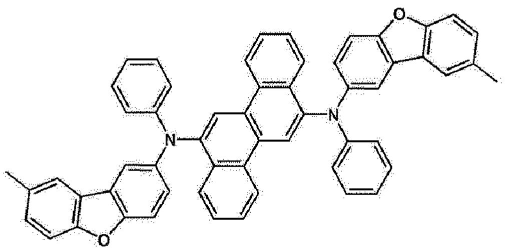

FD7

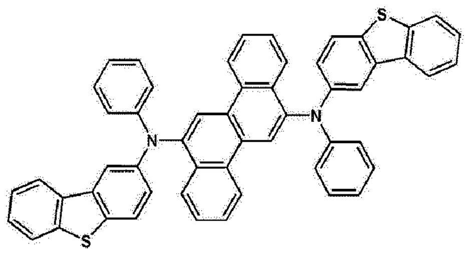

FD8

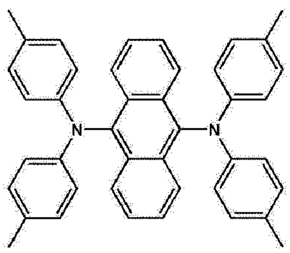

FD9

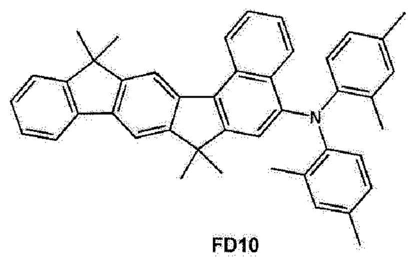

FD10

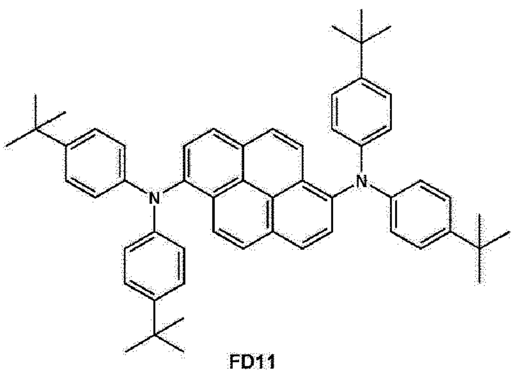

FD11

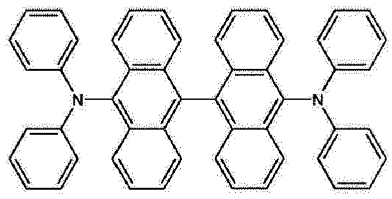

FD12

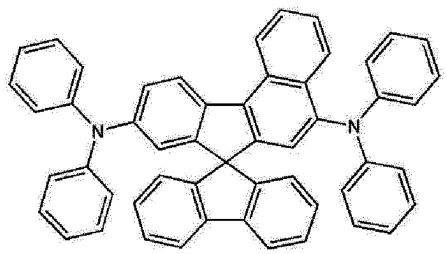

FD13

.

In an embodiment, the emission layer in the organic light-emitting device may further include a phosphorescent dopant, in addition to the silane compound represented by Formula 1.

For example, the phosphorescent dopant may include an organometallic compound represented by Formula 81:

Formula 81 $M(L_{81})_{n81}(L_{82})_{n82}$

wherein $L_{81}$ may be a ligand represented by Formula 81A,

Formula 81A

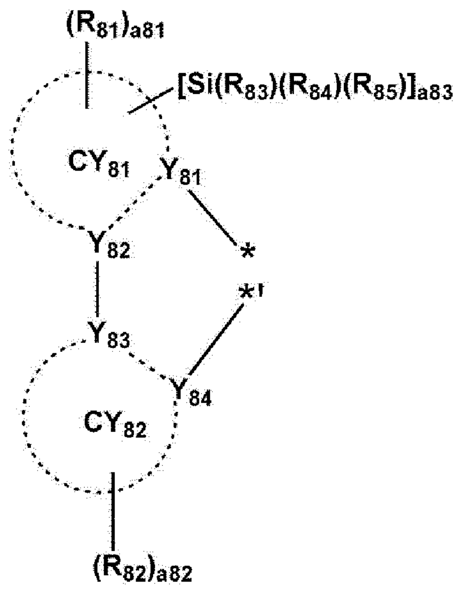

wherein, in Formulae 81 and 81A,

M may be iridium (Ir), platinum (Pt), osmium (Os), titanium (Ti), zirconium (Zr), hafnium (Hf), europium (Eu), terbium (Tb), thulium (Tm), or rhodium (Rh),
n81 may be an integer from 1 to 3; and when n81 is 2 or greater, at least two $L_{81}$(s) may be identical to or different from each other,
$L_{82}$ may be an organic ligand, n82 may be an integer from 0 to 4; and when n82 is 2 or greater, at least two $L_{82}$(s) may be identical to or different from each other,
$Y_{81}$ to $Y_{84}$ may each independently be carbon (C) or nitrogen (N),
$Y_{81}$ and $Y_{82}$ may be linked to each other via a single bond or a double bond, and $Y_{83}$ and $Y_{84}$ are linked to each other via a single bond or a double bond,
$CY_{81}$ and $CY_{82}$ may each independently be a $C_5$-$C_{30}$ carbocyclic group or a $C_2$-$C_{30}$ heterocyclic group,
$CY_{81}$ and $CY_{82}$ may optionally be bound via an organic linking group,
$R_{81}$ to $R_{85}$ may each independently be hydrogen, deuterium, -F, -Cl, - Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, a substituted or unsubstituted $C_1$-$C_{60}$ alkyl group, a substituted or unsubstituted $C_2$-$C_{60}$ alkenyl group, a substituted or unsubstituted

$C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, -Si($Q_{81}$)($Q_{82}$)($Q_{83}$), -N($Q_{84}$)($Q_{85}$), -B($Q_{86}$)($Q_{87}$), or - P(=O)($Q_{88}$)($Q_{89}$),

a81 to a83 may each independently be an integer from 0 to 5,

when a81 is 2 or greater, at least two $R_{81}$(s) may be identical to or different from each other,

when a82 is 2 or greater, at least two $R_{82}$(s) may be identical to or different from each other,

when a81 is 2 or greater, two adjacent $R_{81}$(s) may be optionally bound to form a saturated or unsaturated $C_2$-$C_{30}$ ring (e.g., a benzene ring, a cyclopentane ring, a cyclohexane ring, a cyclopentene ring, a cyclohexene ring, a norbornane ring, a bicyclo[2.2.1]heptane ring, a naphthalene ring, a benzoindene ring, a benzoindole ring, a benzofuran ring, a benzothiophene ring, a pyridine ring, a pyrimidine ring, or a pyrazine ring), or a saturated or unsaturated $C_2$-$C_{30}$ ring substituted with at least one $R_{88}$ (e.g., a benzene ring, a cyclopentane ring, a cyclohexane ring, a cyclopentene ring, a cyclohexene ring, a norbornane ring, a bicyclo[2.2.1]heptane ring, a naphthalene ring, a benzoindene ring, a benzoindole ring, a benzofuran ring, a benzothiophene ring, a pyridine ring, a pyrimidine ring, or a pyrazine ring, each independently substituted with at least one $R_{88}$),

when a82 is 2 or greater, two adjacent $R_{82}$(s) may be optionally bound to form a saturated or unsaturated $C_2$-$C_{30}$ ring (e.g., a benzene ring, a cyclopentane ring, a cyclohexane ring, a cyclopentene ring, a cyclohexene ring, a norbornane ring, a bicyclo[2.2.1]heptane ring, a naphthalene ring, a benzoindene ring, a benzoindole ring, a benzofuran ring, a benzothiophene ring, a pyridine ring, a pyrimidine ring, or a pyrazine ring), or a saturated or unsaturated $C_2$-$C_{30}$ ring substituted with at least one $R_{89}$ (e.g., a benzene ring, a cyclopentane ring, a cyclohexane ring, a cyclopentene ring, a cyclohexene ring, a norbornane ring, a bicyclo[2.2.1]heptane ring, a naphthalene ring, a benzoindene ring, a benzoindole ring, a benzofuran ring, a benzothiophene ring, a pyridine ring, a pyrimidine ring, or a pyrazine ring, each independently substituted with at least one $R_{89}$),

$R_{88}$ may be understood by referring to the description of $R_{81}$ provided herein,

$R_{89}$ may be understood by referring to the description of $R_{82}$ provided herein,

* and *' in Formula 81A each indicate a binding site to M in Formula 81, and

at least one substituent of the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group may be:

deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{66}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, or -Si($Q_{91}$)($Q_{92}$)($Q_{93}$),

wherein $Q_{81}$ to $Q_{89}$ and $Q_{91}$ to $Q_{93}$ may each independently be hydrogen, deuterium, a $C_1$-$C_{60}$ alkyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group.

In an embodiment, in Formula 81A,

a83 may be 1 or 2, and

$R_{83}$ to $R_{85}$ may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, or - $CD_2CDH_2$;

an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a phenyl group, or a naphthyl group; or an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a phenyl group, or a naphthyl group, each independently substituted with at least one of deuterium, a $C_1$-$C_{10}$ alkyl group, or a phenyl group, but embodiments are not limited thereto.

In an embodiment, in Formula 81A,

$Y_{81}$ may be N, $Y_{82}$ and $Y_{83}$ may each be C, $Y_{84}$ may be N or C, and
$CY_{81}$ and $CY_{82}$ may each independently be a cyclopentadiene group, a phenyl group, a heptalene group, an indene group, a naphthalene group, an azulene group, a heptalene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentacene group, a rubicene group, a coronene group, an ovalene group, a pyrrole group, an isoindole group, an indole group, an indazole group, a pyrazole group, an imidazole group, a triazole group, an oxazole group, an isoxazole group, an oxadiazole group, a thiazole group, an isothiazole group, a thiadiazole group, a purine group, a furan group, a thiophene group, a pyridine group, a pyrimidine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, a benzofuran group, a benzothiophene group, an isobenzothiazole group, a benzoxazole group, an isobenzoxazole group, a benzocarbazole group, a dibenzocarbazole group, an imidazopyridine group, an imidazopyrimidine group, a dibenzofuran group, a dibenzothiophene group, a dibenzothiophene sulfone group, a carbazole group, a dibenzosilole group, or a 2,3-dihydro-1H-imidazole group.

In an embodiment, in Formula 81A, $Y_{81}$ may be N, $Y_{82}$ to $Y_{84}$ may each be C, $CY_{81}$ may be 5-membered rings including two N atoms as ring-forming atoms, and $CY_{82}$ may be a phenyl group, a naphthalene group, a fluorene group, a dibenzofuran group, or a dibenzothiophene group, but embodiments are not limited thereto.
In an embodiment, in Formula 81A, $Y_{81}$ may be N, $Y_{82}$ to $Y_{84}$ may each be C, $CY_{81}$ may be an imidazole group or a 2,3-dihydro-1H-imidazole group, and $CY_{82}$ may be a phenyl group, a naphthalene group, a fluorene group, a dibenzofuran group, or a dibenzothiophene group, but embodiments are not limited thereto.
In an embodiment, in Formula 81A,

$Y_{81}$ may be N, $Y_{82}$ to $Y_{84}$ may each be C,
$CY_{81}$ may be a pyrrole group, a pyrazole group, an imidazole group, a triazole group, an oxazole group, an isoxazole group, an oxadiazole group, a thiazole group, an isothiazole group, a thiadiazole group, a pyridine group, a pyrimidine group, a quinoline group, an isoquinoline group, a benzoquinoline group, a phthalazine group, a naphthyridine group, a quinoxaline group, a quinazoline group, a cinnoline group, a benzimidazole group, an isobenzothiazole group, a benzoxazole group, or an isobenzoxazole group, or
$CY_{82}$ may be a cyclopentadiene group, a phenyl group, a naphthalene group, a fluorene group, a benzofluorene group, a dibenzofluorene group, a phenanthrene group, an anthracene group, a triphenylene group, a pyrene group, a chrysene group, a perylene group, a benzofuran group, a benzothiophene group, a benzocarbazole group, a dibenzocarbazole group, a dibenzofuran group, a dibenzothiophene group, a dibenzothiophene sulfone group, a carbazole group, or a dibenzosilole group.

In an embodiment, in Formula 81A,
$R_{81}$ and $R_{82}$ may each independently be:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, a $C_1$-$C_{20}$ alkyl group, a $C_1$-$C_{20}$ alkylthio group, or a $C_1$-$C_{20}$ alkoxy group;
a $C_1$-$C_{20}$ alkyl group, a $C_1$-$C_{20}$ alkylthio group, or a $C_1$-$C_{20}$ alkoxy group, each independently substituted with at least one of deuterium, -F, -Cl, -Br, -I, - $CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a

naphthyl group, a pyridinyl group, or a pyrimidinyl group;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group, each independently substituted with at least one of deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group; or

$-B(Q_{66})(Q_{67})$ or $-P(=O)(Q_{88})(Q_{89})$,

wherein $Q_{86}$ to $Q_{89}$ may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, or $-CD_2CDH_2$;

an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a phenyl group, or a naphthyl group; or

an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group, each independently substituted with at least one of deuterium, a $C_1$-$C_{10}$ alkyl group, or a phenyl group.

In an embodiment, in Formula 81A, at least one of $R_{81}$(s) in the number of a81 and $R_{82}$(s) in the number of a82 may be a cyano group.

In an embodiment, in Formula 81A, at least one of $R_{82}$(s) in the number of a82 may be a cyano group.

In an embodiment, in Formula 81A, at least one of $R_{81}$(s) in the number of a81 and $R_{82}$(s) in the number of a82 may be deuterium.

In an embodiment, in Formula 81, $L_{82}$ may be ligands represented by Formulae one of 3-1(1) to 3-1(69), 3-1(71) to 3-1(79), 3-1(81) to 3-1(88), 3-1(91) to 3-1(98), and 3-1(101) to 3-1(114):

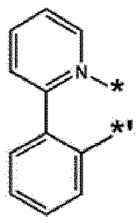
3-1(1)

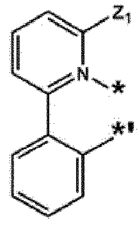
3-1(2)

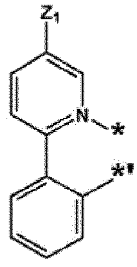
3-1(3)

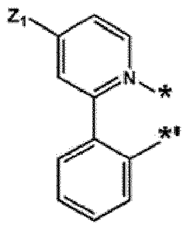
3-1(4)

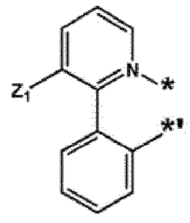
3-1(5)

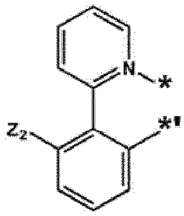
3-1(6)

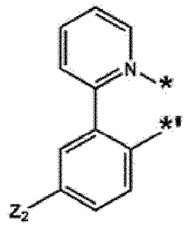
3-1(7)

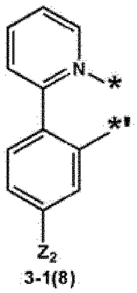
3-1(8)

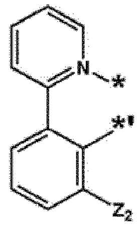
3-1(9)

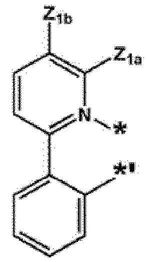
3-1(10)

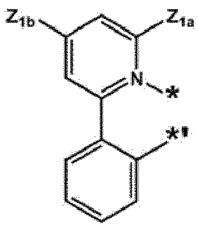
3-1(11)

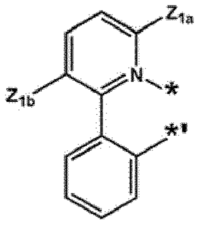
3-1(12)

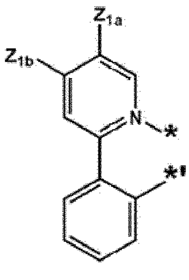
3-1(13)

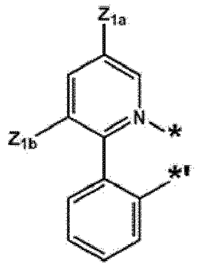
3-1(14)

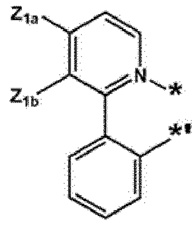
3-1(15)

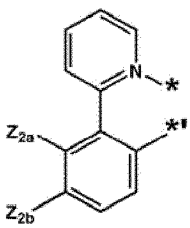
3-1(16)

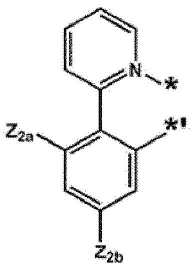
3-1(17)

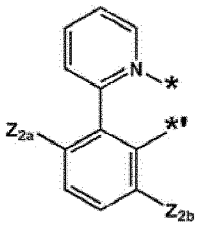
3-1(18)

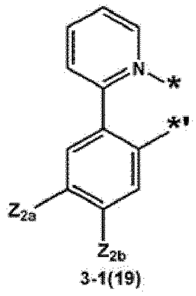
3-1(19)

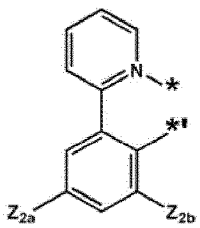
3-1(20)

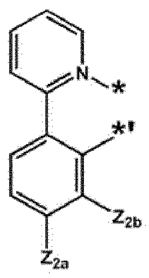
3-1(21)

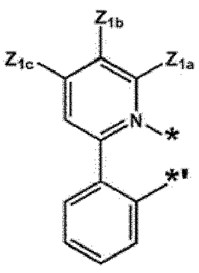
3-1(22)

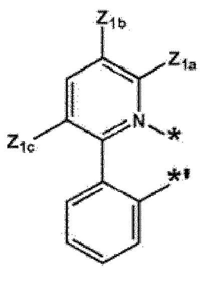
3-1(23)

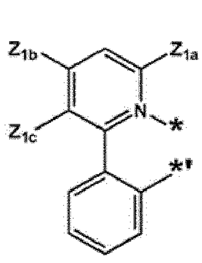
3-1(24)

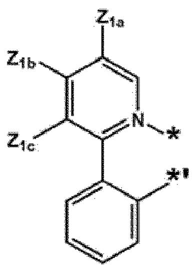
3-1(25)

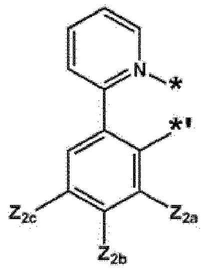
3-1(26)

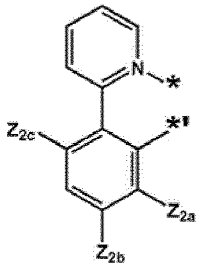
3-1(27)

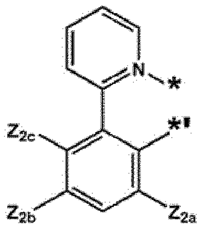
3-1(28)

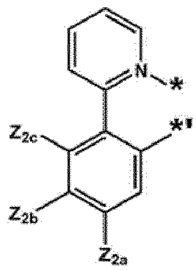
3-1(29)

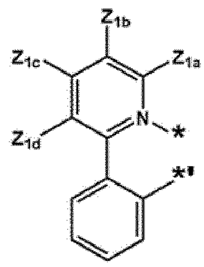
3-1(30)

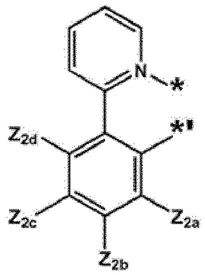
3-1(31)

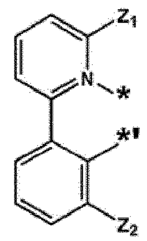
3-1(32)

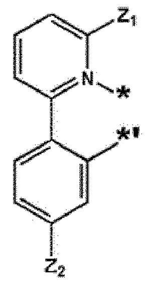
3-1(33)

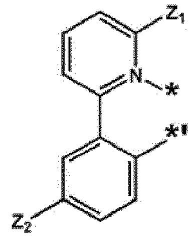
3-1(34)

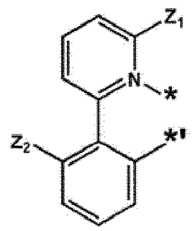
3-1(35)

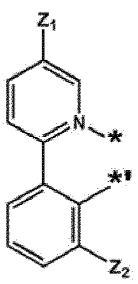
3-1(36)

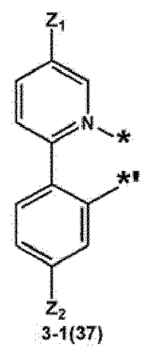
3-1(37)

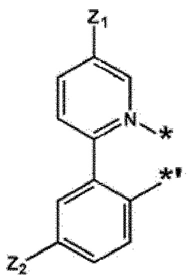
3-1(38)

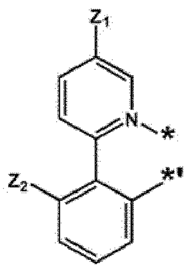
3-1(39)

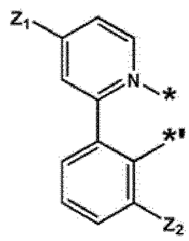
3-1(40)

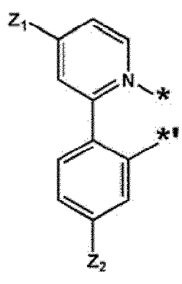
3-1(41)

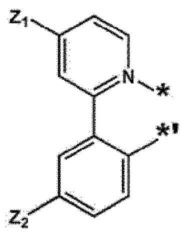
3-1(42)

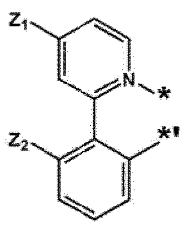
3-1(43)

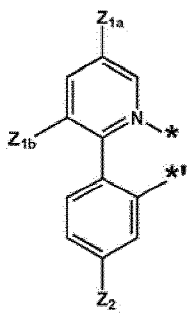
3-1(44)

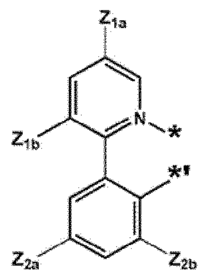
3-1(45)

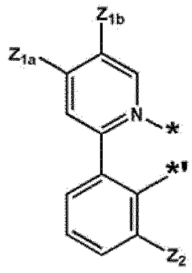
3-1(46)

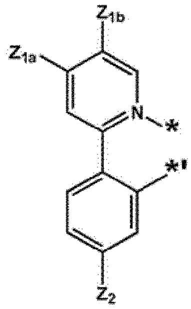
3-1(47)

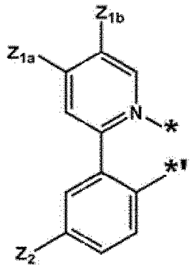
3-1(48)

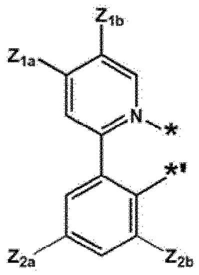
3-1(49)

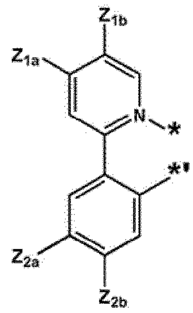
3-1(50)

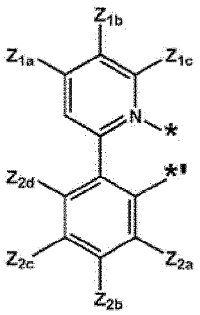
3-1(51)

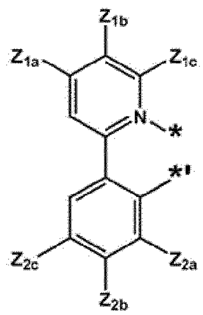
3-1(52)

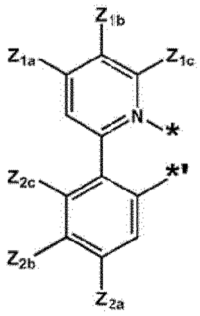
3-1(53)

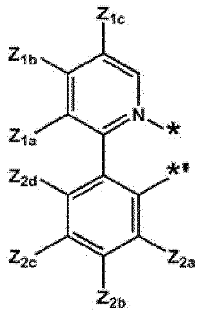
3-1(54)

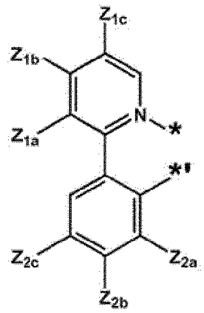
3-1(55)

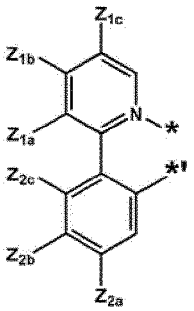
3-1(56)

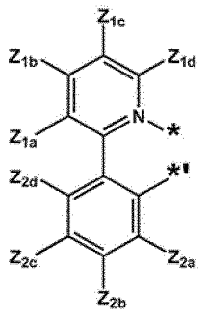
3-1(57)

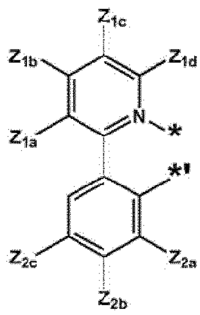
3-1(58)

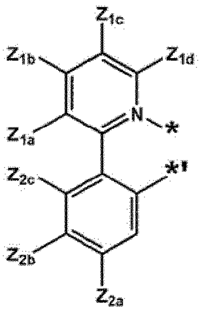
3-1(59)

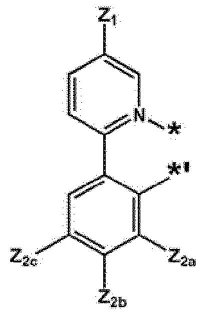
3-1(60)

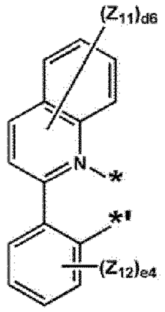
3-1(61)

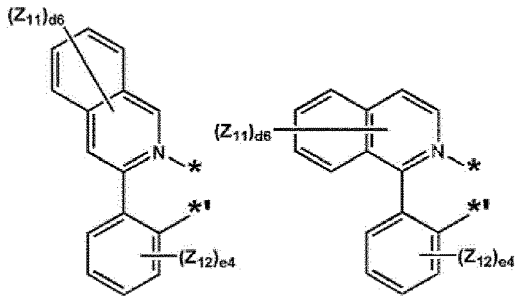
3-1(62)

3-1(63)

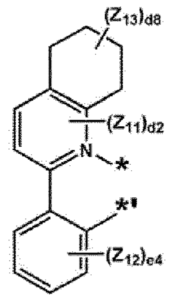
3-1(64)

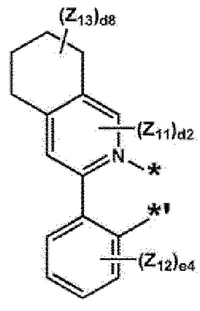
3-1(65)

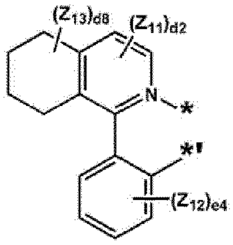
3-1(66)

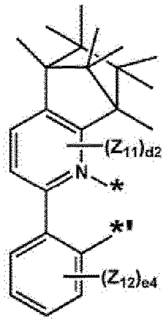
3-1(67)

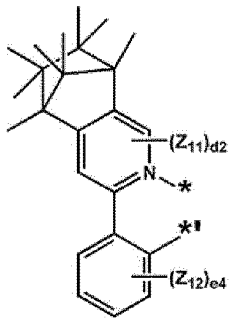
3-1(68)

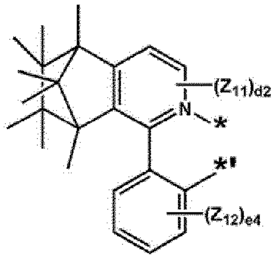
3-1(69)

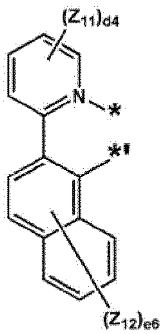
3-1(71)

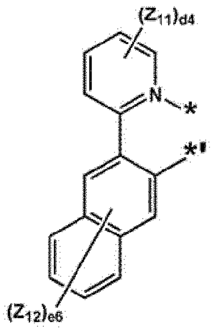
3-1(72)

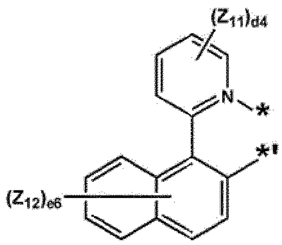
3-1(73)

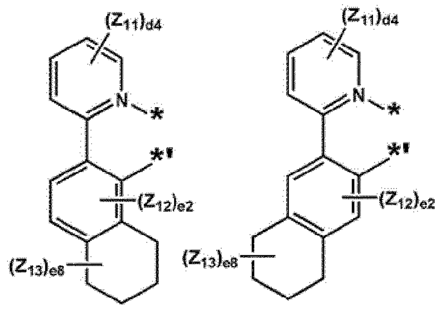
3-1(74)

3-1(75)

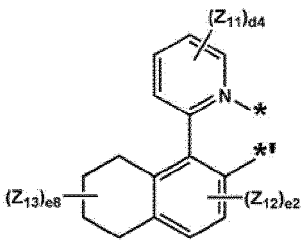
3-1(76)

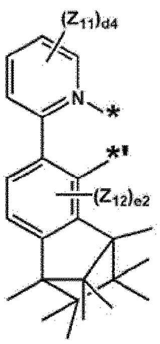
3-1(77)

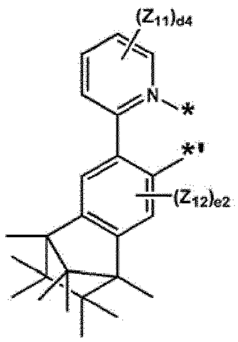
3-1(78)

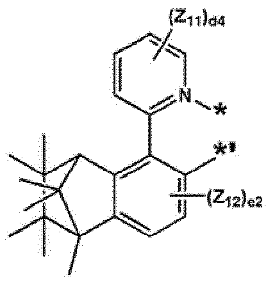
3-1(79)

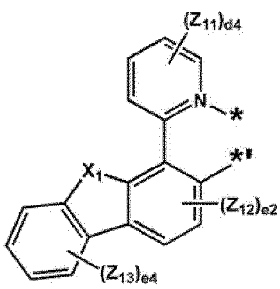
3-1(81)

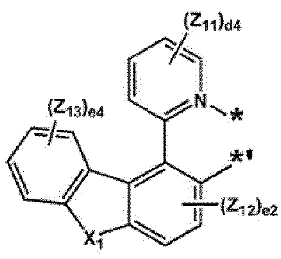
3-1(82)

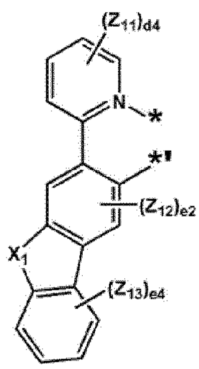
3-1(83)

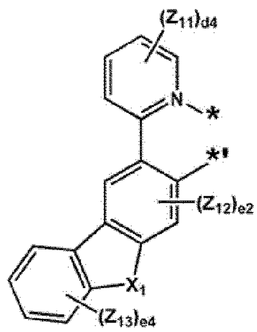
3-1(84)

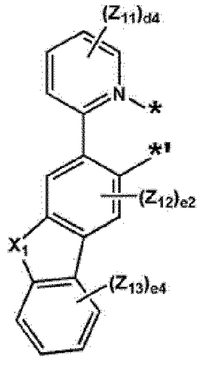

3-1(85)

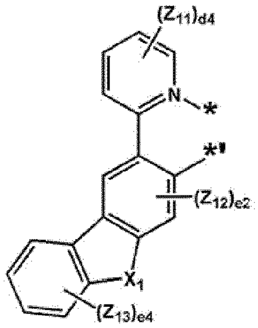

3-1(86)

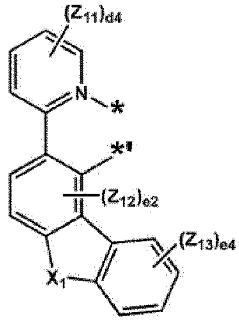

3-1(87)

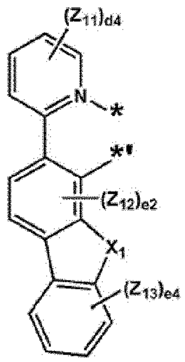

3-1(88)

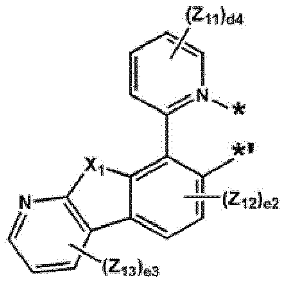

3-1(91)

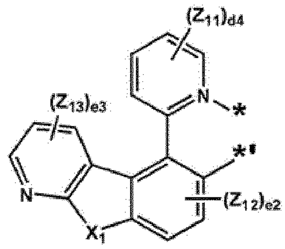

3-1(92)

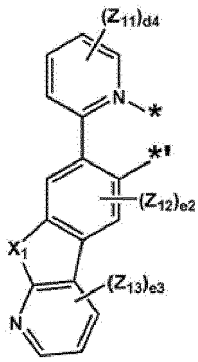

3-1(93)

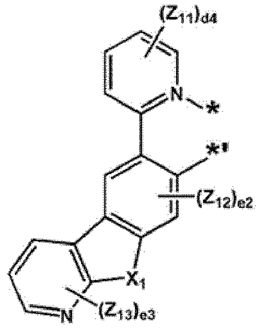

3-1(94)

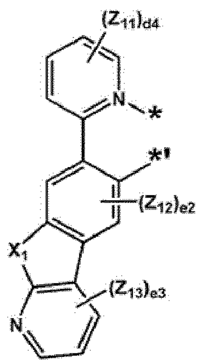

3-1(95)

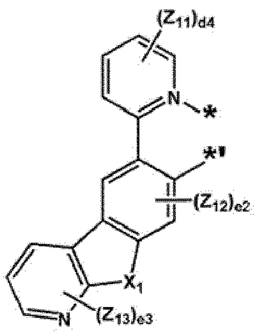

3-1(96)

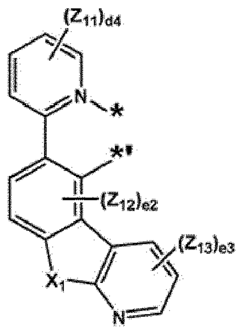

3-1(97)

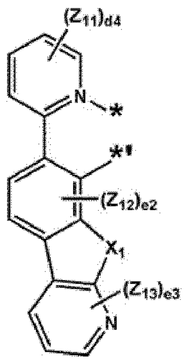

3-1(98)

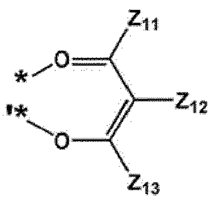

3-1(101)

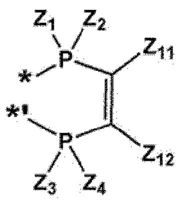

3-1(102)

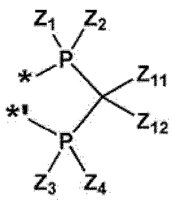

3-1(103)

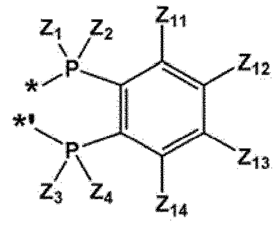

3-1(104)

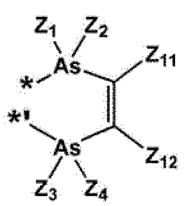

3-1(105)

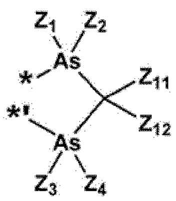

3-1(106)

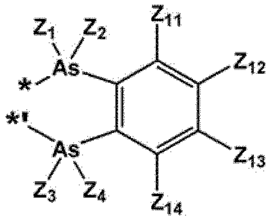

3-1(107)

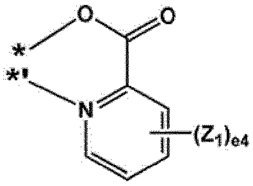

3-1(108)

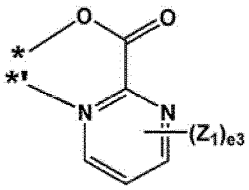

3-1(109)

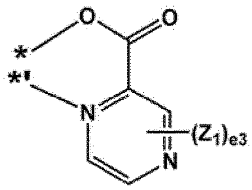

3-1(110)

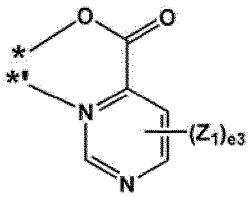

3-1(111)

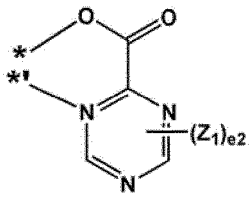

3-1(112)

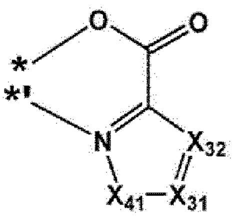

3-1(113)

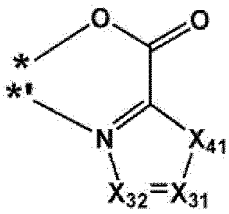

3-1(114)

wherein, in Formulae 3-1(1) to 3-1(69), 3-1(71) to 3-1(79), 3-1(81) to 3-1(88), 3-1(91) to 3-1(98), and 3-1(101) to 3-1(114),

$X_1$ may be O, S, $C(Z_{21})(Z_{22})$, or $N(Z_{23})$,

$X_{31}$ may be N or $C(Z_{1a})$, $X_{32}$ may be N or $C(Z_{1b})$,

$X_{41}$ may be O, S, $N(Z_{1a})$, or $C(Z_{1a})(Z_{1b})$,

$Z_1$ to $Z_4$, $Z_{1a}$, $Z_{1b}$, $Z_{1c}$, $Z_{1d}$, $Z_{2a}$, $Z_{2b}$, $Z_{2c}$, $Z_{2d}$, $Z_{11}$ to $Z_{14}$, and $Z_{21}$ to $Z_{23}$ may each independently be:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, a $C_1$-$C_{20}$ alkyl group, a $C_1$-$C_{20}$ alkylthio group, or a $C_1$-$C_{20}$ alkoxy group;

a $C_1$-$C_{20}$ alkyl group, a $C_1$-$C_{20}$ alkylthio group, or a $C_1$-$C_{20}$ alkoxy group, each independently substituted with at least one of deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, or a pyrimidinyl group;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group,

an imidazopyridinyl group, or an imidazopyrimidinyl group;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group, each independently substituted with at least one of deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group; or $-B(Q_{66})(Q_{67})$ or $-P(=O)(Q_{88})(Q_{89})$,

wherein $Q_{86}$ to $Q_{89}$ may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, or - $CD_2CDH_2$;

an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a phenyl group, or a naphthyl group; or

an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group, each independently substituted with at least one of deuterium, a $C_1$-$C_{10}$ alkyl group, or a phenyl group,

d2 and e2 may each independently be 0 or 2,

e3 may be an integer from 0 to 3,

d4 and e4 may each independently be an integer from 0 to 4,

d6 and e6 may each independently be an integer from 0 to 6,

d8 and e8 may each independently be an integer from 0 to 8, and

* and *' each indicate a binding site to M in Formula 1.

In an embodiment, in Formula 81, M may be Ir, and a sum of n81 and n82 may be 3. In an embodiment, in Formula 81, M may be Pt, and a sum of n81 and n82 may be 2.

In an embodiment, the organometallic compound represented by Formula 81 may be neutral and may not include ion pairs of cations and anions.

In an embodiment, the organometallic compound represented by Formula 81 may include at least one of Compounds PD1 to PD78 or $FIr_6$, but embodiments are not limited thereto:

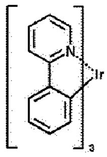
PD1

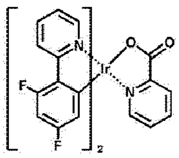
PD2

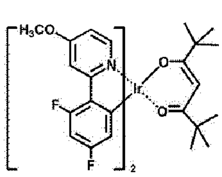
PD3

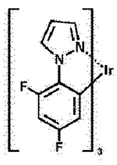
PD4

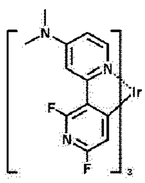
PD5

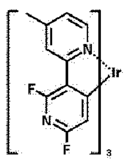
PD6

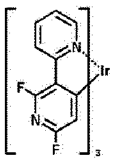
PD7

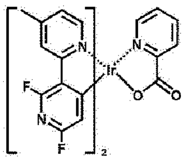
PD8

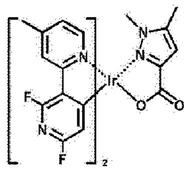
PD9

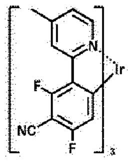
PD10

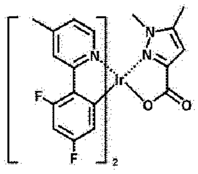
PD11

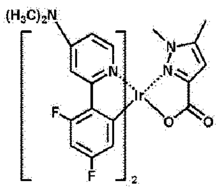
PD12

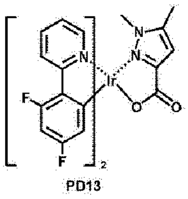
PD13

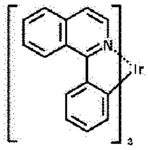
PD14

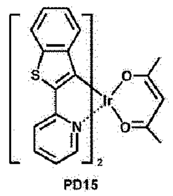
PD15

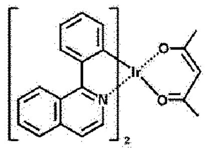
PD16

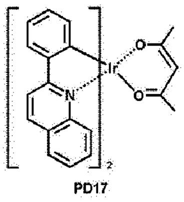
PD17

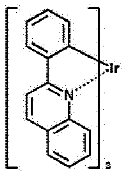
PD18

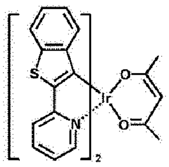
PD19

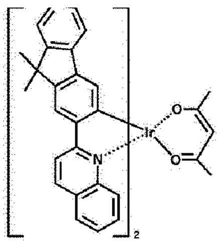
PD20

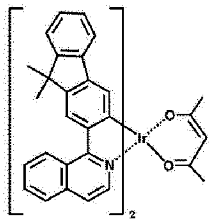
PD21

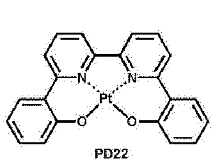
PD22

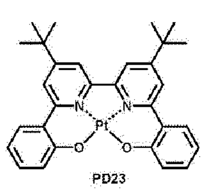
PD23

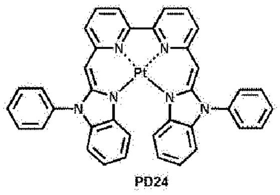
PD24

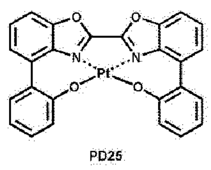
PD25

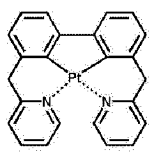
PD26

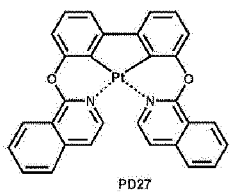
PD27

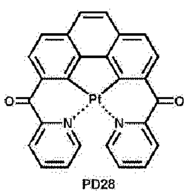
PD28

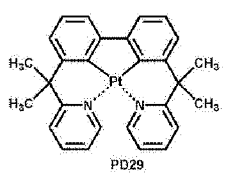
PD29

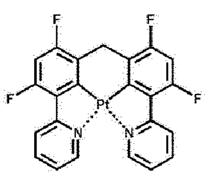
PD30

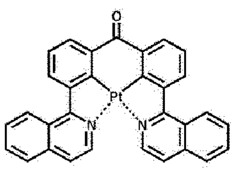
PD31

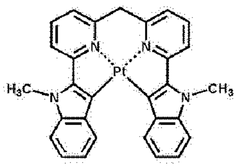
PD32

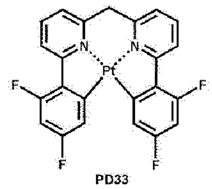
PD33

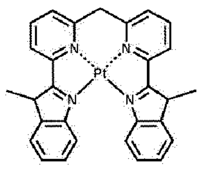
PD34

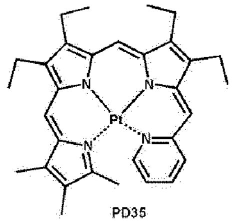
PD35

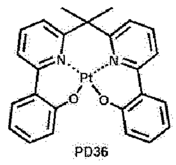
PD36

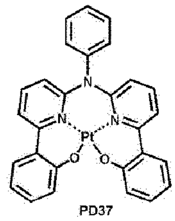
PD37

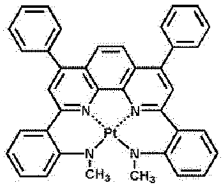
PD38

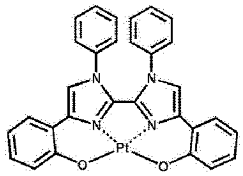
PD39

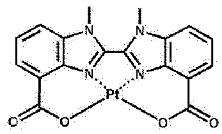
PD40

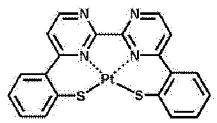
PD41

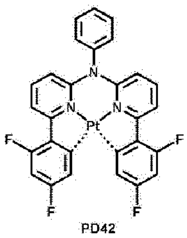
PD42

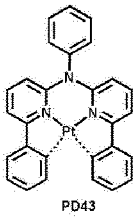
PD43

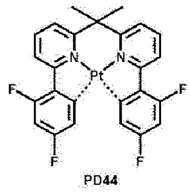
PD44

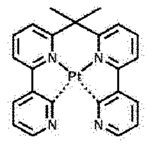
PD45

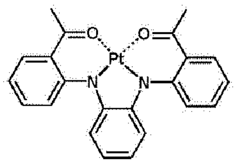
PD46

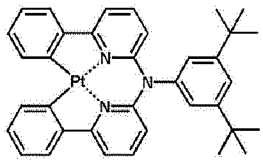
PD47

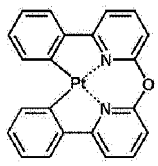
PD48

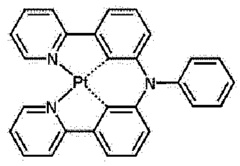
PD49

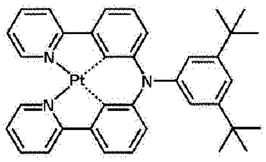
PD50

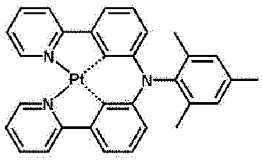
PD51

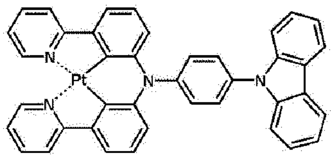
PD52

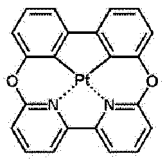
PD53

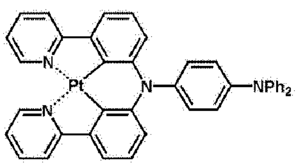
PD54

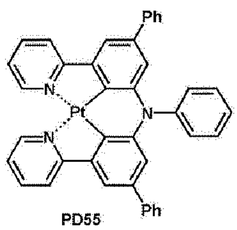
PD55

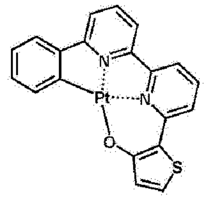
PD56

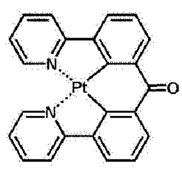
PD57

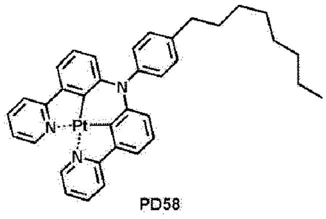
PD58

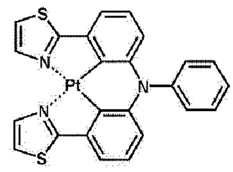
PD59

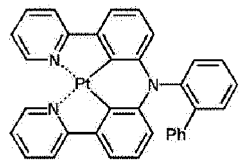
PD60

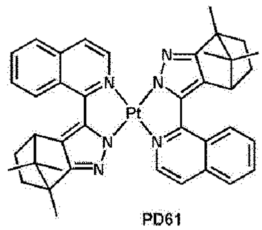
PD61

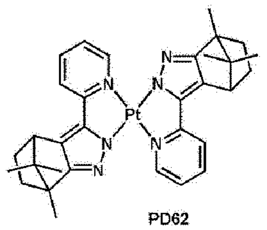
PD62

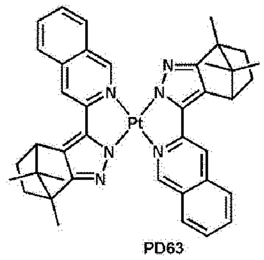
PD63

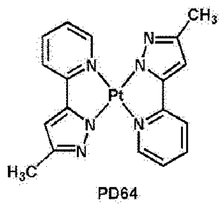
PD64

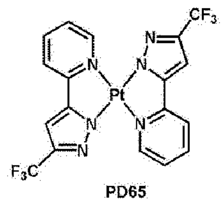
PD65

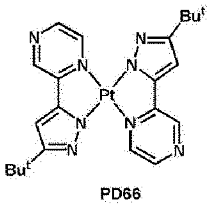
PD66

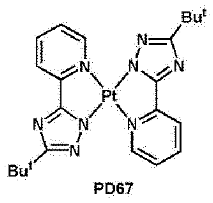
PD67

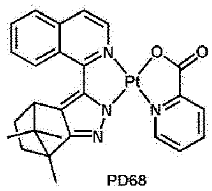
PD68

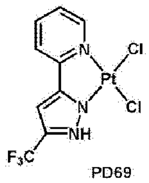
PD69

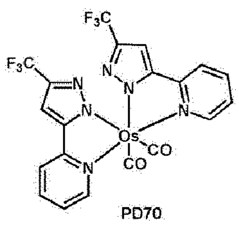
PD70

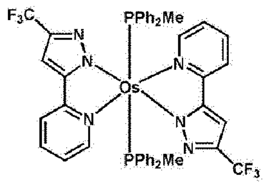
PD71

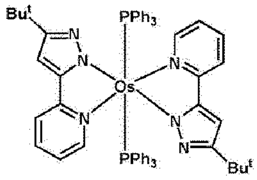
PD72

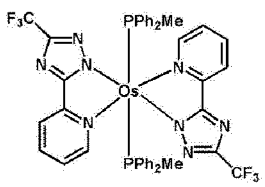
PD73

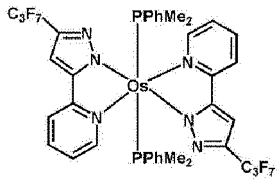
PD74

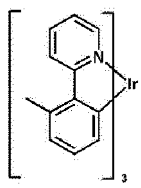
PD75

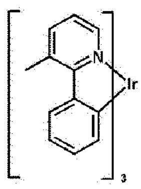
PD76

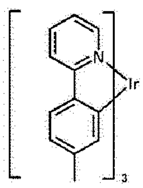
PD77

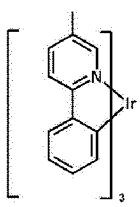
PD78

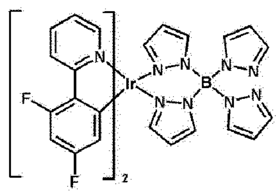
FIr6

In an embodiment, the emission layer in the light-emitting device may emit blue light having a maximum emission wavelength in a range of about 410 nanometers (nm) to about 490 nm.

As used herein, the expression the "(organic layer) includes at least one silane compound represented by Formula 1" may be construed as meaning the "(organic layer) may include one silane compound represented by Formula 1 or two or more different silane compounds represented by Formula 1".

For example, Compound 1 may only be included as the silane compound in the organic layer. In an embodiment, Compound 1 may be included in the emission layer of the organic light-emitting device. In an embodiment, the organic layer may include Compounds 1 and 2 as the silane compounds. In an embodiment, Compounds 1 and 2 may be present in the same layer (for example, Compounds 1 and 2 may be both present in an emission layer), or in different layers (for example, Compound 1 may be present in an emission layer, and Compound 2 may be present in a hole blocking layer).

The first electrode may be an anode, which is a hole injection electrode, and the second electrode may be a cathode, which is an electron injection electrode. In an embodiment, the first electrode may be a cathode, which is an electron injection electrode, and the second electrode may be an anode, which is a hole injection electrode.

The term "organic layer" as used herein refers to a single and/or a plurality of layers between the first electrode and the second electrode in an organic light-emitting device. The "organic layer" may include not only organic compounds but also organometallic complexes including metals.

The FIGURE illustrates a schematic cross-sectional view of an organic light-emitting device 10 according to an embodiment. Hereinafter, a structure of an organic light-emitting device according to one or more embodiments and a method of manufacturing the organic light-emitting device will be described with reference to the FIGURE. The organic light-emitting device 10 may include a first electrode 11, an organic layer 15, and a second electrode 19, which may be sequentially layered in this stated order.

A substrate may be additionally disposed under the first electrode 11 or on the second electrode 19. The substrate may be any suitable substrate used in organic light-emitting devices, e.g., a glass substrate or a transparent plastic substrate, each having excellent mechanical strength, thermal stability, transparency, surface smoothness, ease of handling, and water repellency.

The first electrode 11 may be formed by depositing or sputtering, onto the substrate, a material for forming the first electrode 11. The first electrode 11 may be an anode. The material for forming the first electrode 11 may be materials with a high work function for easy hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide ($SnO_2$), or zinc oxide (ZnO). In an embodiment, the material for forming the first electrode 11 may be a metal, such as magnesium (Mg), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including a plurality of layers. In an embodiment, the first electrode 11 may have a triple-layered structure of ITO/Ag/ITO, but embodiments are not limited thereto.

The organic layer 15 may be on the first electrode 11.

The organic layer 15 may include a hole transport region, an emission layer, and an electron transport region.

The hole transport region may be between the first electrode 11 and the emission layer.

The hole transport region may include at least one of a hole injection layer, a hole transport layer, an electron blocking layer, or a buffer layer.

The hole transport region may include a hole injection layer only or a hole transport layer only. In an embodiment, the hole transport region may include a hole injection layer and a hole transport layer which are sequentially stacked on the first electrode 11. In an embodiment, the hole transport region may include a hole injection layer, a hole transport layer, and an electron blocking layer, which are sequentially stacked on the first electrode 11.

When the hole transport region includes a hole injection layer, the hole injection layer may be formed on the first electrode 11 by using one or more suitable methods, such as vacuum deposition, spin coating, casting, and Langmuir-Blodgett (LB) deposition.

When a hole injection layer is formed by vacuum-deposition, for example, the vacuum deposition may be performed at a temperature in a range of about 100°C to about 500°C, at a vacuum degree in a range of about $10^{-8}$ torr to about $10^{-3}$ torr, and at a rate in a range of about 0.01 Angstroms per second (Å/sec) to about 100 Å/sec, though the conditions may vary depending on a compound used as a hole injection material and a structure and thermal properties of a desired hole injection layer, but embodiments are not limited thereto.

When a hole injection layer is formed by spin coating, the spin coating may be performed at a rate in a range of about 2,000 revolutions per minute (rpm) to about 5,000 rpm and at a temperature in a range of about 80°C to 200°C to facilitate removal of a solvent after the spin coating, though the conditions may vary depending on a compound used as a hole injection material and a structure and thermal properties of a desired hole injection layer, but embodiments are not limited thereto.

The conditions for forming a hole transport layer and an electron blocking layer may be inferred from the conditions for forming the hole injection layer.

The hole transport region may include at least one of m-MTDATA, TDATA, 2-TNATA, NPB, β-NPB, TPD, spiro-TPD, spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), (polyaniline)/poly(4-styrenesulfonate) (PANI/PSS), a compound represented

by Formula 201, or a compound represented by Formula 202:

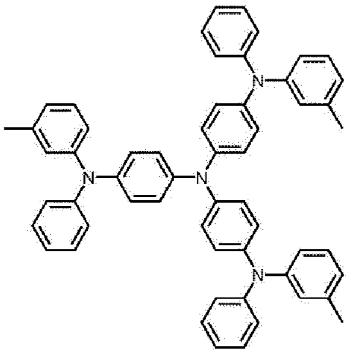

m-MTDATA

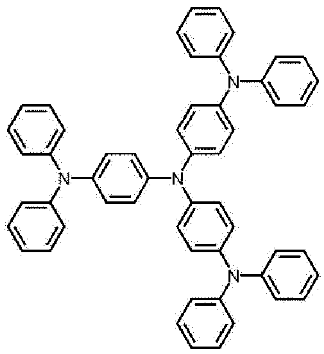

TDATA

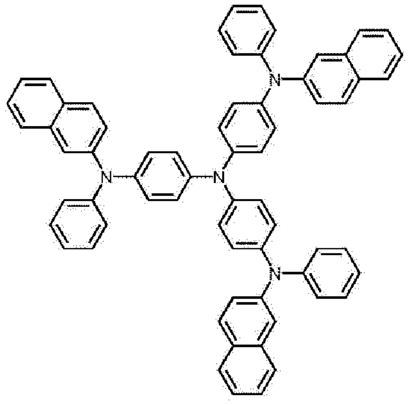

2-TNATA

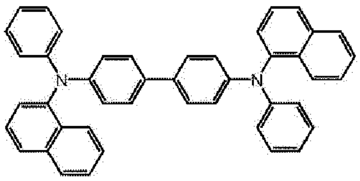

NPB

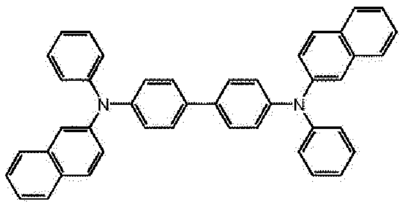

β-NPB

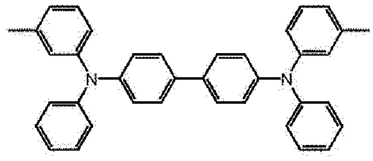

TPD

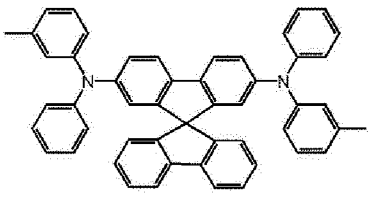

Spiro-TPD

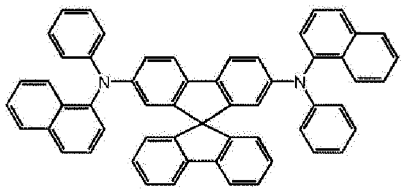

Spiro-NPB

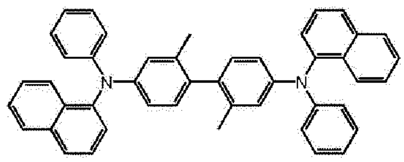

methylated NPB

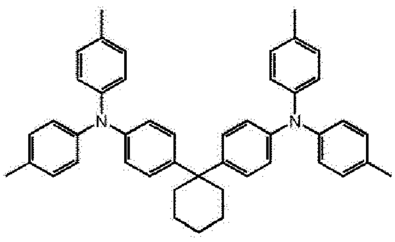

TAPC

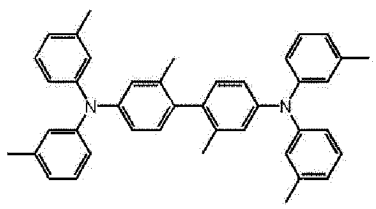

HMTPD

Formula 201

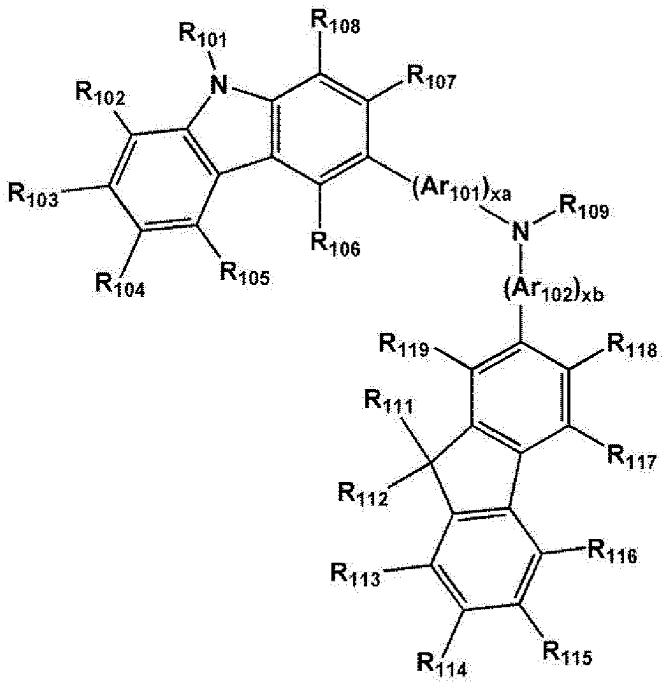

Formula 202

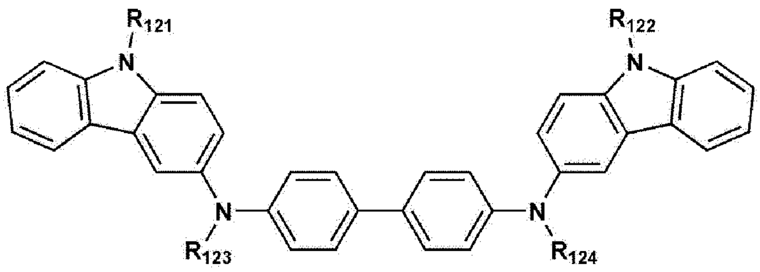

wherein, in Formula 201, $Ar_{101}$ and $Ar_{102}$ may each independently be:

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group; or

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each independently substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group.

In Formula 201, xa and xb may each independently be an integer from 0 to 5. In an embodiment, xa and xb may each independently be 0, 1, or 2. In an embodiment, xa may be 1, and xb may be 0, but embodiments are not limited thereto.

In Formulae 201 and 202, $R_{101}$ to $R_{108}$, $R_{111}$ to $R_{119}$, and $R_{121}$ to $R_{124}$ may each independently be:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group (e.g., a methyl group, an ethyl group, a propyl group, a butyl group, a pentyl group, or a hexyl group), a $C_1$-$C_{10}$ alkoxy group (e.g., a methoxy group, an ethoxy group, a propoxy group, a butoxy group, or a pentoxy group), or a $C_1$-$C_{10}$ alkylthio group (e.g., a thiomethyl group, a thioethyl group, a thiopropyl group, a thiobutyl group, a thiopentyl group, or a thiohexyl group);
a $C_1$-$C_{10}$ alkyl group, a $C_1$-$C_{10}$ alkylthio group, or a $C_1$-$C_{10}$ alkoxy group, each independently substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, or a phosphoric acid group or a salt thereof;
a phenyl group, a naphthyl group, an anthracenyl group, a fluorenyl group, or a pyrenyl group; or
a phenyl group, a naphthyl group, an anthracenyl group, a fluorenyl group, or a pyrenyl group, each independently substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkylthio group, or a $C_1$-$C_{10}$ alkoxy group, but embodiments are not limited thereto.

In Formula 201, $R_{109}$ may be:

a phenyl group, a naphthyl group, an anthracenyl group, or a pyridinyl group; or
a phenyl group, a naphthyl group, an anthracenyl group, or a pyridinyl group, each independently substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_1$-$C_{20}$ alkylthio group, a phenyl group, a naphthyl group, an anthracenyl group, or a pyridinyl group.

In an embodiment, the compound represented by Formula 201 may be represented by Formula 201A, but embodiments are not limited thereto:

Formula 201A

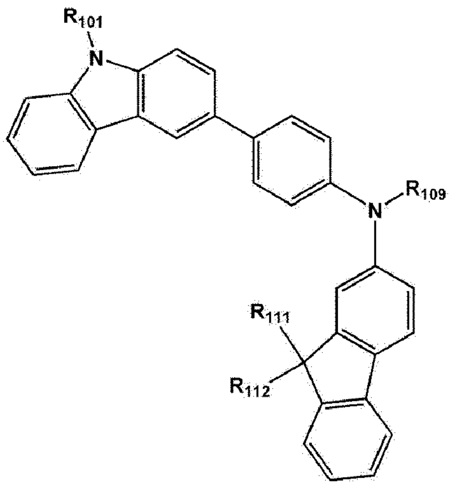

wherein, in Formula 201A, $R_{101}$, $R_{111}$, $R_{112}$, and $R_{109}$ may respectively be understood by referring to the descriptions of $R_{101}$, $R_{111}$, $R_{112}$, and $R_{109}$ provided herein.

In an embodiment, the compounds represented by Formulae 201 and 202 may include Compounds HT1 to HT20, but embodiments are not limited thereto:

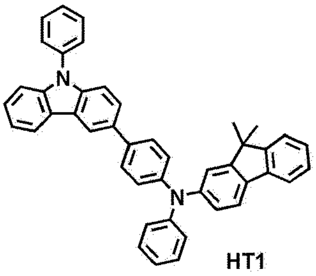

HT1

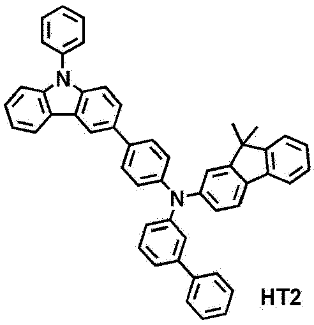

HT2

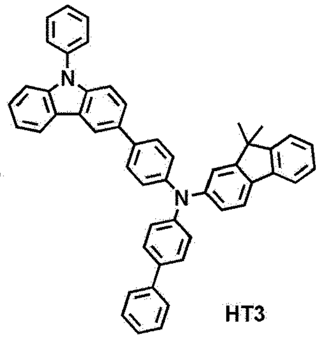

HT3

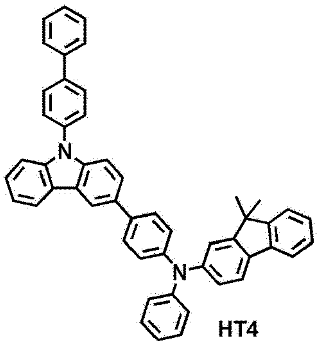

HT4

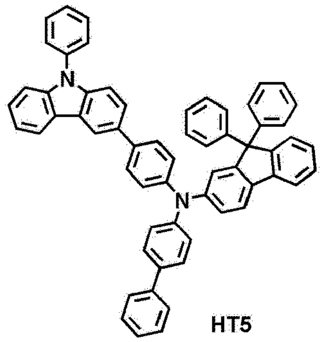

HT5

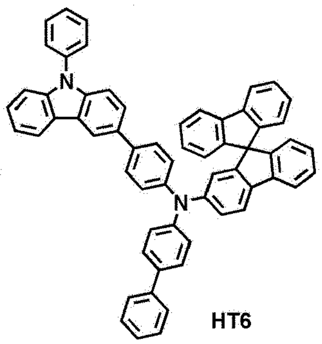

HT6

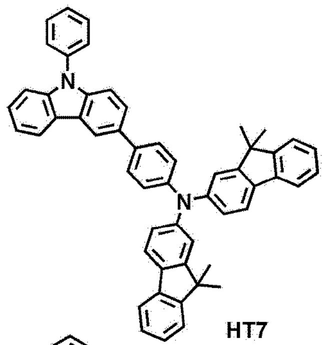

HT7

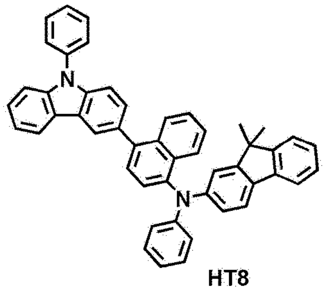

HT8

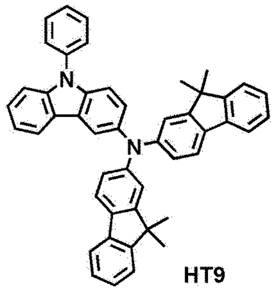

HT9

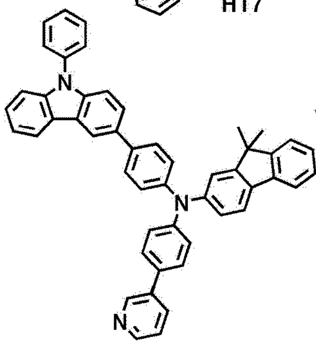

HT10

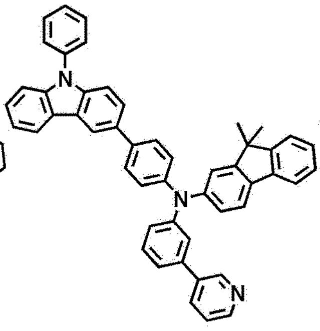

HT11

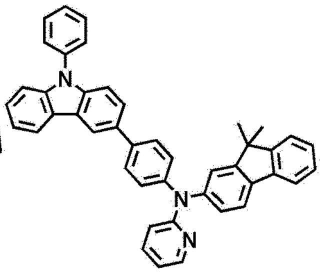

HT12

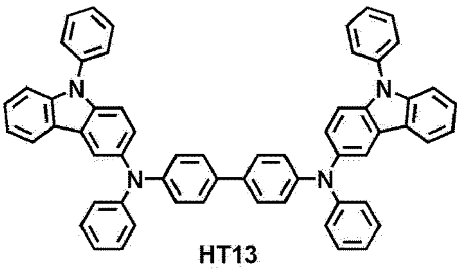

HT13

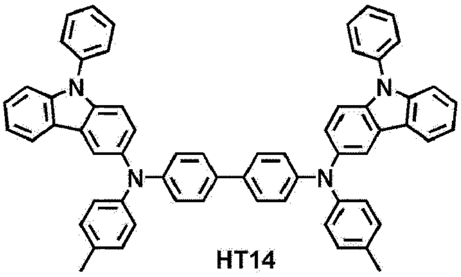

HT14

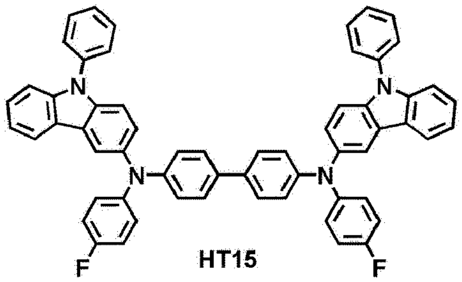

HT15

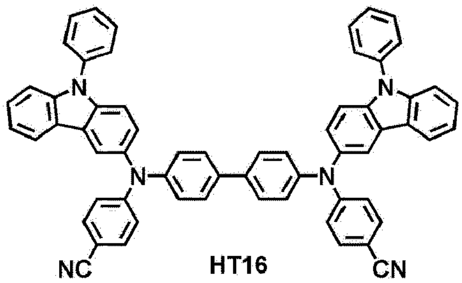

HT16

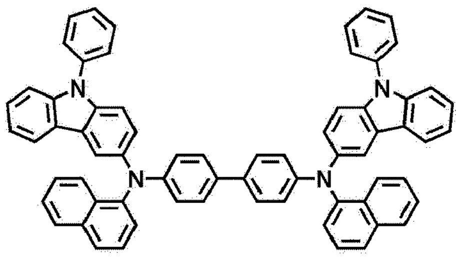

HT17

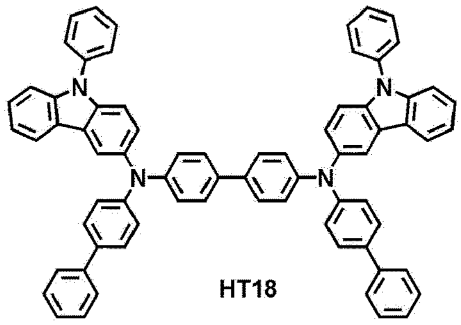

HT18

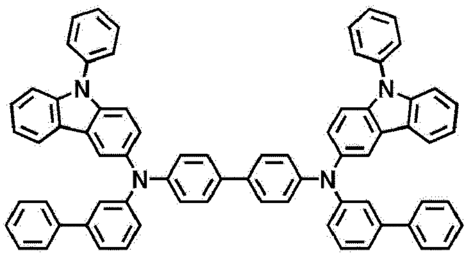

HT19

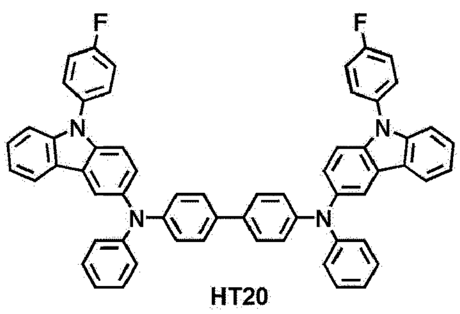

HT20

The thickness of the hole transport region may be in a range of about 100 Angstroms (Å) to about 10,000 Å, for example, about 100 Å to about 1,000 Å, about 100 Å to about 2,000 Å, about 100 Å to about 3,000 Å, about 100 Å to about 4,000 Å, about 100 Å to about 5,000 Å, about 100 Å to about 6,000 Å, about 100 Å to about 7,000 Å, about 100 Å to about 8,000 Å, or about 100 Å to about 9,000 Å. When the hole transport region includes at least one of a hole injection layer and a hole transport layer, the thickness of the hole injection layer may be in a range of about 100 Å to about 10,000 Å, for example, about 100 Å to about 1,000 Å, 100 Å to about 2,000 Å, about 100 Å to about 3,000 Å, about 100 Å to about 4,000 Å, about 100 Å to about 5,000 Å, about 100 Å to about 6,000 Å, about 100 Å to about 7,000 Å, about 100 Å to about 8,000 Å, or about 100 Å to about 9,000 Å. The thickness of the hole transport layer may be in a range of about 50 Å to about 2,000 Å, for example, about 100 Å to about 1,500 Å, about 100 Å to about 1,000 Å, about 100 Å to about 500 Å, about 50 Å to about 1,500 Å, about 50 Å to about 1,000 Å, or about 50 Å to about 500 Å. While not wishing to be bound by theory, it is understood that when the thicknesses of the hole transport region, the hole injection layer, and the hole transport layer are within any of these ranges, excellent or improved hole transport characteristics may be obtained without a substantial increase in driving voltage.

The hole transport region may include a charge generating material as well as the aforementioned materials, to improve conductive properties of the hole transport region. The charge generating material may be substantially homogeneously or non-homogeneously dispersed in the hole transport region.

The charge generating material may include, for example, a p-dopant. The p-dopant may include one of a quinone derivative, a metal oxide, and a compound containing a cyano group, but embodiments are not limited thereto. For example, nonlimiting examples of the p-dopant include a quinone derivative, such as tetracyanoquinodimethane (TCNQ) or 2,3,5,6-tetrafluoro-tetracyano-1,4-benzoquinonedimethane (F4-TCNQ); a metal oxide, such as a tungsten oxide or a molybdenum oxide; and a compound containing a cyano group, such as Compound HT-D1 or Compound HT-D2, but embodiments are not limited thereto:

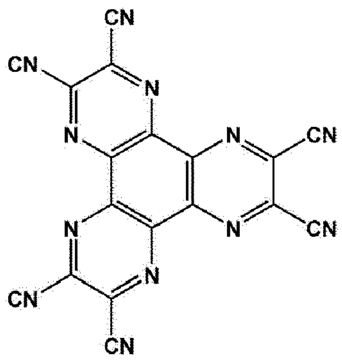

HT-D1

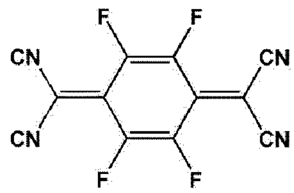

F4-TCNQ

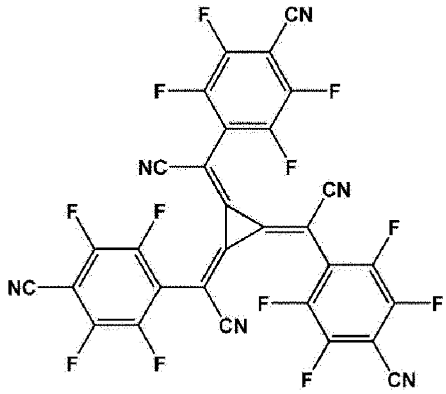

HT-D2

The hole transport region may further include a buffer layer.

The buffer layer may compensate for an optical resonance distance depending on a wavelength of light emitted from the emission layer to improve the efficiency of an organic light-emitting device.

An emission layer may be formed on the hole transport region by using one or more suitable methods, such as vacuum deposition, spin coating, casting, or **LB** deposition. When the emission layer is formed by vacuum deposition or spin coating, vacuum deposition and coating conditions for forming the emission layer may be generally similar to those conditions for forming a hole injection layer, although the conditions may vary depending on a compound that is used.

The hole transport region may further include an electron blocking layer. The electron blocking layer may include any suitable material, e.g., mCP, but embodiments are not limited thereto:

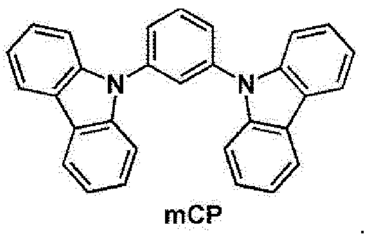

mCP .

The thickness of the electron blocking layer may be in a range of about 50 Å to about 1,000 Å, and in some embodiments, about 70 Å to about 500 Å. While not wishing to be bound by theory, it is understood that when the thickness of the electron blocking layer is within any of these ranges, excellent or improved electron blocking characteristics may be obtained without a substantial increase in driving voltage.

When the organic light-emitting device 10 is a full-color organic light-emitting device, the emission layer may be patterned into a red emission layer, a green emission layer, and/or a blue emission layer. In an embodiment, the emission layer may have a structure in which the red emission layer, the green emission layer, and/or the blue emission layer are layered to emit white light. In an embodiment, the structure of the emission layer may vary.

The emission layer may include the silane compound represented by Formula 1.

In an embodiment, the emission layer may include the silane compound represented by Formula 1 only.

In an embodiment, the emission layer may include

the silane compound represented by Formula 1 and

i) a second compound as a host which is different from the silane compound represented by Formula 1;
ii) the organometallic compound represented by Formula 81; or
iii) any combination of i) and ii).

The silane compound represented by Formula 1, and the organometallic compound represented by Formula 81 may respectively be understood by referring to the descriptions for those provided herein. The second compound may be any suitable host used in an organic light emitting device available in the art.

When the emission layer includes the host and the dopant, an amount of the dopant may be selected from a range of about 0.01 parts to about 20 parts by weight based on about 100 parts by weight of the emission layer, but embodiments are not limited thereto. For example, the amount of the dopant may be from a range of about 0.01 parts to about 20 parts, about 0.01 parts to about 15 parts, about 0.01 parts to about 10 parts, about 0.01 parts to about 7 parts, about 0.01 parts to about 5 parts, about 0.01 parts to about 3 parts, about 0.01 parts to about 1 parts, or about 0.01 parts to about 0.5 parts by weight based on about 100 parts by weight of the emission layer, but embodiments are not limited thereto. While not wishing to be bound by theory, it is understood that when the amount of the dopant is within this range, light emission without quenching may be realized.

When the emission layer includes the silane compound represented by Formula 1 and the second compound, a weight ratio of the silane compound represented by Formula 1 to the second compound may be in a range of about 1:99 to about 99:1, for example, about 90:10 to about 10:90, about 80:20 to about 20:80, about 70:30 to about 30:70, or about 60:40 to about 40:60. In an embodiment, a weight ratio of the silane compound represented by Formula 1 to the second compound may be in a range of about 60:40 to about 40:60. While not wishing to be bound by theory, it is understood that when the weight ratio of the silane compound represented by Formula 1 to the second compound in the emission layer is within any of these ranges, the charge transport balance may be efficiently achieved in the emission layer.

The thickness of the emission layer may be in a range of about 100 Å to about 1,000 Å, and in an embodiment, about 200 Å to about 600 Å. While not wishing to be bound by theory, it is understood that when the thickness of the emission layer is within any of these ranges, improved luminescence characteristics may be obtained without a substantial increase in driving voltage.

In an embodiment, an electron transport region may be formed on the emission layer.

The electron transport region may include at least one of a hole blocking layer, an electron transport layer, or an electron injection layer.

In an embodiment, the electron transport region may have a hole blocking layer/an electron transport layer/an electron injection layer structure or an electron transport layer/an electron injection layer structure, but embodiments are not limited thereto. The electron transport layer may have a single-layered structure or a multi-layered structure including two or more different materials.

The conditions for forming a hole blocking layer, an electron transport layer, and an electron injection layer may be inferred based on the conditions for forming the hole injection layer.

When the electron transport region includes a hole blocking layer, the hole blocking layer, for example, may include at least one of BCP or Bphen, but embodiments are not limited thereto:

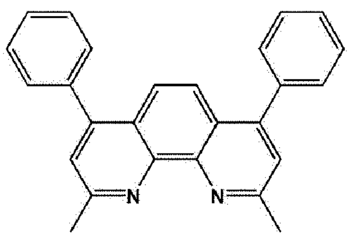

BCP

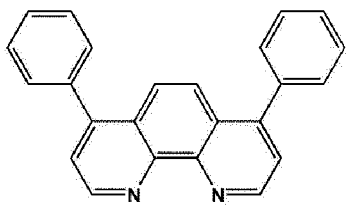

Bphen

.

The hole blocking layer may include the silane compound represented by Formula 1.

The thickness of the hole blocking layer may be in a range of about 20 Å to about 1,000 Å, for example, about 30 Å to about 300 Å, about 40 Å to about 400 Å, about 50 Å to about 500 Å, about 60 Å to about 600 Å, about 70 Å to about 700 Å, about 80 Å to about 800 Å, about 90 Å to about 900 Å, or about 100 Å to about 1000 Å. While not wishing to be bound by theory, it is understood that when the thickness of the hole blocking layer is within any of these ranges, excellent or improved hole blocking characteristics may be obtained without a substantial increase in driving voltage.

The electron transport layer may include at least one of BCP, Bphen, $Alq_3$, BAlq, TAZ, or NTAZ:

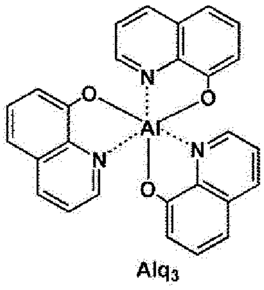

Alq$_3$

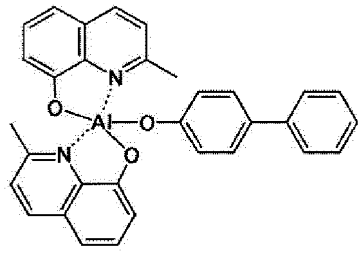

BAlq

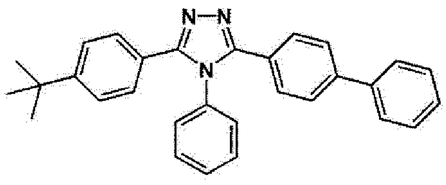

TAZ

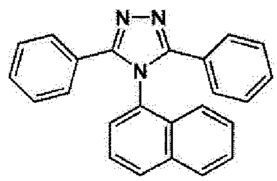

NTAZ

.

In an embodiment, the electron transport layer may include at least one of Compounds ET1, ET2, or ET3, but embodiments are not limited thereto:

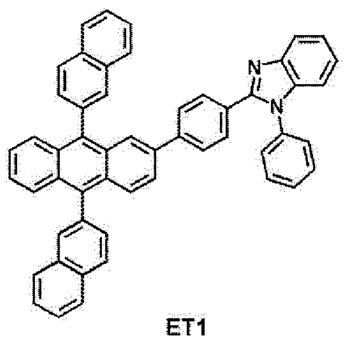

ET1

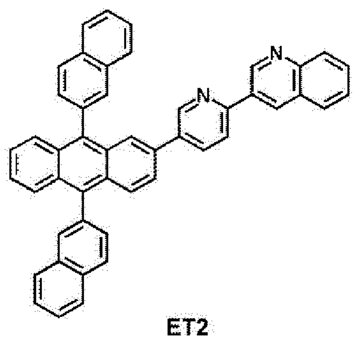

ET2

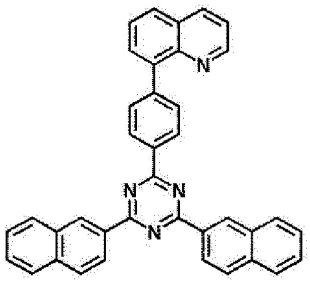

ET3

The thickness of the electron transport layer may be in a range of about 100 Å to about 1,000 Å, and in an embodiment, about 150 Å to about 500 Å, about 200 Å to about 600 Å, about 300 Å to about 700 Å, about 400 Å to about 800 Å, about 500 Å to about 900 Å, or about 600 Å to about 1000 Å. While not wishing to be bound by theory, it is understood that when the thickness of the electron transport layer is within any of these ranges, excellent or improved electron transport characteristics may be obtained without a substantial increase in driving voltage.

The electron transport layer may further include a material containing metal, in addition to the materials described herein.

The material containing metal may include a Li complex. The Li complex may include, e.g., Compound ET-D1 (LiQ) or Compound ET-D2:

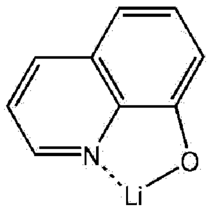
ET-D1

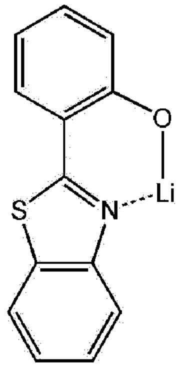
ET-D2

The electron transport region may include an electron injection layer that facilitates electron injection from the second electrode 19.

The electron injection layer may include at least one of LiQ, LiF, NaCl, CsF, $Li_2O$, or BaO.

The thickness of the electron injection layer may be in a range of about 1 Å to about 100 Å, and in an embodiment, about 3 Å to about 90 Å, about 10 Å to about 80 Å, about 20 Å to about 70 Å, about 30 Å to about 60 Å, or about 40 Å to about 50 Å. While not wishing to be bound by theory, it is understood that when the thickness of the electron injection layer is within any of these ranges, excellent or improved electron injection characteristics may be obtained without a substantial increase in driving voltage.

The second electrode 19 may be on the organic layer 15. The second electrode 19 may be a cathode. A material for forming the second electrode 19 may be a material with a relatively low work function, such as a metal, an alloy, an electrically conductive compound, or a mixture thereof. Examples of the material for forming the second electrode 19 may include lithium (Li), magnesium (Mg), aluminum (Al), aluminum-lithium (Al-Li), calcium (Ca), magnesium-indium (Mg-In), or magnesium-silver (Mg-Ag). In an embodiment, ITO or IZO may be used to form a transmissive second electrode 19 to manufacture a top emission light-emitting device. In an embodiment, the material for forming the second electrode 19 may vary.

Hereinbefore the organic light-emitting device 10 has been described with reference to the FIGURE, but embodiments are not limited thereto.

Definition of Terms

The term "$C_1$-$C_{60}$ alkyl group" as used herein refers to a linear or branched saturated aliphatic hydrocarbon monovalent group having 1 to 60 carbon atoms. Examples thereof include a methyl group, an ethyl group, a propyl group, an iso-butyl group, a sec-butyl group, a tert-butyl group, a pentyl group, an iso-amyl group, and a hexyl group. The term "$C_1$-$C_{60}$ alkylene group" as used herein refers to a divalent group having the same structure as the $C_1$-$C_{60}$ alkyl group.

The term "$C_1$-$C_{60}$ alkoxy group" as used herein refers to a monovalent group represented by -$OA_{101}$ (wherein $A_{101}$ is a $C_1$-$C_{60}$ alkyl group). Examples thereof include a methoxy group, an ethoxy group, and an isopropyloxy group.

The term "$C_1$-$C_{60}$ alkylthio group" used herein refers to a monovalent group represented by -$SA_{164}$ (wherein $A_{104}$ is the $C_1$-$C_{60}$ alkyl group), and examples thereof include a thiomethyl group, a thioethyl group, and a thioisopropyl group.

The term "$C_2$-$C_{60}$ alkenyl group" as used herein refers to a group formed by placing at least one carbon-carbon double bond in the middle or at the terminus of the $C_2$-$C_{60}$ alkyl group. Examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a group formed by placing at least one carbon-carbon triple bond in the middle or at the terminus of the $C_2$-$C_{60}$ alkyl group. Examples thereof include an ethynyl group and a propynyl group. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent monocyclic saturated hydrocarbon group including 3 to 10 carbon atoms. Examples thereof include a cyclopropyl group, a cyclobutyl group, a cyclopentyl group, a cyclohexyl group, and a cycloheptyl group. The term "$C_3$-$C_{10}$ cycloalkylene group" as used herein refers to a divalent group having the same structure as the $C_3$-$C_{10}$ cycloalkyl group.

The term "$C_1$-$C_{10}$ heterocycloalkyl group" as used herein refers to a monovalent monocyclic group including at least one heteroatom of N, O, P, Si, or S as a ring-forming atom and 1 to 10 carbon atoms. Examples thereof include a tetrahydrofuranyl group and a tetrahydrothiophenyl group. The term "$C_1$-$C_{10}$ heterocycloalkylene group" as used herein

refers to a divalent group having the same structure as the $C_1$-$C_{10}$ heterocycloalkyl group.

The term "$C_3$-$C_{10}$ cycloalkenyl group" as used herein refers to a monovalent monocyclic group that has 3 to 10 carbon atoms and at least one carbon-carbon double bond in its ring, wherein the molecular structure as a whole is non-aromatic. Examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent monocyclic group including at least one heteroatom of N, O, P, Si, or S as a ring-forming atom, 1 to 10 carbon atoms, and at least one double bond in its ring. Examples of the $C_1$-$C_{10}$ heterocycloalkenyl group include a 2,3-dihydrofuranyl group and a 2,3-dihydrothiophenyl group. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms. The term "$C_6$-$C_{60}$ arylene group" as used herein refers to a divalent group having a carbocyclic aromatic system having 6 to 60 carbon atoms. Examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include a plurality of rings, the plurality of rings may be fused to each other. The term "$C_7$-$C_{60}$ alkyl aryl group" as used herein refers to a $C_6$-$C_{60}$ aryl group substituted with at least one $C_1$-$C_{60}$ alkyl group.

The term "$C_1$-$C_{60}$ heteroaryl group" as used herein refers to a monovalent group having a heterocyclic aromatic system having at least one heteroatom N, O, P, Si, or S as a ring-forming atom and 1 to 60 carbon atoms. The term "$C_1$-$C_{60}$ heteroarylene group" as used herein refers to a divalent group having a heterocyclic aromatic system having at least one heteroatom N, O, P, Si, or S as a ring-forming atom and 1 to 60 carbon atoms. Examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_1$-$C_{60}$ heteroaryl group and the $C_1$-$C_{60}$ heteroarylene group each include a plurality of rings, the plurality of rings may be fused to each other. The term "$C_2$-$C_{60}$ alkyl heteroaryl group" as used herein refers to a $C_1$-$C_{60}$ heteroaryl group substituted with at least one $C_1$-$C_{60}$ alkyl group.

The term "$C_6$-$C_{60}$ aryloxy group" as used herein indicates $-OA_{102}$ (wherein $A_{162}$ is a $C_6$-$C_{60}$ aryl group), and a $C_6$-$C_{60}$ arylthio group as used herein indicates $-SA_{103}$ (wherein $A_{163}$ is a $C_6$-$C_{60}$ aryl group).

The term "$C_1$-$C_{60}$ heteroaryloxy group" as used herein refers to $-OA_{105}$ (wherein $A_{105}$ is the $C_1$-$C_{60}$ heteroaryl group), and the term "$C_1$-$C_{60}$ heteroarylthio group" as used herein indicates $-SA_{106}$ (wherein $A_{106}$ is the $C_1$-$C_{60}$ heteroaryl group).

The term "monovalent non-aromatic condensed polycyclic group" as used herein refers to a monovalent group that has two or more condensed rings and only carbon atoms (e.g., the number of carbon atoms may be in a range of 8 to 60) as ring-forming atoms, wherein the molecular structure as a whole is non-aromatic. Examples of the monovalent non-aromatic condensed polycyclic group include a fluorenyl group. The term "divalent non-aromatic condensed polycyclic group" as used herein refers to a divalent group having substantially the same structure as the monovalent non-aromatic condensed polycyclic group.

The term "monovalent non-aromatic condensed heteropolycyclic group" as used herein refers to a monovalent group that has two or more condensed rings and at least one heteroatom N, O, P, Si, or S and carbon atoms (e.g., the number of carbon atoms may be in a range of 1 to 60) as ring-forming atoms, wherein the molecular structure as a whole is non-aromatic. Examples of the monovalent non-aromatic condensed heteropolycyclic group include a carbazolyl group. The term "divalent non-aromatic condensed heteropolycyclic group" as used herein refers to a divalent group having substantially the same structure as the monovalent non-aromatic condensed heteropolycyclic group.

The term "$C_6$-$C_{36}$ carbocyclic group" as used herein refers to a saturated or unsaturated cyclic group including 5 to 30 carbon atoms only as ring-forming atoms. The $C_5$-$C_{30}$ carbocyclic group may be a monocyclic group or a polycyclic group.

The term "$C_1$-$C_{30}$ heterocyclic group" as used herein refers to saturated or unsaturated cyclic group including 1 to 30 carbon atoms and at least one heteroatom N, O, P, Si, or S as ring-forming atoms. The $C_1$-$C_{30}$ heterocyclic group may be a monocyclic group or a polycyclic group.

At least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_6$-$C_{60}$ aryloxy group, the substituted $C_6$-$C_{60}$ arylthio group, the substituted $C_1$-$C_{60}$ heteroaryl group, the substituted $C_1$-$C_{60}$ heteroaryloxy group, the substituted $C_1$-$C_{60}$ heteroarylthio group, the substituted $C_2$-$C_{60}$ alkyl heteroaryl group, the substituted monovalent non-aromatic condensed polycyclic group, or the substituted monovalent non-aromatic condensed heteropolycyclic group may be:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkylthio group, or a $C_1$-$C_{60}$ alkoxy group;

a $C_1$-$C_{60}$ alkyl group, a $C_2$-$C_{60}$ alkenyl group, a $C_2$-$C_{60}$ alkynyl group, a $C_1$-$C_{60}$ alkylthio group, or a $C_1$-$C_{60}$ alkoxy group, each independently substituted with at least one of deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a $C_2$-$C_{60}$ alkyl heteroaryl group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, $-B(Q_{16})(Q_{17})$, or $-P(=O)(Q_{16})(Q_{19})$,

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a $C_2$-$C_{60}$ alkyl heteroaryl group, a monovalent non-aromatic condensed polycyclic group, or a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a $C_2$-$C_{60}$ alkyl heteroaryl group, a monovalent non-aromatic condensed polycyclic group, or a monovalent non-aromatic condensed heteropolycyclic group, each independently substituted with at least one of deuterium, -F, -Cl, - Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a $C_2$-$C_{60}$ alkyl heteroaryl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-B(Q_{26})(Q_{27})$, or $-P(=O)(Q_{28})(Q_{29})$, or

$-N(Q_{31})(Q_{32})$, $-Si(Q_{33})(Q_{34})(Q_{35})$, $-B(Q_{36})(Q_{37})$, or $-P(=O)(Q_{38})(Q_{39})$,

wherein $Q_1$ to $Q_9$, $Q_{11}$ to $Q_{19}$, $Q_{21}$ to $Q_{29}$, and $Q_{31}$ to $Q_{39}$ may each independently be hydrogen, deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_1$-$C_{60}$ alkyl group substituted with at least one of deuterium, a $C_1$-$C_{60}$ alkyl group, or a $C_6$-$C_{60}$ aryl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryl group substituted with at least one of deuterium, a $C_1$-$C_{60}$ alkyl group, or a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a $C_2$-$C_{66}$ alkyl heteroaryl group, a monovalent non-aromatic condensed polycyclic group, or a monovalent non-aromatic condensed heteropolycyclic group.

Hereinafter, a compound and an organic light-emitting device according to an embodiment will be described in detail with reference to Synthesis Examples and Examples, however, the present disclosure is not limited thereto. The wording "B was used instead of A" used in describing Synthesis Examples means that an identical molar equivalent of B was used in place of A.

Examples

Synthesis Example 1: Synthesis of Compound 10

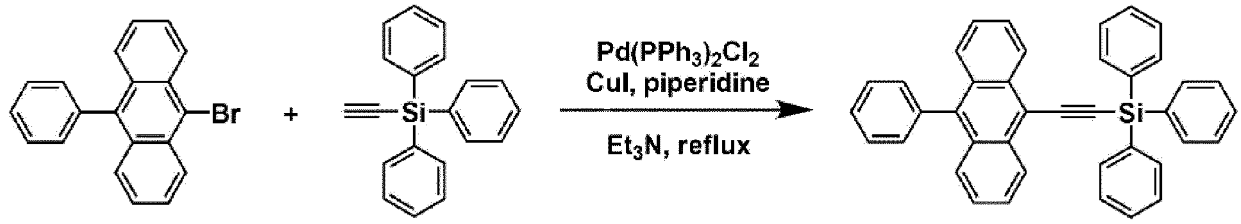


10

9-bromo-10-phenylanthracene (1.0 equivalents (eq.)), triphenyl silylacetylene (2.0 eq.), bis(triphenyl phosphine) palladium(II) dichloride ($Pd(PPh_3)_2Cl_2$) (0.1 eq.), copper(I) iodide (CuI) (0.11 eq.), and piperidine (8.0 eq.) were added to a reaction vessel, followed by purging with nitrogen. Then, triethylamine ($Et_3N$) was used as a solvent to perform heating under reflux for 20 hours. A saturated ammonium chloride solution was added thereto, followed by extraction using dichloromethane. After drying with anhydrous magnesium sulfate, a solvent was removed therefrom, and purification through column chromatography and recrystallization (using ethyl acetate and hexane) were performed, to thereby obtain a white solid of Compound 10. Yield: 32 %, LCMS[M+H, m/z] 537.2

Synthesis Example 2: Synthesis of Compound 24

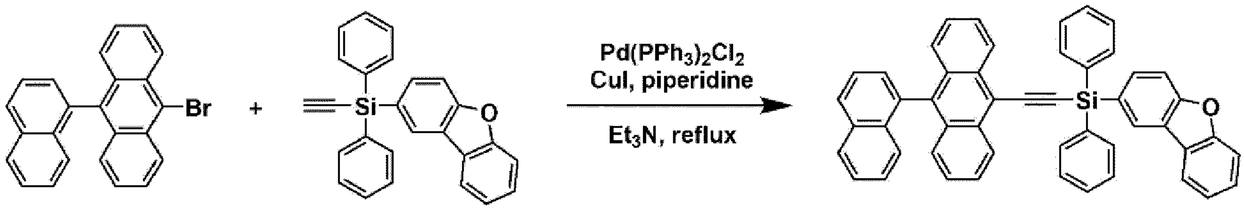


24

Compound 24 was synthesized in substantially the same manner as in Synthesis Example 1, except that 9-bromo-10-(naphthalen-1-yl)anthracene was used instead of 9-bromo-10-phenylanthracene, and dibenzo[b,d]furan-2-yl(ethynyl)diphenyl silane was used instead of triphenyl silylacetylene. Yield: 35 %, LCMS[M+H, m/z] 677.2

Synthesis Example 3: Synthesis of Compound 51

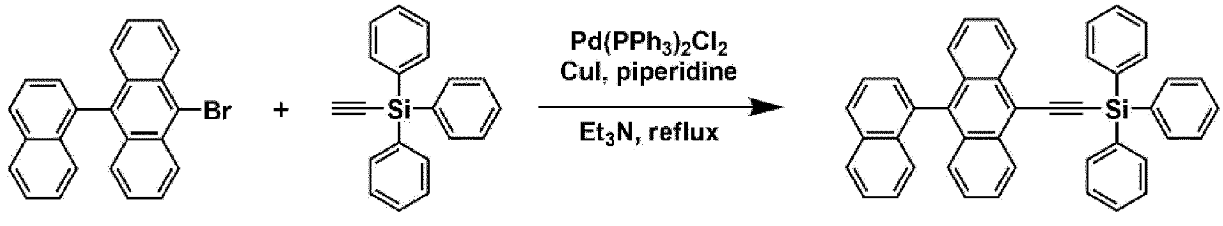


51

Compound 51 was synthesized in substantially the same manner as in Synthesis Example 1, except that 9-bromo-10-(naphthalen-1-yl)anthracene was used instead of 9-bromo-10-phenylanthracene. Yield: 32 %, LCMS[M+H, m/z] 587.2

Synthesis Example 4: Synthesis of Compound 56

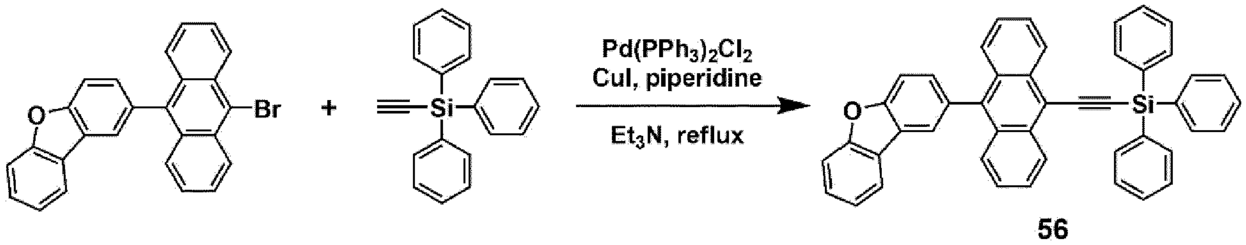


56

Compound 56 was synthesized in substantially the same manner as in Synthesis Example 1, except that 2-(10-bromoanthracen-9-yl)dibenzo[b,d]furan was used instead of 9-bromo-10-phenylanthracene. Yield: 35 %, LCMS[M+H, m/z] 627.2

Example 1

A patterned ITO glass substrate (50 millimeters (mm) × 50 mm × 0.7 mm) was sonicated in acetone, isopropyl alcohol, and distilled water for 20 minutes each, and heat-treated for 20 minutes at 250°C.

Thereafter, a hole injection layer was formed to have a thickness of about 100 Å on the ITO electrode (anode) on the glass substrate by depositing HATCN at a rate of 1 Å/sec. A hole transport layer was formed to have a thickness of about 800 Å on the hole injection layer by depositing NPB at a rate of 1 Å/sec.

Then, an electron blocking layer was formed to have a thickness of 50 Å on the hole transport layer by depositing mCP at a rate of 1 Å/sec.

An emission layer was formed to have a thickness of 200 Å on the electron blocking layer by co-depositing Compound 10 (as a host) and Compound D1 (as a dopant) at a deposition rate of 0.97 Å/sec and 0.3 Å/sec, respectively.

An electron transport layer was formed to have a thickness of 300 Å by depositing DPEPO and LiQ (1:1) on the emission layer at a deposition rate of 0.5 Å/sec. An electron injection layer was formed to have a thickness of 10 Å by depositing LiQ on the electron transport layer at a deposition rate of 0.5 Å/sec. A second electrode (cathode) was formed to have a thickness of 1,000 Å by vacuum-depositing aluminum (Al) on the electron injection layer, thereby completing the manufacture of an organic light-emitting device having a structure of ITO/HATCN (100 Å)/NPB (800 Å)/mCP (50 Å)/Compound 10 + Compound D1 (3 vol%) (200 Å)/DPEPO:LiQ (300 Å)/LiQ (10 Å)/Al (1,000 Å).

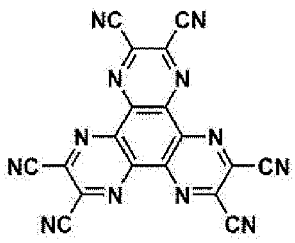
HATCN

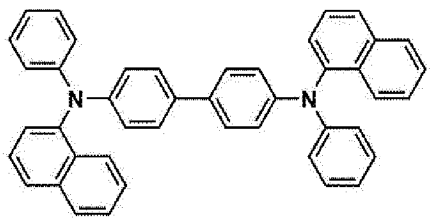
NPB

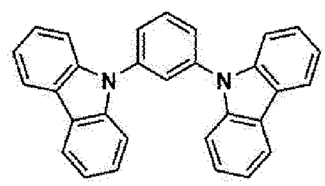
mCP

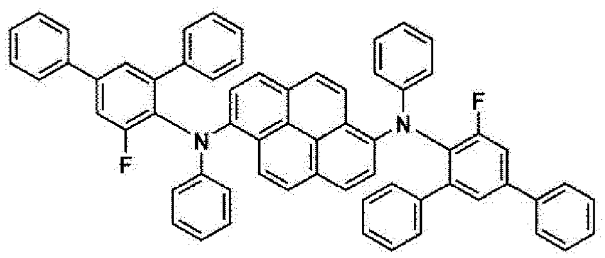
D1

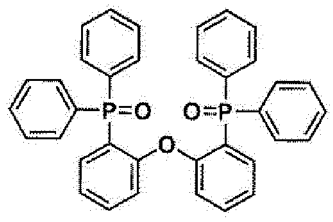
DPEPO

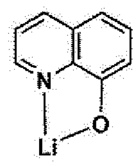
LiQ

Examples 2 to 4

Organic light-emitting devices were manufactured in substantially the same manner as in Example 1, except that the compounds shown in Table 1 were used instead of Compound 10 as a host in the formation of an emission layer.

Comparative Examples 1 and 2

Organic light-emitting devices were manufactured in the same manner as in Example 1, except that Compound A or Compound 10 was used as a single light-emitting material as shown in Table 1.

Evaluation Example 1: Evaluation of characteristics of organic light-emitting device

The external quantum efficiency (EQE), a TTF ratio, and lifespan ($T_{97}$) of the organic light-emitting devices of Examples 1 to 4 and Comparative Examples 1 and 2 were evaluated in relative values. The results thereof are shown in Table 1. A Keithley 2400 current voltmeter and a luminance meter (Minolta Cs-1000A) were used for the evaluation. The lifespan ($T_{97}$) refers to time required for the luminance of the organic light-emitting device to reduce from the initial luminance of 6,000 nits to 97 % thereof. The TTF ratio was measured as a $\gamma$-intercept value reciprocal squared value in the graph of 1/square root of the TrEL Intensity (1/sqrt (TrEL)) - time, in which the decay of transient electroluminescence (TrEL) was measured from 500 nanoseconds (ns) to 4,000 ns. In Table 1, "N.D." indicates "not detected".

Table 1

| No. | Emission layer Host | Emission layer Dopant | Driving voltage (relative value) | EQE (relative value) | Lifespan ($T_{97}$) (relative value) | TTF ratio (%) |
|---|---|---|---|---|---|---|
| Example 1 | Compound 10 | Compound D1 | 100 | 100 | 100 | 40.5 |
| Example 2 | Compound 24 | Compound D1 | 104.9 | 148.9 | 66.9 | 34.2 |
| Example 3 | Compound 51 | Compound D1 | 102.3 | 159.2 | 106.3 | 34.2 |
| Example 4 | Compound 56 | Compound D1 | 103.4 | 164.7 | 99.9 | 35.4 |
| Comparative Example 1 | - | Compound A | 116.4 | 97.6 | 0.5 | N.D. |
| Comparative Example 2 | - | Compound 10 | 105.5 | 110.3 | 2.0 | N.D. |

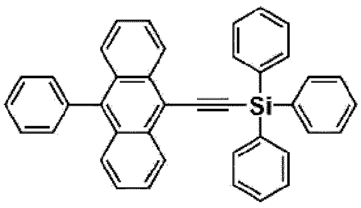

10

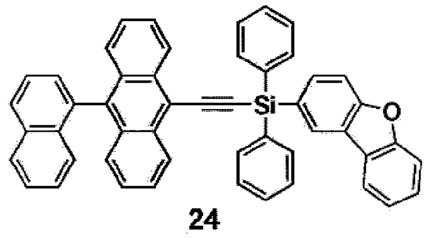

24

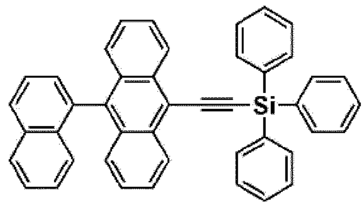

51

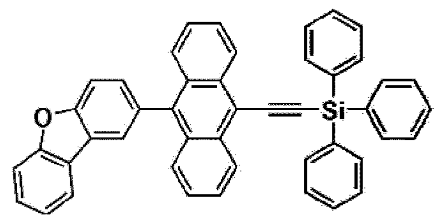

56

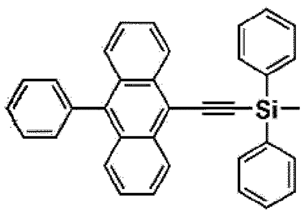

A

As shown in Table 1, the organic light-emitting devices of Examples 1 to 4 were each found to have a low driving voltage, an improved or equal level of EQE, significantly excellent or improved lifespan, and a high or improved TTF ratio, as compared with the organic light-emitting devices of Comparative Examples 1 and 2.

As apparent from the foregoing description, the silane compound was found to have excellent or improved electrical characteristics and thermal stability, and an organic light-emitting device including the silane compound as a host was found to have high or improved efficiency, long or improved lifespan, and a high or improved TTF ratio.

2. The scope of the present invention is defined by the appended claims.

## Claims

**1.** An organic light-emitting device comprising:

a first electrode;
a second electrode; and
an organic layer between the first electrode and the second electrode and comprising an emission layer, wherein the emission layer comprises a host and a dopant, characterized that
the host comprises at least one silane compound represented by Formula 1:

Formula 1

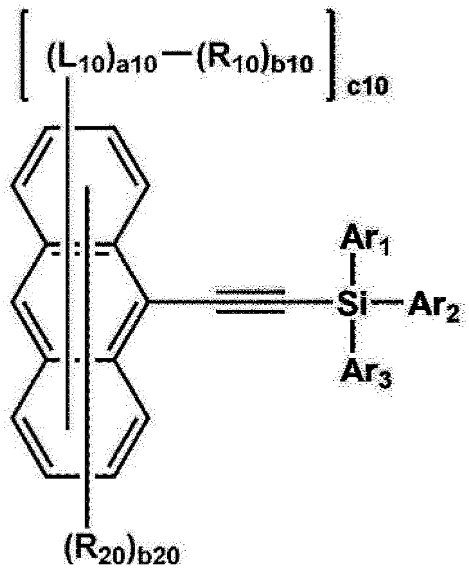

wherein, in Formula 1,
$Ar_1$ to $Ar_3$ are each independently a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-B(Q_6)(Q_7)$, or $-P(=O)(Q_8)(Q_9)$,
at least one of $Ar_1$ to $Ar_3$ is a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group,
$L_{10}$ is a substituted or unsubstituted $C_5$-$C_{30}$ carbocyclic group or a substituted or unsubstituted $C_1$-$C_{30}$ heterocyclic group,
a10 is an integer from 0 to 3, and when a10 is 2 or greater, at least two $L_{16}$(s) are identical to or different from each other,
$R_{10}$ and $R_{20}$ are each independently hydrogen, deuterium, -F, a cyano group, $-CD_3$, $-CD_2H$, $-CDH_2$, $-CF_3$, $-CF_2H$, $-CFH_2$, groups represented by Formulae 9-1 to 9-19, or groups represented by Formulae 10-1 to 10-211:

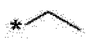
9-1
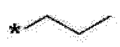
9-2
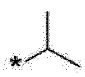
9-3
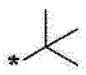
9-4
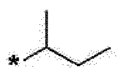
9-5
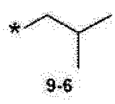
9-6
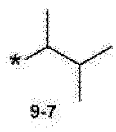
9-7

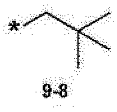
9-8
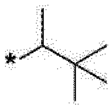
9-9
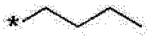
9-10
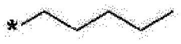
9-11
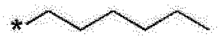
9-12

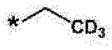
9-13
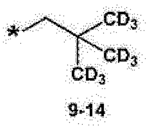
9-14
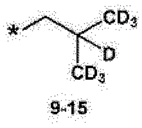
9-15
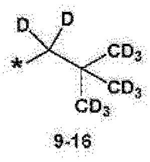
9-16
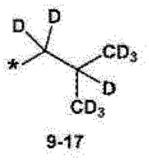
9-17
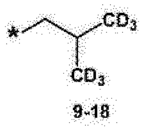
9-18

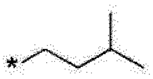
9-19

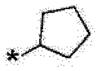
10-1
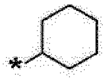
10-2
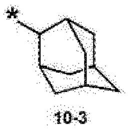
10-3
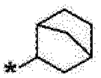
10-4
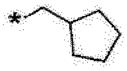
10-5
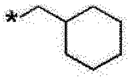
10-6
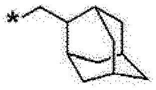
10-7

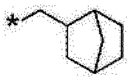
10-8
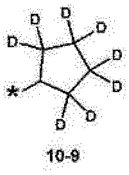
10-9
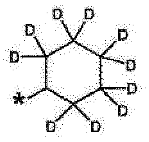
10-10
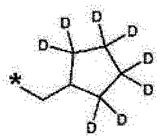
10-11
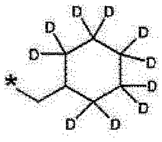
10-12
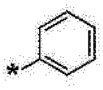
10-13

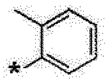
10-14
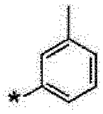
10-15
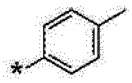
10-16
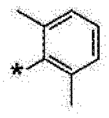
10-17
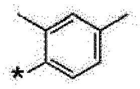
10-18
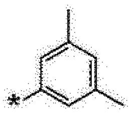
10-19
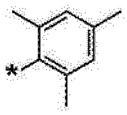
10-20

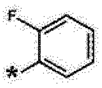
10-21
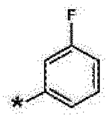
10-22
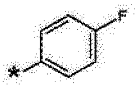
10-23
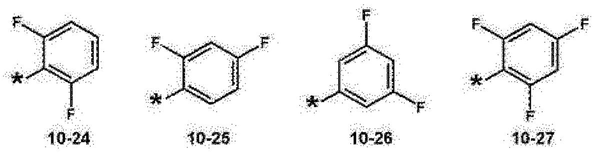
10-24
10-25
10-26
10-27

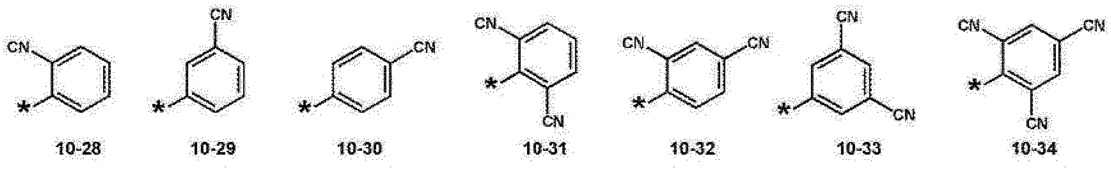
10-28
10-29
10-30
10-31
10-32
10-33
10-34

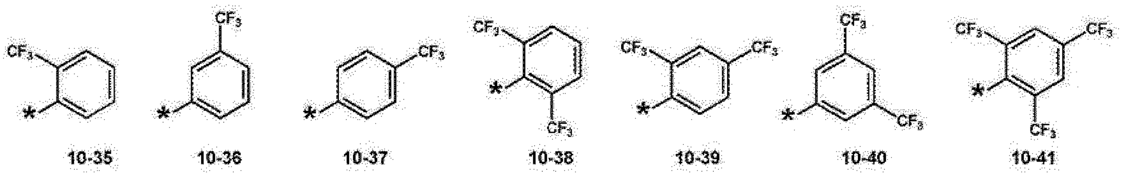
10-35
10-36
10-37
10-38
10-39
10-40
10-41

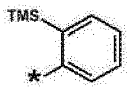
10-42
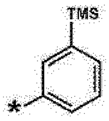
10-43
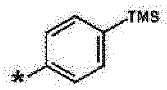
10-44
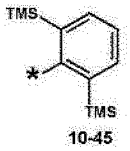
10-45
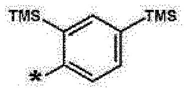
10-46
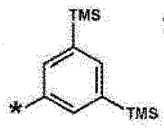
10-47
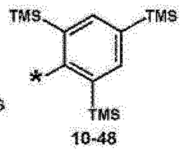
10-48

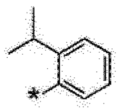
10-49
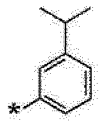
10-50
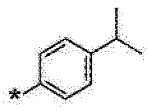
10-51
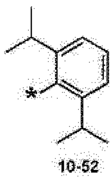
10-52
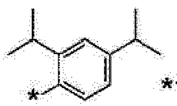
10-53
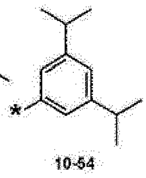
10-54
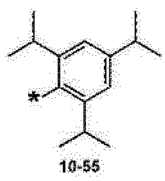
10-55

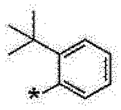
10-56
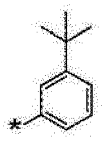
10-57
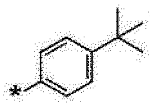
10-58
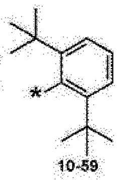
10-59
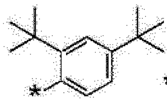
10-60
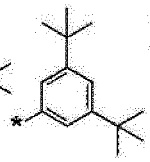
10-61
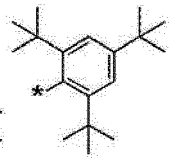
10-62

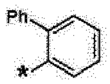
10-63
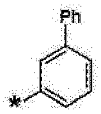
10-64
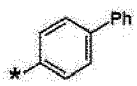
10-65
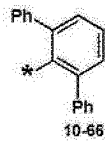
10-66
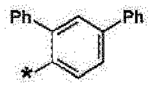
10-67
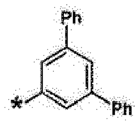
10-68
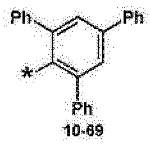
10-69

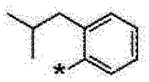
10-70
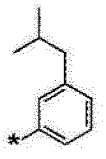
10-71
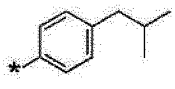
10-72
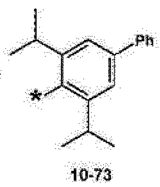
10-73
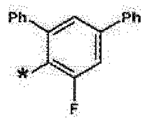
10-74
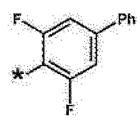
10-75

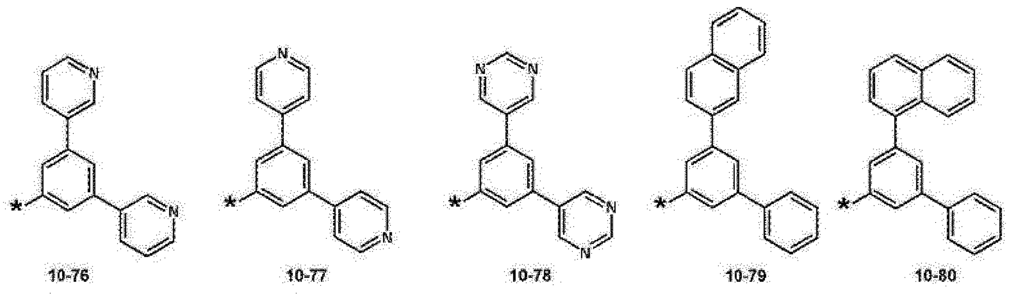
10-76 10-77 10-78 10-79 10-80

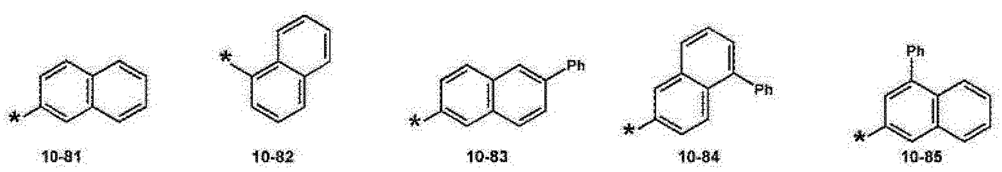
10-81 10-82 10-83 10-84 10-85

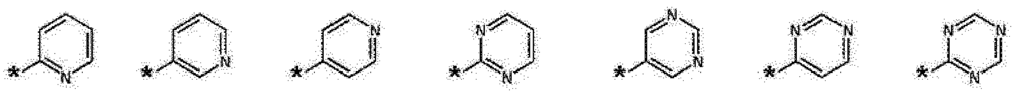
10-86 10-87 10-88 10-89 10-90 10-91 10-92

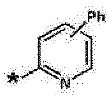
10-93
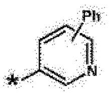
10-94
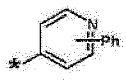
10-95
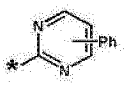
10-96
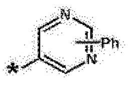
10-97
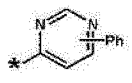
10-98
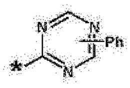
10-99

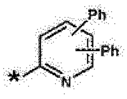
10-100
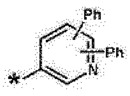
10-101
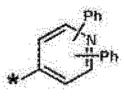
10-102
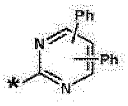
10-103
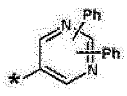
10-104
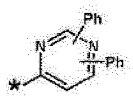
10-105
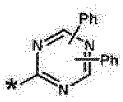
10-106

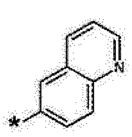
10-107
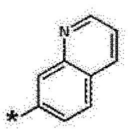
10-108
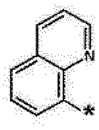
10-109
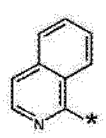
10-110
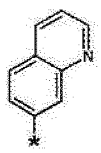
10-111
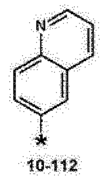
10-112

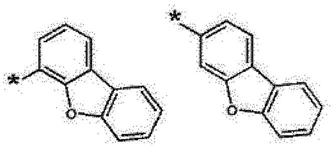
10-113
10-114
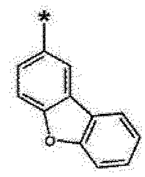
10-115
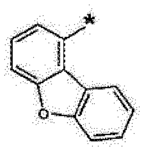
10-116
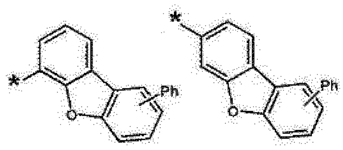
10-117
10-118

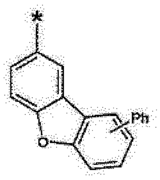
10-119
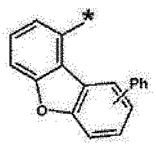
10-120
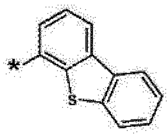
10-121
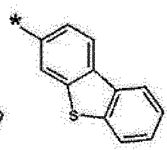
10-122
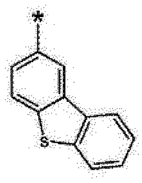
10-123
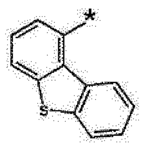
10-124

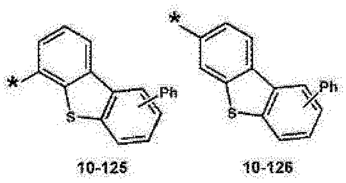
10-125
10-126
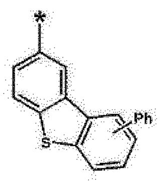
10-127
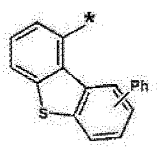
10-128
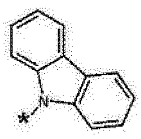
10-129
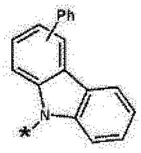
10-130

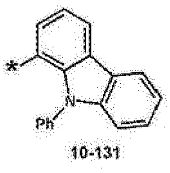
10-131
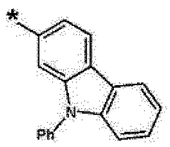
10-132
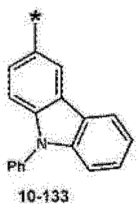
10-133
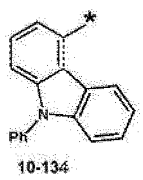
10-134
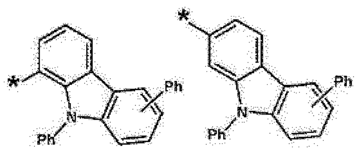
10-135
10-136

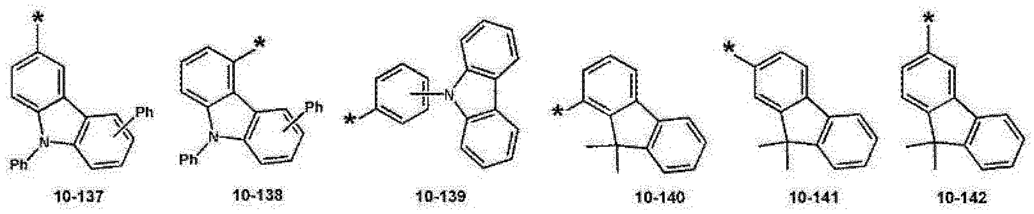

10-137 10-138 10-139 10-140 10-141 10-142

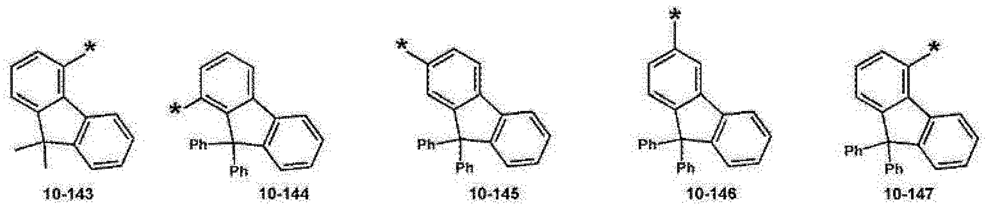

10-143 10-144 10-145 10-146 10-147

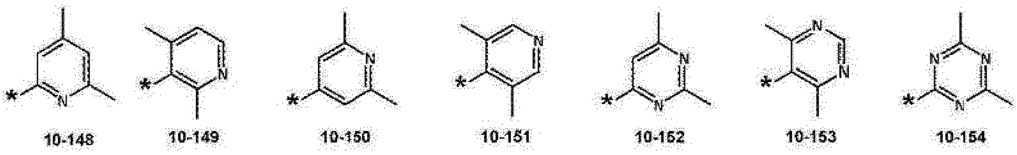

10-148 10-149 10-150 10-151 10-152 10-153 10-154

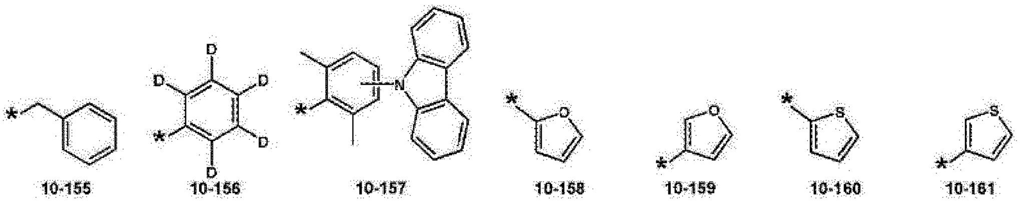

10-155 10-156 10-157 10-158 10-159 10-160 10-161

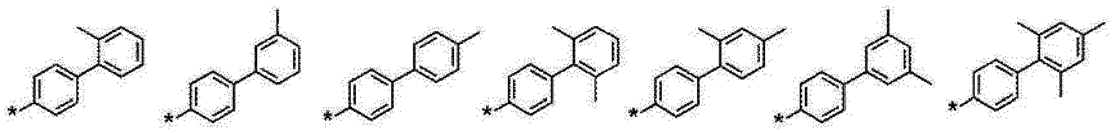

10-162 10-163 10-164 10-165 10-166 10-167 10-168

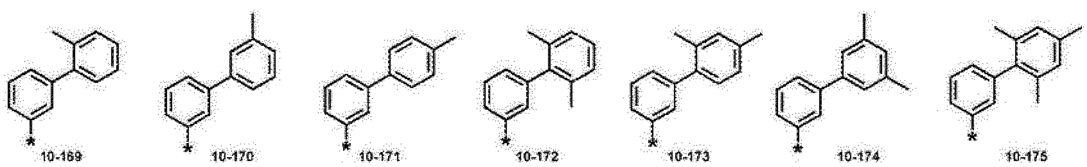

10-169 10-170 10-171 10-172 10-173 10-174 10-175

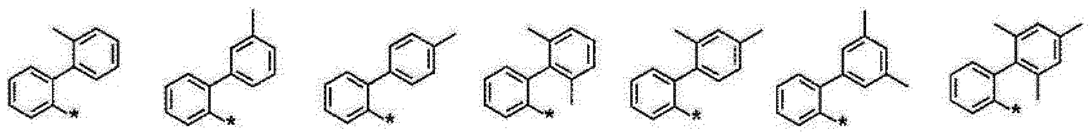

10-176 10-177 10-178 10-179 10-180 10-181 10-182

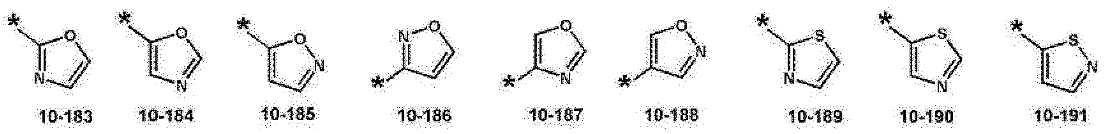

10-183 10-184 10-185 10-186 10-187 10-188 10-189 10-190 10-191

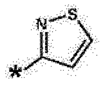
10-192
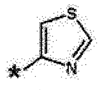
10-193
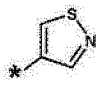
10-194

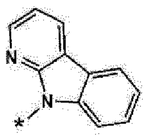
10-195
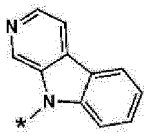
10-196
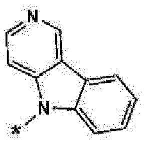
10-197
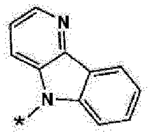
10-198
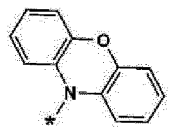
10-200
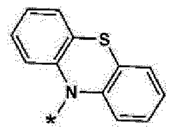
10-201

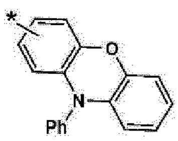
10-202
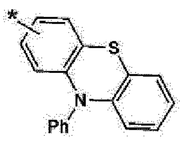
10-203
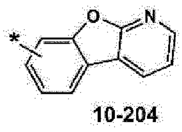
10-204
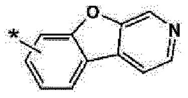
10-205
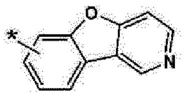
10-206

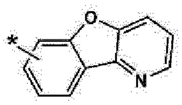
10-207
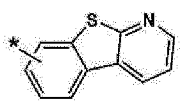
10-208
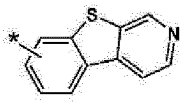
10-209
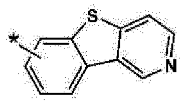
10-210
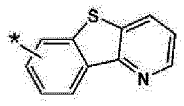
10-211

wherein, in Formulae 9-1 to 9-19 and 10-1 to 10-211, * indicates a binding site to an adjacent atom, "Ph" represents a phenyl group, and "TMS" represents a trimethylsilyl group,
b10 and b20 are each independently an integer from 1 to 8,
when b10 is 2 or greater, at least two $R_{10}$(s) are identical to or different from each other, and when b20 is 2 or greater, at least two $R_{20}$(s) are identical to or different from each other,
c10 is an integer from 1 to 9,
when c10 is 2 or greater, at least two $-[(L_{10})_{a10}-(R_{10})_{b10}]$(s) are identical to or different from each other,
at least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group is:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkylthio group, or a $C_1$-$C_{60}$ alkoxy group;
a $C_1$-$C_{60}$ alkyl group, a $C_2$-$C_{60}$ alkenyl group, a $C_2$-$C_{60}$ alkynyl group, a $C_1$-$C_{60}$ alkylthio group, or a $C_1$-$C_{60}$ alkoxy group, each independently substituted with at least one of deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-Si(Q_{11})(Q_{12})(Q_{13})$, $-N(Q_{14})(Q_{15})$, or $-B(Q_{16})(Q_{17})$;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed

polycyclic group, or a monovalent non-aromatic condensed heteropolycyclic group;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each independently substituted with at least one of deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-Si(Q_{21})(Q_{22})(Q_{23})$, $-N(Q_{24})(Q_{25})$, or $-B(Q_{26})(Q_{27})$; or
$-Si(Q_{31})(Q_{32})(Q_{33})$, $-N(Q_{34})(Q_{35})$, or $-B(Q_{36})(Q_{37})$,
wherein $Q_1$ to $Q_9$, $Q_{11}$ to $Q_{17}$, $Q_{21}$ to $Q_{27}$, and $Q_{31}$ to $Q_{37}$ are each independently hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{13}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group, and
wherein substituents $L_{10}$, $R_{10}$, and $R_{20}$ are present on each ring through which the bond with the corresponding substituent passes.

**2.** The organic light-emitting device of claim 1, wherein $Ar_1$ to $Ar_3$ are each independently:

a $C_1$-$C_{20}$ alkyl group, a $C_1$-$C_{20}$ alkylthio group, or a $C_1$-$C_{20}$ alkoxy group;
a $C_1$-$C_{20}$ alkyl group, a $C_1$-$C_{20}$ alkylthio group, or a $C_1$-$C_{20}$ alkoxy group, each independently substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a phenyl group, a naphthyl group, a pyridinyl group, a pyrimidinyl group, a pyrazinyl group, a pyridazinyl group, or a triazinyl group;
a cyclopentyl group, a cyclohexyl group, a cyclopentenyl group, a cyclohexenyl group, a cycloheptenyl group, a phenyl group, a pentalenyl group, an indenyl group, a naphthyl group, an azulenyl group, a heptalenyl group, an indacenyl group, an acenaphthyl group, a fluorenyl group, a spiro-bifluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pyrrolyl group, an imidazolyl group, a pyrazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoxazolyl group, a benzimidazolyl group, a furanyl group, a benzofuranyl group, a thiophenyl group, a benzothiophenyl group, a thiazolyl group, an isothiazolyl group, a benzothiazolyl group, an isoxazolyl group, an oxazolyl group, a triazolyl group, a tetrazolyl group, an oxadiazolyl group, a triazinyl group, a carbazolyl group, a dibenzofuranyl group, a dibenzothiophenyl group, a benzocarbazolyl group, an azacarbazolyl group, an azadibenzofuranyl group, an azadibenzothiophenyl group, a phenoxazinyl group, a phenothiazinyl group, an imidazopyrimidinyl group, or an imidazopyridinyl group; and
a cyclopentyl group, a cyclohexyl group, a cyclopentenyl group, a cyclohexenyl group, a cycloheptenyl group, a phenyl group, a pentalenyl group, an indenyl group, a naphthyl group, an azulenyl group, a heptalenyl group, an indacenyl group, an acenaphthyl group, a fluorenyl group, a spiro-bifluorenyl group, a phenalenyl group, a phenanthrenyl group, an anthracenyl group, a fluoranthenyl group, a triphenylenyl group, a pyrenyl group, a

chrysenyl group, a naphthacenyl group, a picenyl group, a perylenyl group, a pentaphenyl group, a hexacenyl group, a pyrrolyl group, an imidazolyl group, a pyrazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoxazolyl group, a benzimidazolyl group, a furanyl group, a benzofuranyl group, a thiophenyl group, a benzothiophenyl group, a thiazolyl group, an isothiazolyl group, a benzothiazolyl group, an isoxazolyl group, an oxazolyl group, a triazolyl group, a tetrazolyl group, an oxadiazolyl group, a triazinyl group, a carbazolyl group, a dibenzofuranyl group, a dibenzothiophenyl group, a benzocarbazolyl group, an azacarbazolyl group, an azadibenzofuranyl group, an azadibenzothiophenyl group, a phenoxazinyl group, a phenothiazinyl group, an imidazopyrimidinyl group, or an imidazopyridinyl group, each independently substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_2$-$C_{20}$ alkenyl group, a $C_2$-$C_{20}$ alkynyl group, a $C_1$-$C_{20}$ alkoxy group, a $C_1$-$C_{20}$ alkylthio group, a phenyl group, a naphthyl group, an anthracenyl group, a pyrenyl group, a phenanthrenyl group, a fluorenyl group, a pyridinyl group, a pyrimidinyl group, a pyrazinyl group, a pyridazinyl group, a triazinyl group, a quinolinyl group, an isoquinolinyl group, a phthalazinyl group, a quinoxalinyl group, a cinnolinyl group, or a quinazolinyl group.

**3.** The organic light-emitting device of claims 1 or 2, wherein $Ar_1$ to $Ar_3$ are each independently:

a cyclopentyl group, a cyclohexyl group, a cyclopentenyl group, a cyclohexenyl group, a cycloheptenyl group, a phenyl group, a pentalenyl group, an indenyl group, a naphthyl group, an azulenyl group, a heptalenyl group, an indacenyl group, an acenaphthyl group, a fluorenyl group, a spiro-bifluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pyrrolyl group, an imidazolyl group, a pyrazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoxazolyl group, a benzimidazolyl group, a furanyl group, a benzofuranyl group, a thiophenyl group, a benzothiophenyl group, a thiazolyl group, an isothiazolyl group, a benzothiazolyl group, an isoxazolyl group, an oxazolyl group, a triazolyl group, a tetrazolyl group, an oxadiazolyl group, a triazinyl group, a carbazolyl group, a dibenzofuranyl group, a dibenzothiophenyl group, a benzocarbazolyl group, an azacarbazolyl group, an azadibenzofuranyl group, an azadibenzothiophenyl group, a phenoxazinyl group, a phenothiazinyl group, an imidazopyrimidinyl group, or an imidazopyridinyl group; and
a cyclopentyl group, a cyclohexyl group, a cyclopentenyl group, a cyclohexenyl group, a cycloheptenyl group, a phenyl group, a pentalenyl group, an indenyl group, a naphthyl group, an azulenyl group, a heptalenyl group, an indacenyl group, an acenaphthyl group, a fluorenyl group, a spiro-bifluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pyrrolyl group, an imidazolyl group, a pyrazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoxazolyl group, a benzimidazolyl group, a furanyl group, a benzofuranyl group, a thiophenyl group, a benzothiophenyl group, a thiazolyl group, an isothiazolyl group, a benzothiazolyl group, an isoxazolyl group, an oxazolyl group, a triazolyl group, a tetrazolyl group, an oxadiazolyl group, a triazinyl group, a carbazolyl group, a dibenzofuranyl group, a dibenzothiophenyl group, a benzocarbazolyl group, an azacarbazolyl group, an azadibenzofuranyl group, an azadibenzothiophenyl group, a phenoxazinyl group, a phenothiazinyl group, an imidazopyrimidinyl group, or an imidazopyridinyl group, each independently substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_2$-$C_{20}$ alkenyl group, a $C_2$-$C_{20}$ alkynyl group, a $C_1$-$C_{20}$ alkoxy group, a $C_1$-$C_{20}$ alkylthio group, a phenyl group, a naphthyl group, an anthracenyl group, a pyrenyl group, a phenanthrenyl group, a fluorenyl group, a pyridinyl group, a pyrimidinyl group, a pyrazinyl group, a pyridazinyl group, a triazinyl group, a quinolinyl group, an isoquinolinyl group, a phthalazinyl group, a quinoxalinyl group, a cinnolinyl group, or a quinazolinyl group.

**4.** The organic light-emitting device of any of claims 1-3, wherein $L_{10}$ is:

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, a pentacenylene group, a carbazolylene group, a dibenzofuranylene group, a dibenzothiophenylene group, a dibenzosilolylene group, a benzocarbazolylene group, a pyridinylene group, a pyrimidinylene group, a triazinylene group, a quinolinylene group, an isoquinolinylene group, a benzoquinolinylene group, a phthalazinylene group, a naphthyridinylene group, a quinoxalinylene group, a quinazolinylene group, a phenanthridinylene group, an acridinylene group, a phenanthrolinylene group, a phenazinylene group, a phenoxazinylene group, a phenothiazinylene group, an azacarbazolylene group, an azadibenzofuranylene group, or an azadibenzothiophenylene group;

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, a pentacenylene group, a carbazolylene group, a dibenzofuranylene group, a dibenzothiophenylene group, a dibenzosilolylene group, a benzocarbazolylene group, a pyridinylene group, a pyrimidinylene group, a triazinylene group, a quinolinylene group, an isoquinolinylene group, a benzoquinolinylene group, a phthalazinylene group, a naphthyridinylene group, a quinoxalinylene group, a quinazolinylene group, a phenanthridinylene group, an acridinylene group, a phenanthrolinylene group, a phenazinylene group, a phenoxazinylene group, a phenothiazinylene group, an azacarbazolylene group, an azadibenzofuranylene group, or an azadibenzothiophenylene group, each independently substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group; or

a group represented by Formula 2A or Formula 2B:

Formula 2A

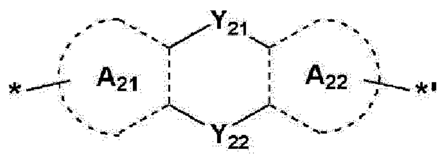

Formula 2B

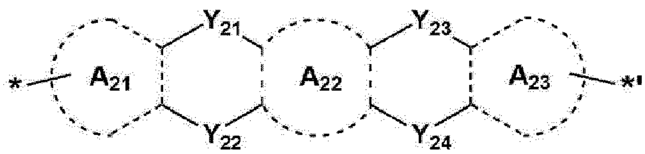

wherein, in Formulae 2A and 2B,

$Y_{21}$ to $Y_{24}$ are each independently a single bond, O, S, N($R_{21}$), C($R_{21}$)($R_{22}$), Si($R_{21}$)($R_{22}$), C(=O), S(=O), S(=O)$_2$, B($R_{21}$), P($R_{21}$), or P(=O)($R_{21}$),

$A_{21}$ to $A_{23}$ are each independently a phenyl group, a naphthalene group, a 1,2,3,4-tetrahydronaphthalene group, a phenanthrene group, a pyridine group, a pyrimidine group, a pyrazine group, a triazine group, a quinoline group, an isoquinoline group, a quinoxaline group, a quinazoline group, a phenanthroline group, a benzofuran group, a benzothiophene group, a fluorene group, a carbazole group, a dibenzofuran group, a dibenzothiophene group, a dibenzosilole group, an azafluorene group, an azacarbazole group, an azadibenzofuran group, an azadibenzothiophene group, or an azadibenzosilole group,

$R_{21}$ and $R_{22}$ are each independently understood by referring to the description of $R_{10}$ or $R_{20}$ in claim 1, and * and *' each indicate a binding site to an adjacent atom.

**5.** The organic light-emitting device of any of claims 1-4, wherein a10 is 0 or 1.

**6.** The organic light-emitting device of any of claims 1-5, wherein $R_{10}$ and $R_{20}$ are each independently:

hydrogen, deuterium, -F, a cyano group, $-CD_3$, $-CD_2H$, $-CDH_2$, $-CF_3$, $-CF_2H$, $-CFH_2$, $C_1$-$C_{20}$ alkyl group, a $C_1$-$C_{20}$ alkylthio group, or a $C_1$-$C_{20}$ alkoxy group;
a $C_1$-$C_{20}$ alkyl group, a $C_1$-$C_{20}$ alkylthio group, or a $C_1$-$C_{20}$ alkoxy group, each independently substituted with at least one of deuterium, -F, a cyano group, a phenyl group, a biphenyl group, a terphenyl group, or a naphthyl group;
a cyclopentyl group, a cyclohexyl group, a cyclopentenyl group, a cyclohexenyl group, a cycloheptenyl group, a phenyl group, a biphenyl group, a terphenyl group, a naphthyl group, a fluorenyl group, a carbazolyl group, a dibenzofuranyl group, or a dibenzothiophenyl group; or
a cyclopentyl group, a cyclohexyl group, a cyclopentenyl group, a cyclohexenyl group, a cycloheptenyl group, a phenyl group, a biphenyl group, a terphenyl group, a naphthyl group, a fluorenyl group, a carbazolyl group, a dibenzofuranyl group, or a dibenzothiophenyl group, each independently substituted with at least one of deuterium, a cyano group, a $C_1$-$C_{20}$ alkyl group, a $C_1$-$C_{20}$ alkoxy group, a $C_1$-$C_{20}$ alkylthio group, a phenyl group, a biphenyl group, a terphenyl group, or a naphthyl group.

**7.** The organic light-emitting device of any of claims 1-6, wherein $R_{10}$ is:

deuterium, -F, a cyano group, $-CD_3$, $-CD_2H$, $-CDH_2$, $-CF_3$, $-CF_2H$, $-CFH_2$, a $C_1$-$C_{20}$ alkyl group, a $C_1$-$C_{20}$ alkylthio group, or a $C_1$-$C_{20}$ alkoxy group;
a $C_1$-$C_{20}$ alkyl group, a $C_1$-$C_{20}$ alkylthio group, or a $C_1$-$C_{20}$ alkoxy group, each independently substituted with at least one of deuterium, a cyano group, a phenyl group, a biphenyl group, a terphenyl group, or a naphthyl group;
a cyclopentyl group, a cyclohexyl group, a cyclopentenyl group, a cyclohexenyl group, a cycloheptenyl group, a phenyl group, a biphenyl group, a terphenyl group, a naphthyl group, a fluorenyl group, a carbazolyl group, a dibenzofuranyl group, a dibenzothiophenyl group, a benzocarbazolyl group, an azacarbazolyl group, an azadibenzofuranyl group, an azadibenzothiophenyl group, a phenoxazinyl group, or a phenothiazinyl group; or
a cyclopentyl group, a cyclohexyl group, a cyclopentenyl group, a cyclohexenyl group, a cycloheptenyl group, a phenyl group, a biphenyl group, a terphenyl group, a naphthyl group, a fluorenyl group, a carbazolyl group, a dibenzofuranyl group, a dibenzothiophenyl group, a benzocarbazolyl group, an azacarbazolyl group, an azadibenzofuranyl group, an azadibenzothiophenyl group, a phenoxazinyl group, or a phenothiazinyl group, each independently substituted with at least one of deuterium, a cyano group, a $C_1$-$C_{20}$ alkyl group, a $C_1$-$C_{20}$ alkoxy group, a $C_1$-$C_{20}$ alkylthio group, a phenyl group, a biphenyl group, a terphenyl group, a naphthyl group, a carbazole group, a dibenzofuranyl group, or a dibenzothiophenyl group, and
$R_{20}$ is hydrogen, deuterium, -F, a cyano group, $-CD_3$, $-CD_2H$, $-CDH_2$, $-CF_3$, $-CF_2H$, $-CFH_2$, a $C_1$-$C_{20}$ alkyl group, or a phenyl group.

**8.** The organic light-emitting device of any of claims 1-7, wherein c10 is 1.

**9.** The organic light-emitting device of any of claims 1-8, wherein the silane compound represented by Formula 1 is represented by one of Formulae 10-1 to 10-5:

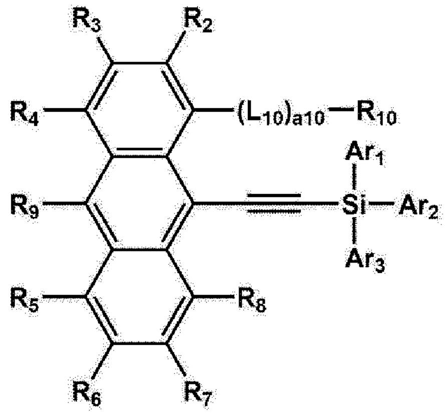

10-1

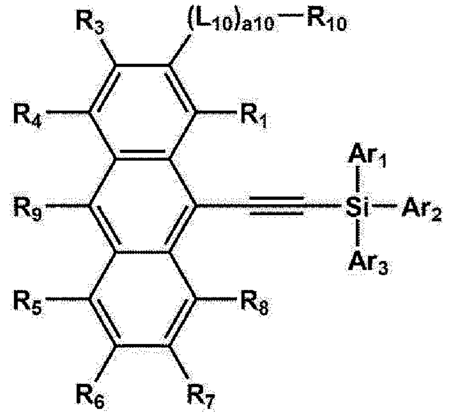

10-2

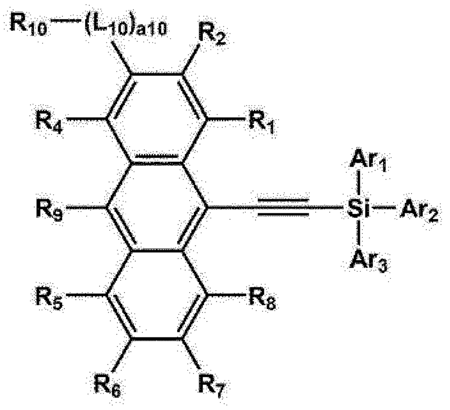

10-3

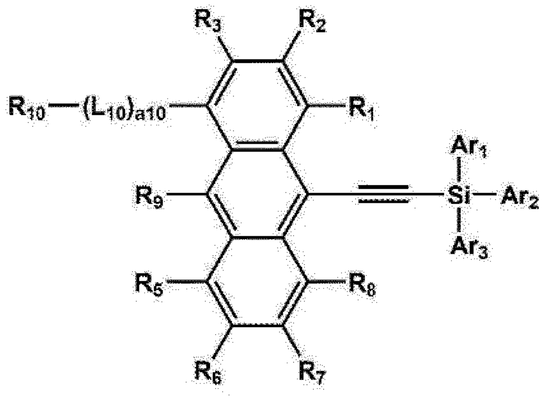

10-4

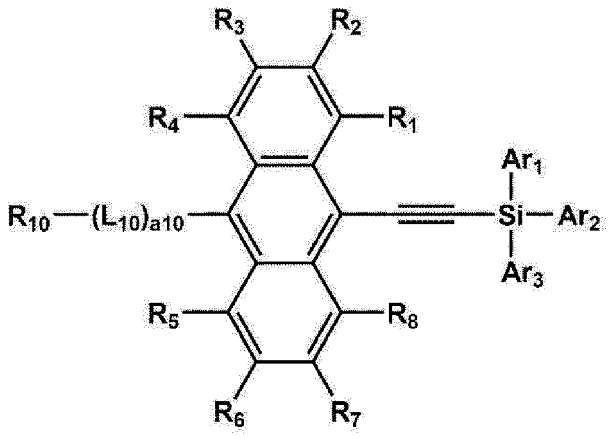

10-5

wherein, in Formulae 10-1 to 10-5,

$Ar_1$ to $Ar_3$, $L_{10}$, a10, and $R_{10}$ are respectively understood by referring to the descriptions of $Ar_1$ to $Ar_3$, $L_{10}$, a10, and $R_{10}$ in claim 1, and

$R_1$ to $R_9$ are each independently understood by referring to the description of $R_{20}$ in claim 1;

preferably wherein the silane compound represented by Formula 1 is a compound represented by Formula 10-5, and

$R_{10}$ is:

deuterium, -F, a cyano group, $-CD_3$, $-CD_2H$, $-CDH_2$, $-CF_3$, $-CF_2H$, $-CFH_2$, a $C_1$-$C_{20}$ alkyl group, a $C_1$-$C_{20}$ alkylthio group, or a $C_1$-$C_{20}$ alkoxy group;

a $C_1$-$C_{20}$ alkyl group, a $C_1$-$C_{20}$ alkylthio group, or a $C_1$-$C_{20}$ alkoxy group, each independently substituted with at least one of deuterium, a cyano group, a phenyl group, a biphenyl group, a terphenyl group, or a naphthyl group;

a cyclopentyl group, a cyclohexyl group, a cyclopentenyl group, a cyclohexenyl group, a cycloheptenyl group, a phenyl group, a biphenyl group, a terphenyl group, a naphthyl group, a fluorenyl group, a carbazolyl group, a dibenzofuranyl group, a dibenzothiophenyl group, a benzocarbazolyl group, an azacarbazolyl group, an azadibenzofuranyl group, an azadibenzothiophenyl group, a phenoxazinyl group, or a phenothiazinyl group; or

a cyclopentyl group, a cyclohexyl group, a cyclopentenyl group, a cyclohexenyl group, a cycloheptenyl group, a phenyl group, a biphenyl group, a terphenyl group, a naphthyl group, a fluorenyl group, a carbazolyl group, a dibenzofuranyl group, a dibenzothiophenyl group, a benzocarbazolyl group, an azacarbazolyl group, an azadibenzofuranyl group, an azadibenzothiophenyl group, a phenoxazinyl group, or a phenothiazinyl group, each independently substituted with at least one of deuterium, a cyano group, a $C_1$-$C_{20}$ alkyl group, a $C_1$-$C_{20}$ alkoxy group, a $C_1$-$C_{20}$ alkylthio group, a phenyl group, a biphenyl group, a terphenyl group, a naphthyl group, a carbazole group, a dibenzofuranyl group, or a dibenzothiophenyl group.

**10.** The organic light-emitting device of any of claims 1-9, wherein the silane compound represented by Formula 1 satisfies Equation 1:

Equation 1

$$E(T1) < E(S1) < 2 \times E(T1)$$

wherein, in Equation 1,
E(T1) indicates a lowest excited triplet energy level of the silane compound, and E(S1) indicates a lowest excited singlet energy level of the silane compound.

**11.** The organic light-emitting device of any of claims 1-10, wherein the silane compound represented by Formula 1 satisfies Equation 2:

Equation 2

$$[\,2 \times E(T1)\,] - E(S1) < 1 \text{ electronvolt}$$

wherein, in Equation 2,
E(T1) indicates a lowest excited triplet energy level of the silane compound, and E(S1) indicates a lowest excited singlet energy level of the silane compound.

**12.** The organic light-emitting device of claim 1, wherein the silane compound represented by Formula 1 is one of Compounds 1-16,18-121,123-130,145-160:

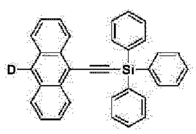
1

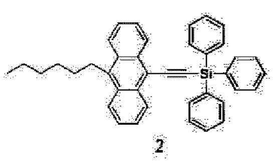
2

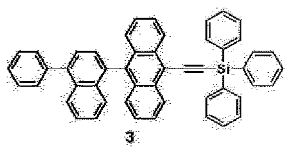
3

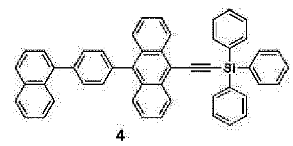
4

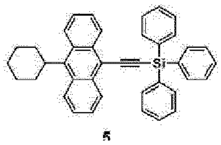
5

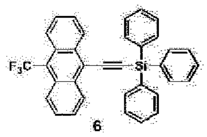
6

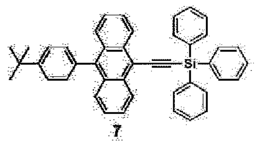
7

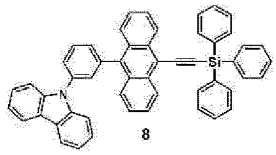
8

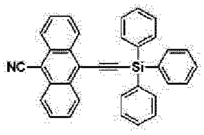
9

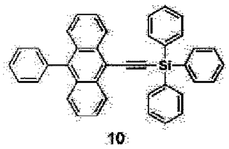
10

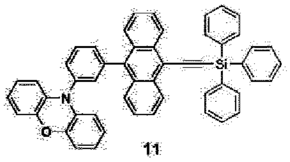
11

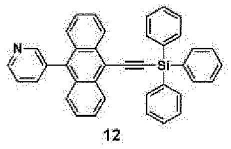
12

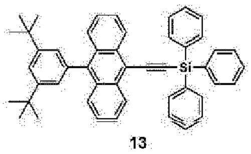
13

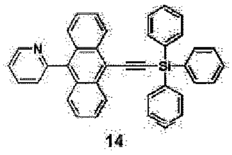
14

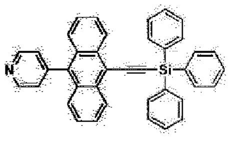
15

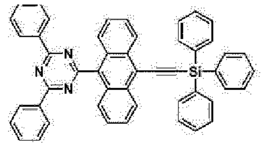
16

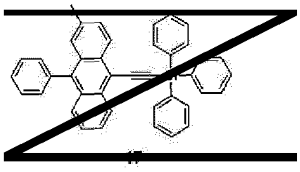
17

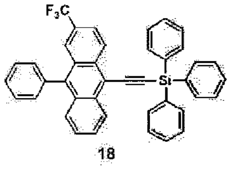
18

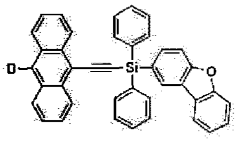
19

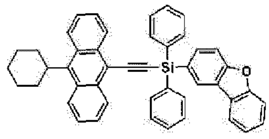
20

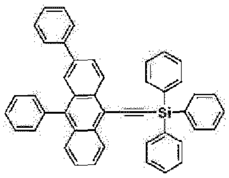
21

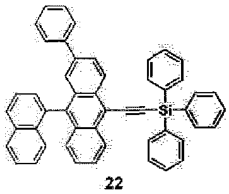
22

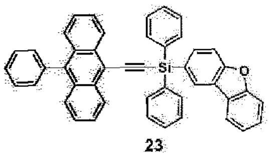
23

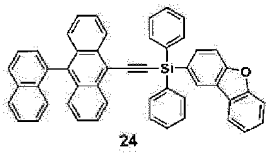
24

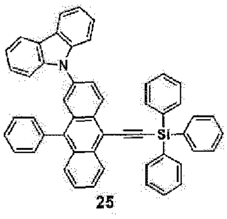
25

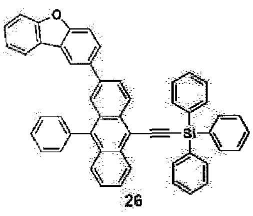
26

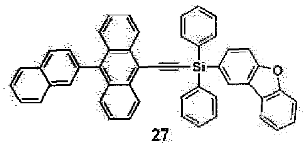
27

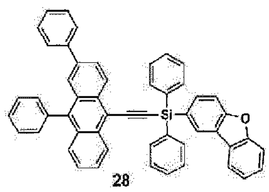
28

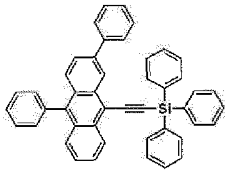
29

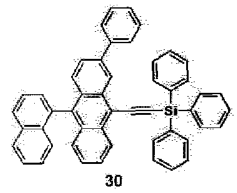
30

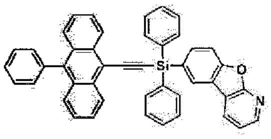
31

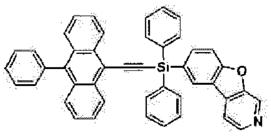
32

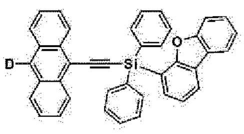
33

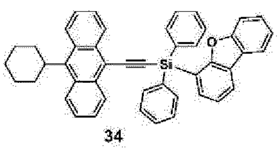
34

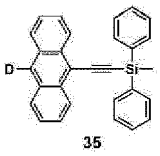
35

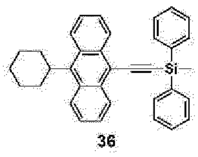
36

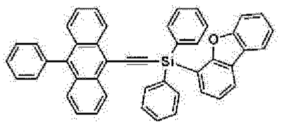
37

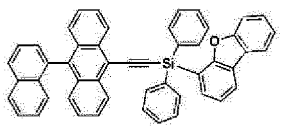
38

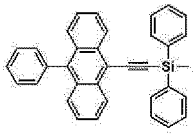
39

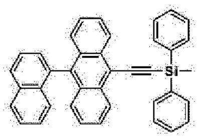
40

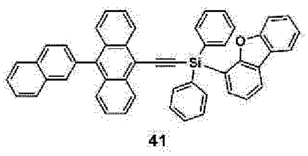
41

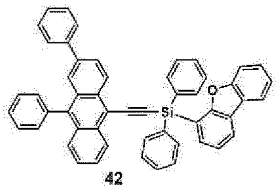
42

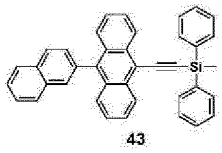
43

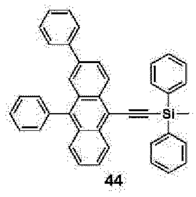
44

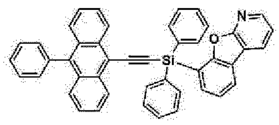
45

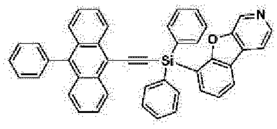
46

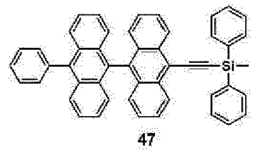
47

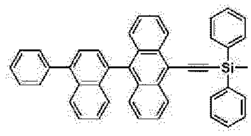
48

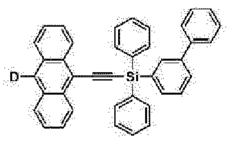
49

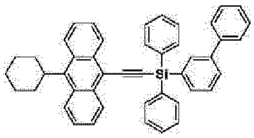
50

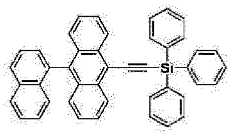
51

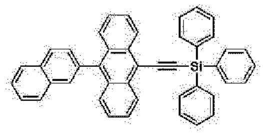
52

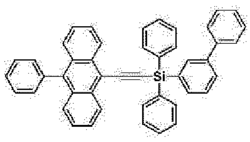
53

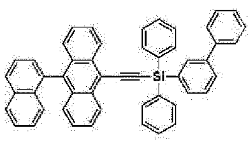
54

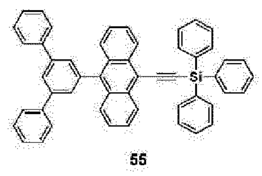
55

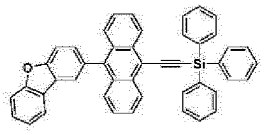
56

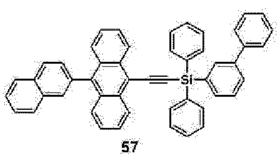
57

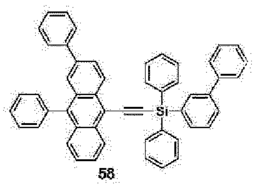
58

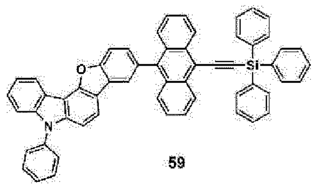
59

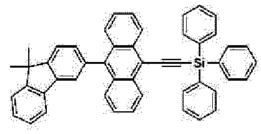
60

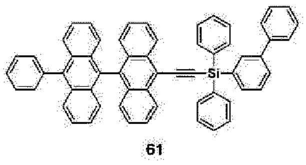
61

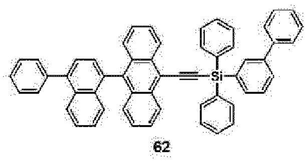
62

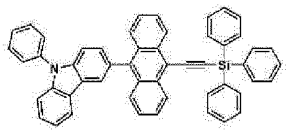
63

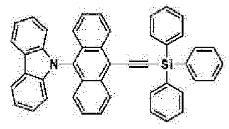
64

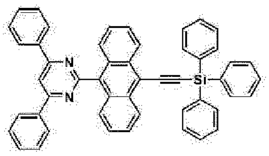
65

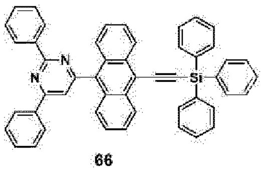
66

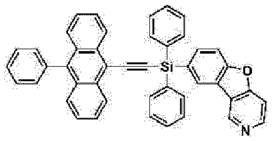
67

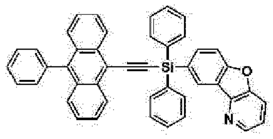
68

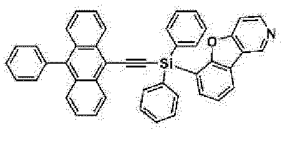
69

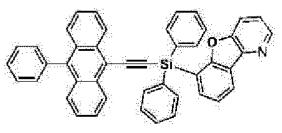
70

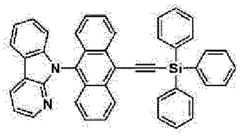
71

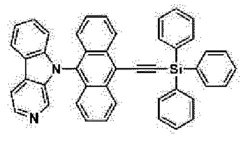
72

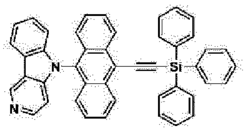
73

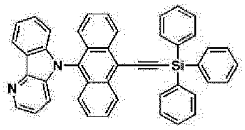
74

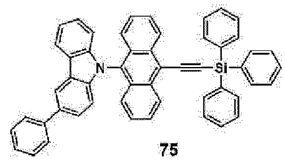
75

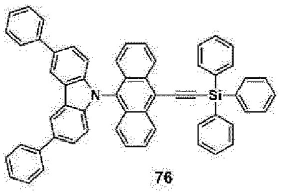
76

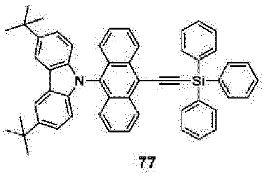
77

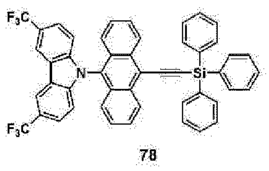
78

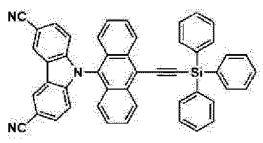
79

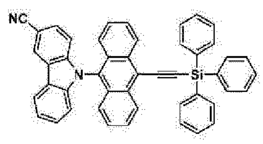
80

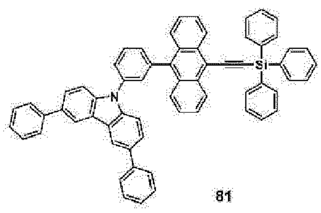
81

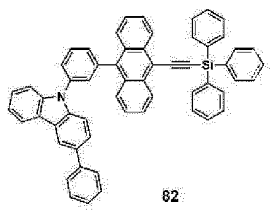
82

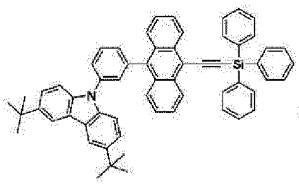
83

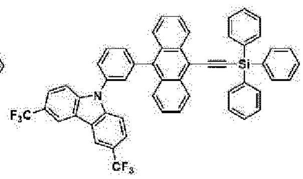
84

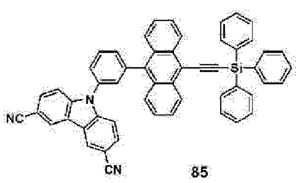
85

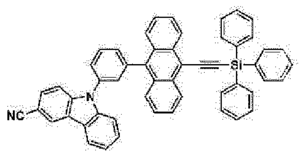
86

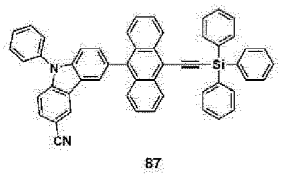
87

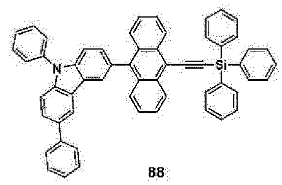
88

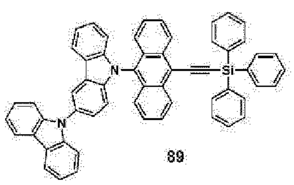
89

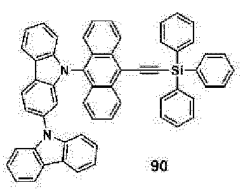
90

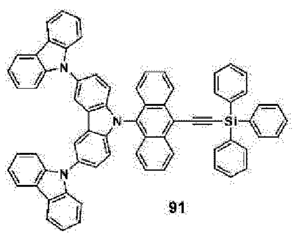
91

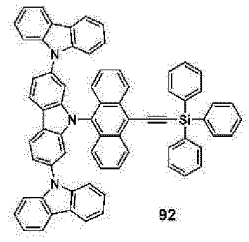
92

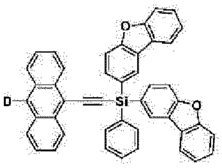
93

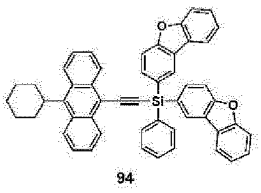
94

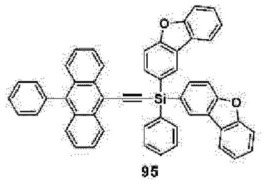
95

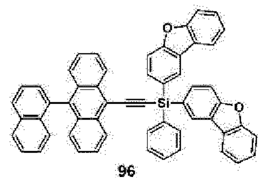
96

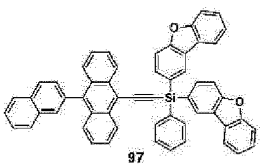
97

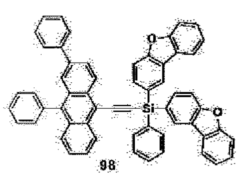
98

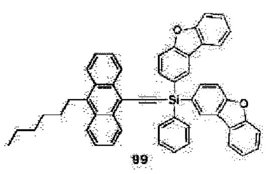
99

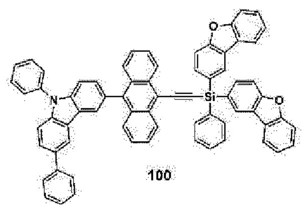
100

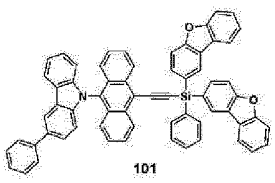
101

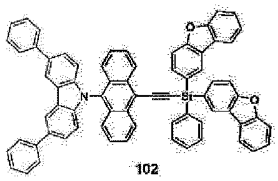
102

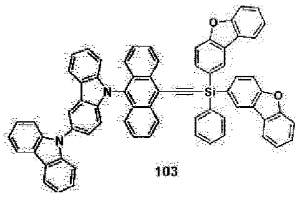
103

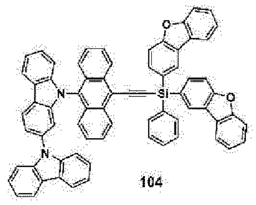
104

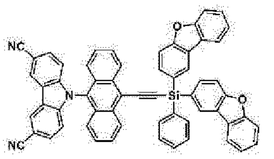
105

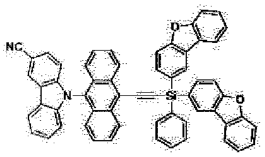
106

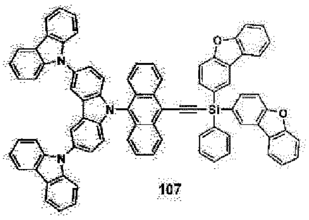
107

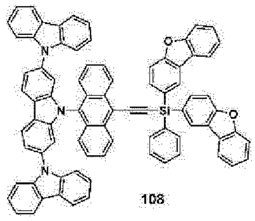
108

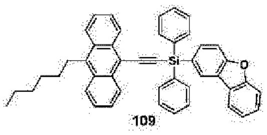
109

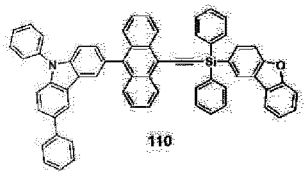
110

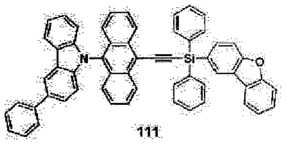
111

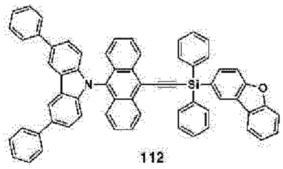
112

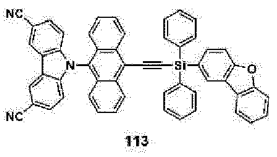
113

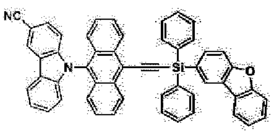
114

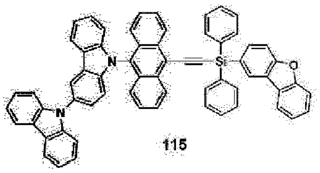
115

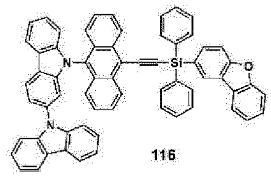
116

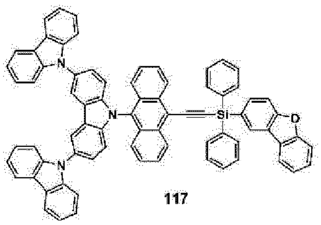
117

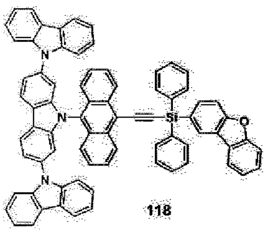
118

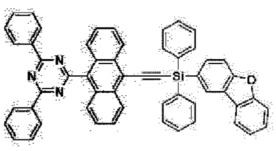
119

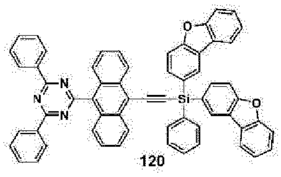
120

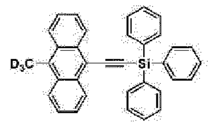
121

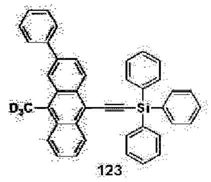
123

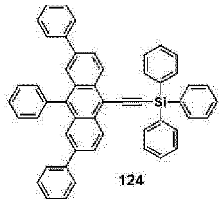
124

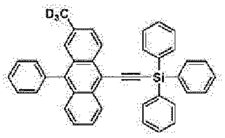
125

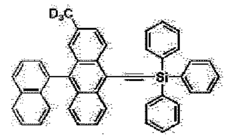
126

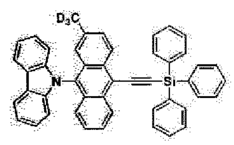
127

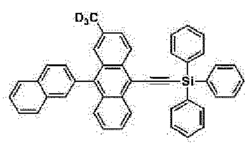
128

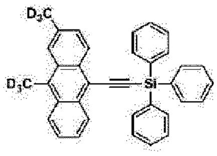

129

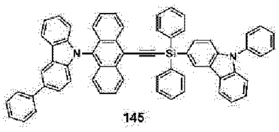
145
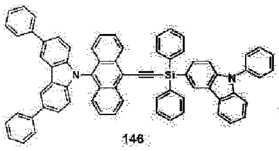
146
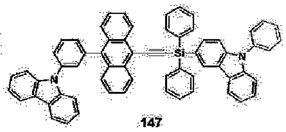
147
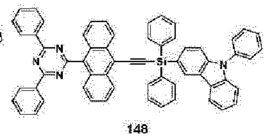
148

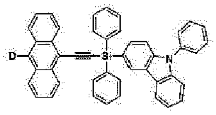
149
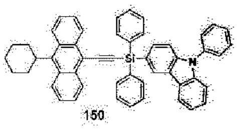
150
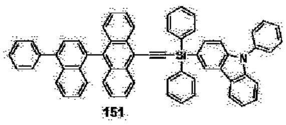
151
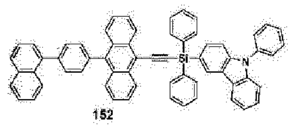
152

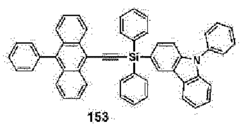
153
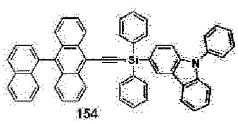
154
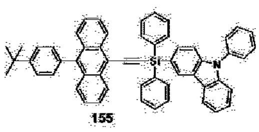
155
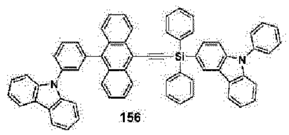
156

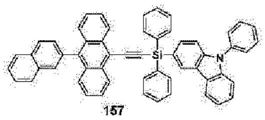
157
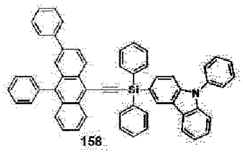
158
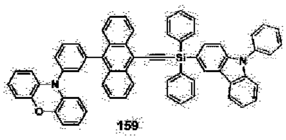
159
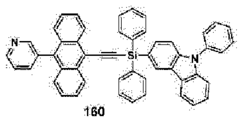
160

.

**13.** The organic light-emitting device of any of claims 1-12, wherein a content of the host is greater than a content of the dopant; and/or

wherein the host consists of the silane compound; and/or
wherein a ratio of emission components emitted from the dopant is 80 percent or greater of the whole emission components emitted from the emission layer; and/or
wherein the dopant is a fluorescent dopant; and/or
wherein the emission layer emits blue light having a maximum emission wavelength in a range of 410 nanometers to 490 nanometers.

**14.** The organic light-emitting device of any of claims 1-13, wherein the first electrode is an anode, the second electrode is a cathode,

the organic layer comprises a hole transport region between the first electrode and the emission layer and an electron transport region between the emission layer and the second electrode,
the hole transport region comprises at least one of a hole injection layer, a hole transport layer, or an electron blocking layer, and
the electron transport region comprises at least one of a hole blocking layer, an electron transport layer, or an electron injection layer.

**Patentansprüche**

**1.** Organische lichtemittierende Vorrichtung, umfassend:

eine erste Elektrode;

eine zweite Elektrode; und

eine organische Schicht zwischen der ersten Elektrode und der zweiten Elektrode und eine Emissionsschicht umfassend,

wobei die Emissionsschicht einen Wirt und einen Dotierstoff umfasst,

**dadurch gekennzeichnet, dass**

der Wirt zumindest eine Silanverbindung dargestellt durch Formel 1 umfasst:

Formel 1

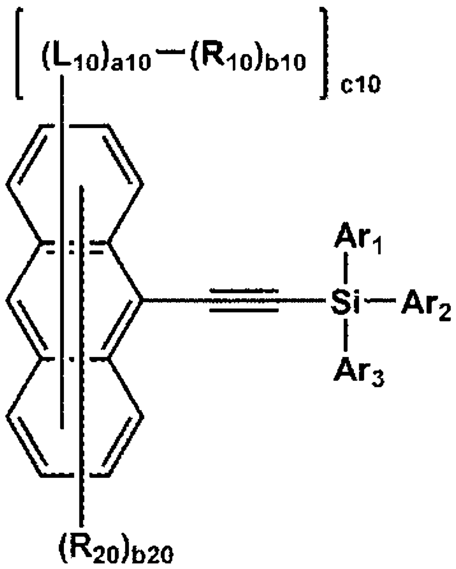

wobei in Formel 1

$Ar_1$ bis $Ar_3$ jeweils unabhängig eine substituierte oder unsubstituierte $C_1$-$C_{60}$-Alkylgruppe, eine substituierte oder unsubstituierte $C_2$-$C_{60}$-Alkenylgruppe, eine substituierte oder unsubstituierte $C_2$-$C_{60}$-Alkinylgruppe, eine substituierte oder unsubstituierte $C_1$-$C_{60}$-Alkoxygruppe, eine substituierte oder unsubstituierte $C_1$-$C_{60}$-Alkylthiogruppe, eine substituierte oder unsubstituierte $C_3$-$C_{10}$-Cycloalkylgruppe, eine substituierte oder unsubstituierte $C_1$-$C_{10}$-Heterocycloalkylgruppe, eine substituierte oder unsubstituierte $C_3$-$C_{10}$-Cycloalkenylgruppe, eine substituierte oder unsubstituierte $C_1$-$C_{10}$-Heterocycloalkenylgruppe, eine substituierte oder unsubstituierte $C_6$-$C_{60}$-Arylgruppe, eine substituierte oder unsubstituierte $C_6$-$C_{60}$-Aryloxygruppe, eine substituierte oder unsubstituierte $C_6$-$C_{60}$-Arylthiogruppe, eine substituierte oder unsubstituierte $C_1$-$C_{60}$- Heteroarylgruppe, eine substituierte oder unsubstituierte $C_1$-$C_{60}$-Heteroaryloxygruppe, eine substituierte oder unsubstituierte $C_1$-$C_{60}$-Heteroarylthiogruppe, eine substituierte oder unsubstituierte monovalente nichtaromatische kondensierte polycyclische Gruppe, eine substituierte oder unsubstituierte monovalente nichtaromatische kondensierte heteropolycyclische Gruppe, $-N(Q_1)(Q_2)$, $-Si(Q_3)(Q_4)(Q_5)$, $-B(Q_6)(Q_7)$ oder $-P(O)(Q_8)(Q_9)$ sind,

zumindest eines von $Ar_1$ bis $Ar_3$ eine substituierte oder unsubstituierte $C_6$-$C_{60}$-Arylgruppe, eine substituierte oder unsubstituierte $C_1$-$C_{60}$-Heteroarylgruppe, eine substituierte oder unsubstituierte monovalente nichtaromatische kondensierte polycyclische Gruppe oder eine substituierte oder unsubstituierte monovalente nichtaromatische kondensierte heteropolycyclische Gruppe ist,

$L_{10}$ eine substituierte oder unsubstituierte carbocyclische $C_5$-$C_{30}$-Gruppe oder eine substituierte oder unsubstituierte heterocyclische $C_1$-$C_{30}$-Gruppe ist,

a10 eine ganze Zahl von 0 bis 3 ist, und wenn a10 2 oder größer ist, zumindest zwei $L_{10}$(s) identisch zueinander oder verschieden voneinander sind,

$R_{10}$ und $R_{20}$ jeweils unabhängig Wasserstoff, Deuterium, -F, eine Cyanogruppe, $-CD_3$, - $CD_2H$, $-CDH_2$, $-CF_3$, $-CF_2H$, $-CFH_2$, Gruppen dargestellt durch Formel 9-1 bis 9-19 oder Gruppen dargestellt durch Formel 10-1 bis 10-211 sind:

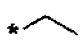
9-1

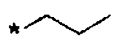
9-2

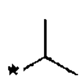
9-3

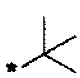
9-4

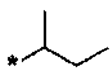
9-5

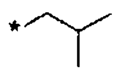
9-6

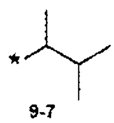
9-7

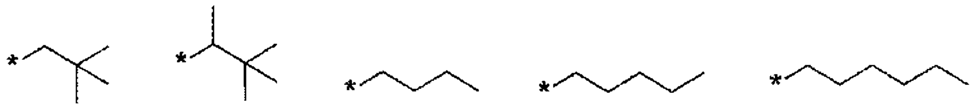

9-8 9-9 9-10 9-11 9-12

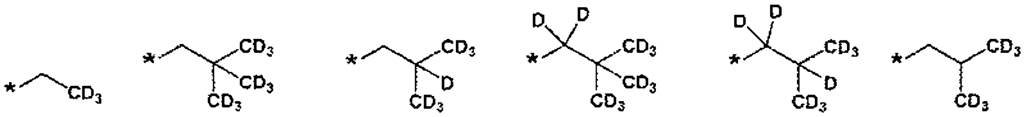

9-13 9-14 9-15 9-16 9-17 9-18

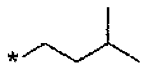

9-19

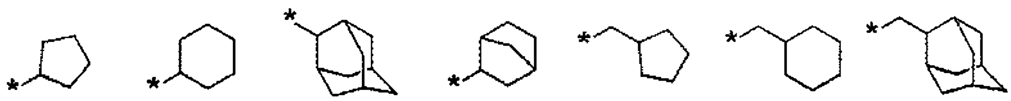

10-1 10-2 10-3 10-4 10-5 10-6 10-7

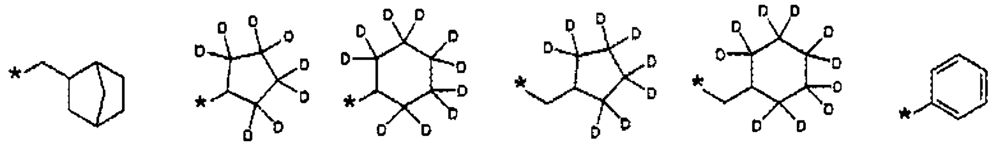

10-8 10-9 10-10 10-11 10-12 10-13

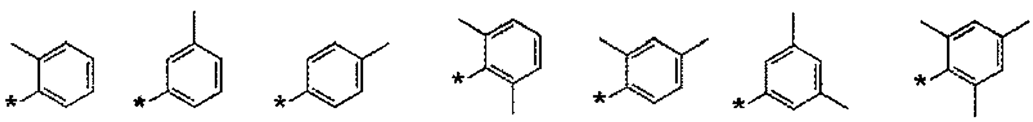

10-14 10-15 10-16 10-17 10-18 10-19 10-20

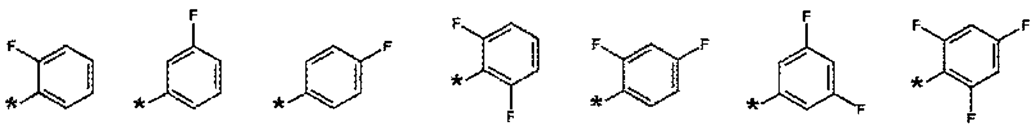

10-21 10-22 10-23 10-24 10-25 10-26 10-27

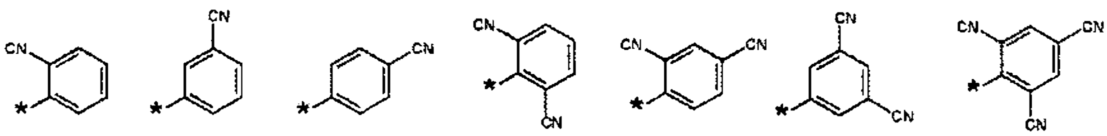

10-28 10-29 10-30 10-31 10-32 10-33 10-34

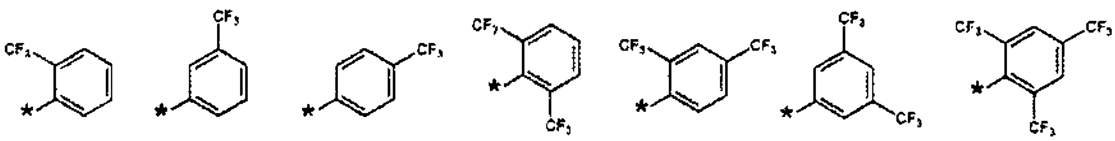

10-35 10-36 10-37 10-38 10-39 10-40 10-41

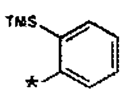 10-42
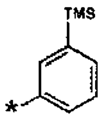 10-43
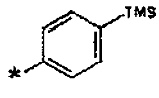 10-44
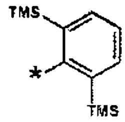 10-45
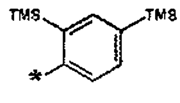 10-46
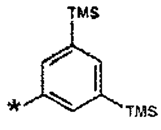 10-47
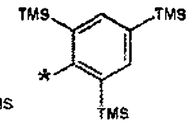 10-48

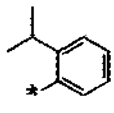 10-49
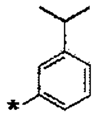 10-50
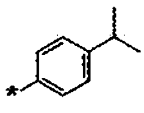 10-51
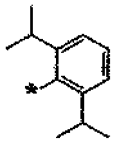 10-52
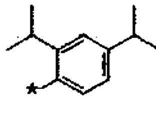 10-53
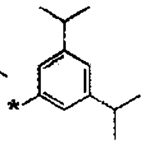 10-54
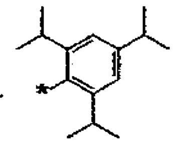 10-55

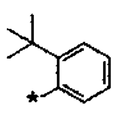 10-56
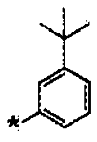 10-57
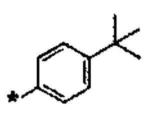 10-58
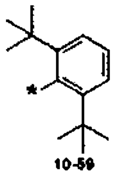 10-59
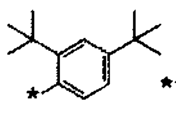 10-60
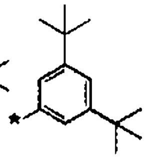 10-61
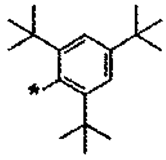 10-62

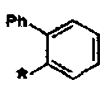 10-63
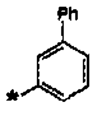 10-64
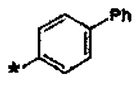 10-65
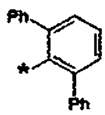 10-66
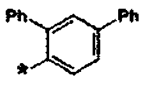 10-67
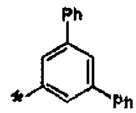 10-68
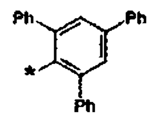 10-69

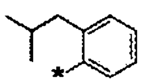 10-70
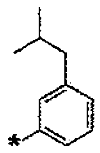 10-71
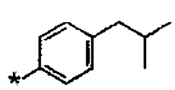 10-72
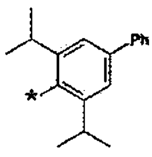 10-73
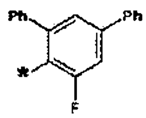 10-74
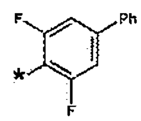 10-75

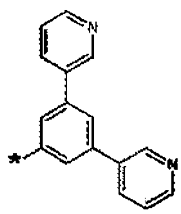 10-76
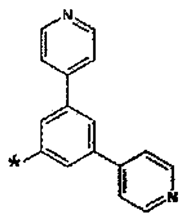 10-77
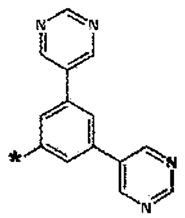 10-78
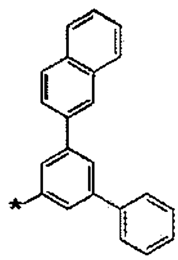 10-79
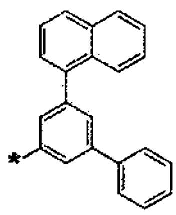 10-80

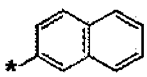 10-81
10-82
10-83
10-84
10-85

10-86
10-87
10-88
10-89
10-90
10-91
10-92

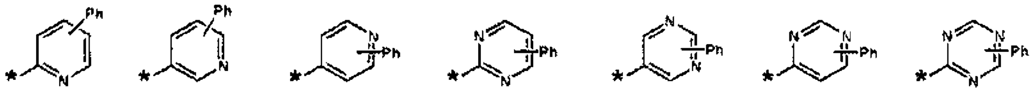
10-93 10-94 10-95 10-96 10-97 10-98 10-99

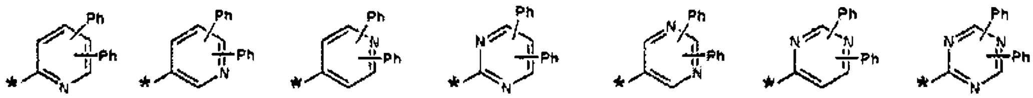
10-100 10-101 10-102 10-103 10-104 10-105 10-106

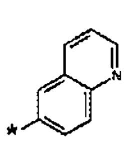
10-107
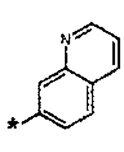
10-108
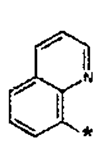
10-109
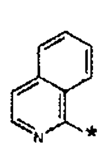
10-110
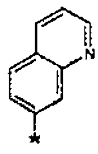
10-111
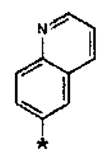
10-112

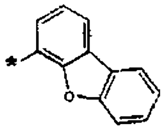
10-113
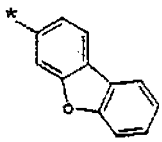
10-114
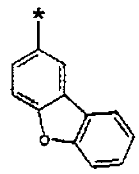
10-115
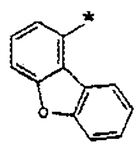
10-116
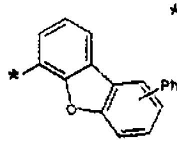
10-117
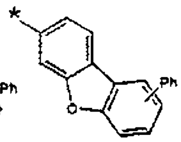
10-118

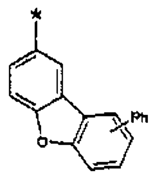
10-119
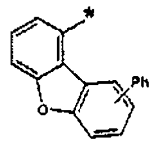
10-120
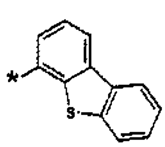
10-121
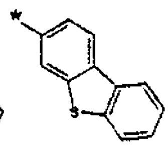
10-122
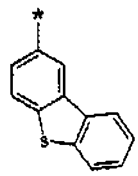
10-123
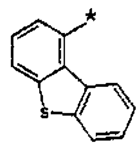
10-124

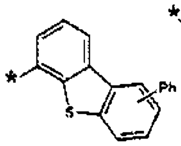
10-125
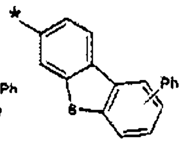
10-126
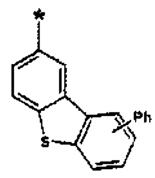
10-127
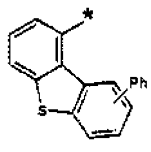
10-128
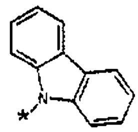
10-129
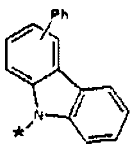
10-130

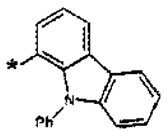
10-131
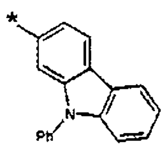
10-132
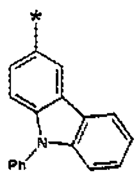
10-133
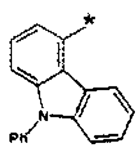
10-134
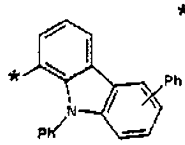
10-135
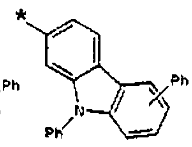
10-136

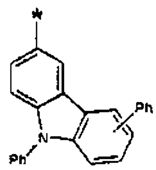
10-137
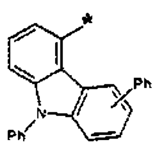
10-138
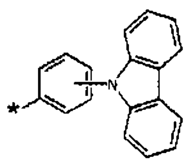
10-139
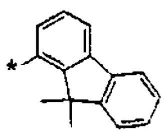
10-140
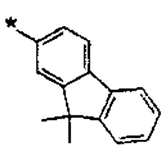
10-141
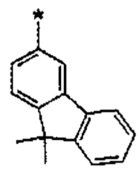
10-142

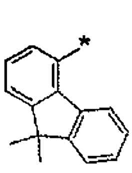 10-143 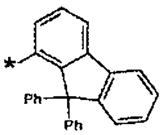 10-144 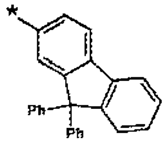 10-145 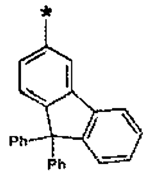 10-146 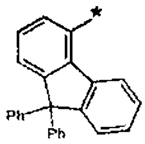 10-147

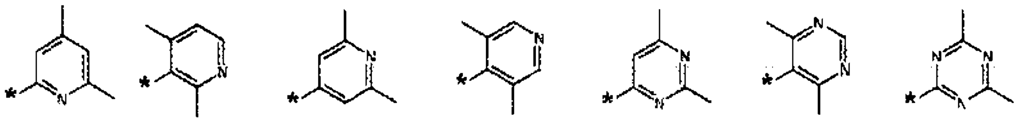
10-148 10-149 10-150 10-151 10-152 10-153 10-154

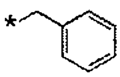 10-155 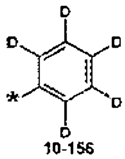 10-156 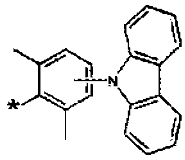 10-157 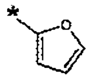 10-158 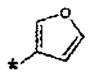 10-159 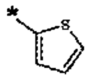 10-160 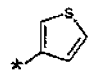 10-161

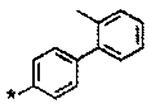 10-162 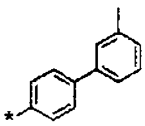 10-163 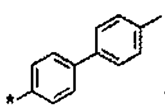 10-164 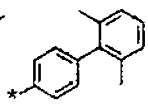 10-165 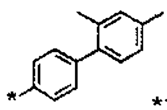 10-166 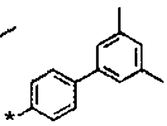 10-167 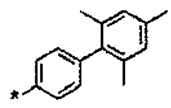 10-168

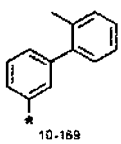 10-169 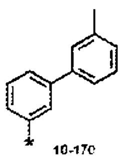 10-170 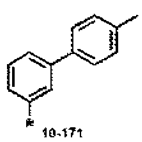 10-171 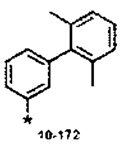 10-172 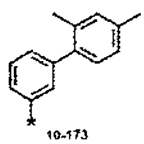 10-173 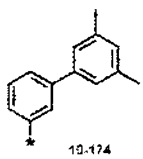 10-174 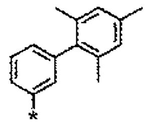 10-175

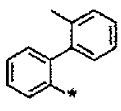 10-176 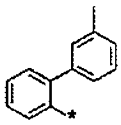 10-177 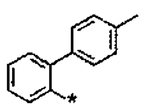 10-178 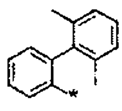 10-179 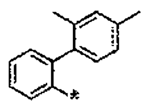 10-180 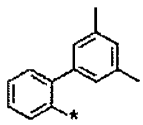 10-181 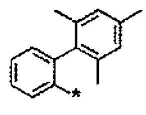 10-182

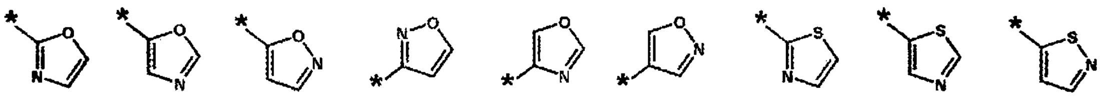
10-183 10-184 10-185 10-186 10-187 10-188 10-189 10-190 10-191

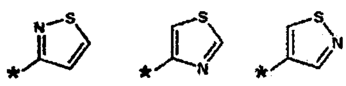
10-192 10-193 10-194

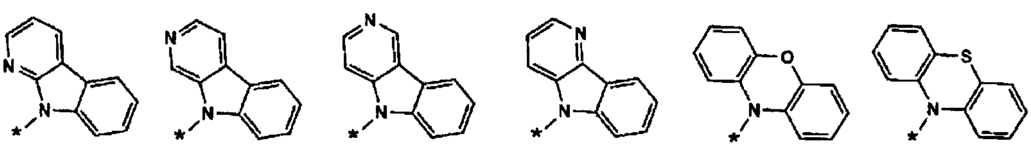
10-195 10-196 10-197 10-198 10-200 10-201

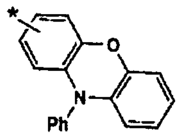
10-202

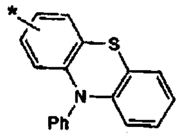
10-203

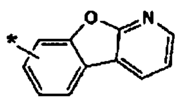
10-204

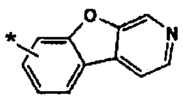
10-205

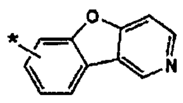
10-206

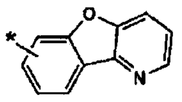
10-207

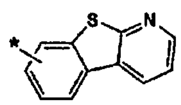
10-208

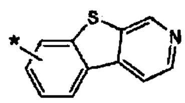
10-209

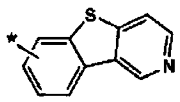
10-210

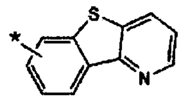
10-211

wobei in Formel 9-1 bis 9-19 und 10-1 bis 10-211 * eine Bindungsstelle zu einem benachbarten Atom angibt, "Ph" eine Phenylgruppe darstellt und "TMS" eine Trimethylsilylgruppe darstellt,
b10 und b20 jeweils unabhängig eine ganze Zahl von 1 bis 8 sind,
wenn b10 2 oder größer ist, zumindest zwei $R_{10}$(s) identisch zueinander oder verschieden voneinander sind, und wenn b20 2 oder größer ist, zumindest zwei $R_{20}$(s) identisch zueinander oder verschieden voneinander sind,
c10 eine ganze Zahl von 1 bis 9 ist,
wenn c10 2 oder größer ist, zumindest zwei $-[(L_{10})_{a10}-(R_{10})_{b10}]$(s) identisch zueinander oder verschieden voneinander sind,
zumindest ein Substituent der substituierten carbocyclischen $C_5$-$C_{30}$-Gruppe, der substituierten heterocyclischen $C_1$-$C_{30}$-Gruppe, der substituierten $C_1$-$C_{60}$-Alkylgruppe, der substituierten $C_2$-$C_{60}$-Alkenylgruppe, der substituierten $C_2$-$C_{60}$-Alkinylgruppe, der substituierten $C_1$-$C_{60}$-Alkoxygruppe, der substituierten $C_1$-$C_{60}$-Alkylthiogruppe, der substituierten $C_3$-$C_{10}$-Cycloalkylgruppe, der substituierten $C_1$-$C_{10}$-Heterocycloalkylgruppe, der substituierten $C_3$-$C_{10}$-Cycloalkenylgruppe, der substituierten $C_1$-$C_{10}$-Heterocycloalkenylgruppe, der substituierten $C_6$-$C_{60}$-Arylgruppe, der substituierten $C_6$-$C_{60}$-Aryloxygruppe, der substituierten $C_6$-$C_{60}$-Arylthiogruppe, der substituierten $C_1$-$C_{60}$-Heteroarylgruppe, der substituierten $C_1$-$C_{60}$-Heteroaryloxygruppe, der substituierten $C_1$-$C_{60}$-Heteroarylthiogruppe, der substituierten monovalenten nichtaromatischen kondensierten polycyclischen Gruppe und der substituierten monovalenten nichtaromatischen kondensierten heteropolycyclischen Gruppe wie folgt ist:
Deuterium, -F, -Cl, -Br, -I, $-CD_3$, $-CD_2H$, $-CDH_2$, $-CF_3$, $-CF_2H$, $-CFH_2$, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine $C_1$-$C_{60}$-Alkylgruppe, eine $C_2$-$C_{60}$-Alkenylgruppe, eine $C_2$-$C_{60}$-Alkinylgruppe, eine $C_1$-$C_{60}$-Alkylthiogruppe oder eine $C_1$-$C_{60}$-Alkoxygruppe;
eine $C_1$-$C_{60}$-Alkylgruppe, eine $C_2$-$C_{60}$-Alkenylgruppe, eine $C_2$-$C_{60}$-Alkinylgruppe, eine $C_1$-$C_{60}$-Alkylthiogruppe oder eine $C_1$-$C_{60}$-Alkoxygruppe, jeweils unabhängig substituiert mit zumindest einem von Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer monovalenten nichtaromatischen kondensierten polycyclischen Gruppe, einer monovalenten nichtaromatischen kondensierten heteropolycyclischen Gruppe, $-Si(Q_{11})(Q_{12})(Q_{13})$, $-N(Q_{14})(Q_{15})$ oder $-B(Q_{16})(Q_{17})$;
eine $C_3$-$C_{10}$-Cycloalkylgruppe, eine $C_1$-$C_{10}$-Heterocycloalkylgruppe, eine $C_3$-$C_{10}$-Cycloalkenylgruppe, eine $C_1$-$C_{10}$-Heterocycloalkenylgruppe, eine $C_6$-$C_{60}$-Arylgruppe, eine $C_6$-$C_{60}$-Aryloxygruppe, eine $C_6$-$C_{60}$-Arylthiogruppe, eine $C_1$-$C_{60}$-Heteroarylgruppe, eine $C_1$-$C_{60}$-Heteroaryloxygruppe, eine $C_1$-$C_{60}$-Heteroarylthiogruppe, eine monovalente nichtaromatische kondensierte polycyclische Gruppe oder eine monovalente nichtaromatische kondensierte heteropolycyclische Gruppe;
eine $C_3$-$C_{10}$-Cycloalkylgruppe, eine $C_1$-$C_{10}$-Heterocycloalkylgruppe, eine $C_3$-$C_{10}$-Cycloalkenylgruppe, eine $C_1$-$C_{10}$-Heterocycloalkenylgruppe, eine $C_6$-$C_{60}$-Arylgruppe, eine $C_6$-$C_{60}$-Aryloxygruppe, eine $C_6$-$C_{60}$-Arylthiogruppe, eine $C_1$-$C_{60}$-Heteroarylgruppe, eine $C_1$-$C_{60}$-Heteroaryloxygruppe, eine $C_1$-$C_{60}$-Heteroarylthiogruppe, eine monovalente nichtaromatische kondensierte polycyclische Gruppe oder eine monovalente nichtaromatische kondensierte heteropolycyclische Gruppe, jeweils unabhängig substituiert mit zumindest einem von Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe,

einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkinylgruppe, einer $C_1$-$C_{60}$-Alkoxygruppe, einer $C_1$-$C_{60}$-Alkylthiogruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer monovalenten nichtaromatischen kondensierten polycyclischen Gruppe, einer monovalenten nichtaromatischen kondensierten heteropolycyclischen Gruppe, - $Si(Q_{21})(Q_{22})(Q_{23})$, $-N(Q_{24})(Q_{25})$ oder $-B(Q_{26})(Q_{27})$; oder
$-Si(Q_{31})(Q_{32})(Q_{33})$, $-N(Q_{34})(Q_{35})$ oder $-B(Q_{36})(Q_{37})$,
wobei $Q_1$ bis $Q_9$, $Q_{11}$ bis $Q_{17}$, $Q_{21}$ bis $Q_{27}$ und $Q_{31}$ bis $Q_{37}$ jeweils unabhängig Wasserstoff, Deuterium, -F, -Cl, -Br, -I, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine substituierte oder unsubstituierte $C_1$-$C_{60}$-Alkylgruppe, eine substituierte oder unsubstituierte $C_2$-$C_{60}$-Alkenylgruppe, eine substituierte oder unsubstituierte $C_2$-$C_{60}$-Alkinylgruppe, eine substituierte oder unsubstituierte $C_1$-$C_{60}$-Alkoxygruppe, eine substituierte oder unsubstituierte $C_1$-$C_{60}$-Alkylthiogruppe, eine substituierte oder unsubstituierte $C_3$-$C_{10}$-Cycloalkylgruppe, eine substituierte oder unsubstituierte $C_1$-$C_{10}$-Heterocycloalkylgruppe, eine substituierte oder unsubstituierte $C_3$-$C_{10}$-Cycloalkenylgruppe, eine substituierte oder unsubstituierte $C_1$-$C_{10}$-Heterocycloalkenylgruppe, eine substituierte oder unsubstituierte $C_6$-$C_{60}$-Arylgruppe, eine substituierte oder unsubstituierte $C_6$-$C_{60}$-Aryloxygruppe, eine substituierte oder unsubstituierte $C_6$-$C_{60}$-Arylthiogruppe, eine substituierte oder unsubstituierte $C_1$-$C_{60}$-Heteroarylgruppe, eine substituierte oder unsubstituierte $C_1$-$C_{60}$-Heteroaryloxygruppe, eine substituierte oder unsubstituierte $C_1$-$C_{60}$-Heteroarylthiogruppe, eine substituierte oder unsubstituierte monovalente nichtaromatische kondensierte polycyclische Gruppe oder eine substituierte oder unsubstituierte monovalente nichtaromatische kondensierte heteropolycyclische Gruppe sind, und
wobei Substituenten $L_{10}$, $R_{10}$ und $R_{20}$ an jedem Ring vorhanden sind, durch den die Bindung mit dem entsprechenden Substituenten verläuft.

**2.** Organische lichtemittierende Vorrichtung nach Anspruch 1, wobei $Ar_1$ bis $Ar_3$ jeweils unabhängig wie folgt sind:

eine $C_1$-$C_{20}$-Alkylgruppe, eine $C_1$-$C_{20}$-Alkylthiogruppe oder eine $C_1$-$C_{20}$-Alkoxygruppe;
eine $C_1$-$C_{20}$-Alkylgruppe, eine $C_1$-$C_{20}$-Alkylthiogruppe oder eine $C_1$-$C_{20}$-Alkoxygruppe, jeweils unabhängig substituiert mit zumindest einem von Deuterium, -F, -Cl, -Br, -I, einer Hydroxygruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer Phenylgruppe, einer Naphthylgruppe, einer Pyridinylgruppe, einer Pyrimidinylgruppe, einer Pyrazinylgruppe, einer Pyridazinylgruppe oder einer Triazinylgruppe;
eine Cyclopentylgruppe, eine Cyclohexylgruppe, eine Cyclopentenylgruppe, eine Cyclohexenylgruppe, eine Cycloheptenylgruppe, eine Phenylgruppe, eine Pentalenylgruppe, eine Indenylgruppe, eine Naphthylgruppe, eine Azulenylgruppe, eine Heptalenylgruppe, eine Indacenylgruppe, eine Acenaphthylgruppe, eine Fluorenylgruppe, eine Spirobifluorenylgruppe, eine Phenalenylgruppe, eine Phenanthrenylgruppe, eine Anthracenylgruppe, eine Fluoranthenylgruppe, eine Triphenylenylgruppe, eine Pyrenylgruppe, eine Chrysenylgruppe, eine Naphthacenylgruppe, eine Picenylgruppe, eine Perylenylgruppe, eine Pentaphenylgruppe, eine Hexacenylgruppe, eine Pyrrolylgruppe, eine Imidazolylgruppe, eine Pyrazolylgruppe, eine Pyridinylgruppe, eine Pyrazinylgruppe, eine Pyrimidinylgruppe, eine Pyridazinylgruppe, eine Isoindolylgruppe, eine Indolylgruppe, eine Indazolylgruppe, eine Purinylgruppe, eine Chinolinylgruppe, eine Isochinolinylgruppe, eine Benzochinolinylgruppe, eine Phthalazinylgruppe, eine Naphthyridinylgruppe, eine Chinoxalinylgruppe, eine Chinazolinylgruppe, eine Cinnolinylgruppe, eine Phenanthridinylgruppe, eine Acridinylgruppe, eine Phenanthrolinylgruppe, eine Phenazinylgruppe, eine Benzoxazolylgruppe, eine Benzimidazolylgruppe, eine Furanylgruppe, eine Benzofuranylgruppe, eine Thiophenylgruppe, eine Benzothiophenylgruppe, eine Thiazolylgruppe, eine Isothiazolylgruppe, eine Benzothiazolylgruppe, eine Isoxazolylgruppe, eine Oxazolylgruppe, eine Triazolylgruppe, eine Tetrazolylgruppe, eine Oxadiazolylgruppe, eine Triazinylgruppe, eine Carbazolylgruppe, eine Dibenzofuranylgruppe, eine Dibenzothiophenylgruppe, eine Benzocarbazolylgruppe, eine Azacarbazolylgruppe, eine Azadibenzofuranylgruppe, eine Azadibenzothiophenylgruppe, eine Phenoxazinylgruppe, eine Phenothiazinylgruppe, eine Imidazopyrimidinylgruppe oder eine Imidazopyridinylgruppe; und
eine Cyclopentylgruppe, eine Cyclohexylgruppe, eine Cyclopentenylgruppe, eine Cyclohexenylgruppe, eine Cycloheptenylgruppe, eine Phenylgruppe, eine Pentalenylgruppe, eine Indenylgruppe, eine Naphthylgruppe, eine Azulenylgruppe, eine Heptalenylgruppe, eine Indacenylgruppe, eine Acenaphthylgruppe, eine Fluorenylgruppe, eine Spirobifluorenylgruppe, eine Phenalenylgruppe, eine Phenanthrenylgruppe, eine Anthracenylgruppe, eine Fluoranthenylgruppe, eine Triphenylenylgruppe, eine Pyrenylgruppe, eine Chrysenylgruppe, eine Naphthacenylgruppe, eine Picenylgruppe, eine Perylenylgruppe, eine Pentaphenylgruppe, eine Hexacenylgruppe, eine Pyrrolylgruppe, eine Imidazolylgruppe, eine Pyrazolylgruppe, eine Pyridinylgruppe, eine Pyrazinylgruppe, eine Pyrimidinylgruppe, eine Pyridazinylgruppe, eine Isoindolylgruppe, eine Indolylgruppe, eine Indazolylgruppe, eine Purinylgruppe, eine Chinolinylgruppe, eine Isochinolinylgruppe, eine Benzochinolinylgruppe, eine Phthalazinylgruppe, eine Naphthyridinylgruppe, eine Chinoxalinylgruppe, eine Chinazolinylgruppe, eine Cinnolinylgruppe, eine Phenanthridinylgruppe, eine Acridinylgruppe, eine Phenanthrolinylgruppe, eine Phenazinylgruppe, eine Benzoxazolylgruppe, eine Benzimidazolylgruppe, eine Furanylgruppe, eine Benzofuranylgruppe, eine Thiophenylgruppe, eine Benzothiophenylgruppe, eine Thiazolylgruppe, eine Isothiazolylgruppe, eine Benzothiazolylgruppe, eine Isoxazolylgruppe, eine Oxazolylgruppe, eine Triazolylgruppe, eine Tetrazolylgruppe, eine Oxadiazolylgruppe, eine Triazinylgruppe, eine Carbazolylgruppe, eine Dibenzofuranylgruppe, eine Dibenzothiophenylgruppe, eine Benzocarbazolylgruppe, eine Azacarbazolylgruppe, eine Azadibenzofuranylgruppe, eine Azadibenzothiophenylgruppe, eine Phenoxazinylgruppe, eine Phenothiazinylgruppe, eine Imidazopyrimidinylgruppe oder eine Imidazopyridinylgruppe, jeweils unabhängig substituiert mit zumindest einem von Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe, einer $C_2$-$C_{20}$-Alkenylgruppe, einer $C_2$-$C_{20}$-Alkinylgruppe, einer $C_1$-$C_{20}$-Alkoxygruppe, einer $C_1$-$C_{20}$-Alkylthiogruppe, einer Phenylgruppe, einer Naphthylgruppe, einer Anthracenylgruppe, einer Pyrenylgruppe, einer Phenanthrenylgruppe, einer Fluorenylgruppe, einer Pyridinylgruppe, einer Pyrimidinylgruppe, einer Pyrazinylgruppe, einer Pyridazinylgruppe, einer Triazinylgruppe, einer Chinolinylgruppe, einer Isochinolinylgruppe, einer Phthalazinylgruppe, einer Chinoxalinylgruppe, einer Cinnolinylgruppe oder einer Chinazolinylgruppe.

**3.** Organische lichtemittierende Vorrichtung nach Anspruch 1 oder 2, wobei $Ar_1$ bis $Ar_3$ jeweils unabhängig wie folgt sind:

eine Cyclopentylgruppe, eine Cyclohexylgruppe, eine Cyclopentenylgruppe, eine Cyclohexenylgruppe, eine Cycloheptenylgruppe, eine Phenylgruppe, eine Pentalenylgruppe, eine Indenylgruppe, eine Naphthylgruppe, eine Azulenylgruppe, eine Heptalenylgruppe, eine Indacenylgruppe, eine Acenaphthylgruppe, eine Fluorenylgruppe, eine Spirobifluorenylgruppe, eine Phenalenylgruppe, eine Phenanthrenylgruppe, eine Anthracenylgruppe, eine Fluoranthenylgruppe, eine Triphenylenylgruppe, eine Pyrenylgruppe, eine Chrysenylgruppe, eine Naphthacenylgruppe, eine Picenylgruppe, eine Perylenylgruppe, eine Pentaphenylgruppe, eine Hexacenylgruppe, eine Pyrrolylgruppe, eine Imidazolylgruppe, eine Pyrazolylgruppe, eine Pyridinylgruppe, eine Pyrazinylgruppe, eine Pyrimidinylgruppe, eine Pyridazinylgruppe, eine Isoindolylgruppe, eine Indolylgruppe, eine Indazolylgruppe, eine Purinylgruppe, eine Chinolinylgruppe, eine Isochinolinylgruppe, eine Benzochinolinylgruppe, eine Phthalazinylgruppe, eine Naphthyridinylgruppe, eine Chinoxalinylgruppe, eine Chinazolinylgruppe, eine Cinnolinylgruppe, eine Phenanthridinylgruppe, eine Acridinylgruppe, eine Phenanthrolinylgruppe, eine Phenazinylgruppe, eine Benzoxazolylgruppe, eine Benzimidazolylgruppe, eine Furanylgruppe, eine Benzofuranylgruppe, eine Thiophenylgruppe, eine Benzothiophenylgruppe, eine Thiazolylgruppe, eine Isothiazolylgruppe, eine Benzothiazolylgruppe, eine Isoxazolylgruppe, eine Oxazolylgruppe, eine Triazolylgruppe, eine Tetrazolylgruppe, eine Oxadiazolylgruppe, eine Triazinylgruppe, eine Carbazolylgruppe, eine Dibenzofuranylgruppe, eine Dibenzothiophenylgruppe, eine Benzocarbazolylgruppe, eine Azacarbazolylgruppe, eine Azadibenzofuranylgruppe, eine Azadibenzothiophenylgruppe, eine Phenoxazinylgruppe, eine Phenothiazinylgruppe, eine Imidazopyrimidinylgruppe oder eine Imidazopyridinylgruppe; und

eine Cyclopentylgruppe, eine Cyclohexylgruppe, eine Cyclopentenylgruppe, eine Cyclohexenylgruppe, eine Cycloheptenylgruppe, eine Phenylgruppe, eine Pentalenylgruppe, eine Indenylgruppe, eine Naphthylgruppe, eine Azulenylgruppe, eine Heptalenylgruppe, eine Indacenylgruppe, eine Acenaphthylgruppe, eine Fluorenylgruppe, eine Spirobifluorenylgruppe, eine Phenalenylgruppe, eine Phenanthrenylgruppe, eine Anthracenylgruppe, eine Fluoranthenylgruppe, eine Triphenylenylgruppe, eine Pyrenylgruppe, eine Chrysenylgruppe, eine Naphthacenylgruppe, eine Picenylgruppe, eine Perylenylgruppe, eine Pentaphenylgruppe, eine Hexacenylgruppe, eine Pyrrolylgruppe, eine Imidazolylgruppe, eine Pyrazolylgruppe, eine Pyridinylgruppe, eine Pyrazinylgruppe, eine Pyrimidinylgruppe, eine Pyridazinylgruppe, eine Isoindolylgruppe, eine Indolylgruppe, eine Indazolylgruppe, eine Purinylgruppe, eine Chinolinylgruppe, eine Isochinolinylgruppe, eine Benzochinolinylgruppe, eine Phthalazinylgruppe, eine Naphthyridinylgruppe, eine Chinoxalinylgruppe, eine Chinazolinylgruppe, eine Cinnolinylgruppe, eine Phenanthridinylgruppe, eine Acridinylgruppe, eine Phenanthrolinylgruppe, eine Phenazinylgruppe, eine Benzoxazolylgruppe, eine Benzimidazolylgruppe, eine Furanylgruppe, eine Benzofuranylgruppe, eine Thiophenylgruppe, eine Benzothiophenylgruppe, eine Thiazolylgruppe, eine Isothiazolylgruppe,

eine Benzothiazolylgruppe, eine Isoxazolylgruppe, eine Oxazolylgruppe, eine Triazolylgruppe, eine Tetrazolylgruppe, eine Oxadiazolylgruppe, eine Triazinylgruppe, eine Carbazolylgruppe, eine Dibenzofuranylgruppe, eine Dibenzothiophenylgruppe, eine Benzocarbazolylgruppe, eine Azacarbazolylgruppe, eine Azadibenzofuranylgruppe, eine Azadibenzothiophenylgruppe, eine Phenoxazinylgruppe, eine Phenothiazinylgruppe, eine Imidazopyrimidinylgruppe oder eine Imidazopyridinylgruppe, jeweils unabhängig substituiert mit zumindest einem von Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe, einer $C_2$-$C_{20}$-Alkenylgruppe, einer $C_2$-$C_{20}$-Alkinylgruppe, einer $C_1$-$C_{20}$-Alkoxygruppe, einer $C_1$-$C_{20}$-Alkylthiogruppe, einer Phenylgruppe, einer Naphthylgruppe, einer Anthracenylgruppe, einer Pyrenylgruppe, einer Phenanthrenylgruppe, einer Fluorenylgruppe, einer Pyridinylgruppe, einer Pyrimidinylgruppe, einer Pyrazinylgruppe, einer Pyridazinylgruppe, einer Triazinylgruppe, einer Chinolinylgruppe, einer Isochinolinylgruppe, einer Phthalazinylgruppe, einer Chinoxalinylgruppe, einer Cinnolinylgruppe oder einer Chinazolinylgruppe.

**4.** Organische lichtemittierende Vorrichtung nach einem der Ansprüche 1-3, wobei $L_{10}$ wie folgt ist:

eine Phenylengruppe, eine Pentalenylengruppe, eine Indenylengruppe, eine Naphthylengruppe, eine Azulenylengruppe, eine Heptalenylengruppe, eine Acenaphthylengruppe, eine Fluorenylengruppe, eine Phenalenylengruppe, eine Phenanthrenylengruppe, eine Anthracenylengruppe, eine Auoranthenylengruppe, eine Triphenylenylengruppe, eine Pyrenylengruppe, eine Chrysenylenylengruppe, eine Naphthacenylengruppe, eine Picenylengruppe, eine Perylenylengruppe, eine Pentacenylengruppe, eine Carbazolylengruppe, eine Dibenzofuranylengruppe, eine Dibenzothiophenylengruppe, eine Dibenzosilolylengruppe, eine Benzocarbazolylengruppe, eine Pyridinylengruppe, eine Pyrimidinylengruppe, eine Triazinylengruppe, eine Chinolinylengruppe, eine Isochinolinylengruppe, eine Benzochinolinylengruppe, eine Phthalazinylengruppe, eine Naphthyridinylengruppe, eine Chinoxalinylengruppe, eine Chinazolinylengruppe, eine Phenanthridinylengruppe, eine Acridinylengruppe, eine Phenanthrolinylengruppe, eine Phenazinylengruppe, eine Phenoxazinylengruppe, eine Phenothiazinylengruppe, eine Azacazolylengruppe, eine Azadibenzuranofuranylengruppe oder eine Azadibenzothiophenylengruppe;

eine Phenylengruppe, eine Pentalenylengruppe, eine Indenylengruppe, eine Naphthylengruppe, eine Azulenylengruppe, eine Heptalenylengruppe, eine Acenaphthylengruppe, eine Fluorenylengruppe, eine Phenalenylengruppe, eine Phenanthrenylengruppe, eine Anthracenylengruppe, eine Fluoranthenylengruppe, eine Triphenylenylengruppe, eine Pyrenylengruppe, eine Chrysenylenylengruppe, eine Naphthacenylengruppe, eine Picenylengruppe, eine Perylenylengruppe, eine Pentacenylengruppe, eine Carbazolylengruppe, eine Dibenzofuranylengruppe, eine Dibenzothiophenylengruppe, eine Dibenzosilolylengruppe, eine Benzocarbazolylengruppe, eine $Pyr_1d_1$nylengruppe, eine Pyrimidinylengruppe, eine Triazinylengruppe, eine Chinolinylengruppe, eine Isochinolinylengruppe, eine Benzochinolinylengruppe, eine Phthalazinylengruppe, eine Naphthyridinylengruppe, eine Chinoxalinylengruppe, eine Chinazolinylengruppe, eine Phenanthridinylengruppe, eine Acridinylengruppe, eine Phenanthrolinylengruppe, eine Phenazinylengruppe, eine Phenoxazinylengruppe, eine Phenothiazinylengruppe, eine Azacarbazolylengruppe, eine Azadibenzofuranylengruppe oder eine Azadibenzothiophenylengruppe, jeweils unabhängig substituiert mit zumindest einem von Deuterium, -F, -Cl, -Br, -I, einer Hydroxylgruppe, eine Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkinylgruppe, einer $C_1$-$C_{60}$-Alkoxygruppe, einer $C_1$-$C_{60}$-Alkylthiogruppe, einer $C_3$-$C_{10}$-Cycloalkylgruppe, einer $C_3$-$C_{10}$-Cycloalkenylgruppe, einer $C_1$-$C_{10}$-Heterocycloalkylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer monovalenten nichtaromatischen kondensierten polycyclischen Gruppe oder einer monovalenten nichtaromatischen kondensierten heteropolycyclischen Gruppe; oder

eine Gruppe dargestellt durch Formel 2A oder Formel 2B:

Formel 2A

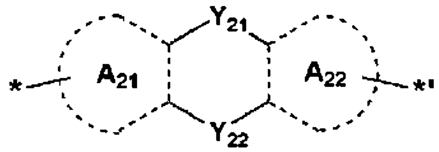

Formel 2B

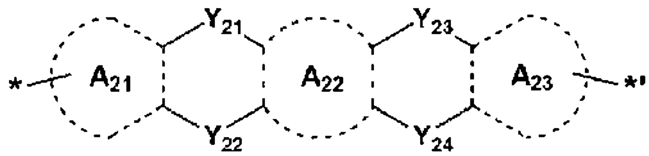

wobei in Formel 2A und 2B
$Y_{21}$ bis $Y_{24}$ jeweils unabhängig eine Einfachbindung, O, S, $N(R_{21})$, $C(R_{21})(R_{22})$, $Si(R_{21})(R_{22})$, C(=O), S(=O), $S(=O)_2$, $B(R_{21})$, $P(R_{21})$ oder $P(=O)(R_{21})$ sind,
$A_{21}$ bis $A_{23}$ jeweils unabhängig eine Phenylgruppe, eine Naphthalengruppe, eine 1,2,3,4-Tetrahydronaphthalengruppe, eine Phenanthrengruppe, eine Pyridingruppe, eine Pyrimidingruppe, eine Pyrazingruppe, eine Triazingruppe, eine Chinolingruppe, eine Isochinolingruppe, eine Chinoxalingruppe, eine Chinazolingruppe, eine Phenanthrolingruppe, eine Benzofurangruppe, eine Benzothiophengruppe, eine Fluorengruppe, eine Carbazolgruppe, eine Dibenzofurangruppe, eine Dibenzothiophengruppe, eine Dibenzosilolgruppe, eine Azafluorengruppe, eine Azacarbazolgruppe, eine Azadibenzofurangruppe, eine Azadibenzothiophengruppe oder eine Azadibenzosilolgruppe,
$R_{21}$ und $R_{22}$ jeweils unabhängig verstanden werden, indem auf die Beschreibung von $R_{10}$ oder $R_{20}$ in Anspruch 1 Bezug genommen wird, und
* und *' jeweils eine Bindungsstelle zu einem benachbarten Atom angeben.

**5.** Organische lichtemittierende Vorrichtung nach einem der Ansprüche 1-4, wobei a10 0 oder 1 ist.

**6.** Organische lichtemittierende Vorrichtung nach einem der Ansprüche 1-5, wobei $R_{10}$ und $R_{20}$ jeweils unabhängig wie folgt sind:

Wasserstoff, Deuterium, -F, eine Cyanogruppe, $-CD_3$, $-CD_2H$, $-CDH_2$, $-CF_3$, $-CF_2H$, - $CFH_2$, $C_1$-$C_{20}$-Alkylgruppe, eine $C_1$-$C_{20}$-Alkylthiogruppe oder eine $C_1$-$C_{20}$-Alkoxygruppe;
eine $C_1$-$C_{20}$-Alkylgruppe, eine $C_1$-$C_{20}$-Alkylthiogruppe oder eine $C_1$-$C_{20}$-Alkoxygruppe, jeweils unabhängig substituiert mit zumindest einem von Deuterium, -F, einer Cyanogruppe, einer Phenylgruppe, einer Biphenylgruppe, einer Terphenylgruppe oder einer Naphthylgruppe;
eine Cyclopentylgruppe, eine Cyclohexylgruppe, eine Cyclopentenylgruppe, eine Cyclohexenylgruppe, eine Cycloheptenylgruppe, eine Phenylgruppe, eine Biphenylgruppe, eine Terphenylgruppe, eine Naphthylgruppe, eine Fluorenylgruppe, eine Carbazolylgruppe, eine Dibenzofuranylgruppe oder eine Dibenzothiophenylgruppe; oder
eine Cyclopentylgruppe, eine Cyclohexylgruppe, eine Cyclopentenylgruppe, eine Cyclohexenylgruppe, eine Cycloheptenylgruppe, eine Phenylgruppe, eine Biphenylgruppe, eine Terphenylgruppe, eine Naphthylgruppe, eine Fluorenylgruppe, eine Carbazolylgruppe, eine Dibenzofuranylgruppe oder eine Dibenzothiophenylgruppe, jeweils unabhängig substituiert mit zumindest einem von Deuterium, einer Cyanogruppe, einer $C_1$-$C_{20}$-Alkylgruppe, einer $C_1$-$C_{20}$-Alkoxygruppe, einer $C_1$-$C_{20}$-Alkylthiogruppe, einer Phenylgruppe, einer Biphenylgruppe, einer Terphenylgruppe oder einer Naphthylgruppe.

**7.** Organische lichtemittierende Vorrichtung nach einem der Ansprüche 1-6, wobei $R_{10}$ wie folgt ist:

Deuterium, -F, eine Cyanogruppe, $-CD_3$, $-CD_2H$, $-CDH_2$, $-CF_3$, $-CF_2H$, $-CFH_2$, eine $C_1$-$C_{20}$-Alkylgruppe, eine $C_1$-$C_{20}$-Alkylthiogruppe oder eine $C_1$-$C_{20}$-Alkoxygruppe;
eine $C_1$-$C_{20}$-Alkylgruppe, eine $C_1$-$C_{20}$-Alkylthiogruppe oder eine $C_1$-$C_{20}$-Alkoxygruppe, jeweils unabhängig substituiert mit zumindest einem von Deuterium, einer Cyanogruppe, einer Phenylgruppe, einer Biphenylgruppe, einer Terphenylgruppe oder einer Naphthylgruppe;

eine Cyclopentylgruppe, eine Cyclohexylgruppe, eine Cyclopentenylgruppe, eine Cyclohexenylgruppe, eine Cycloheptenylgruppe, eine Phenylgruppe, eine Biphenylgruppe, eine Terphenylgruppe, eine Naphthylgruppe, eine Fluorenylgruppe, eine Carbazolylgruppe, eine Dibenzofuranylgruppe, eine Dibenzothiophenylgruppe, eine Benzocarbazolylgruppe, eine Azacarbazolylgruppe, eine Azadibenzofuranylgruppe, eine Azadibenzothiophenylgruppe, eine Phenoxazinylgruppe oder eine Phenothiazinylgruppe; oder
eine Cyclopentylgruppe, eine Cyclohexylgruppe, eine Cyclopentenylgruppe, eine Cyclohexenylgruppe, eine Cycloheptenylgruppe, eine Phenylgruppe, eine Biphenylgruppe, eine Terphenylgruppe, eine Naphthylgruppe, eine Fluorenylgruppe, eine Carbazolylgruppe, eine Dibenzofuranylgruppe, eine Dibenzothiophenylgruppe, eine Benzocarbazolylgruppe, eine Azacarbazolylgruppe, eine Azadibenzofuranylgruppe, eine Azadibenzothiophenylgruppe, eine Phenoxazinylgruppe oder eine Phenothiazinylgruppe, jeweils unabhängig substituiert mit zumindest einem von Deuterium, einer Cyanogruppe, einer $C_1$-$C_{20}$-Alkylgruppe, einer $C_1$-$C_{20}$-Alkoxygruppe, einer $C_1$-$C_{20}$-Alkylthiogruppe, einer Phenylgruppe, einer Biphenylgruppe, einer Terphenylgruppe, einer Naphthylgruppe, einer Carbazolgruppe, einer Dibenzofuranylgruppe oder einer Dibenzothiophenylgruppe, und
$R_{20}$ Wasserstoff, Deuterium, -F, eine Cyanogruppe, $-CD_3$, $-CD_2H$, $-CDH_2$, $-CF_3$, - $CF_2H$, - $CFH_2$, eine $C_1$-$C_{20}$-Alkylgruppe oder eine Phenylgruppe ist.

**8.** Organische lichtemittierende Vorrichtung nach einem der Ansprüche 1-7, wobei c10 1 ist.

**9.** Organische lichtemittierende Vorrichtung nach einem der Ansprüche 1-8, wobei die Silanverbindung dargestellt durch Formel 1 dargestellt ist durch eine von Formel 10-1 bis 10-5:

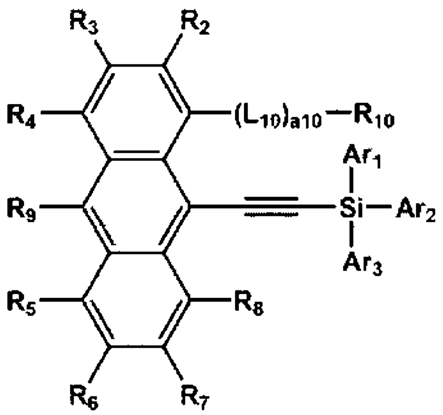

10-1

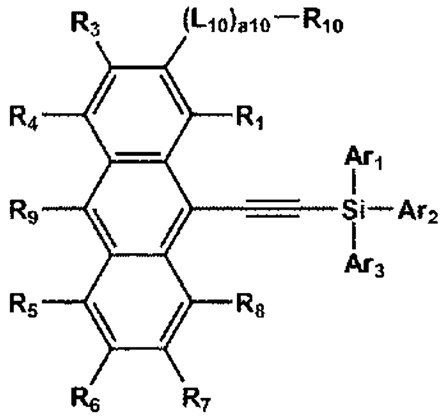

10-2

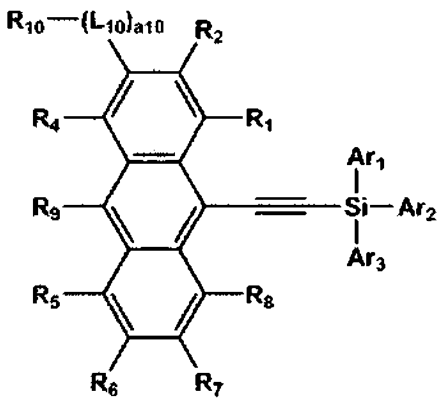

10-3

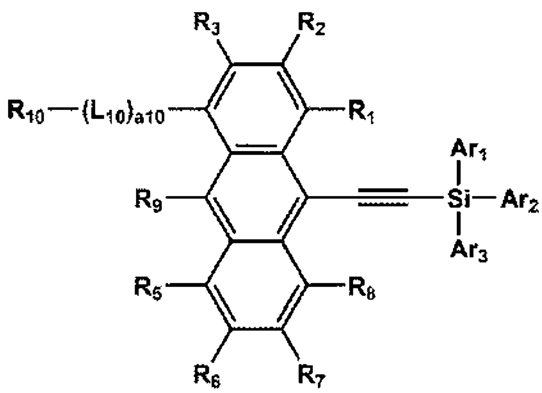

10-4

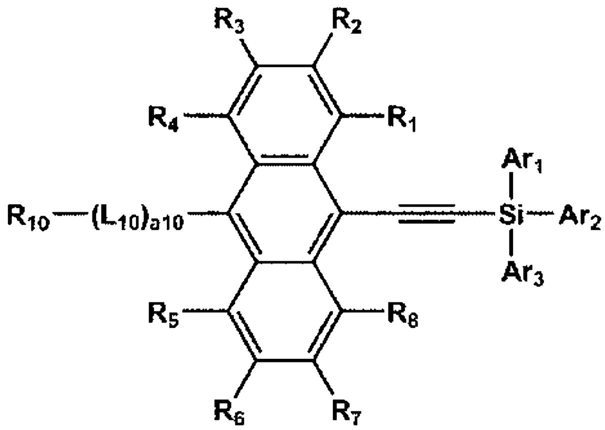

**10-5**

wobei in Formel 10-1 bis 10-5
$Ar_1$ bis $Ar_3$, $L_{10}$, a10 und $R_{10}$ jeweils durch Bezugnahme auf die Beschreibungen von $Ar_1$ bis $Ar_3$, $L_{10}$, a10 und $R_{10}$ in Anspruch 1 verstanden werden, und
$R_1$ bis $R_9$ jeweils unabhängig durch Bezugnahme auf die Beschreibung von $R_{20}$ in Anspruch 1 verstanden werden;
wobei bevorzugt die Silanverbindung dargestellt durch Formel 1 eine Verbindung dargestellt durch Formel 10-5 ist, und
$R_{10}$ wie folgt ist:

Deuterium, -F, eine Cyanogruppe, $-CD_3$, $-CD_2H$, $-CDH_2$, $-CF_3$, $-CF_2H$, $-CFH_2$, eine $C_1$-$C_{20}$-Alkylgruppe, eine $C_1$-$C_{20}$-Alkylthiogruppe oder eine $C_1$-$C_{20}$-Alkoxygruppe;
eine $C_1$-$C_{20}$-Alkylgruppe, eine $C_1$-$C_{20}$-Alkylthiogruppe oder eine $C_1$-$C_{20}$-Alkoxygruppe, jeweils unabhängig substituiert mit zumindest einem von Deuterium, einer Cyanogruppe, einer Phenylgruppe, einer Biphenylgruppe, einer Terphenylgruppe oder einer Naphthylgruppe;
eine Cyclopentylgruppe, eine Cyclohexylgruppe, eine Cyclopentenylgruppe, eine Cyclohexenylgruppe, eine Cycloheptenylgruppe, eine Phenylgruppe, eine Biphenylgruppe, eine Terphenylgruppe, eine Naphthylgruppe, eine Fluorenylgruppe, eine Carbazolylgruppe, eine Dibenzofuranylgruppe, eine Dibenzothiophenylgruppe, eine Benzocarbazolylgruppe, eine Azacarbazolylgruppe, eine Azadibenzofuranylgruppe, eine Azadibenzothiophenylgruppe, eine Phenoxazinylgruppe oder eine Phenothiazinylgruppe; oder
eine Cyclopentylgruppe, eine Cyclohexylgruppe, eine Cyclopentenylgruppe, eine Cyclohexenylgruppe, eine Cycloheptenylgruppe, eine Phenylgruppe, eine Biphenylgruppe, eine Terphenylgruppe, eine Naphthylgruppe, eine Fluorenylgruppe, eine Carbazolylgruppe, eine Dibenzofuranylgruppe, eine Dibenzothiophenylgruppe, eine Benzocarbazolylgruppe, eine Azacarbazolylgruppe, eine Azadibenzofuranylgruppe, eine Azadibenzothiophenylgruppe, eine Phenoxazinylgruppe oder eine Phenothiazinylgruppe, jeweils unabhängig substituiert mit zumindest einem von Deuterium, einer Cyanogruppe, einer $C_1$-$C_{20}$-Alkylgruppe, einer $C_1$-$C_{20}$-Alkoxygruppe, einer $C_1$-$C_{20}$-Alkylthiogruppe, einer Phenylgruppe, einer Biphenylgruppe, einer Terphenylgruppe, einer Naphthylgruppe, einer Carbazolgruppe, einer Dibenzofuranylgruppe oder einer Dibenzothiophenylgruppe.

**10.** Organische lichtemittierende Vorrichtung nach einem der Ansprüche 1-9, wobei die Silanverbindung dargestellt durch Formel 1 Gleichung 1 erfüllt:

Gleichung 1

$$E(T1) < E(S1) < 2 \times E(T1)$$

wobei in Gleichung 1
E(T1) ein niedrigstes angeregtes Triplett-Energieniveau der Silanverbindung angibt und E(S1) ein niedrigstes angeregtes Singulett-Energieniveau der Silanverbindung angibt.

11. Organische lichtemittierende Vorrichtung nach einem der Ansprüche 1-10, wobei die Silanverbindung dargestellt durch Formel 1 Gleichung 2 erfüllt:

Gleichung 2

$$[2 \times E(T1)] - E(S1) < 1 \text{ Elektronenvolt}$$

wobei in Gleichung 2
E(T1) ein niedrigstes angeregtes Triplett-Energieniveau der Silanverbindung angibt und E(S1) ein niedrigstes angeregtes Singulett-Energieniveau der Silanverbindung angibt.

12. Organische lichtemittierende Vorrichtung nach Anspruch 1, wobei die Silanverbindung dargestellt durch Formel 1 eine von Verbindung 1-16,18-121, 123-130, 145-160 ist:

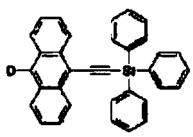
1

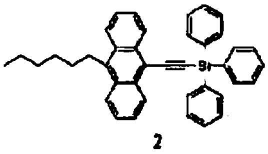
2

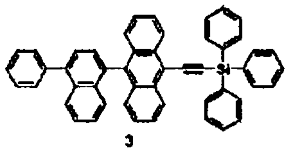
3

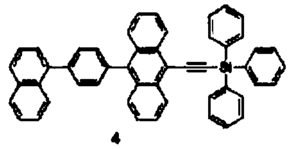
4

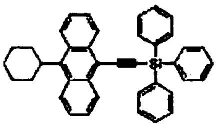
5

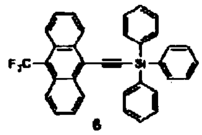
6

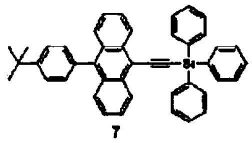
7

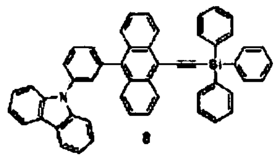
8

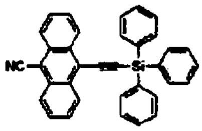
9

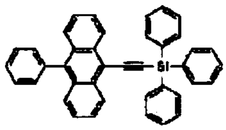
10

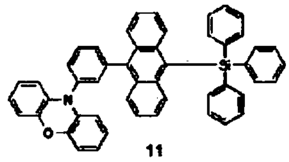
11

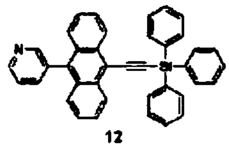
12

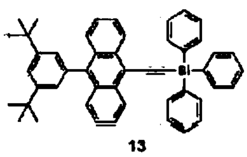
13

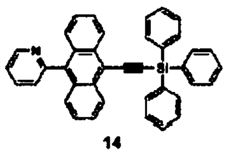
14

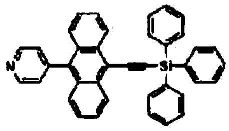
15

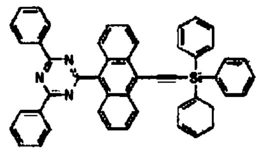
16

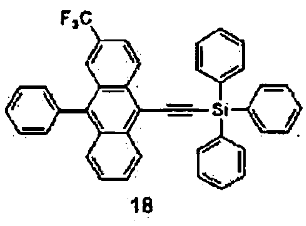
18

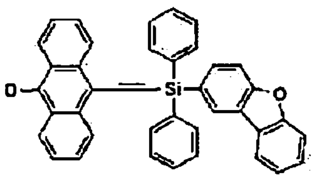
19

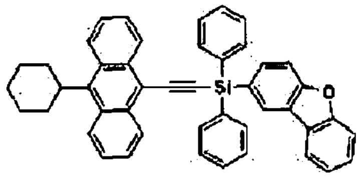
20

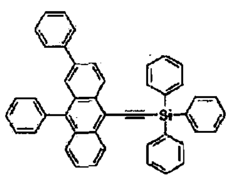
21

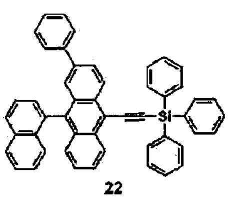
22

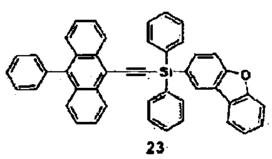
23

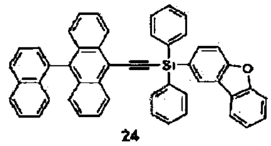
24

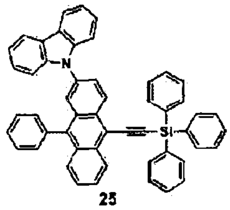

25

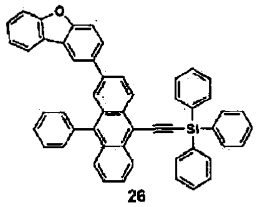

26

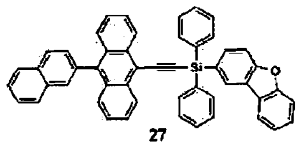

27

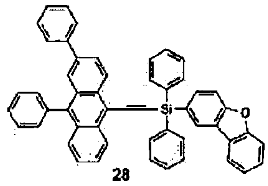

28

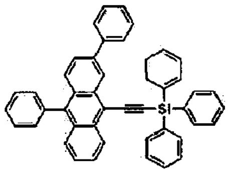

29

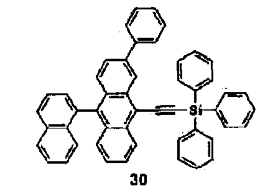

30

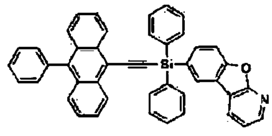

31

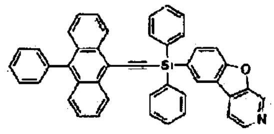

32

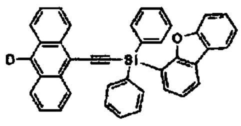

33

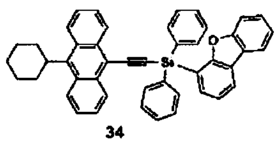

34

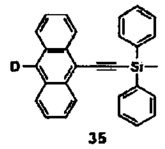

35

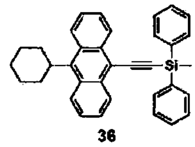

36

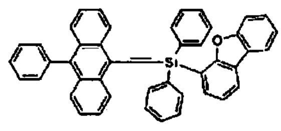

37

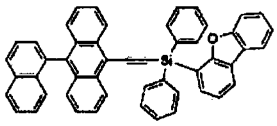

38

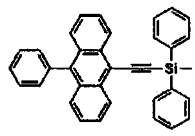

39

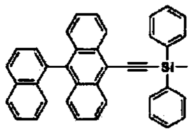

40

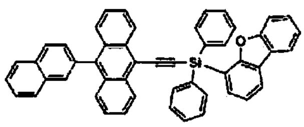

41

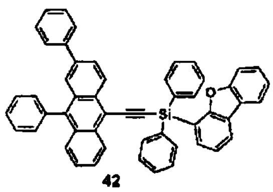

42

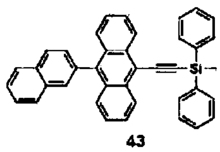

43

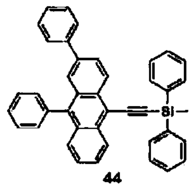

44

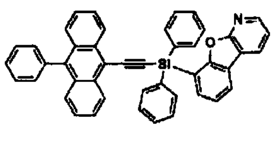

45

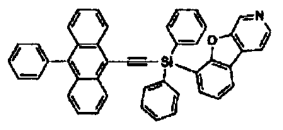

46

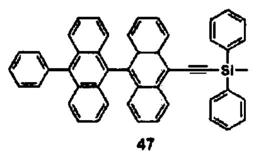

47

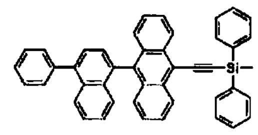

48

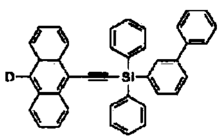

49

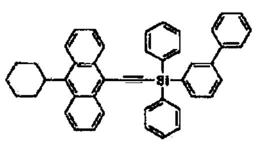

50

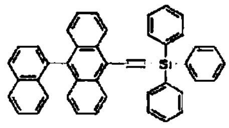

51

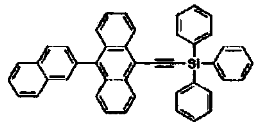

52

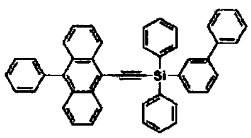

53

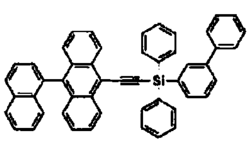

54

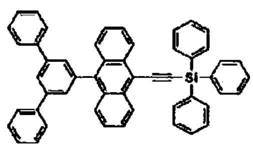

55

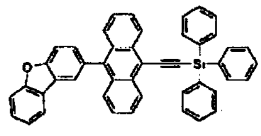

56

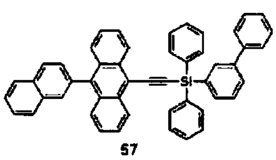
57

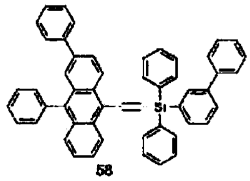
58

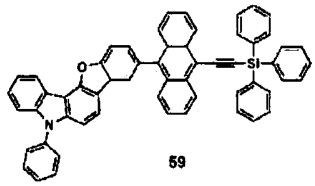
59

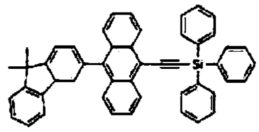
60

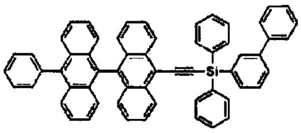
61

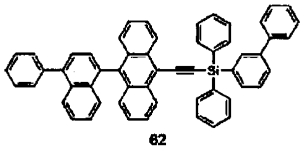
62

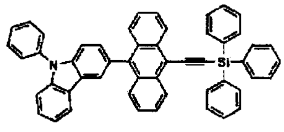
63

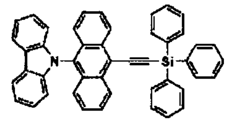
64

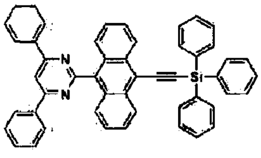
65

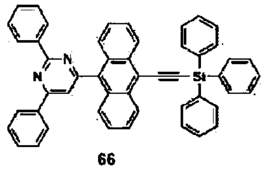
66

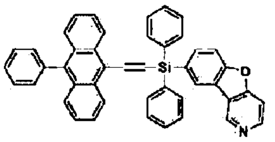
67

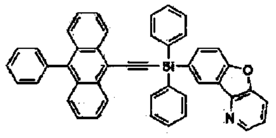
68

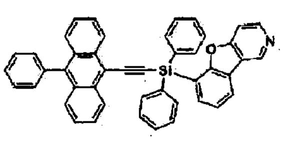
69

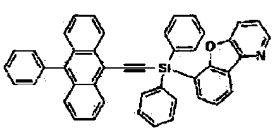
70

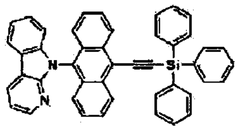
71

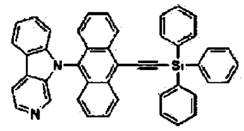
72

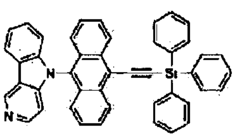
73

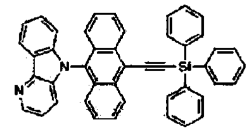
74

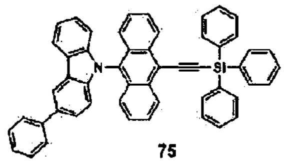
75

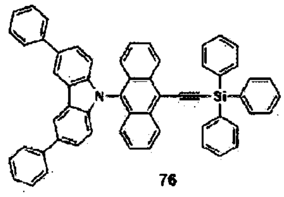
76

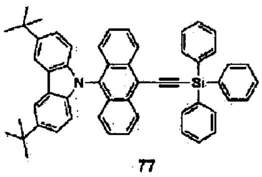
77

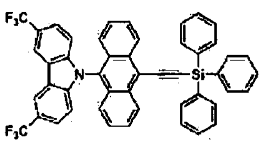
78

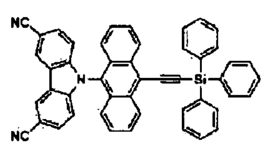
79

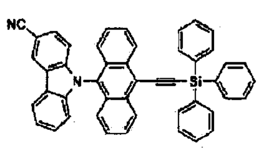
80

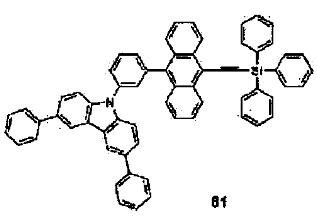
81

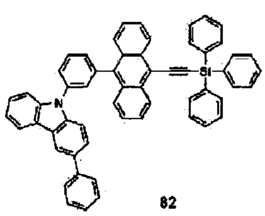
82

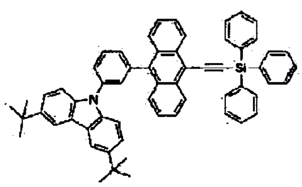
83

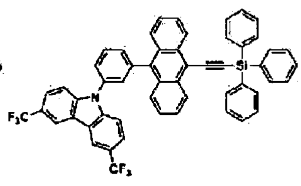
84

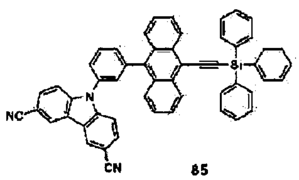
85

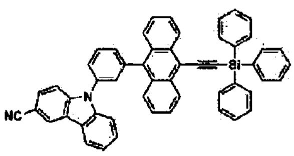
86

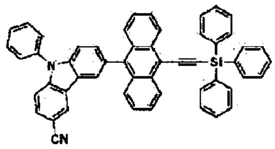
87

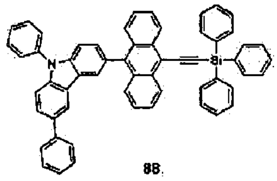
88

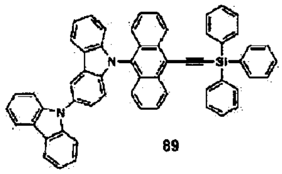
89

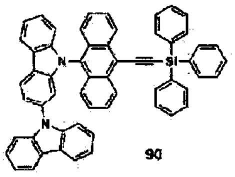
90

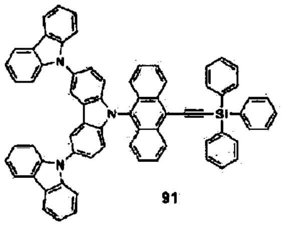
91

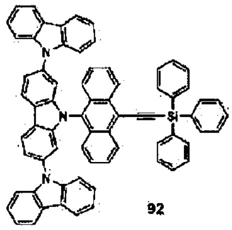
92

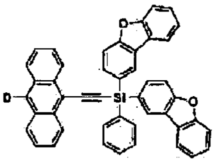
93

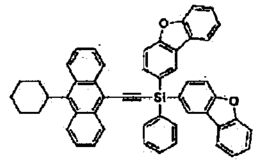
94

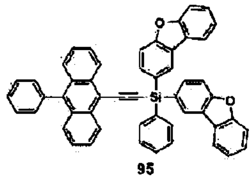
95

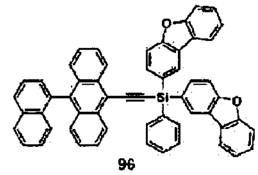
96

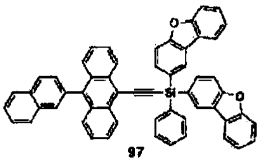
97

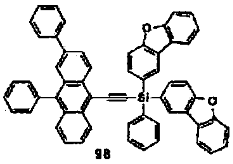
98

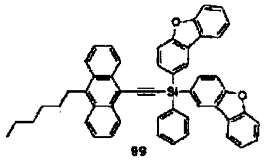
99

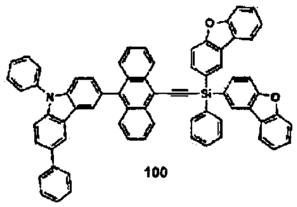
100

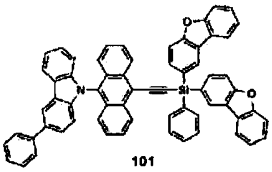
101

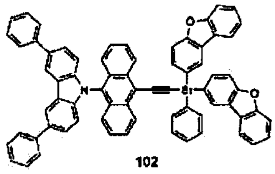
102

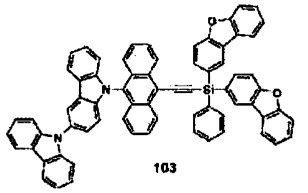
103

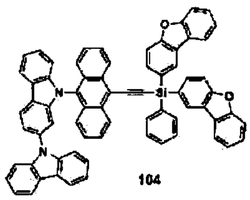
104

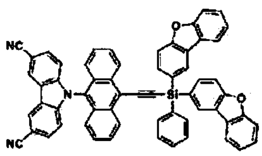
105

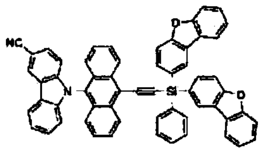
106

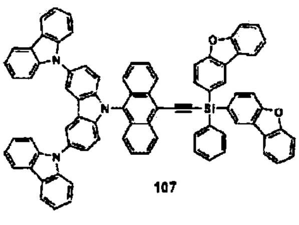
107

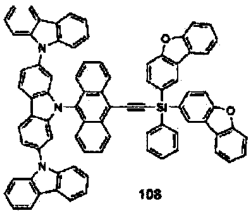
108

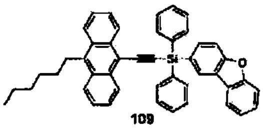
109

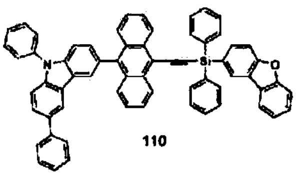
110

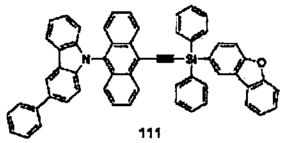
111

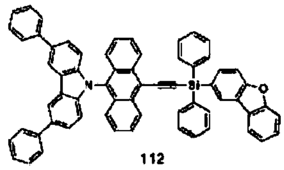
112

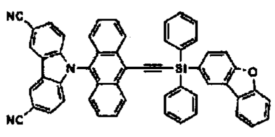
113

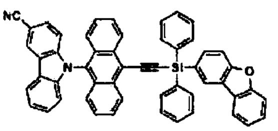
114

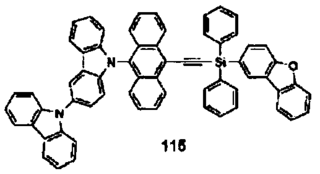
115

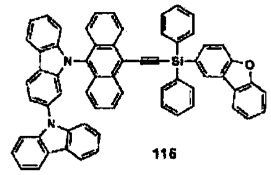
116

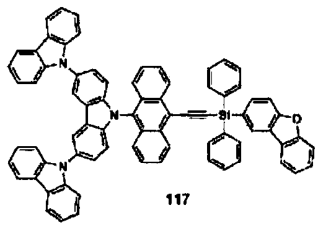
117

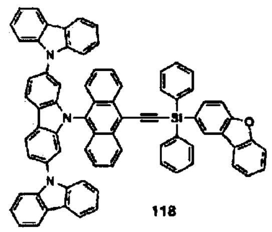
118

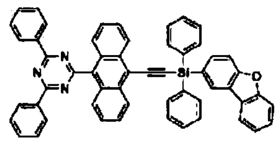
119

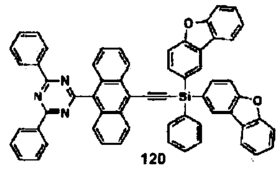
120

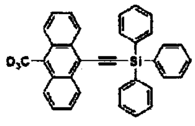
121

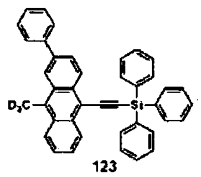
123

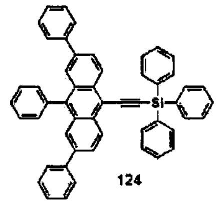
124

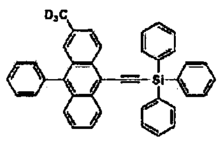
125

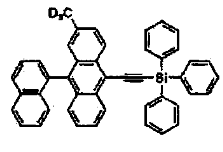
126

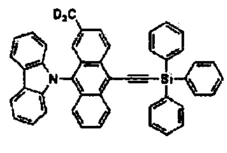
127

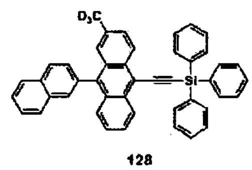
128

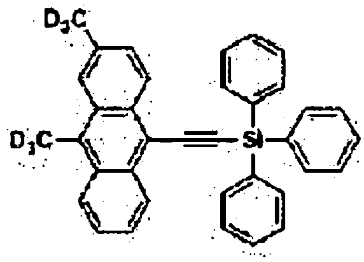
129

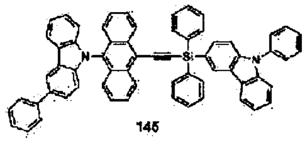
145

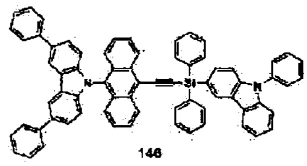
146

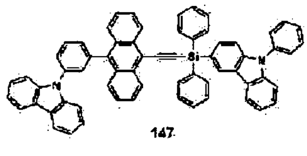
147

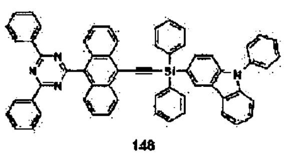
148

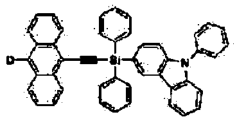
149

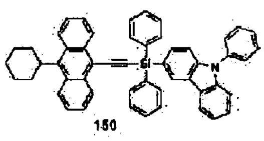
150

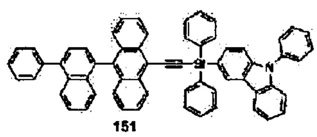
151

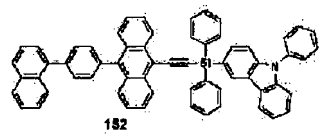
152

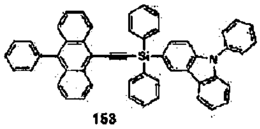
153

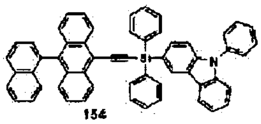
154

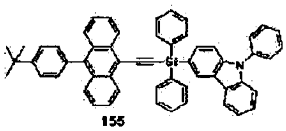
155

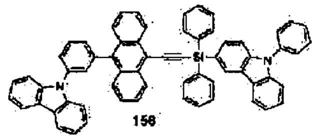
156

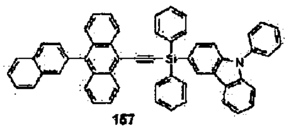
157

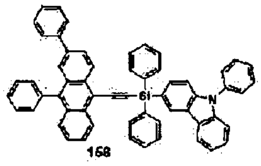
158

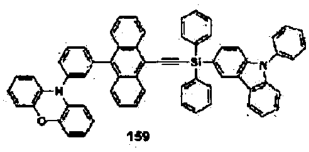
159

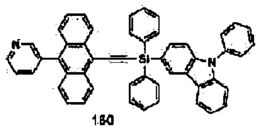
160

.

**13.** Organische lichtemittierende Vorrichtung nach einem der Ansprüche 1-12, wobei ein Gehalt des Wirts größer als ein Gehalt des Dotierstoffes ist, und/oder

wobei der Wirt aus der Silanverbindung besteht; und/oder
wobei ein Verhältnis von Emissionskomponenten emittiert von dem Dotierstoff 80 Prozent oder größer der gesamten Emissionskomponenten emittiert von der Emissionsschicht ist; und/oder
wobei der Dotierstoff ein fluoreszierender Dotierstoff ist; und/oder
wobei die Emissionsschicht blaues Licht mit einer maximalen Emissionswellenlänge in einer Spanne von 410 Nanometern bis 490 Nanometern emittiert.

**14.** Organische lichtemittierende Vorrichtung nach einem der Ansprüche 1-13, wobei die erste Elektrode eine Anode ist, die zweite Elektrode eine Kathode ist,

die organische Schicht eine Lochtransportregion zwischen der ersten Elektrode und der Emissionsschicht und eine Elektronentransportregion zwischen der Emissionsschicht und der zweiten Elektrode umfasst,
die Lochtransportregion eine Locheinspritzschicht, eine Lochtransportschicht oder eine Elektronenblockierschicht umfasst, und
die Elektronentransportregion zumindest eines von einer Lochblockierschicht, einer Elektronentransportschicht oder einer Elektroneneinpritzschicht umfasst.

## Revendications

**1.** Dispositif électroluminescent organique, comprenant :

une première électrode ;
une seconde électrode ; et
une couche organique entre la première électrode et la seconde électrode et comprenant une couche d'émission, dans lequel la couche d'émission comprend un hôte et un dopant, **caractérisé en ce que** l'hôte comprend au moins un composé silane représenté par la Formule 1 :

Formule 1

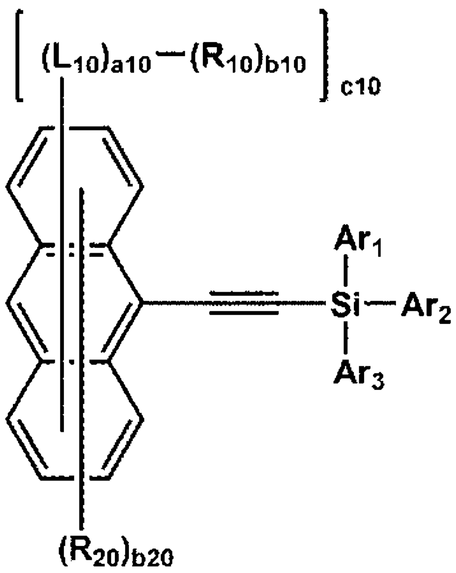

où, dans la Formule 1,

$Ar_1$ à $Ar_3$ sont chacun indépendamment un groupe alkyle en $C_1$-$C_{60}$ substitué ou non substitué, un groupe alcényle en $C_2$-$C_{60}$ substitué ou non substitué, un groupe alcynyle en $C_2$-$C_{60}$ substitué ou non substitué, un groupe alcoxy en $C_1$-$C_{60}$ substitué ou non substitué, un groupe alkylthio en $C_1$-$C_{60}$ substitué ou non substitué, un groupe cycloalkyle en $C_3$-$C_{10}$ substitué ou non substitué, un groupe hétérocycloalkyle en $C_1$-$C_{10}$ substitué ou non substitué, un groupe cycloalcényle en $C_3$-$C_{10}$ substitué ou non substitué, un groupe hétérocycloalcényle en $C_1$-$C_{10}$ substitué ou non substitué, un groupe aryle en $C_6$-$C_{60}$ substitué ou non substitué, un groupe aryloxy en $C_6$-$C_{60}$ substitué ou non substitué, un groupe arylthio en $C_6$-$C_{60}$ substitué ou non substitué, un groupe hétéroaryle en $C_1$-$C_{60}$ substitué ou non substitué, un groupe hétéroaryloxy en $C_1$-$C_{60}$ substitué ou non substitué, un groupe hétéroarylthio en $C_1$-$C_{60}$ substitué ou non substitué, un groupe polycyclique condensé non aromatique monovalent substitué ou non substitué, un groupe hétéropolycyclique condensé non aromatique monovalent substitué ou non substitué, $-N(Q_1)(Q_2)$, $-Si(Q_3)(Q_4)(Q_5)$, $-B(Q_6)(Q_7)$ ou $-P(=O)(Q_8)(Q_9)$,

au moins l'un de $Ar_1$ à $Ar_3$ est un groupe aryle en $C_6$-$C_{60}$ substitué ou non substitué, un groupe hétéroaryle en $C_1$-$C_{60}$ substitué ou non substitué, un groupe polycyclique condensé non aromatique monovalent substitué ou non substitué ou un groupe hétéropolycyclique condensé non aromatique monovalent substitué ou non substitué,

$L_{10}$ est un groupe carbocyclique en $C_5$-$C_{30}$ substitué ou non substitué ou un groupe hétérocyclique en $C_1$-$C_{30}$ substitué ou non substitué,

a10 est un entier de 0 à 3, et lorsque a10 est supérieur ou égal à 2, au moins deux $L_{10}$ sont identiques ou différents l'un de l'autre,

$R_{10}$ et $R_{20}$ sont chacun indépendamment un hydrogène, un deutérium, -F, un groupe cyano, $-CD_3$, $-CD_2H$, $-CDH_2$, $-CF_3$, $-CF_2H$, $-CFH_2$, des groupes représentés par les Formules 9-1 à 9-19, ou des groupes représentés par les Formules 10-1 à 10-211 :

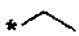
9-1

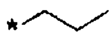
9-2

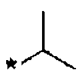
9-3

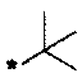
9-4

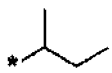
9-5

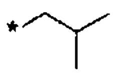
9-6

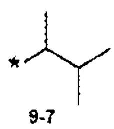
9-7

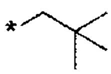
9-8

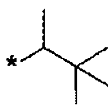
9-9

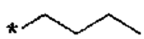
9-10

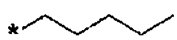
9-11

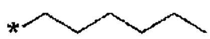
9-12

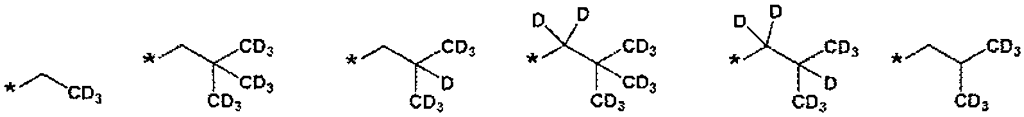

9-13 9-14 9-15 9-16 9-17 9-18

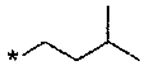

9-19

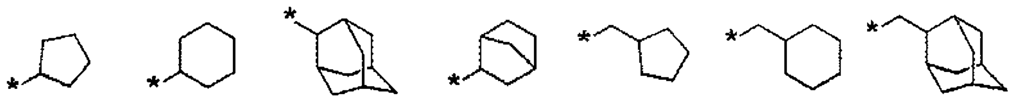

10-1 10-2 10-3 10-4 10-5 10-6 10-7

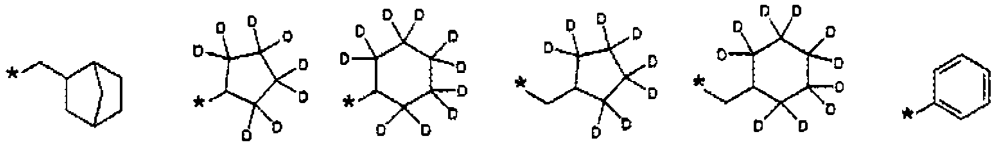

10-8 10-9 10-10 10-11 10-12 10-13

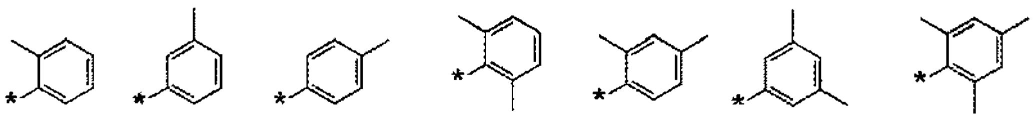

10-14 10-15 10-16 10-17 10-18 10-19 10-20

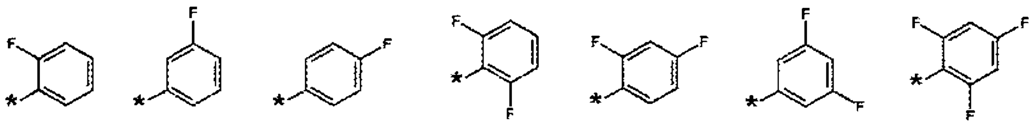

10-21 10-22 10-23 10-24 10-25 10-26 10-27

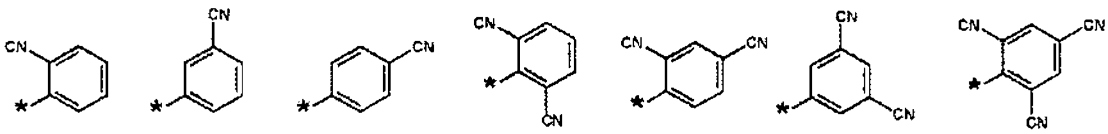

10-28 10-29 10-30 10-31 10-32 10-33 10-34

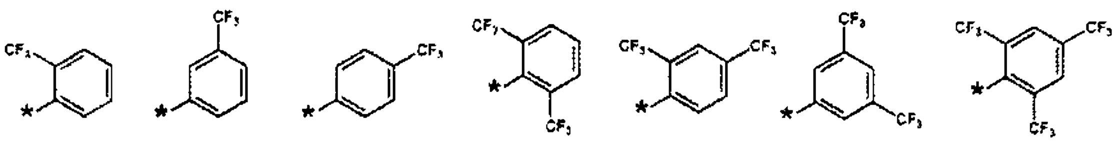

10-35 10-36 10-37 10-38 10-39 10-40 10-41

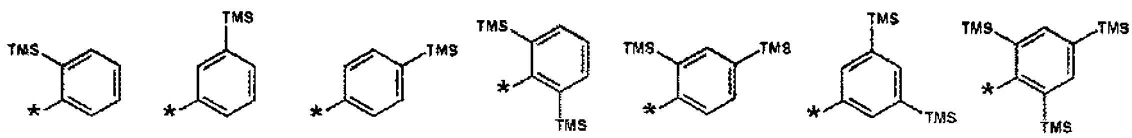

10-42 10-43 10-44 10-45 10-46 10-47 10-48

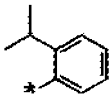 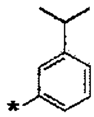 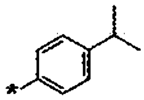 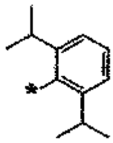 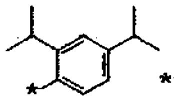 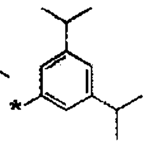 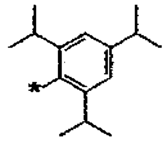

10-49 10-50 10-51 10-52 10-53 10-54 10-55

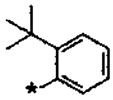 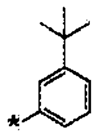 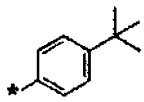 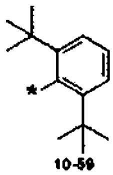 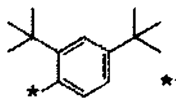 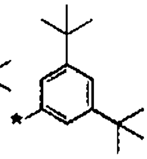 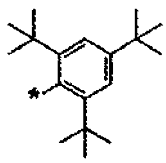

10-56 10-57 10-58 10-59 10-60 10-61 10-62

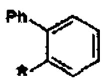 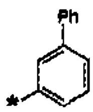 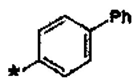 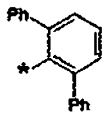 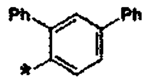 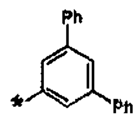 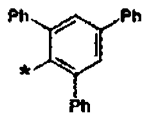

10-63 10-64 10-65 10-66 10-67 10-68 10-69

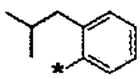 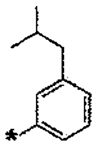 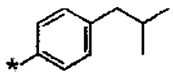 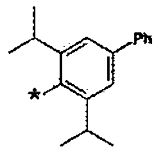 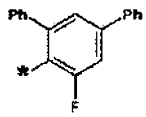 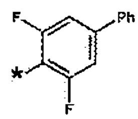

10-70 10-71 10-72 10-73 10-74 10-75

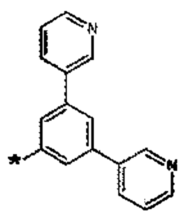 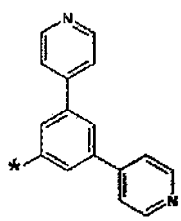 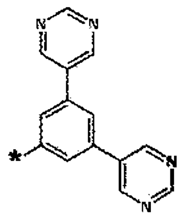 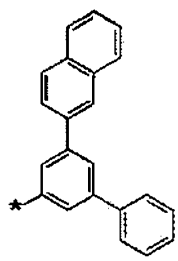 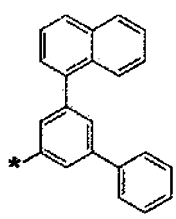

10-76 10-77 10-78 10-79 10-80

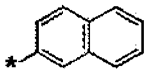 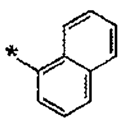 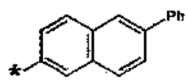 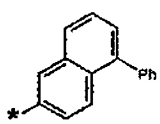 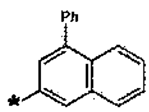

10-81 10-82 10-83 10-84 10-85

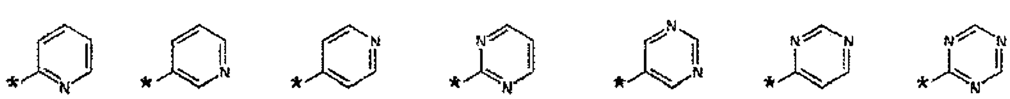

10-86 10-87 10-88 10-89 10-90 10-91 10-92

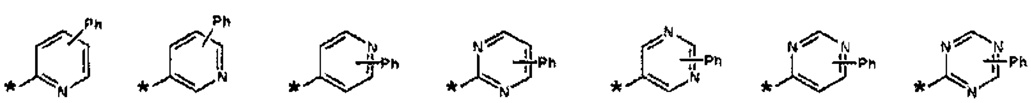

10-93 10-94 10-95 10-96 10-97 10-98 10-99

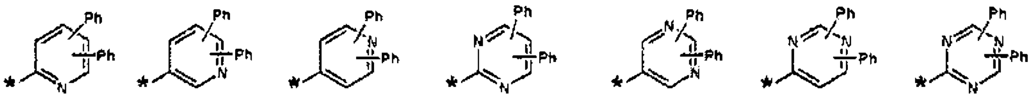

10-100 10-101 10-102 10-103 10-104 10-105 10-106

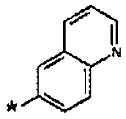 10-107
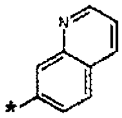 10-108
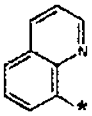 10-109
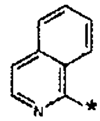 10-110
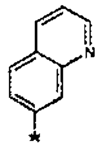 10-111
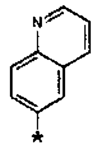 10-112

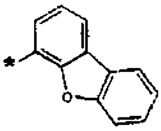 10-113
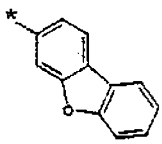 10-114
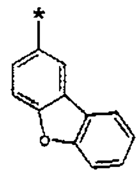 10-115
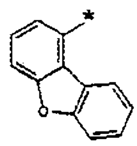 10-116
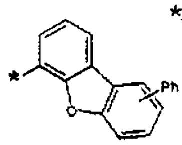 10-117
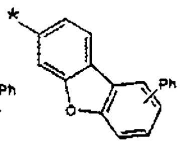 10-118

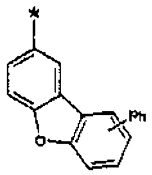 10-119
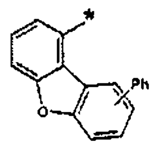 10-120
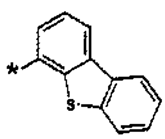 10-121
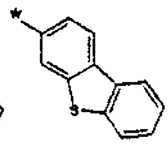 10-122
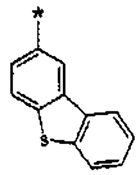 10-123
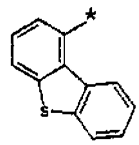 10-124

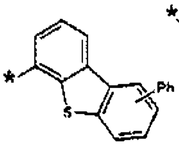 10-125
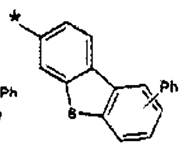 10-126
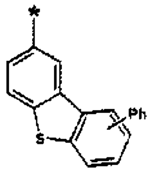 10-127
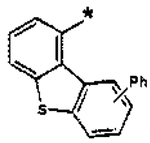 10-128
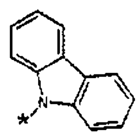 10-129
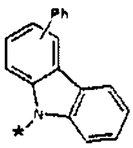 10-130

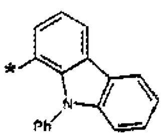 10-131
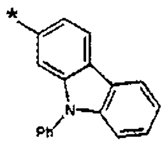 10-132
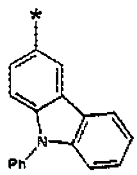 10-133
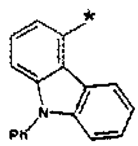 10-134
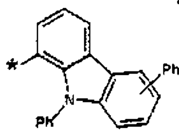 10-135
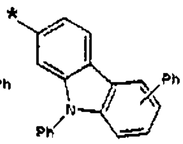 10-136

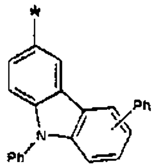 10-137
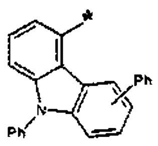 10-138
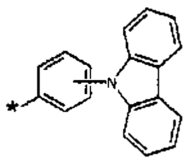 10-139
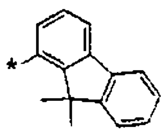 10-140
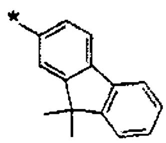 10-141
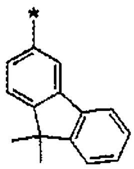 10-142

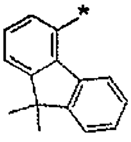 10-143 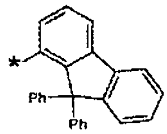 10-144 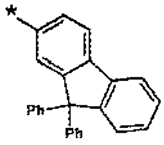 10-145 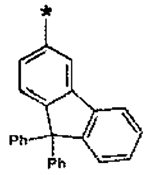 10-146 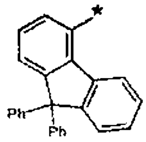 10-147

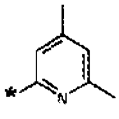 10-148 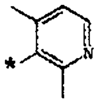 10-149 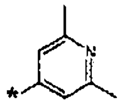 10-150 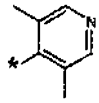 10-151 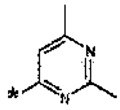 10-152 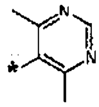 10-153 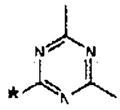 10-154

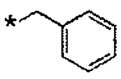 10-155 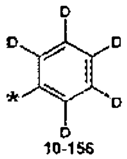 10-156 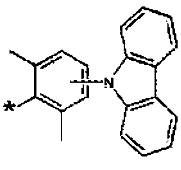 10-157 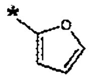 10-158 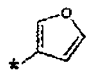 10-159 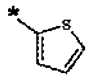 10-160 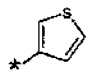 10-161

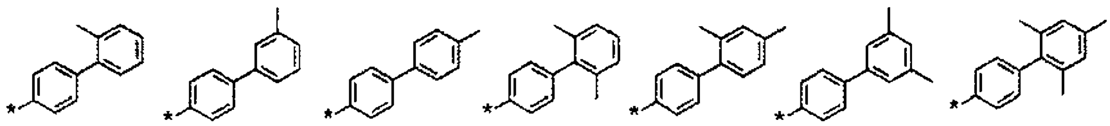

10-162 10-163 10-164 10-165 10-166 10-167 10-168

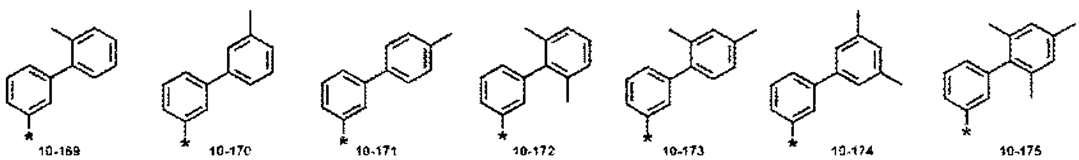

10-169 10-170 10-171 10-172 10-173 10-174 10-175

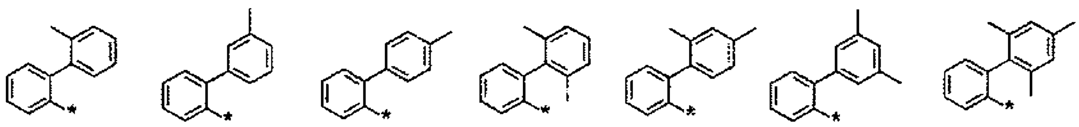

10-176 10-177 10-178 10-179 10-180 10-181 10-182

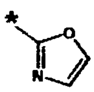 10-183 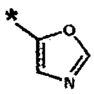 10-184 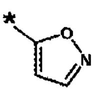 10-185 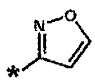 10-186 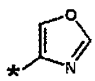 10-187 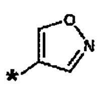 10-188 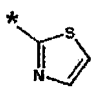 10-189 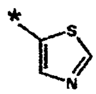 10-190 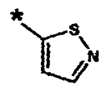 10-191

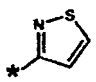 10-192 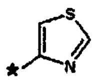 10-193 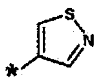 10-194

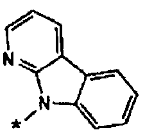 10-195 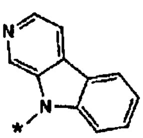 10-196 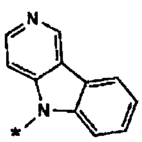 10-197 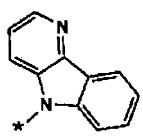 10-198 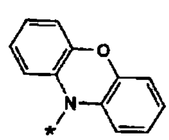 10-200 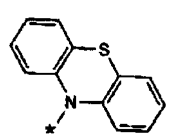 10-201

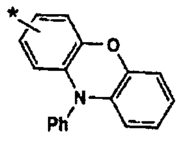
10-202

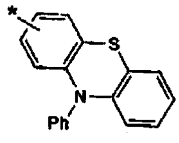
10-203

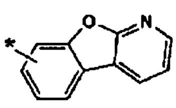
10-204

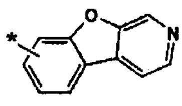
10-205

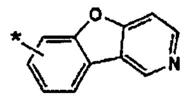
10-206

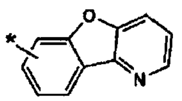
10-207

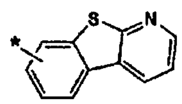
10-208

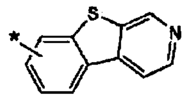
10-209

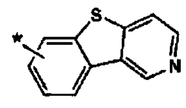
10-210

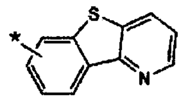
10-211

où, dans les Formules 9-1 à 9-19 et 10-1 à 10-211, * indique un site de liaison à un atome adjacent, « Ph » représente un groupe phényle et « TMS » représente un groupe triméthylsilyle,
b10 et b20 sont chacun indépendamment un entier de 1 à 8,
lorsque b10 est supérieur ou égal à 2, au moins deux $R_{10}$ sont identiques ou différents l'un de l'autre, et lorsque b20 est supérieur ou égal à 2, au moins deux $R_{20}$ sont identiques ou différents l'un de l'autre,
c10 est un entier de 1 à 9,
lorsque c10 est supérieur ou égal à 2, au moins deux $-[(L_{10})_{a10}-(R_{10})_{b10}]$ sont identiques ou différents l'un de l'autre,
au moins un substituent du groupe carbocyclique en $C_5$-$C_{30}$ substitué, du groupe hétérocyclique en $C_1$-$C_{30}$ substitué, du groupe alkyle en $C_1$-$C_{60}$ substitué, du groupe alcényle en $C_2$-$C_{60}$ substitué, du groupe alcynyle en $C_2$-$C_{60}$ substitué, du groupe alcoxy en $C_1$-$C_{60}$ substitué, du groupe alkylthio en $C_1$-$C_{60}$ substitué, du groupe cycloalkyle en $C_3$-$C_{10}$ substitué, du groupe hétérocycloalkyle en $C_1$-$C_{10}$ substitué, du groupe cycloalcényle en $C_3$-$C_{10}$ substitué, du groupe hétérocycloalcényle en $C_1$-$C_{10}$ substitué, du groupe aryle en $C_6$-$C_{60}$ substitué, du groupe aryloxy en $C_6$-$C_{60}$ substitué, du groupe arylthio en $C_6$-$C_{60}$ substitué, du groupe hétéroaryle en $C_1$-$C_{60}$ substitué, du groupe hétéroaryloxy en $C_1$-$C_{60}$ substitué, du groupe hététoarylthio en $C_1$-$C_{60}$ substitué, du groupe polycyclique condensé non aromatique monovalent substitué et du groupe hétéropolycyclique condensé non aromatique monovalent substitué est :

un deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$-$C_{60}$, un groupe alcényle en $C_2$-$C_{60}$, un groupe alcynyle en $C_2$-$C_{60}$, un groupe alkylthio en $C_1$-$C_{60}$ ou un groupe alcoxy en $C_1$-$C_{60}$ ;
un groupe alkyle en $C_1$-$C_{60}$, un groupe alcényle en $C_2$-$C_{60}$, un groupe alcynyle en $C_2$-$C_{60}$, un groupe alkylthio en $C_1$-$C_{60}$, ou un groupe alcoxy en $C_1$-$C_{60}$, chacun étant indépendamment substitué par au moins l'un parmi un deutérium, -F, -Cl, -Br, -I, $-CD_3$, $-CD_2H$, $-CDH_2$, $-CF_3$, - $CF_2H$, $-CFH_2$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle en $C_3$-$C_{10}$, un groupe hétérocycloalkyle en $C_1$-$C_{10}$, un groupe cycloalcényle en $C_3$-$C_{10}$, un groupe hétérocycloalcényle en $C_1$-$C_{10}$, un groupe aryle en $C_6$-$C_{60}$, un aryloxy en $C_6$-$C_{60}$, un groupe arylthio en $C_6$-$C_{60}$, un groupe hétéroaryle en $C_1$-$C_{60}$, un groupe hétéroaryloxy en $C_1$-$C_{60}$, un groupe hétéroarylthio en $C_1$-$C_{60}$, un groupe polycyclique condensé non aromatique monovalent, un groupe hétéropolycyclique condensé non aromatique monovalent, $-Si(Q_{11})(Q_{12})(Q_{13})$, $-N(Q_{14})(Q_{15})$ ou $-B(Q_{16})(Q_{17})$ ;
un groupe cycloalkyle en $C_3$-$C_{10}$, un groupe hétérocycloalkyle en $C_1$-$C_{10}$, un groupe cycloalcényle en $C_3$-$C_{10}$, un groupe hétérocycloalcényle en $C_1$-$C_{10}$, un groupe aryle en $C_6$-$C_{60}$, un groupe aryloxy en $C_6$-$C_{60}$, un groupe arylthio en $C_6$-$C_{60}$, un groupe hétéroaryle en $C_1$-$C_{60}$, un groupe hétéroaryloxy en $C_1$-$C_{60}$, un groupe hétéroarylthio en $C_1$-$C_{60}$, un groupe polycyclique condensé non aromatique monovalent ou un groupe hétéropolycyclique condensé non aromatique monovalent ;
un groupe cycloalkyle en $C_3$-$C_{10}$, un groupe hétérocycloalkyle en $C_1$-$C_{10}$, un groupe cycloalcényle en $C_3$-$C_{10}$, un groupe hétérocycloalcényle en $C_1$-$C_{10}$, un groupe aryle en $C_6$-$C_{60}$, un groupe aryloxy en $C_6$-$C_{60}$, un groupe arylthio en $C_6$-$C_{60}$, un groupe hétéroaryle en $C_1$-$C_{60}$, un groupe hétéroaryloxy en $C_1$-$C_{60}$, un groupe hétéroarylthio en $C_1$-$C_{60}$, un groupe polycyclique condensé non aromatique monovalent ou un groupe hétéropolycyclique condensé non aromatique monovalent, chacun étant indépendamment substitué par au moins l'un parmi un deutérium, -F, - Cl, -Br, -I, $-CD_3$, $-CD_2H$, $-CDH_2$, $-CF_3$, $-CF_2H$, $-CFH_2$, un groupe

hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$-$C_{60}$, un groupe alcényle en $C_2$-$C_{60}$, un groupe alcynyle en $C_2$-$C_{60}$, un groupe alcoxy en $C_1$-$C_{60}$ , un groupe alkylthio en $C_1$-$C_{60}$, un groupe cycloalkyle en $C_3$-$C_{10}$, un groupe hétérocycloalkyle en $C_1$-$C_{10}$, un groupe cycloalcényle en $C_3$-$C_{10}$, un groupe hétérocycloalcényle en $C_1$-$C_{10}$, un groupe aryle en $C_6$-$C_{60}$, un groupe aryloxy en $C_6$-$C_{60}$, un groupe arylthio en $C_6$-$C_{60}$, un groupe hétéroaryle en $C_1$-$C_{60}$, un groupe hétéroaryloxy en $C_1$-$C_{60}$, un groupe hétéroarylthio en $C_1$-$C_{60}$, un groupe polycyclique condensé non aromatique monovalent, un groupe hétéropolycyclique condensé non aromatique monovalent, -Si($Q_{21}$)($Q_{22}$)($Q_{23}$), -N($Q_{24}$)($Q_{25}$) ou -B($Q_{26}$)($Q_{27}$) ; ou

-S1($Q_{31}$)($Q_{32}$)($Q_{33}$), -N($Q_{34}$)($Q_{35}$) ou -B($Q_{36}$)($Q_{37}$), où $Q_1$ à $Q_9$, $Q_{11}$ à $Q_{17}$, $Q_{21}$ à $Q_{27}$ et $Q_{31}$ à $Q_{37}$ sont chacun indépendamment un hydrogène, un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$-$C_{60}$ substitué ou non substitué, un groupe alcényle en $C_2$-$C_{60}$ substitué ou non substitué, un groupe alcynyle en $C_2$-$C_{60}$ substitué ou non substitué, un groupe alcoxy en $C_1$-$C_{60}$ substitué ou non substitué, un groupe alkylthio en $C_1$-$C_{60}$ substitué ou non substitué, un groupe cycloalkyle en $C_3$-$C_{10}$ substitué ou non substitué, un groupe hétérocycloalkyle en $C_1$-$C_{10}$ substitué ou non substitué, un groupe cycloalcényle en $C_3$-$C_{10}$ substitué ou non substitué, un groupe hétérocycloalcényle en $C_1$-$C_{10}$ substitué ou non substitué, un groupe aryle en $C_6$-$C_{60}$ substitué ou non substitué, un groupe aryloxy en $C_6$-$C_{60}$ substitué ou non substitué, un groupe arylthio en $C_6$-$C_{60}$ substitué ou non substitué, un groupe hétéroaryle en $C_1$-$C_{60}$ substitué ou non substitué, un groupe hétéroaryloxy en $C_1$-$C_{60}$ substitué ou non substitué, un groupe hétéroarylthio en $C_1$-$C_{60}$ substitué ou non substitué, un groupe polycyclique condensé non aromatique monovalent substitué ou non substitué ou un groupe hétéropolycyclique condensé non aromatique monovalent substitué ou non substitué, et

où les substituants $L_{10}$, $R_{10}$ et $R_{20}$ sont présents sur chaque cycle à travers lequel passe la liaison avec le substituant correspondant.

**2.** Dispositif électroluminescent organique de la revendication 1, dans lequel $Ar_1$ à $Ar_3$ sont chacun indépendamment :

un groupe alkyle en $C_1$-$C_{20}$, un groupe alkylthio en $C_1$-$C_{20}$ ou un groupe alcoxy en $C_1$-$C_{20}$ ;

un groupe alkyle en $C_1$-$C_{20}$, un groupe alkylthio en $C_1$-$C_{20}$ ou un groupe alcoxy en $C_1$-$C_{20}$, chacun étant indépendamment substitué par au moins l'un parmi un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe phényle, un groupe naphtyle, un groupe pyridinyle, un groupe pyrimidinyle, un groupe pyrazinyle, un groupe pyridazinyle ou un groupe triazinyle ;

un groupe cyclopentyle, un groupe cyclohexyle, un groupe cyclopentényle, un groupe cyclohexényle, un groupe cycloheptényle, un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-bifluorényle, un groupe phénalényle, un groupe phénanthrényle, un groupe anthracényle, un groupe fluoranthényle, un groupe triphénylényle, un groupe pyrényle, un groupe chrysényle, un groupe naphtacényle, un groupe picényle, un groupe pérylényle, un groupe pentaphényle, un groupe hexacényle, un groupe pyrrolyle, un groupe imidazolyle, un groupe pyrazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe cinnolinyle, un groupe phénanthridinyle, un groupe acridinyle, un groupe phénanthrolinyle, un groupe phénazinyle, un groupe benzoxazolyle, un groupe benzimidazolyle, un groupe furanyle, un groupe benzofuranyle, un groupe thiophényle, un groupe benzothiophényle, un groupe thiazolyle, un groupe isothiazolyle, un groupe benzothiazolyle, un groupe isoxazolyle, un groupe oxazolyle, un groupe triazolyle, un groupe tétrazolyle, un groupe oxadiazolyle, un groupe triazinyle, un groupe carbazolyle, un groupe dibenzofuranyle, un groupe dibenzothiophényle, un groupe benzocarbazolyle, un groupe azacarbazolyle, un groupe azadibenzofuranyle, un groupe azadibenzothiophényle, un groupe phénoxazinyle, un groupe phénothiazinyle, un groupe imidazopyrimidinyle ou un groupe imidazopyridinyle ; et

un groupe cyclopentyle, un groupe cyclohexyle, un groupe cyclopentényle, un groupe cyclohexényle, un groupe cycloheptényle, un groupe phényle, un groupe pentalényle, un groupe indényle, un groupe naphtyle, un groupe azulényle, un groupe heptalényle, un groupe indacényle, un groupe acénaphtyle, un groupe fluorényle, un

groupe spiro-bifluorényle, un groupe phénalényle, un groupe phénanthrényle, un groupe anthracényle, un groupe fluoranthényle, un groupe triphénylényle, un groupe pyrényle, un groupe chrysényle, un groupe naphtacényle, un groupe picényle, un groupe pérylényle, un groupe pentaphényle, un groupe hexacényle, un groupe pyrrolyle, un groupe imidazolyle, un groupe pyrazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe phtalazinyle, un groupe naphthyridinyle, un groupe quinoxalinyle, un groupe quinazolinyle, un groupe cinnolinyle, un groupe phénanthridinyle, un groupe acridinyle, un groupe phénanthrolinyle, un groupe phénazinyle, un groupe benzoxazolyle, un groupe benzimidazolyle, un groupe furanyle, un groupe benzofuranyle, un groupe thiophényle, un groupe benzothiophényle, un groupe thiazolyle, un groupe isothiazolyle, un groupe benzothiazolyle, un groupe isoxazolyle, un groupe oxazolyle, un groupe triazolyle, un groupe tétrazolyle, un groupe oxadiazolyle, un groupe triazinyle, un groupe carbazolyle, un groupe dibenzofuranyle, un groupe dibenzothiophényle, un groupe benzocarbazolyle, un groupe azacarbazolyle, un groupe azadibenzofuranyle, un groupe azadibenzothiophényle, un groupe phénoxazinyle, un groupe phénothiazinyle, un groupe imidazopyrimidinyle ou un groupe imidazopyridinyle, chacun étant indépendamment substitué par au moins l'un parmi un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$-$C_{20}$, un groupe alcényle en $C_2$-$C_{20}$, un groupe alcynyle en $C_2$-$C_{20}$, un groupe alcoxy en $C_1$-$C_{20}$, un groupe alkylthio en $C_1$-$C_{20}$, un groupe phényle, un groupe naphtyle, un groupe anthracényle, un groupe pyrényle, un groupe phénanthrényle, un groupe fluorényle, un groupe pyridinyle, un groupe pyrimidinyle, un groupe pyrazinyle, un groupe pyridazinyle, un groupe triazinyle, un groupe quinolinyle, un groupe isoquinolinyle, un groupe phtalazinyle, un groupe quinoxalinyle, un groupe cinnolinyle ou un groupe quinazolinyle.

**3.** Dispositif électroluminescent organique de l'une des revendications 1 ou 2, dans lequel $Ar_1$ à $Ar_3$ sont chacun indépendamment :

un groupe cyclopentyle, un groupe cyclohexyle, un groupe cyclopentényle, un groupe cyclohexényle, un groupe cycloheptényle, un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-bifluorényle, un groupe phénalényle, un groupe phénanthrényle, un groupe anthracényle, un groupe fluoranthényle, un groupe triphénylényle, un groupe pyrényle, un groupe chrysényle, un groupe naphtacényle, un groupe picényle, un groupe pérylényle, un groupe pentaphényle, un groupe hexacényle, un groupe pyrrolyle, un groupe imidazolyle, un groupe pyrazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe cinnolinyle, un groupe phénanthridinyle, un groupe acridinyle, un groupe phénanthrolinyle, un groupe phénazinyle, un groupe benzoxazolyle, un groupe benzimidazolyle, un groupe furanyle, un groupe benzofuranyle, un groupe thiophényle, un groupe benzothiophényle, un groupe thiazolyle, un groupe isothiazolyle, un groupe benzothiazolyle, un groupe isoxazolyle, un groupe oxazolyle, un groupe triazolyle, un groupe tétrazolyle, un groupe oxadiazolyle, un groupe triazinyle, un groupe carbazolyle, un groupe dibenzofuranyle, un groupe dibenzothiophényle, un groupe benzocarbazolyle, un groupe azacarbazolyle, un groupe azadibenzofuranyle, un groupe azadibenzothiophényle, un groupe phénoxazinyle, un groupe phénothiazinyle, un groupe imidazopyrimidinyle ou un groupe imidazopyridinyle ; et
un groupe cyclopentyle, un groupe cyclohexyle, un groupe cyclopentényle, un groupe cyclohexényle, un groupe cycloheptényle, un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-bifluorényle, un groupe phénalényle, un groupe phénanthrényle, un groupe anthracényle, un groupe fluoranthényle, un groupe triphénylényle, un groupe pyrényle, un groupe chrysényle, un groupe naphtacényle, un groupe picényle, un groupe pérylényle, un groupe pentaphényle, un groupe hexacényle, un groupe pyrrolyle, un groupe imidazolyle, un groupe pyrazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe phtalazinyle, un groupe naphthyridinyle, un groupe quinoxalinyle, un groupe quinazolinyle, un groupe cinnolinyle, un groupe phénanthridinyle, un groupe acridinyle, un groupe phénanthrolinyle, un groupe phénazinyle, un groupe benzoxazolyle, un groupe benzimidazolyle, un groupe furanyle, un groupe benzofuranyle, un groupe thiophényle, un groupe benzothiophényle, un groupe thiazolyle, un groupe isothiazolyle, un groupe benzothiazolyle, un groupe isoxazolyle, un groupe oxazolyle, un groupe triazolyle, un groupe tétrazolyle, un groupe oxadiazolyle, un groupe triazinyle, un groupe carbazolyle, un groupe dibenzofuranyle, un groupe dibenzothiophényle, un groupe benzocarbazolyle, un groupe azacarbazolyle, un groupe azadibenzofuranyle, un groupe azadibenzothiophényle, un groupe phénoxazinyle, un groupe phénothiazinyle, un groupe imidazopyrimidinyle ou un groupe imidazopyridinyle, chacun étant indépendamment substitué par au moins l'un parmi un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$-$C_{20}$, un groupe alcényle en $C_2$-$C_{20}$, un groupe alcynyle en $C_2$-$C_{20}$, un groupe alcoxy en $C_1$-$C_{20}$, un groupe alkylthio en $C_1$-$C_{20}$, un groupe phényle, un groupe naphtyle, un groupe anthracényle, un groupe pyrényle, un groupe phénanthrényle, un groupe fluorényle, un groupe pyridinyle, un groupe pyrimidinyle, un groupe pyrazinyle, un groupe pyridazinyle, un groupe triazinyle, un groupe quinolinyle, un groupe isoquinolinyle, un groupe phtalazinyle, un groupe quinoxalinyle, un groupe cinnolinyle ou un groupe quinazolinyle.

**4.** Dispositif électroluminescent organique de l'une quelconque des revendications 1 à 3, dans lequel $L_{10}$ est :

un groupe phénylène, un groupe pentalénylène, un groupe indénylène, un groupe naphtylène, un groupe azulénylène, un groupe heptalénylène, un groupe acénaphtylène, un groupe fluorénylène, un groupe phénalénylène, un groupe phénanthrénylène, un groupe anthracénylène, un groupe fluoranthénylène, un groupe triphénylénylène, un groupe pyrénylène, un groupe chrysénylénylène, un groupe naphtacénylène, un groupe picénylène, un groupe pérylénylène, un groupe pentacénylène, un groupe carbazolylène, un groupe dibenzofuranylène, un groupe dibenzothiophénylène, un groupe dibenzosilolylène, un groupe benzocarbazolylène, un groupe pyridinylène, un groupe pyrimidinylène, un groupe triazinylène, un groupe quinolinylène, un groupe isoquinolinylène, un groupe benzoquinolinylène, un groupe phtalazinylène, un groupe naphtyridinylène, un groupe quinoxalinylène, un groupe quinazolinylène, un groupe phénanthridinylène, un groupe acridinylène, un groupe phénanthrolinylène, un groupe phénazinylène, un groupe phénoxazinylène, un groupe phénothiazinylène, un groupe azacarbazolylène, un groupe azadibenzofuranylène ou un groupe azadibenzothiophénylène ;
un groupe phénylène, un groupe pentalénylène, un groupe indénylène, un groupe naphtylène, un groupe azulénylène, un groupe heptalénylène, un groupe acénaphtylène, un groupe fluorénylène, un groupe phénalénylène, un groupe phénanthrénylène, un groupe anthracénylène, un groupe fluoranthénylène, un groupe triphénylénylène, un groupe pyrénylène, un groupe chrysénylénylène, un groupe naphtacénylène, un groupe picénylène, un groupe pérylénylène, un groupe pentacénylène, un groupe carbazolylène, un groupe dibenzofuranylène, un groupe dibenzothiophénylène, un groupe dibenzosilolylène, un groupe benzocarbazolylène, un groupe pyridinylène, un groupe pyrimidinylène, un groupe triazinylène, un groupe quinolinylène, un groupe isoquinolinylène, un groupe benzoquinolinylène, un groupe phtalazinylène, un groupe naphthyridinylène, un groupe quinoxalinylène, un groupe quinazolinylène, un groupe phénanthridinylène, un groupe acridinylène, un groupe phénanthrolinylène, un groupe phénazinylène, un groupe phénoxazinylène, un groupe phénothiazinylène, un groupe azacarbazolylène, un groupe azadibenzofuranylène, ou un groupe azadibenzothiophénylène, chacun étant indépendamment substitué par au moins l'un parmi un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$-$C_{60}$, un groupe alcényle en $C_2$-$C_{60}$, un groupe alcynyle en $C_2$-$C_{60}$, un groupe alcoxy en $C_1$-$C_{60}$, un groupe alkylthio en $C_1$-$C_{60}$, un groupe cycloalkyle en $C_3$-$C_{10}$, un groupe cycloalcényle en $C_3$-$C_{10}$, un groupe hétérocycloalkyle en $C_1$-$C_{10}$, un groupe hétérocycloalcényle en $C_1$-$C_{10}$, un groupe aryle en $C_6$-$C_{60}$, un groupe aryloxy en $C_6$-$C_{60}$, un groupe arylthio en $C_6$-$C_{60}$, un groupe hétéroaryle en $C_1$-$C_{60}$, un groupe hétéroaryloxy en $C_1$-$C_{60}$, un groupe hétéroarylthio en $C_1$-$C_{60}$, un groupe polycyclique condensé non aromatique monovalent ou un groupe hétéropolycyclique condensé non aromatique monovalent ; ou
un groupe représenté par la Formule 2A ou la Formule 2B :

Formule 2A

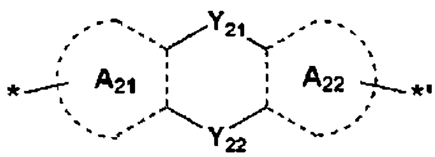

Formule 2B

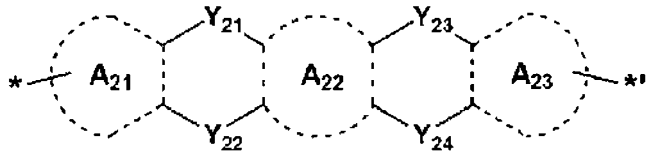

où, dans les Formules 2A et 2B,
$Y_{21}$ à $Y_{24}$ sont chacun indépendamment une liaison simple, O, S, $N(R_{21})$, $C(R_{21})(R_{22})$, $Si(R_{21})(R_{22})$, C(=O), S(=O), $S(=O)_2$, $B(R_{21})$, $P(R_{21})$ ou $P(=O)(R_{21})$,
$A_{21}$ à $A_{23}$ sont chacun indépendamment un groupe phényle, un groupe naphtalène, un groupe 1,2,3,4-tétrahydronaphtalène, un groupe phénanthrène, un groupe pyridine, un groupe pyrimidine, un groupe pyrazine, un groupe triazine, un groupe quinoléine, un groupe isoquinoléine, un groupe quinoxaline, un groupe quinazoline, un groupe phénanthroline, un groupe benzofurane, un groupe benzothiophène, un groupe fluorène, un groupe carbazole, un groupe dibenzofurane, un groupe dibenzothiophène, un groupe dibenzosilole, un groupe azafluorène, un groupe azacarbazole, un groupe azadibenzofurane, un groupe azadibenzothiophène ou un groupe azadibenzosilole,
$R_{21}$ et $R_{22}$ sont chacun indépendamment compris en se référant à la description de $R_{10}$ ou $R_{20}$ dans la revendication 1, et
* et *' indiquent chacun un site de liaison à un atome adjacent.

**5.** Dispositif électroluminescent organique de l'une quelconque des revendications 1 à 4, dans lequel a10 vaut 0 ou 1.

**6.** Dispositif électroluminescent organique de l'une quelconque des revendications 1 à 5, dans lequel $R_{10}$ et $R_{20}$ sont chacun indépendamment :

un hydrogène, un deutérium, -F, un groupe cyano, $-CD_3$, $-CD_2H$, $-CDH_2$, $-CF_3$, $-CF_2H$, - $CFH_2$, un groupe alkyle en $C_1$-$C_{20}$, un groupe alkylthio en $C_1$-$C_{20}$ ou un groupe alcoxy en $C_1$-$C_{20}$ ;
un groupe alkyle en $C_1$-$C_{20}$, un groupe alkylthio en $C_1$-$C_{20}$, un groupe alcoxy en $C_1$-$C_{20}$, chacun étant indépendamment substitué par un deutérium, -F, un groupe cyano, un groupe phényle, un groupe biphényle, un groupe terphényle ou un groupe naphtyle ;
un groupe cyclopentyle, un groupe cyclohexyle, un groupe cyclopentényle, un groupe cyclohexényle, un groupe cycloheptényle, un groupe phényle, un groupe biphényle, un groupe terphényle, un groupe naphtyle, un groupe fluorényle, un groupe carbazolyle, un groupe dibenzofuranyle ou un groupe dibenzothiophényle ; ou
un groupe cyclopentyle, un groupe cyclohexyle, un groupe cyclopentényle, un groupe cyclohexényle, un groupe cycloheptényle, un groupe phényle, un groupe biphényle, un groupe terphényle, un groupe naphtyle, un groupe fluorényle, un groupe carbazolyle, un groupe dibenzofuranyle ou un groupe dibenzothiophényle, chacun étant indépendamment substitué par au moins l'un parmi un deutérium, un groupe cyano, un groupe alkyle en $C_1$-$C_{20}$, un groupe alcoxy en $C_1$-$C_{20}$, un groupe alkylthio en $C_1$-$C_{20}$, un groupe phényle, un groupe biphényle, un groupe terphényle ou un groupe naphtyle.

**7.** Dispositif électroluminescent organique de l'une quelconque des revendications 1 à 6, dans lequel $R_{10}$ est :

un deutérium, -F, un groupe cyano, $-CD_3$, $-CD_2H$, $-CDH_2$, $-CF_3$, $-CF_2H$, $-CFH_2$, un groupe alkyle en $C_1$-$C_{20}$, un groupe alkylthio en $C_1$-$C_{20}$ ou un groupe alcoxy en $C_1$-$C_{20}$ ;
un groupe alkyle en $C_1$-$C_{20}$, un groupe alkylthio en $C_1$-$C_{20}$ ou un groupe alcoxy en $C_1$-$C_{20}$, chacun étant indépendamment substitué par au moins l'un parmi un deutérium, un groupe cyano, un groupe phényle, un groupe biphényle, un groupe terphényle ou un groupe naphtyle ;
un groupe cyclopentyle, un groupe cyclohexyle, un groupe cyclopentényle, un groupe cyclohexényle, un groupe cycloheptényle, un groupe phényle, un groupe biphényle, un groupe terphényle, un groupe naphtyle, un groupe fluorényle, un groupe carbazolyle, un groupe dibenzofuranyle, un groupe dibenzothiophényle, un groupe benzocarbazolyle, un groupe azacarbazolyle, un groupe azadibenzofuranyle, un groupe azadibenzothiophényle, un groupe phénoxazinyle ou un groupe phénothiazinyle ; ou
un groupe cyclopentyle, un groupe cyclohexyle, un groupe cyclopentényle, un groupe cyclohexényle, un groupe cycloheptényle, un groupe phényle, un groupe biphényle, un groupe terphényle, un groupe naphtyle, un groupe fluorényle, un groupe carbazolyle, un groupe dibenzofuranyle, un groupe dibenzothiophényle, un groupe benzocarbazolyle, un groupe azacarbazolyle, un groupe azadibenzofuranyle, un groupe azadibenzothiophényle, un groupe phénoxazinyle ou un groupe phénothiazinyle, chacun étant indépendamment substitué par au moins l'un parmi un deutérium, un groupe cyano, un groupe alkyle en $C_1$-$C_{20}$, un groupe alcoxy en $C_1$-$C_{20}$, un groupe alkylthio en $C_1$-$C_{20}$, un groupe phényle, un groupe biphényle, un groupe terphényle, un groupe naphtyle, un groupe carbazole, un groupe dibenzofuranyle ou un groupe dibenzothiophényle, et

$R_{20}$ est un hydrogène, un deutérium, -F, un groupe cyano, $-CD_3$, $-CD_2H$, $-CDH_2$, $-CF_3$, $-CF_2H$, $-CFH_2$, un groupe alkyle en $C_1$-$C_{20}$ ou un groupe phényle.

8. Dispositif électroluminescent organique de l'une quelconque des revendications 1 à 7, dans lequel c10 vaut 1.

9. Dispositif électroluminescent organique de l'une quelconque des revendications 1 à 8, dans lequel le composé silane représenté par la Formule 1 est représenté par l'une des Formules 10-1 à 10-5 :

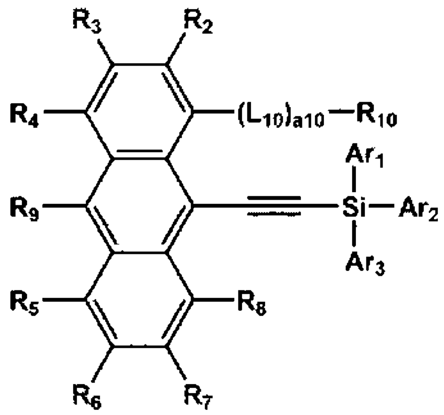

10-1

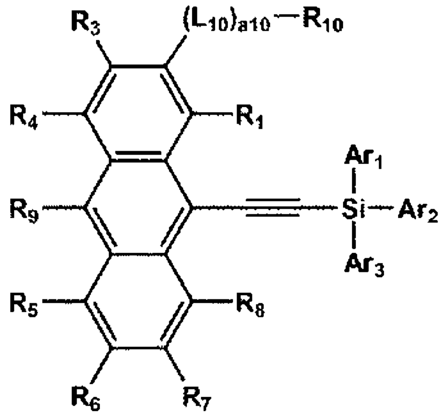

10-2

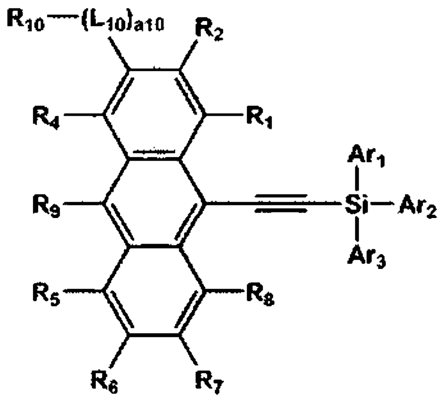

10-3

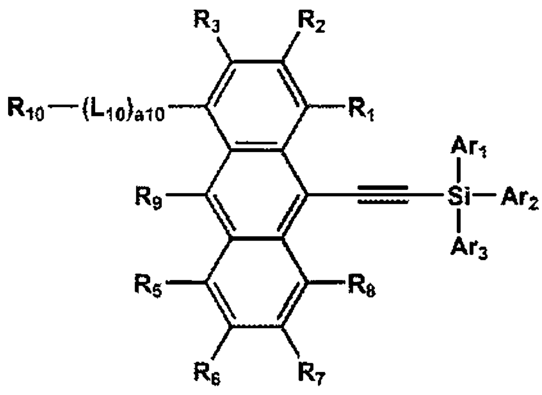

10-4

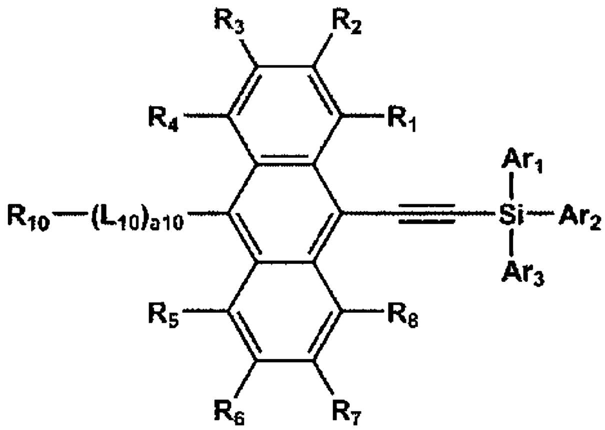

**10-5**

où, dans les Formules 10-1 à 10-5,
$Ar_1$ à $Ar_3$, $L_{10}$, a10 et $R_{10}$ sont respectivement compris en se référant aux descriptions de $Ar_1$ à $Ar_3$, $L_{10}$, a10 et $R_{10}$ dans la revendication 1, et
$R_1$ à $R_9$ sont chacun indépendamment compris en se référant à la description de $R_{20}$ dans la revendication 1 ;
de préférence, ledit composé silane représenté par la Formule 1 est un composé représenté par la Formule 10-5, et
$R_{10}$ est :

un deutérium, -F, un groupe cyano, $-CD_3$, $-CD_2H$, $-CDH_2$, $-CF_3$, $-CF_2H$, $-CFH_2$, un groupe alkyle en $C_1$-$C_{20}$, un groupe alkylthio en $C_1$-$C_{20}$ ou un groupe alcoxy en $C_1$-$C_{29}$ ;
un groupe alkyle en $C_1$-$C_{20}$, un groupe alkylthio en $C_1$-$C_{20}$ ou un groupe alcoxy en $C_1$-$C_{20}$, chacun étant indépendamment substitué par au moins l'un parmi un deutérium, un groupe cyano, un groupe phényle, un groupe biphényle, un groupe terphényle ou un groupe naphtyle ;
un groupe cyclopentyle, un groupe cyclohexyle, un groupe cyclopentényle, un groupe cyclohexényle, un groupe cycloheptényle, un groupe phényle, un groupe biphényle, un groupe terphényle, un groupe naphtyle, un groupe fluorényle, un groupe carbazolyle, un groupe dibenzofuranyle, un groupe dibenzothiophényle, un groupe benzocarbazolyle, un groupe azacarbazolyle, un groupe azadibenzofuranyle, un groupe azadibenzothiophényle, un groupe phénoxazinyle ou un groupe phénothiazinyle ; ou
un groupe cyclopentyle, un groupe cyclohexyle, un groupe cyclopentényle, un groupe cyclohexényle, un groupe cycloheptényle, un groupe phényle, un groupe biphényle, un groupe terphényle, un groupe naphtyle, un groupe fluorényle, un groupe carbazolyle, un groupe dibenzofuranyle, un groupe dibenzothiophényle, un groupe benzocarbazolyle, un groupe azacarbazolyle, un groupe azadibenzofuranyle, un groupe azadibenzothiophényle, un groupe phénoxazinyle ou un groupe phénothiazinyle, chacun étant indépendamment substitué par au moins l'un parmi un deutérium, un groupe cyano, un groupe alkyle en $C_1$-$C_{20}$, un groupe alcoxy en $C_1$-$C_{20}$, un groupe alkylthio en $C_1$-$C_{20}$, un groupe phényle, un groupe biphényle, un groupe terphényle, un groupe naphtyle, un groupe carbazole, un groupe dibenzofuranyle ou un groupe dibenzothiophényle.

**10.** Dispositif électroluminescent organique de l'une quelconque des revendications 1 à 9, dans lequel le composé silane représenté par la Formule 1 satisfait à l'Équation 1 :

Équation 1

$$E(T1) < E(S1) < 2 \times E(T1)$$

où, dans l'Équation 1,
E(T1) indique un niveau d'énergie du triplet excité le plus bas du composé silane, et E(S1) indique un niveau d'énergie du singulet excité le plus bas du composé silane.

**11.** Dispositif électroluminescent organique de l'une quelconque des revendications 1 à 10, dans lequel le composé

silane représenté par la Formule 1 satisfait à l'Équation 2 :

Équation 2

$$[2 \times E(T1)] - E(S1) < 1 \text{ électronvolt}$$

où, dans l'Équation 2,
E(T1) indique un niveau d'énergie du triplet excité le plus bas du composé silane, et E(S1) indique un niveau d'énergie du singulet excité le plus bas du composé silane.

**12.** Dispositif électroluminescent organique de la revendication 1, dans lequel le composé silane représenté par la Formule 1 est l'un des Composés 1-16, 18-121, 123-130, 145-160 :

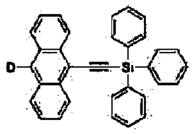

1

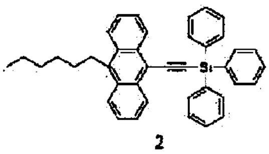

2

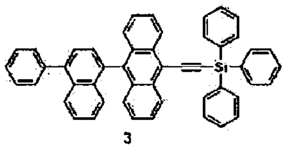

3

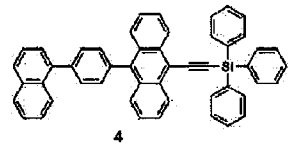

4

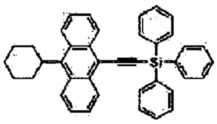

5

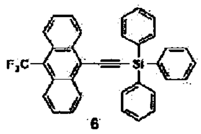

6

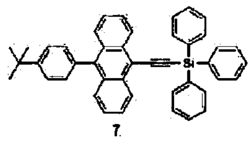

7

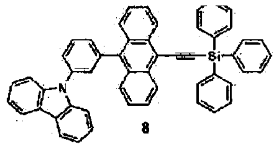

8

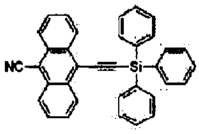

9

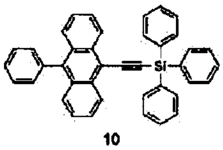

10

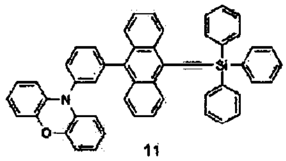

11

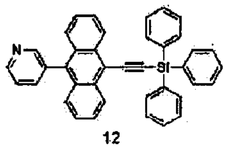

12

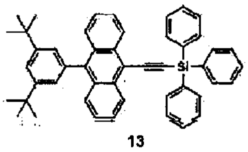

13

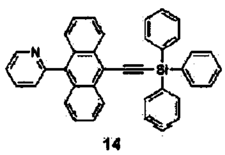

14

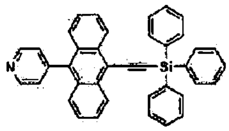

15

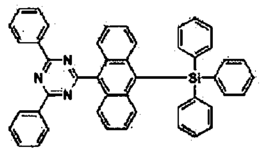

16

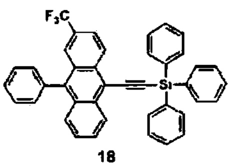

18

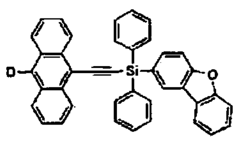

19

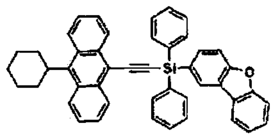

20

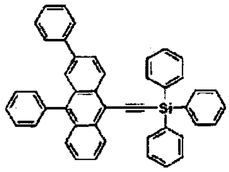

21

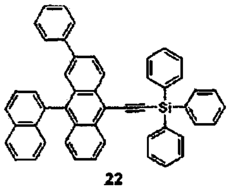

22

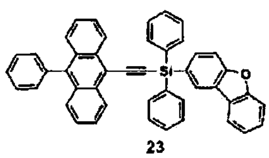

23

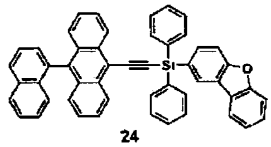

24

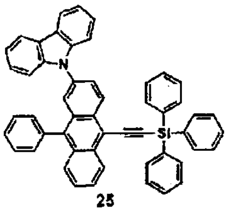
25

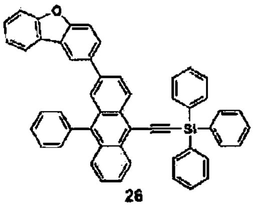
26

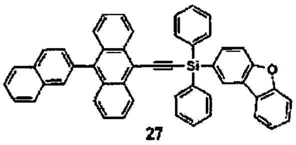
27

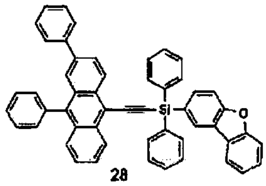
28

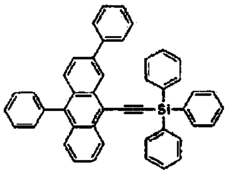
29

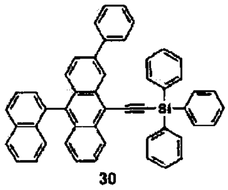
30

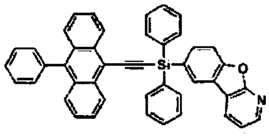
31

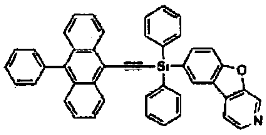
32

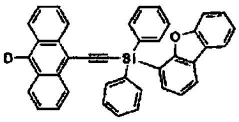
33

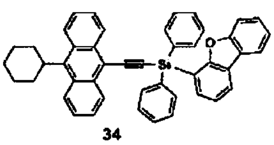
34

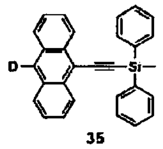
35

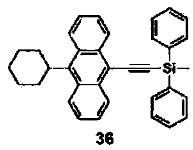
36

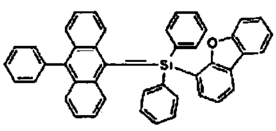
37

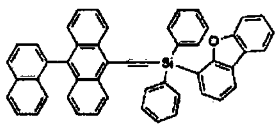
38

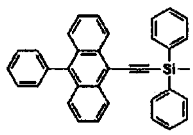
39

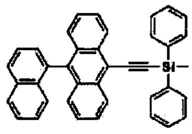
40

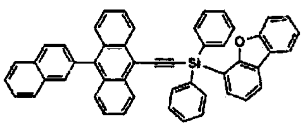
41

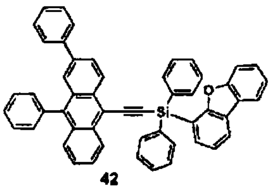
42

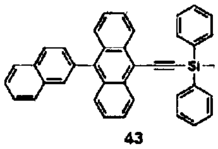
43

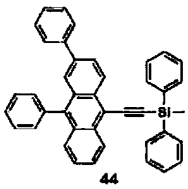
44

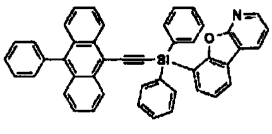
45

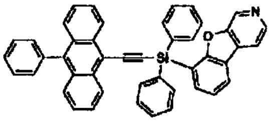
46

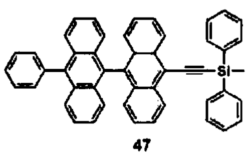
47

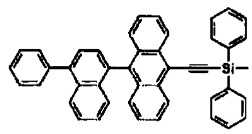
48

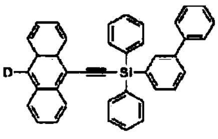
49

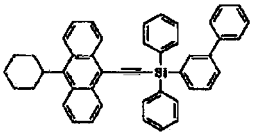
50

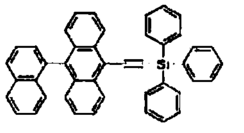
51

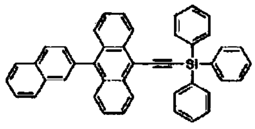
52

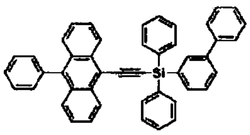
53

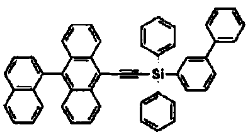
54

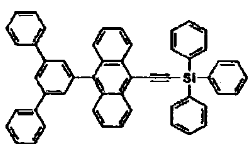
55

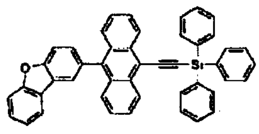
56

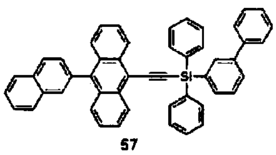
57

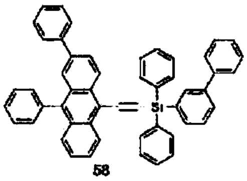
58

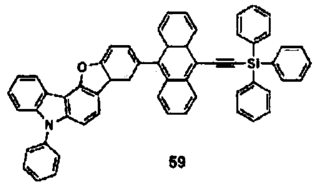
59

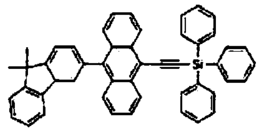
60

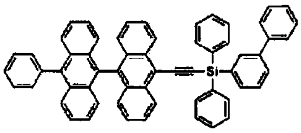
61

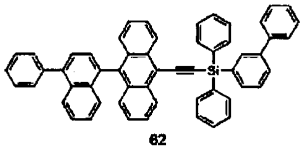
62

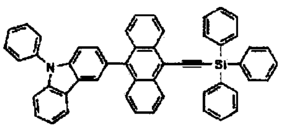
63

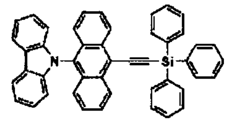
64

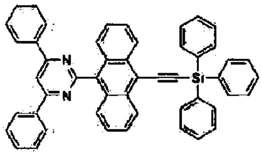
65

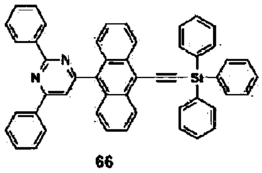
66

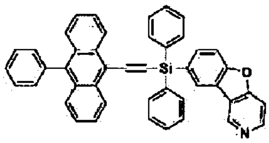
67

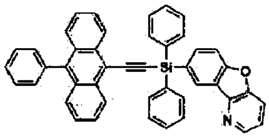
68

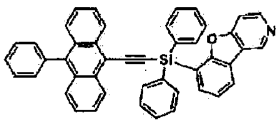
69

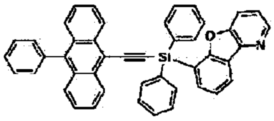
70

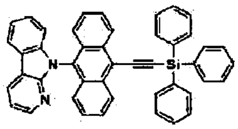
71

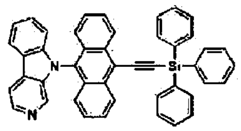
72

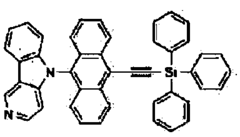
73

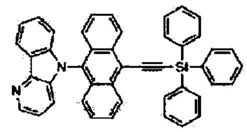
74

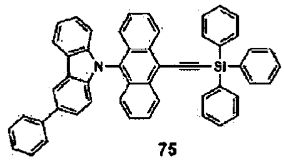
75

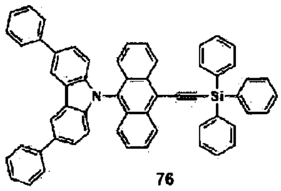
76

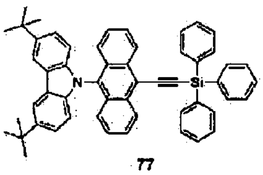
77

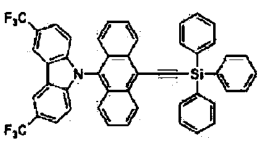
78

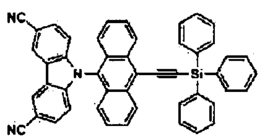
79

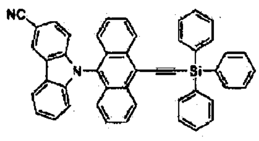
80

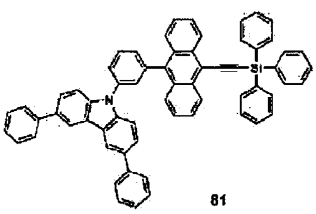
81

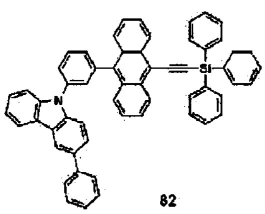
82

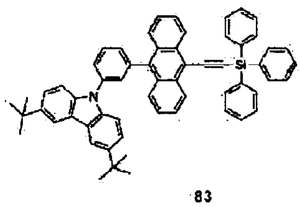
83

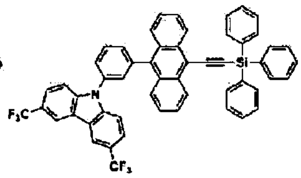
84

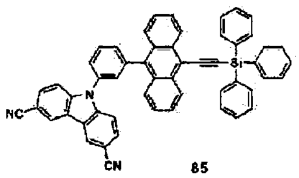
85

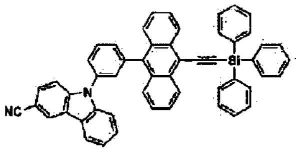
86

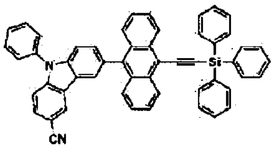
87

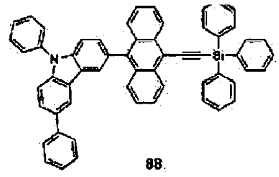
88

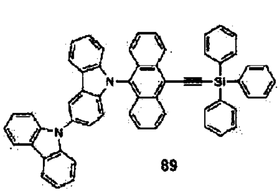
89

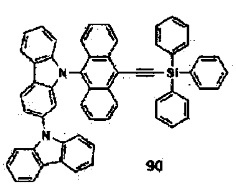
90

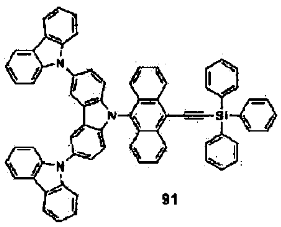
91

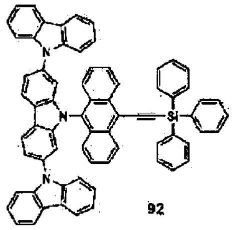
92

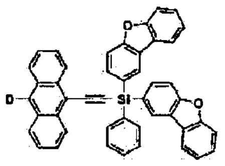
93

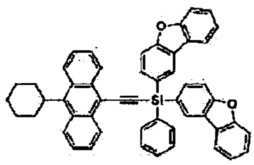
94

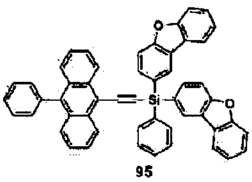
95

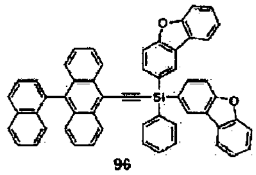
96

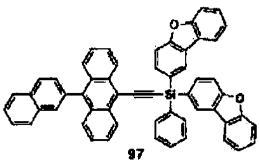
97

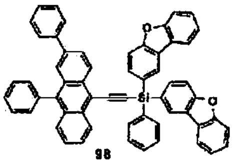
98

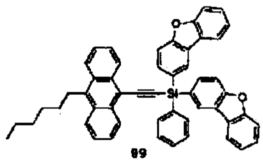
99

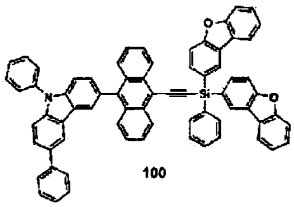
100

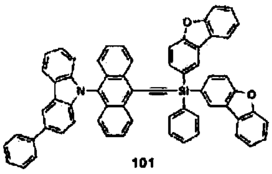
101

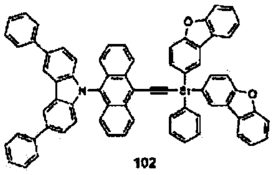
102

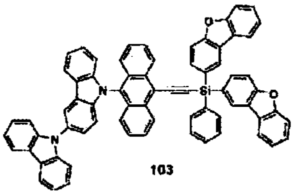
103

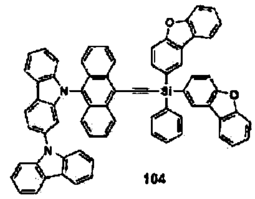
104

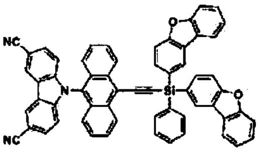
105

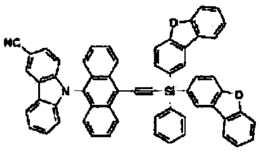
106

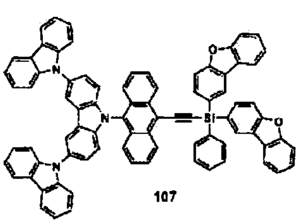
107

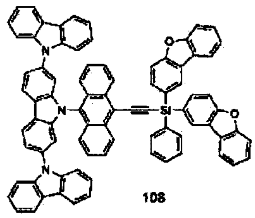
108

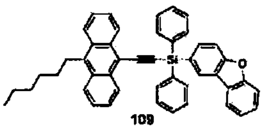
109

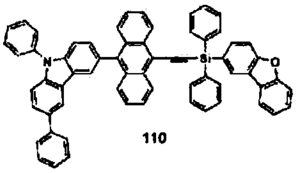
110

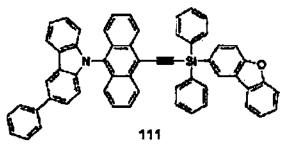
111

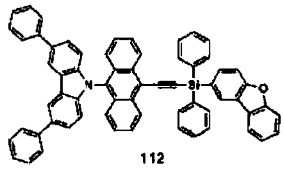
112

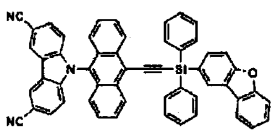

113

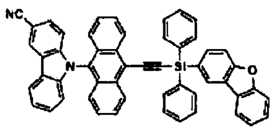

114

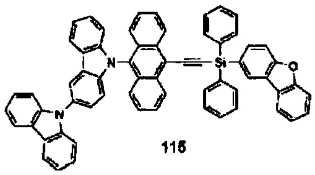

115

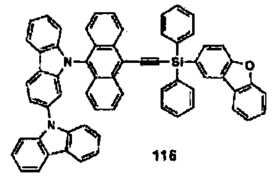

116

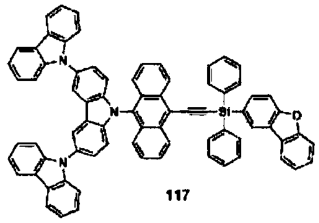

117

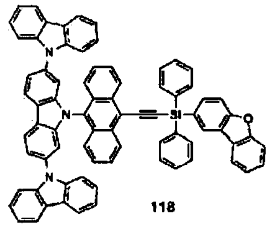

118

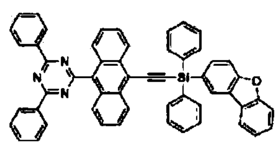

119

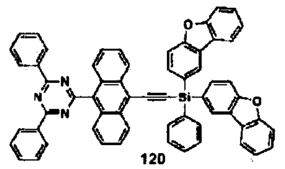

120

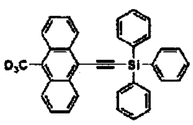

121

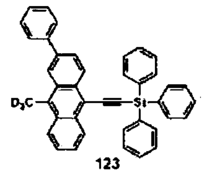

123

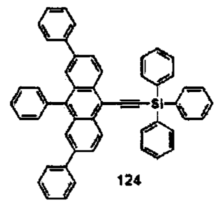

124

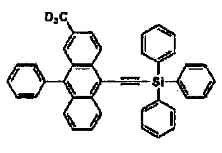

125

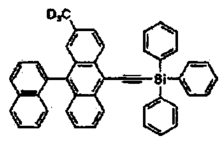

126

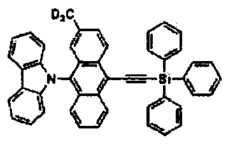

127

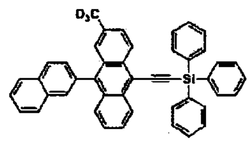

128

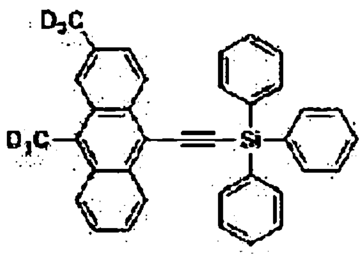

129

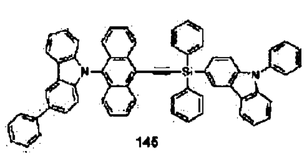

145

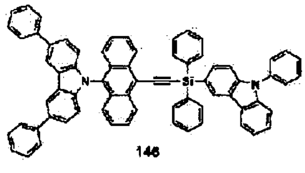

146

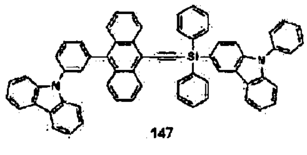

147

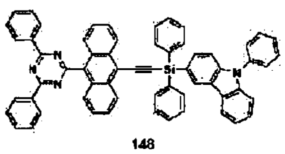

148

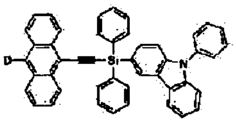

149

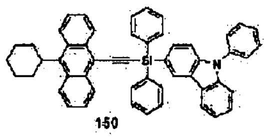

150

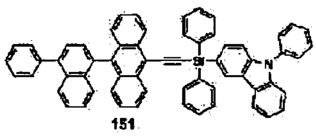

151

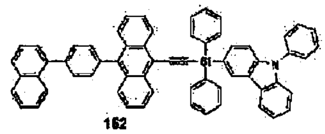

152

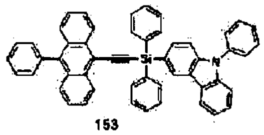 153 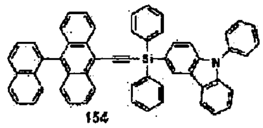 154 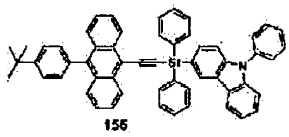 155 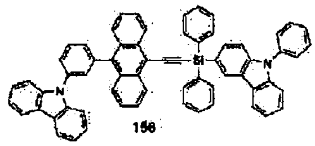 156

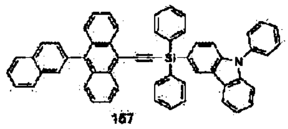 157 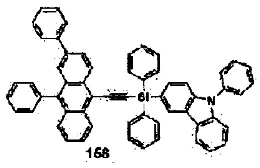 158 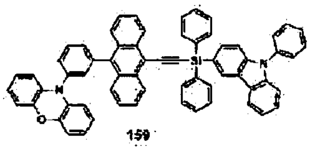 159 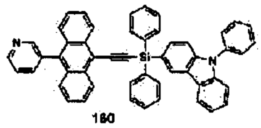 160 .

**13.** Dispositif électroluminescent organique de l'une quelconque des revendications 1 à 12, dans lequel une teneur de l'hôte est supérieure à une teneur du dopant ; et/ou

dans lequel l'hôte est constitué du composé silane ; et/ou
dans lequel un rapport de composants d'émission émis par le dopant est de 80 pour cent ou plus de l'ensemble des composants d'émission émis par la couche d'émission ; et/ou
dans lequel le dopant est un dopant fluorescent ; et/ou
dans lequel la couche d'émission émet une lumière bleue présentant une longueur d'onde d'émission maximale comprise dans une plage de 410 nanomètres à 490 nanomètres.

**14.** Dispositif électroluminescent organique de l'une quelconque des revendications 1 à 13, dans lequel la première électrode est une anode, la seconde électrode est une cathode,

la couche organique comprend une région de transport de trous entre la première électrode et la couche d'émission et une région de transport d'électrons entre la couche d'émission et la seconde électrode,
la région de transport de trous comprend au moins l'une d'une couche d'injection de trous, d'une couche de transport de trous, ou d'une couche de blocage d'électrons, et
la région de transport d'électrons comprend au moins l'une d'une couche de blocage de trous, d'une couche de transport d'électrons ou d'une couche d'injection d'électrons.

FIGURE

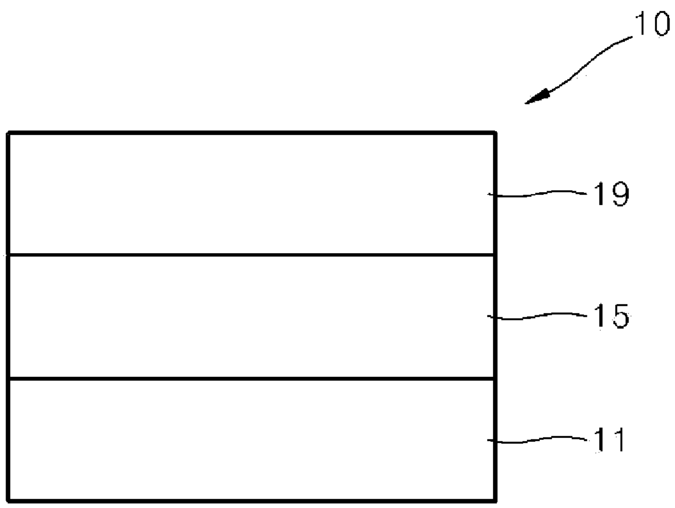

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2015171356 A1